(19) Europäisches Patentamt
European Patent Office
Office européen des brevets

(11) EP 3 985 750 B1

(12) EUROPEAN PATENT SPECIFICATION

(45) Date of publication and mention of the grant of the patent:
**29.04.2026 Bulletin 2026/18**

(21) Application number: **21203294.0**

(22) Date of filing: **18.10.2021**

(51) International Patent Classification (IPC):
***H10K 50/10*** *(2023.01)* ***H10K 85/60*** *(2023.01)*

(52) Cooperative Patent Classification (CPC):
**C09K 11/06; H10K 85/615; H10K 85/626; H10K 85/633; H10K 85/658;** C09K 2211/1007; C09K 2211/1011; C09K 2211/1014; C09K 2211/1055; H10K 50/11; H10K 50/16; H10K 2101/20; H10K 2101/90

# (54) LIGHT-EMITTING DEVICE AND APPARATUS INCLUDING THE SAME

LICHTEMITTIERENDE VORRICHTUNG UND GERÄT DAMIT

DISPOSITIF ÉLECTROLUMINESCENT ET APPAREIL LE COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.10.2020 KR 20200135507**

(43) Date of publication of application:
**20.04.2022 Bulletin 2022/16**

(73) Proprietor: **Samsung Display Co., Ltd.**
**Gyeonggi-do 17113 (KR)**

(72) Inventor: **PARK, Hyejeong**
**Yongin-si 17113 (KR)**

(74) Representative: **Marks & Clerk LLP**
**15 Fetter Lane**
**London EC4A 1BW (GB)**

(56) References cited:
**EP-A1- 3 406 597**
**EP-A1- 3 476 852**
**US-A1- 2019 315 776**
**US-A1- 2019 389 877**
**US-A1- 2020 235 343**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 985 750 B1

## Description

## BACKGROUND

### 1 Field

Embodiments of the present disclosure relate to a light-emitting device and an electronic apparatus including the same.

### 2. Description of Related Art

Organic light-emitting devices are self-emission devices that, as compared with other devices of the related art, have wide viewing angles, high contrast ratios, short response times, and excellent characteristics in terms of luminance, driving voltage, and response speed, and produce full-color images.

In an example, an organic light-emitting device may include a first electrode on a substrate, and a hole transport region, an emission layer, an electron transport region, and a second electrode sequentially stacked on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons transit from an excited state to a ground state to thereby generate light.

Document US 2020/235343 A1 is concerning an organic light emitting device comprising a anthracene derivative and fluorene derivative with triazene moiety.

## SUMMARY

Embodiments of the present disclosure relate to a light-emitting device and an electronic apparatus including the same.

Additional aspects of embodiments will be set forth in part in the description which follows and, in part, will be apparent from the description, or may be learned by practice of the presented embodiments of the disclosure.

According to one or more embodiments, a light-emitting device includes a first electrode,

a second electrode facing the first electrode,
an interlayer between the first electrode and the second electrode and including an emission layer,
at least one first compound represented by Formula 1, and
at least one second compound represented by Formula 2

Formula 1

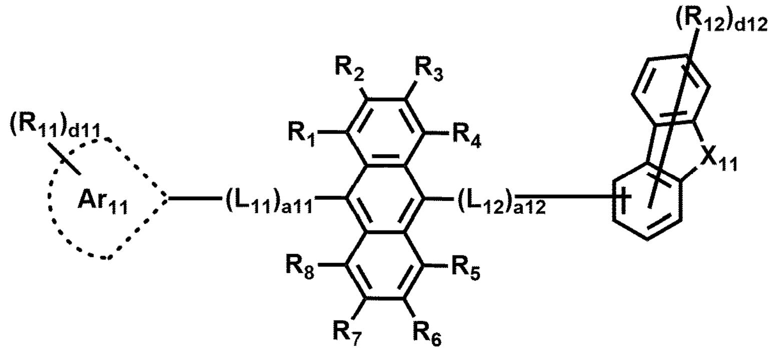

Formula 2

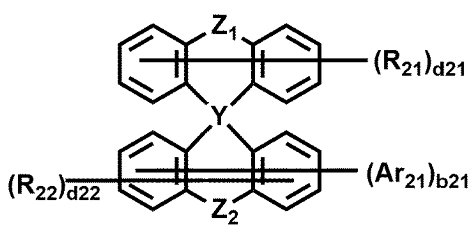

Formula 3

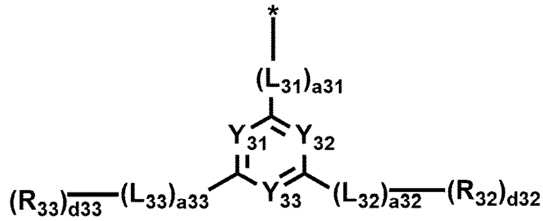

wherein, in Formulae 1, 2, and 3,
$X_{11}$ is O, S, $N(R_{11a})$, or $C(R_{11a})(R_{11b})$,
$L_{11}$, $L_{12}$, and $L_{31}$ to $L_{33}$ are each independently a single bond, a $C_5$-$C_{60}$ carbocyclic group unsubstituted or substituted with at least one $R_{10a}$, or a $C_1$-$C_{60}$ heterocyclic group unsubstituted or substituted with at least one $R_{10a}$,
a11, a12, and a31 to a33 are each independently an integer from 1 to 3,
$Ar_{11}$ is a $C_5$-$C_{60}$ carbocyclic group or a $C_1$-$C_{60}$ heterocyclic group,
Y is C or Si,
$Z_1$ is no bond, a single bond, O, S, $N(R_{21a})$, or $C(R_{21a})(R_{21b})$,
$Z_2$ is no bond, a single bond, O, S, $N(R_{22a})$, or $C(R_{22a})(R_{22b})$,
wherein when $Z_1$ is O or S, $Z_2$ is not a single bond,
$Ar_{21}$ is a group represented by Formula 3,
b21 is an integer from 1 to 10,
$Y_{31}$ is N or $C(R_{31a})$,
$Y_{32}$ is N or $C(R_{32a})$,
$Y_{33}$ is N or $C(R_{33a})$,
* indicates a binding site to a neighboring atom,
$R_1$ to $R_8$, $R_{11}$, $R_{11a}$, $R_{11b}$, $R_{12}$, $R_{21}$, $R_{21a}$, $R_{21b}$, $R_{22}$, $R_{22a}$, $R_{22b}$, $R_{32}$, $R_{33}$, $R_{31a}$, $R_{32a}$, and $R_{33a}$ are each independently hydrogen, deuterium, -F, -Cl, -Br, -I, a hydroxyl group, a cyano group, a nitro group, an amidino group, a hydrazino group, a hydrazono group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$,
d11 is an integer from 1 to 10,
d12 is an integer from 1 to 7,
d21 is an integer from 1 to 10,
d22 is an integer from 1 to 9,
d32 is 1,
d33 is 1,
the first compound includes at least one deuterium, and
$R_{10a}$ is
deuterium, -F, -Cl, -Br, -I, a hydroxyl group, a cyano group, or a nitro group,
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, $-P(=O)(Q_{11})(Q_{12})$, or any combination thereof,
a $C_3$-$C_{60}$ carbocyclic group, a $C_1$-$C_{60}$ heterocyclic group, a $C_6$-$C_{60}$ aryloxy group, or a $C_6$-$C_{60}$ arylthio group, unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, $-Si(Q_{21})(Q_{22})(Q_{23})$, $-N(Q_{21})(Q_{22})$, $-B(Q_{21})(Q_{22})$, $-C(=O)(O_{21})$, $-S(=O)_2(Q_{21})$, $-P(=O)(Q_{21})(Q_{22})$, or any combination thereof, or
$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or $-P(=O)(O_{31})(O_{32})$,
wherein $Q_1$ to $Q_3$, $Q_{11}$ to $Q_{13}$, $Q_{21}$ to $Q_{23}$ and $Q_{31}$ to $Q_{33}$ are each independently: hydrogen; deuterium; -F; -Cl; -Br; -I; a hydroxyl group; a cyano group; a nitro group; a $C_1$-$C_{60}$ alkyl group; a $C_2$-$C_{60}$ alkenyl group; a $C_2$-$C_{60}$ alkynyl group; a $C_1$-$C_{60}$ alkoxy group; or a $C_3$-$C_{60}$ carbocyclic group or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or

any combination thereof.

According to one or more embodiments, an electronic apparatus includes the light-emitting device, and

a thin-film transistor,
wherein the thin-film transistor includes a source electrode, and a drain electrode, and
the first electrode of the light-emitting device is electrically coupled to the source electrode or the drain electrode.

At least some of the above and other features of the invention are set out in the claims.

## BRIEF DESCRIPTION OF THE DRAWINGS

The above and other aspects and features of certain embodiments of the disclosure will be more apparent from the following description taken in conjunction with the accompanying drawings, in which:
FIG. 1 is a schematic cross-sectional view of a light-emitting device according to an embodiment; FIG. 2 is a schematic cross-sectional view of a light-emitting device according to another embodiment; and FIG. 3 is a schematic cross-sectional view of a light-emitting device according to another embodiment.

## DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of embodiments of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

An aspect of an embodiment of the present disclosure provides a light-emitting device including: a first electrode;

a second electrode facing the first electrode;
an interlayer between the first electrode and the second electrode and including an emission layer;
at least one first compound represented by Formula 1; and
at least one second compound represented by Formula 2:

Formula 1

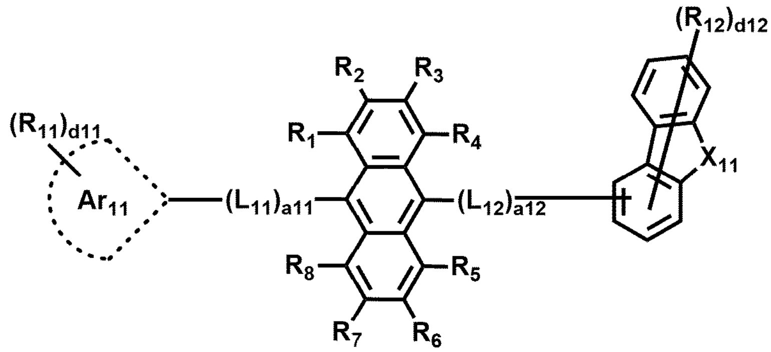

Formula 2

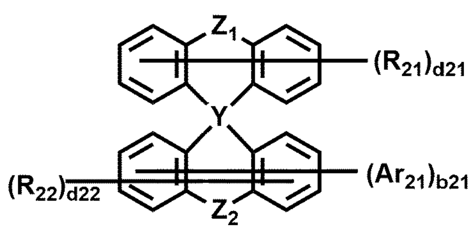

Formula 3

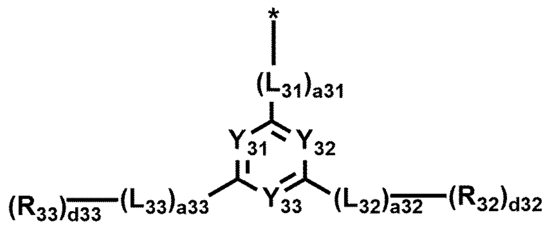

wherein, in Formulae 1, 2, and 3,

$X_{11}$ is O, S, $N(R_{11a})$, or $C(R_{11a})(R_{11b})$, and

$Ar_{11}$ is a $C_5$-$C_{60}$ carbocyclic group or a $C_1$-$C_{60}$ heterocyclic group. For example, $Ar_{11}$ may be a $C_5$-$C_{30}$ carbocyclic group or a $C_1$-$C_{20}$ heterocyclic group.

In an embodiment, $Ar_{11}$ may be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

In one or more embodiments, $Ar_{11}$ may be represented by one of Formulae 11-1 to 11-51:

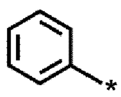

11-1

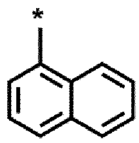

11-2

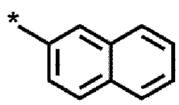

11-3

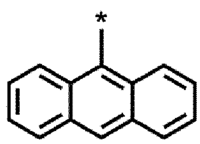

11-4

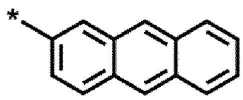

11-5

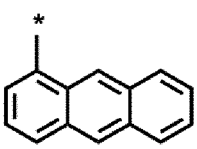

11-6

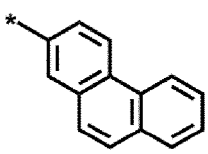

11-7

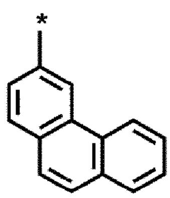

11-8

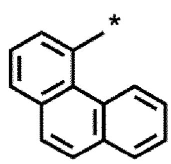

11-9

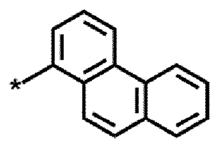

11-10

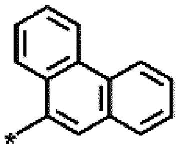
11-11

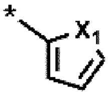
11-12

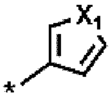
11-13

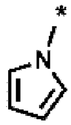
11-14

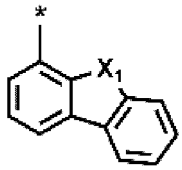
11-15

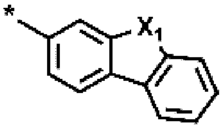
11-16

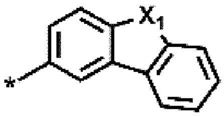
11-17

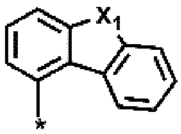
11-18

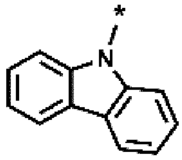
11-19

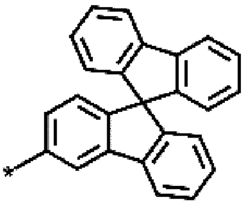
11-20

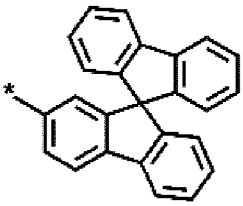
11-21

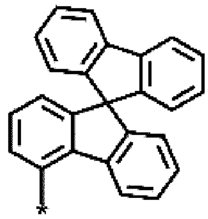
11-22

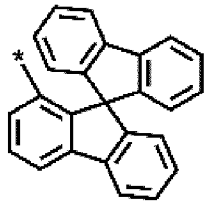
11-23

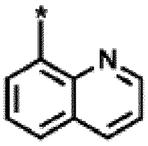
11-24

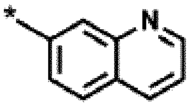
11-25

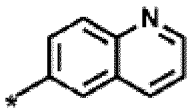
11-26

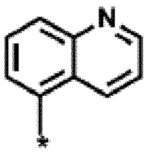
11-27

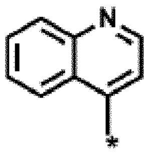
11-28

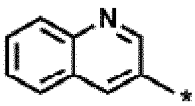
11-29

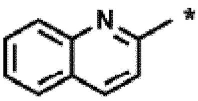
11-30

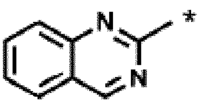
11-31

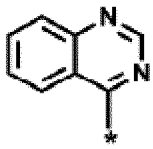
11-32

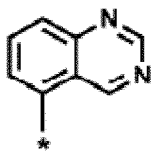
11-33

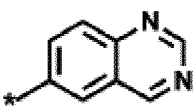
11-34

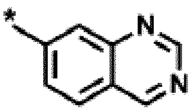
11-35

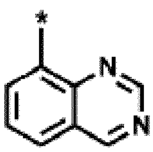
11-36

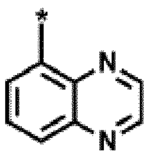
11-37

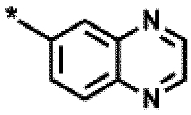
11-38

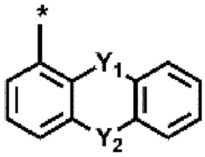

**11-39**

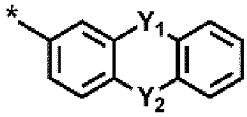

**11-40**

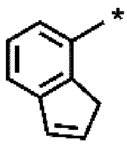

**11-41**

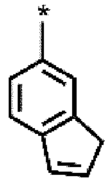

**11-42**

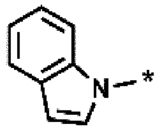

**11-43**

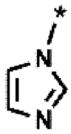

**11-44**

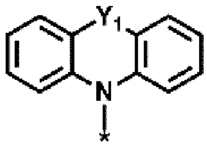

**11-45**

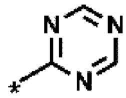

**11-46**

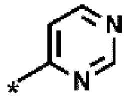

**11-47**

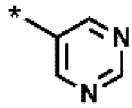

**11-48**

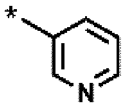

**11-49**

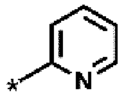

**11-50**

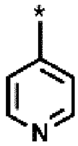

**11-51**

wherein, in Formulae 11-1 to 11-51:

$X_1$ is O, S, $N(R_{1a})$, or $C(R_{1a})(R_{1b})$,
$_1$ is O, S, $N(R_{1a})$, or $C(R_{1a})(R_{1b})$,
$Y_2$ is O, S, $N(R_{2a})$, or $C(R_{2a})(R_{2b})$,
$R_{1a}$, $R_{1b}$, $R_{2a}$, and $R_{2b}$ are each the same as described in connection with $R_{11}$, and
wherein * in the formulae indicates a binding site to a neighboring atom.

In one or more embodiments, a moiety represented by

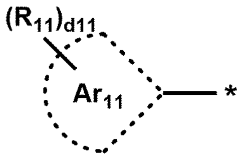

in Formula 1 may be represented by one of Formulae A-1 to A-27:

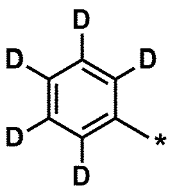

**A-1**

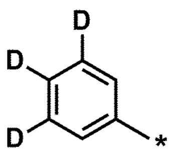

**A-2**

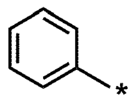

**A-3**

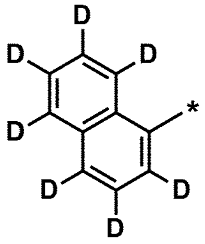

A-4

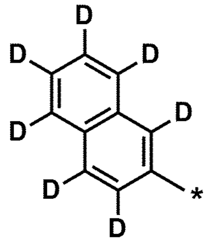

A-5

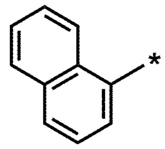

A-6

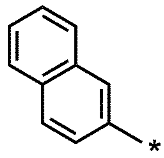

A-7

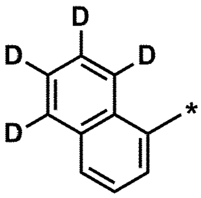

A-8

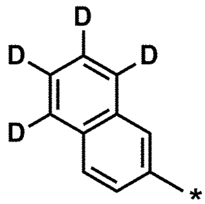

A-9

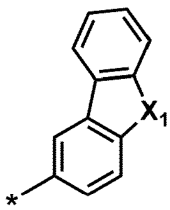

A-10

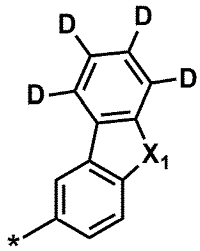

A-11

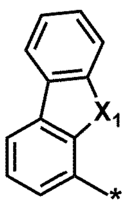

A-12

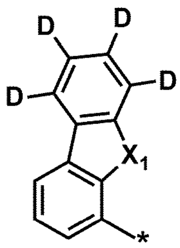

A-13

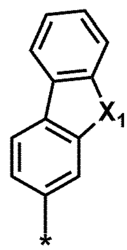

A-14

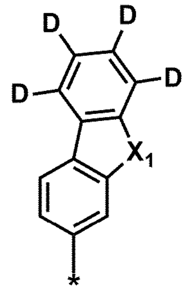

A-15

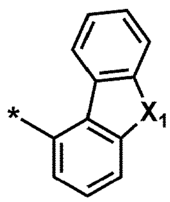

A-16

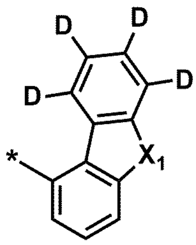

A-17

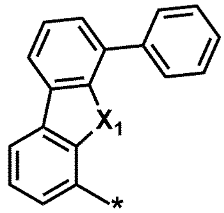

A-18

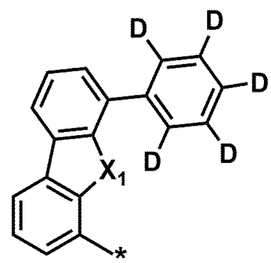

A-19

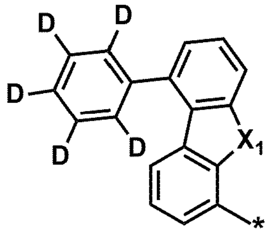

A-20

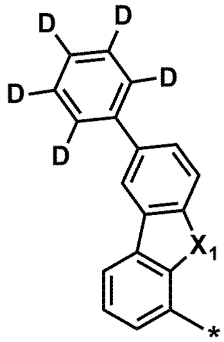

A-21

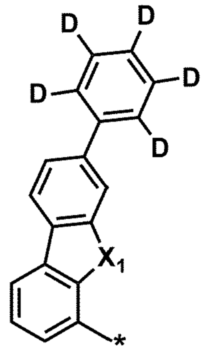

A-22

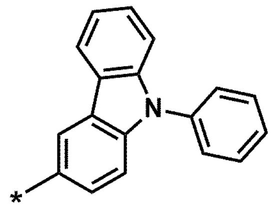

A-23

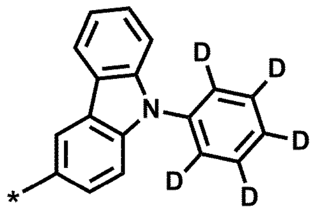

A-24

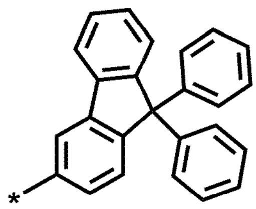

A-25

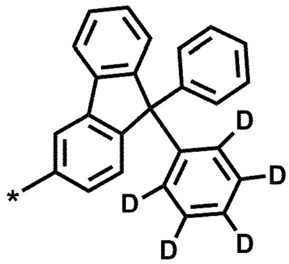

A-26

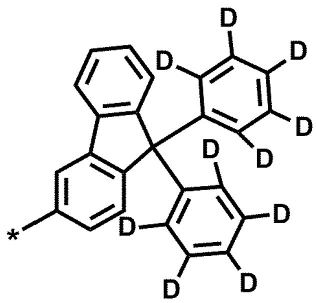

A-27

wherein, in Formulae A-1 to A-27,
$X_1$ is O, S, $N(R_{1a})$, or $C(R_{1a})(R_{1b})$,
$R_{1a}$ and $R_{1b}$ are each the same as described in connection with $R_{11a}$, and
* indicates a binding site to an adjacent atom.
$L_{11}$, $L_{12}$, and $L_{31}$ to $L_{33}$ are each independently a single bond, a $C_5$-$C_{60}$ (e.g. $C_5$-$C_{30}$) carbocyclic group unsubstituted or substituted with at least one $R_{10a}$, or a $C_1$-$C_{60}$ (e.g. $C_1$-$C_{20}$) heterocyclic group unsubstituted or substituted with at least one $R_{10a}$.
In one or more embodiments, $L_{11}$, $L_{12}$, and $L_{31}$ to $L_{33}$ may each independently be: a single bond; or
a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, each unsubstituted or substituted with at least one $R_{10a}$.

In one or more embodiments, $L_{11}$, $L_{12}$, and $L_{31}$ to $L_{33}$ may each independently be: a single bond; or
a group represented by one of Formulae 10-1 to 10-41:

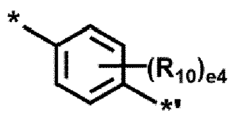

10-1

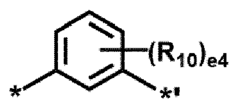

10-2

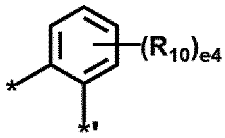

10-3

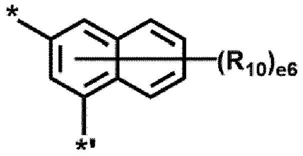

10-4

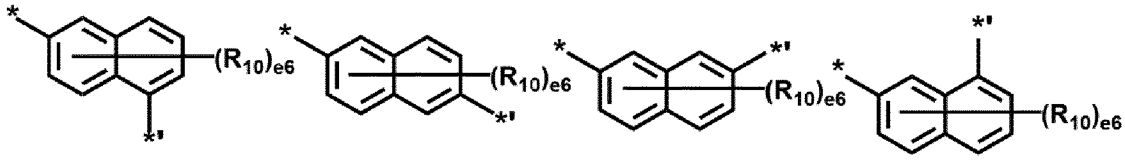

10-5 10-6 10-7 10-8

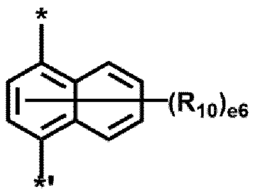

10-9

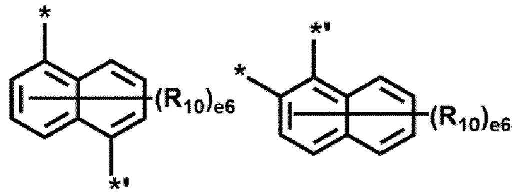

10-10 10-11

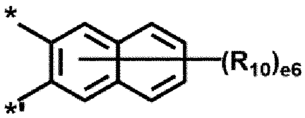

10-12

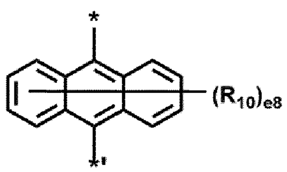

10-13

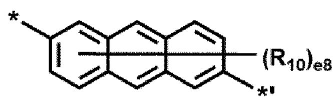

10-14

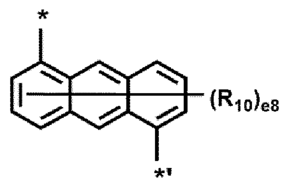

10-15

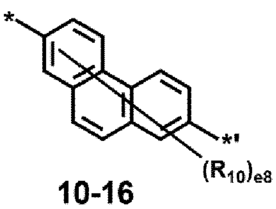

10-16

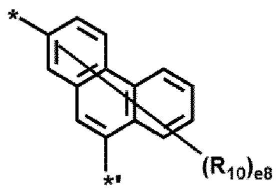

10-17

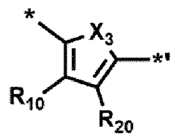

10-18

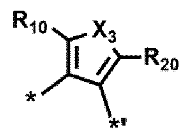

10-19

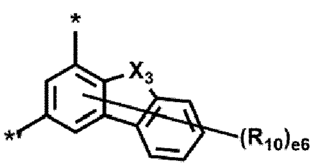

10-20

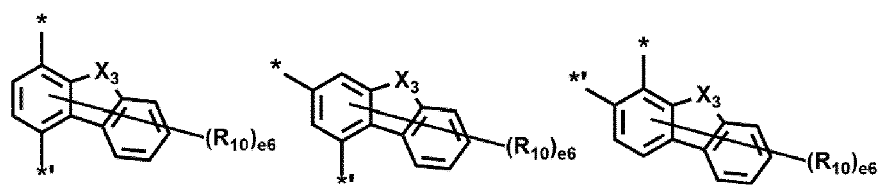

10-21 10-22 10-23

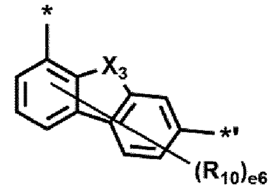 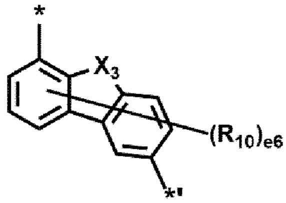 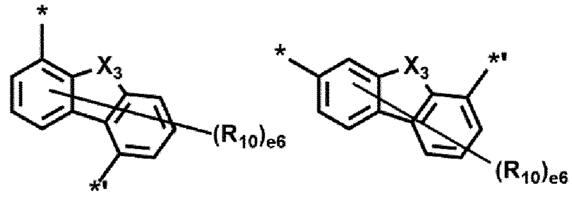

10-24 10-25 10-26 10-27

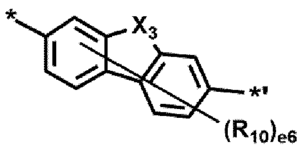 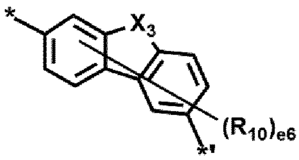 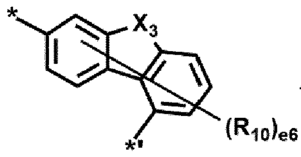 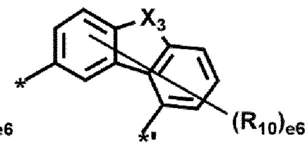

10-28 10-29 10-30 10-31

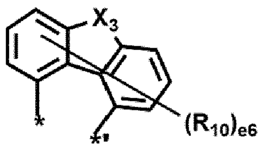 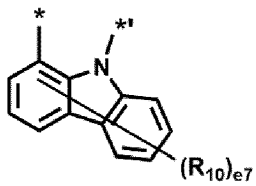 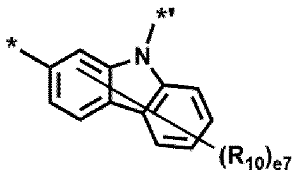 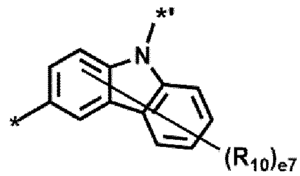

10-32 10-33 10-34 10-35

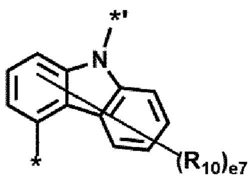 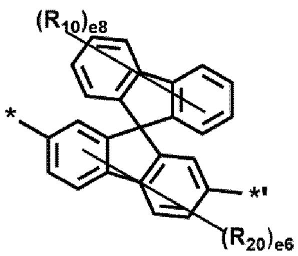 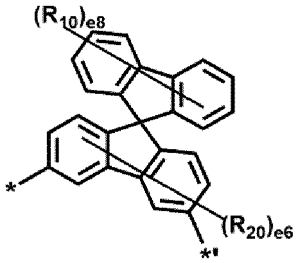 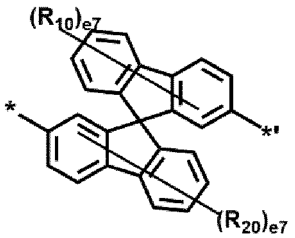

10-36 10-37 10-38 10-39

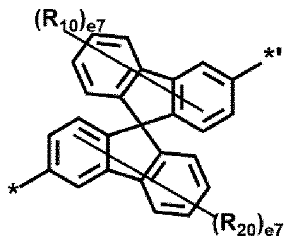 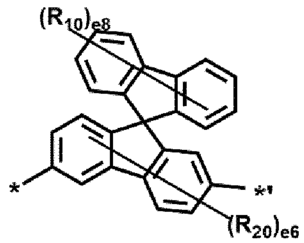

10-40 10-41

wherein, in Formulae 10-1 to 10-41,

$X_3$ is O, S, $N(R_{3a})$, or $C(R_{3a})(R_{3b})$,

$R_{10}$, $R_{20}$, $R_{3a}$, and $R_{3b}$ are each the same as described in connection with R11,

e4 is an integer from 1 to 4,

e6 is an integer from 1 to 6,

e7 is an integer from 1 to 7,

e8 is an integer from 1 to 8, and

* and *' each indicate a binding site to a neighboring atom.

In one or more embodiments, $L_{11}$ and $L_{12}$ may each independently be a single bond; or

a group represented by one of Formulae 12-1 to 12-30:

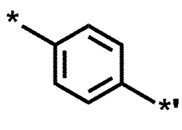

12-1

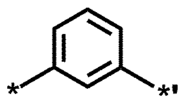

12-2

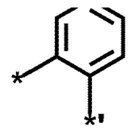

12-3

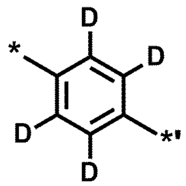

12-4

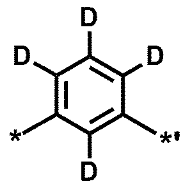

12-5

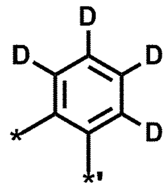

12-6

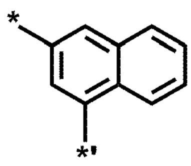

12-7

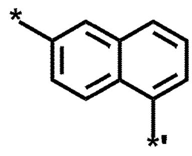

12-8

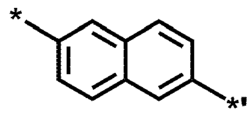

12-9

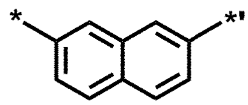

12-10

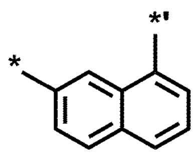

12-11

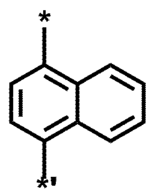

12-12

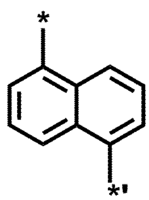

12-13

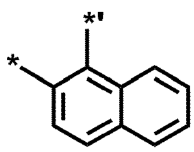

12-14

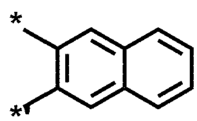

12-15

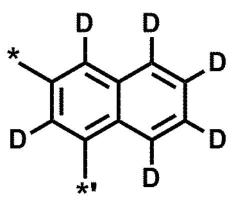

12-16

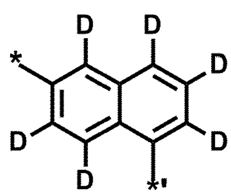

12-17

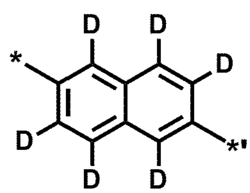

12-18

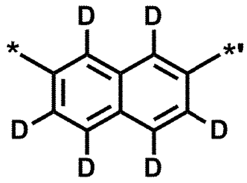
12-19

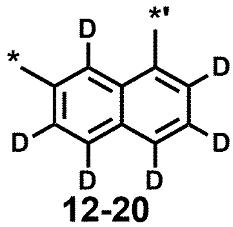
12-20

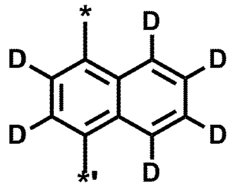
12-21

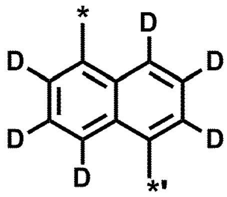
12-22

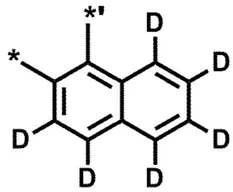
12-23

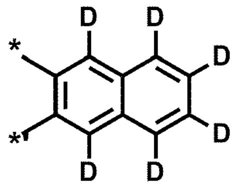
12-24

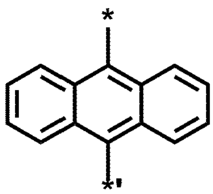
12-25

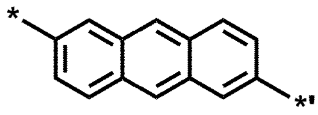
12-26

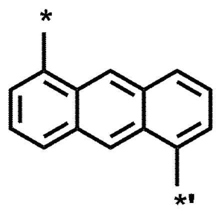
12-27

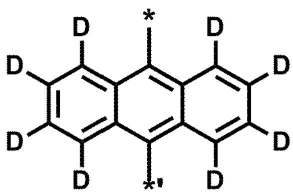
12-28

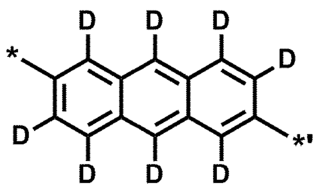
12-29

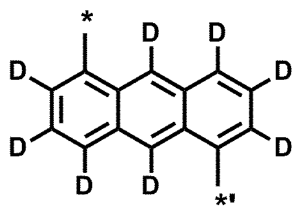
12-30

wherein, in Formulae 12-1 to 12-30,
* and *' each indicate a binding site to a neighboring atom.
a11, a12, and a31 to a33 are each independently an integer from 1 to 3.

In an embodiment, a moiety represented by

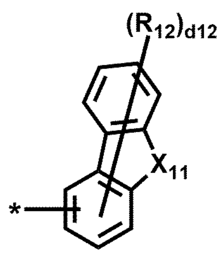

in Formula 1 may be represented by one of Formulae 1-1 to 1-4:

Formula 1-1

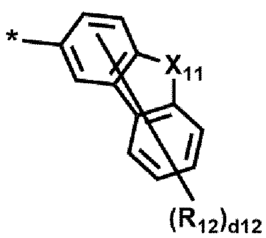

Formula 1-2

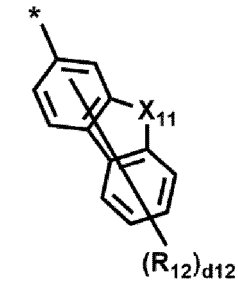

Formula 1-3

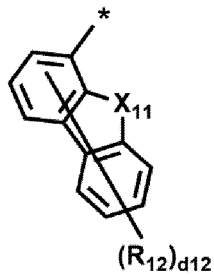

Formula 1-4

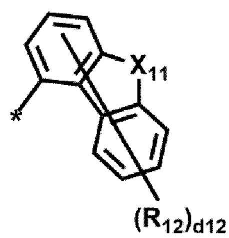

wherein, in Formulae 1-1 to 1-4,

$X_{11}$, $R_{12}$, and d12 are each the same as described elsewhere herein, and

* indicates a binding site to a neighboring atom.

In an embodiment, a moiety represented by

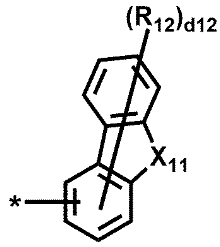

in Formula 1 may be represented by one of Formulae B-1 to B-18:

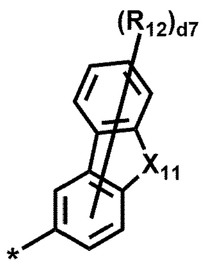

B-1

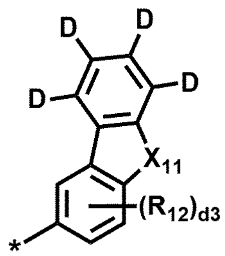

B-2

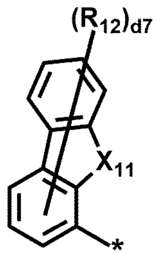

B-3

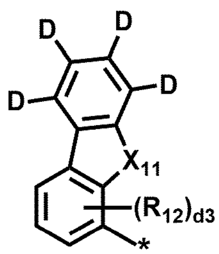

B-4

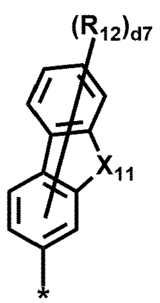

B-5

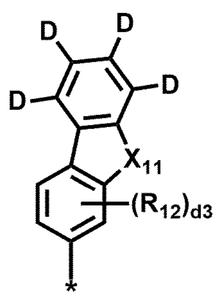

B-6

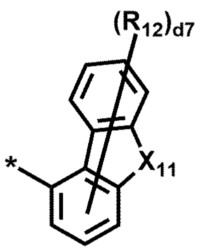

B-7

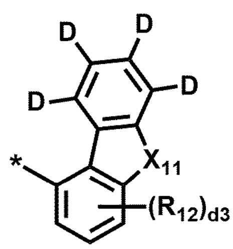

B-8

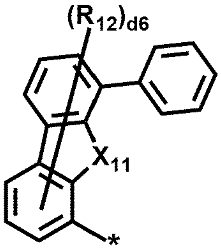
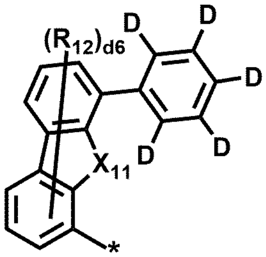
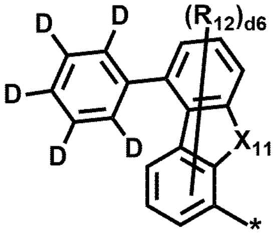
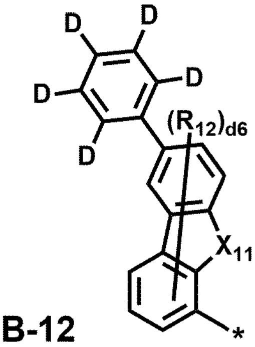

B-9 B-10 B-11 B-12

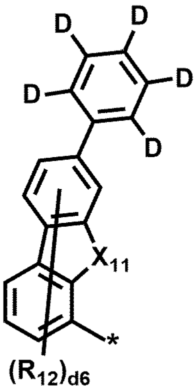
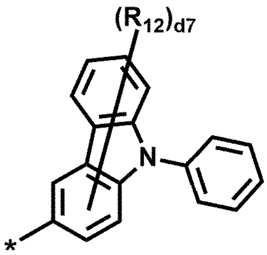
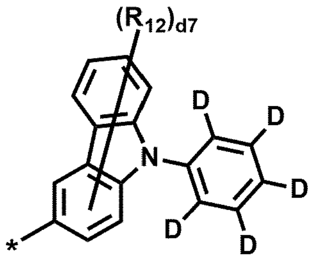

B-13 B-14 B-15

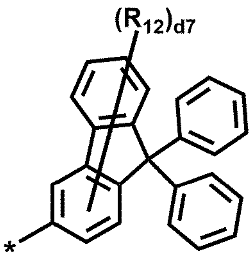
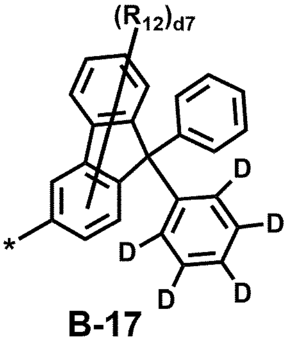
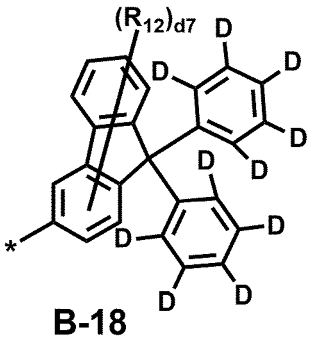

B-16 B-17 B-18

wherein, in Formulae B-1 to B-18,
$X_{11}$ and $R_{12}$ are each the same as described elsewhere herein,
d7 is an integer from 1 to 7,
d2 is 1 or 2,
d6 is an integer from 1 to 6,
d3 is an integer from 1 to 3, and
* indicates a binding site to a neighboring atom.

In an embodiment, a moiety represented by

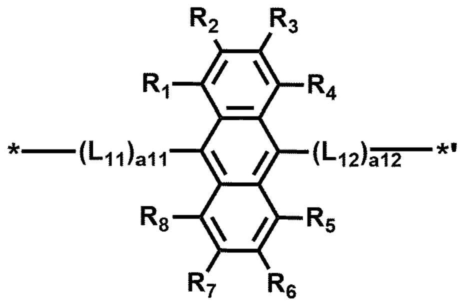

in Formula 1 may be represented by one of Formulae C-1 to C-44:

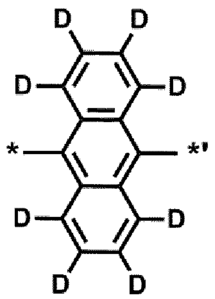

C-1

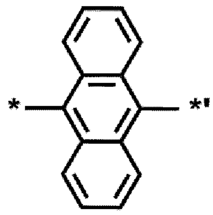

C-2

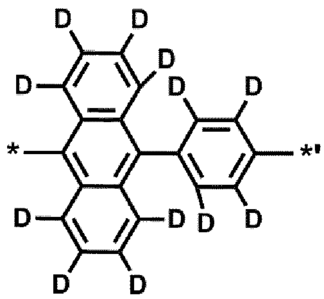

C-3

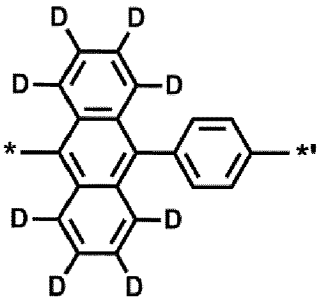

C-4

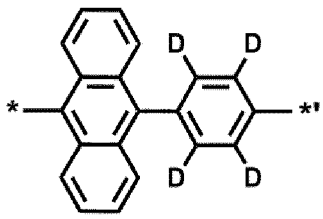

C-5

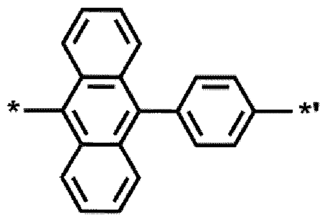

C-6

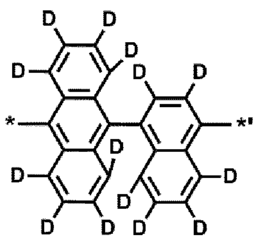

C-7

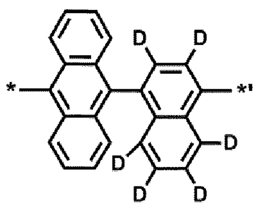

C-8

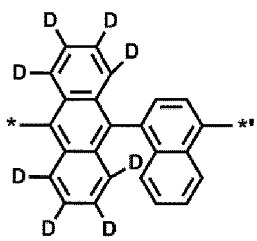

C-9

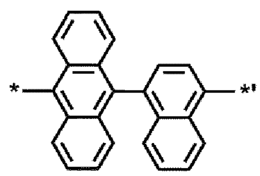

C-10

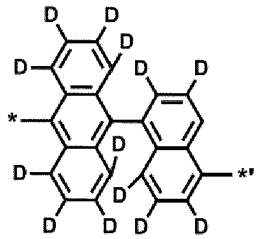
C-11

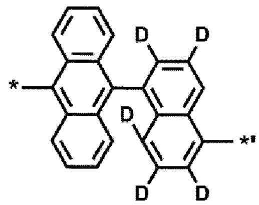
C-12

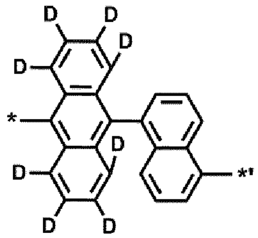
C-13

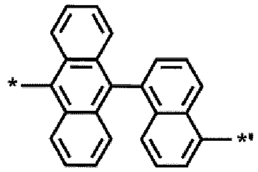
C-14

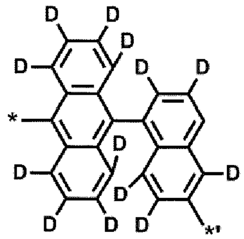
C-15

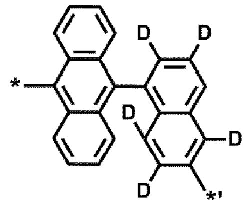
C-16

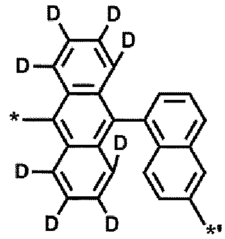
C-17

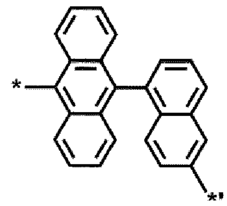
C-18

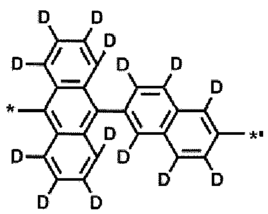
C-19

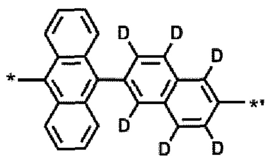
C-20

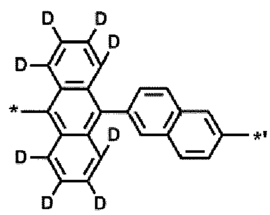
C-21

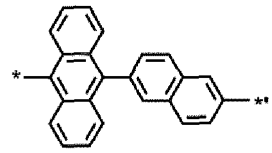
C-22

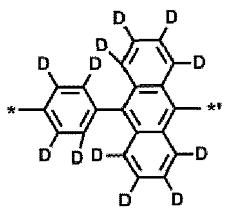
C-23

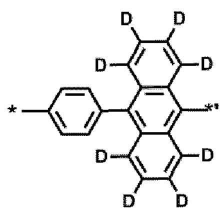
C-24

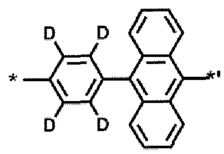
C-25

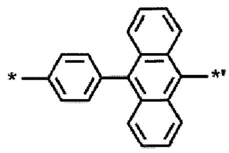
C-26

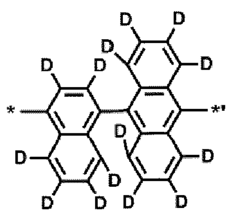
C-27

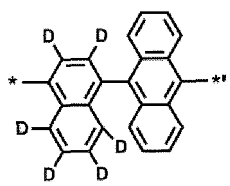
C-28

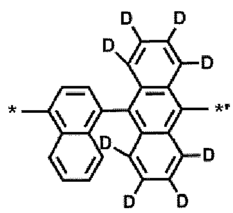
C-29

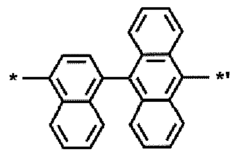
C-30

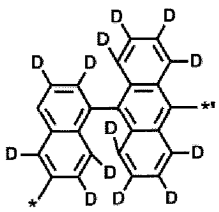

C-31

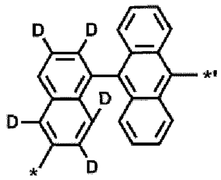

C-32

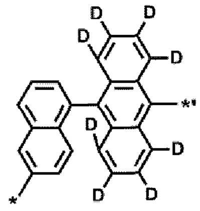

C-33

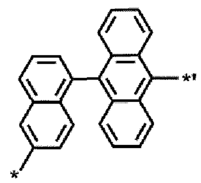

C-34

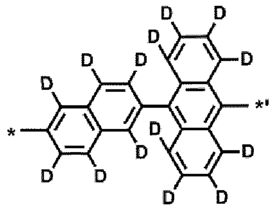

C-35

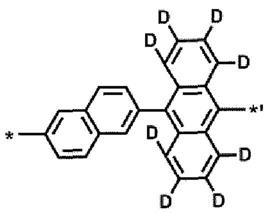

C-36

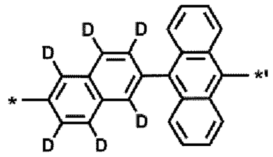

C-37

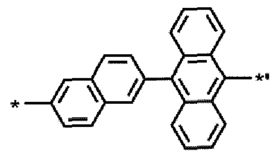

C-38

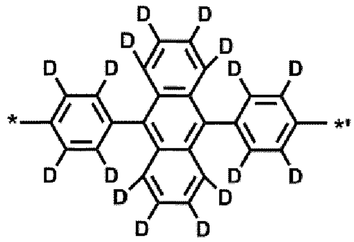

C-39

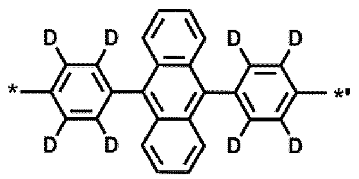

C-40

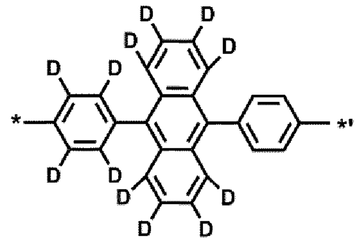

C-41

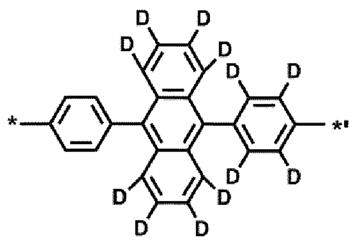

C-42

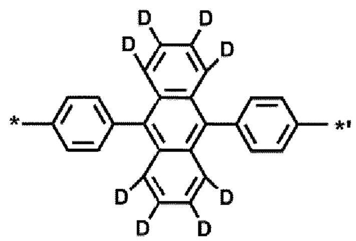

C-43

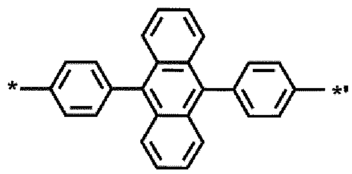

C-44

wherein, in Formulae C-1 to C-44, * and *' each indicate a binding site to a neighboring atom.

In Formula 2, Y is C or Si.

In Formula 2, $Z_1$ is no bond (e.g., $Z_1$ is absent), a single bond, O, S, $N(R_{21a})$, or $C(R_{21a})(R_{21b})$, and $Z_2$ is no bond, a single bond, O, S, $N(R_{22a})$, or $C(R_{22a})(R_{22b})$.

When $Z_1$ is no bond (e.g., $Z_1$ is absent), it indicates the atoms connected by $Z_1$ are not bonded with each other, and each atom may be substituted by $R_{21}$. Similarly, when $Z_2$ is no bond (e.g., $Z_2$ is absent), it indicates the atoms connected by $Z_2$ are not bonded with each other, and each atom may be substituted by $Ar_{21}$.

Here, when $Z_1$ is O or S, $Z_2$ is not a single bond.

For example, $Z_1$ may be no bond (e.g., $Z_1$ is absent), and $Z_2$ may be no bond;

$Z_1$ may be no bond (e.g., $Z_1$ is absent), and $Z_2$ may be a single bond;
$Z_1$ may be no bond (e.g., $Z_1$ is absent), and $Z_2$ may be O;
$Z_1$ may be no bond (e.g., $Z_1$ is absent), and $Z_2$ may be S;
$Z_1$ may be no bond (e.g., $Z_1$ is absent), and $Z_2$ may be $N(R_{22a})$;
$Z_1$ may be no bond (e.g., $Z_1$ is absent), and $Z_2$ may be $C(R_{22a})(R_{22b})$;
$Z_1$ may be a single bond, and $Z_2$ may be no bond (e.g., $Z_2$ is absent);
$Z_1$ may be a single bond, and $Z_2$ may be a single bond;

$Z_1$ may be O, and $Z_2$ may be no bond (e.g., $Z_2$ is absent);
$Z_1$ may be O, and $Z_2$ may be O;
$Z_1$ may be O, and $Z_2$ may be S;
$Z_1$ may be S, and $Z_2$ may be no bond (e.g., $Z_2$ is absent);
$Z_1$ may be S, and $Z_2$ may be O;
$Z_1$ may be S, and $Z_2$ may be S;
$Z_1$ may be $N(R_{21a})$, and $Z_2$ may be no bond (e.g., $Z_2$ is absent); or
$Z_1$ may be $C(R_{21a})(R_{21b})$, and $Z_2$ may be O.

In Formula 2, $Ar_{21}$ is a group represented by Formula 3.

In Formula 2, b21 is an integer from 1 to 10.

In an embodiment, Formula 2 may be represented by one of Formulae 2-1 to 2-6:

Formula 2-1

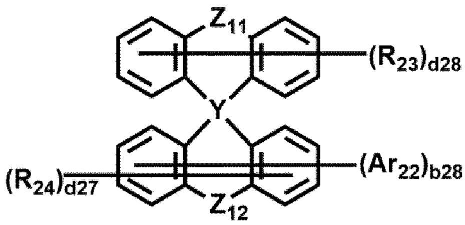

Formula 2-2

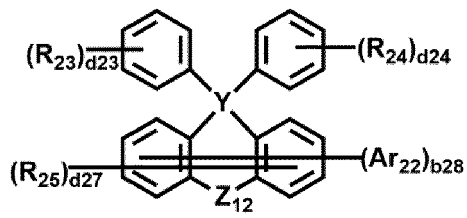

Formula 2-3

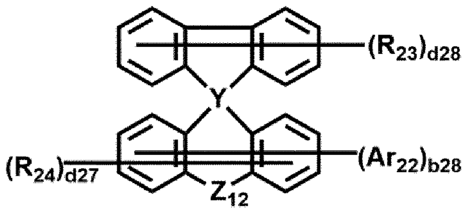

Formula 2-4

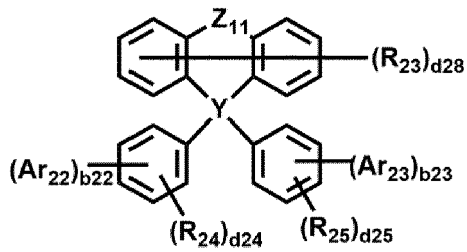

Formula 2-5

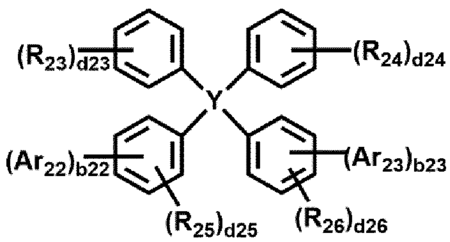

Formula 2-6

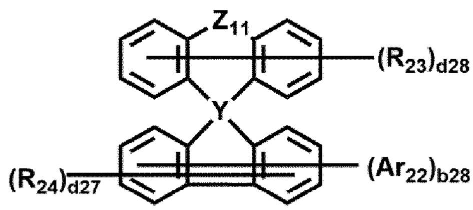

wherein, in Formulae 2-1 to 2-6,
Y is C or Si,
$Ar_{22}$ and $Ar_{23}$ are each the same as described in connection with $Ar_{21}$,
b28 is an integer from 1 to 8 (or may be an integer from 1 to 7),
in Formulae 2-4 and 2-5, b22 is an integer from 0 to 5 (or may be an integer from 0 to 4), b23 is an integer from 0 to 5 (or may be an integer from 0 to 4), and the sum of b22 and b23 is an integer of 1 or more,
$R_{23}$ to $R_{26}$ are each independently the same as described in connection with R21,
d23 is an integer from 1 to 5,
d24 is an integer from 1 to 5,
d25 is an integer from 1 to 5,
d26 is an integer from 1 to 5,
d27 is an integer from 1 to 7,

d28 is an integer from 1 to 8,
$Z_{12}$ is O, S, $N(R_{24a})$, or $C(R_{24a})(R_{24b})$,
in Formulae 2-1 and 2-4, $Z_{11}$ is O, S, $N(R_{23a})$, or $C(R_{23a})(R_{23b})$,
in Formula 2-6, $Z_{11}$ is $N(R_{23a})$ or $C(R_{23a})(R_{23b})$, and
$R_{23a}$, $R_{23b}$, $R_{24a}$, and $R_{24b}$ are each independently the same as described in connection with $R_{21a}$.

In one or more embodiments, Formula 2 may be represented by one of Formulae 2-11 to 2-14:

Formula 2-11

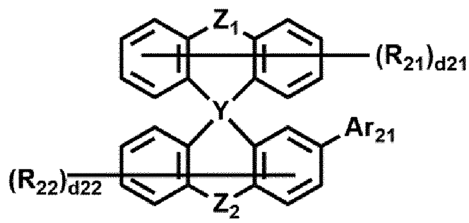

Formula 2-12

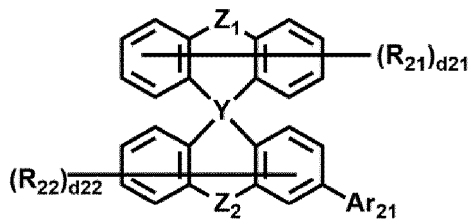

Formula 2-13

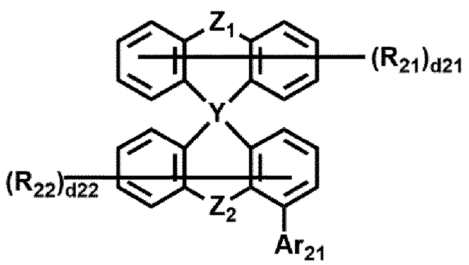

Formula 2-14

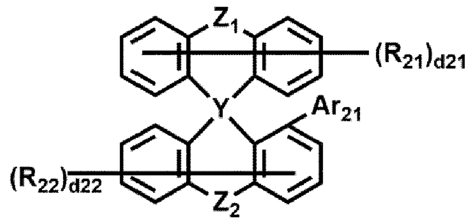

wherein, in Formulae 2-11 to 2-14, Y, $Z_1$, $Z_2$, $Ar_{21}$, $R_{21}$, $R_{22}$, d21, and d22 are each the same as described elsewhere herein.

In Formula 3, $Y_{31}$ is N or $C(R_{31a})$,

$Y_{32}$ is N or $C(R_{32a})$, and
$Y_{33}$ is N or $C(R_{33a})$.

In Formula 3, * indicates a binding site to a neighboring atom.

$R_1$ to $R_8$, $R_{11}$, $R_{11a}$, $R_{11b}$, $R_{12}$, $R_{21}$, $R_{21a}$, $R_{21b}$, $R_{22}$, $R_{22a}$, $R_{22b}$, $R_{32}$, $R_{33}$, $R_{31a}$, $R_{32a}$, and $R_{33a}$ are each independently hydrogen, deuterium, -F, -Cl, -Br, -I, a hydroxyl group, a cyano group, a nitro group, an amidino group, a hydrazino group, a hydrazono group, a $C_1$-$C_{60}$ (e.g. $C_1$-$C_{20}$) alkyl group unsubstituted or substituted with at least one $R_{10a}$, a $C_2$-$C_{60}$ (e.g. $C_2$-$C_{20}$) alkenyl group unsubstituted or substituted with at least one $R_{10a}$, a $C_2$-$C_{60}$ (e.g. $C_2$-$C_{20}$) alkynyl group unsubstituted or substituted with at least one $R_{10a}$, a $C_1$-$C_{60}$ (e.g. $C_1$-$C_{20}$) alkoxy group unsubstituted or substituted with at least one $R_{10a}$, a $C_3$-$C_{60}$ (e.g. $C_3$-$C_{30}$) carbocyclic group unsubstituted or substituted with at least one $R_{10a}$, a $C_1$-$C_{60}$ (e.g. $C_1$-$C_{20}$) heterocyclic group unsubstituted or substituted with at least one $R_{10a}$, a $C_6$-$C_{60}$ (e.g. $C_6$-$C_{30}$) aryloxy group unsubstituted or substituted with at least one $R_{10a}$, a $C_6$-$C_{60}$ (e.g. $C_6$-$C_{30}$) arylthio group unsubstituted or substituted with at least one $R_{10a}$,$-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or - $P(=O)(Q_1)(Q_2)$.

d11 is an integer from 1 to 10,
d12 is an integer from 1 to 7,
d21 is an integer from 1 to 10 (or may be an integer from 1 to 8),
d22 is an integer from 1 to 9 (or may be an integer from 1 to 7),
d32 is 1, and
d33 is 1.

The first compound includes at least one deuterium.

In an embodiment, Formula 1 may satisfy at least one of Conditions (1) to (7):

**Condition** (1)
at least one of $R_{11}$(s) in the number of d11 includes at least one deuterium

**Condition** (2)
at least one of $L_{11}$(s) in the number of a11 includes at least one deuterium

**Condition** (3)
at least one of $R_1$ to $R_8$ includes at least one deuterium

**Condition (4)**
at least one of $L_{12}$(s) in the number of a12 includes at least one deuterium

**Condition** (5)
at least one of $R_{12}$(s) in the number of d12 includes at least one deuterium

**Condition (6)**
$X_{11}$ is $N(R_{11a})$, and $R_{11a}$ includes at least one deuterium

**Condition (7)**
$X_{11}$ is $C(R_{11a})(R_{11b})$, and at least one of $R_{11a}$ and $R_{11b}$ includes at least one deuterium.

$R_{10a}$ is:

deuterium, -F, -Cl, -Br, -I, a hydroxyl group, a cyano group, or a nitro group,
a $C_1$-$C_{60}$ *(e.g.* $C_1$-$C_{20}$) alkyl group, a $C_2$-$C_{60}$ *(e.g.* $C_2$-$C_{20}$) alkenyl group, a $C_2$-$C_{60}$ *(e.g.* $C_2$-$C_{20}$) alkynyl group, or a $C_1$-$C_{60}$ *(e.g.* $C_1$-$C_{20}$) alkoxy group, each unsubstituted or substituted with deuterium, -F, -Cl, -Br, -I, a hydroxyl group, a cyano group, a nitro group, a $C_3$-$C_{60}$ *(e.g.* $C_3$-$C_{30}$) carbocyclic group, a $C_1$-$C_{60}$ *(e.g.* $C_1$-$C_{20}$) heterocyclic group, a $C_6$-$C_{60}$ (*e.g.* $C_6$-$C_{30}$) aryloxy group, a $C_6$-$C_{60}$ (*e.g.* $C_6$-$C_{30}$) arylthio group, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, - $P(=O)(Q_{11})(Q_{12})$, or any combination thereof,
a $C_3$-$C_{60}$ (*e.g.* $C_3$-$C_{30}$) carbocyclic group, a $C_1$-$C_{60}$ (*e.g.* $C_1$-$C_{20}$) heterocyclic group, a $C_6$-$C_{60}$ (*e.g.* $C_6$-$C_{30}$) aryloxy group, or a $C_6$-$C_{60}$ (*e.g.* $C_6$-$C_{30}$) arylthio group, unsubstituted or substituted with deuterium, -F, -Cl, -Br, -I, a hydroxyl group, a cyano group, a nitro group, a $C_1$-$C_{60}$ *(e.g.* $C_1$-$C_{20}$) alkyl group, a $C_2$-$C_{60}$ *(e.g.* $C_2$-$C_{20}$) alkenyl group, a $C_2$-$C_{60}$ (*e.g.* $C_2$-$C_{20}$) alkynyl group, a $C_1$-$C_{60}$ (*e.g.* $C_1$-$C_{20}$) alkoxy group, a $C_3$-$C_{60}$ (*e.g.* $C_3$-$C_{30}$) carbocyclic group, a $C_1$-$C_{60}$ (*e.g.* $C_1$-$C_{20}$) heterocyclic group, a $C_6$-$C_{60}$ *(e.g.* $C_6$-$C_{30}$) aryloxy group, a $C_6$-$C_{60}$ *(e.g.* $C_6$-$C_{30}$) arylthio group, $-Si(Q_{21})(Q_{22})(Q_{23})$, - $N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or any combination thereof, or
$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or - $P(=O)(O_{31})(O_{32})$,
wherein $Q_1$ to $Q_3$, $Q_{11}$ to $Q_{13}$, $Q_{21}$ to $Q_{23}$, and $Q_{31}$ to $Q_{33}$ are each independently : hydrogen; deuterium; -F; -Cl; -Br; -I; a hydroxyl group; a cyano group; a nitro group; $C_1$-$C_{60}$ (*e.g.* $C_1$-$C_{20}$) alkyl group; $C_2$-$C_{60}$ (*e.g.* $C_2$-$C_{20}$) alkenyl group; $C_2$-$C_{60}$ (*e.g.* $C_2$-$C_{20}$) alkynyl group; $C_1$-$C_{60}$ *(e.g.* $C_1$-$C_{20}$) alkoxy group; or a $C_3$-$C_{60}$ *(e.g.* $C_3$-$C_{30}$) carbocyclic group or a $C_1$-$C_{60}$ (e.g. $C_1$-$C_{20}$) heterocyclic group, each unsubstituted or substituted with deuterium, -F, a cyano group, a $C_1$-$C_{60}$ (*e.g.* $C_1$-$C_{20}$) alkyl group, a $C_1$-$C_{60}$ (e.g. $C_1$-$C_{20}$) alkoxy group, a phenyl group, a biphenyl group, or any combination thereof.
In an embodiment, $R_1$ to $R_8$, $R_{11}$, $R_{11a}$, $R_{11b}$, $R_{12}$, $R_{21}$, $R_{21a}$, $R_{21b}$, $R_{22}$, $R_{22a}$, $R_{22b}$, $R_{32}$, $R_{33}$, $R_{31a}$, $R_{32a}$, and $R_{33a}$ may each independently be selected from:
hydrogen, deuterium, -F, -Cl, -Br, -I, a hydroxyl group, a cyano group, a nitro group, an amidino group, a hydrazino group, a hydrazono group, a $C_1$-$C_{20}$ (e.g. $C_1$-$C_{10}$) alkyl group, and a $C_1$-$C_{20}$ (e.g. $C_1$-$C_{10}$) alkoxy group;
a $C_1$-$C_{20}$ (*e.g.* $C_1$-$C_{10}$) alkyl group and a $C_1$-$C_{20}$ (*e.g.* $C_1$-$C_{10}$) alkoxy group, each substituted with at least one of deuterium, -F, -Cl, -Br, -I, $-CD_3$, $-CD_2H$, $-CDH_2$, - $CF_3$, $-CF_2H$, $-CFH_2$, a hydroxyl group, a cyano group, a nitro group, an amidino group, a hydrazino group, a hydrazono group, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, and a pyrimidinyl group;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thienyl group, a furanyl group, an imidazolyl group, a pyrazolyl group, a thiazolyl group, an isothiazolyl group,

an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothienyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothienyl group, a benzocarbazolyl group, a dibenzocarbazolyl group, an imidazopyridinyl group, an imidazopyrimidinyl group, an azacarbazolyl group, an azadibenzofuranyl group, an azadibenzothienyl group, an azafluorenyl group, and an azadibenzosilolyl group, each unsubstituted or substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazino group, a hydrazono group, a $C_1$-$C_{20}$ *(e.g.* $C_1$-$C_{10}$) alkyl group, a $C_1$-$C_{20}$ *(e.g.* $C_1$-$C_{10}$) alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thienyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothienyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothienyl group, a benzocarbazolyl group, a dibenzocarbazolyl group, an imidazopyridinyl group, an imidazopyrimidinyl group, an azacarbazolyl group, an azadibenzofuranyl group, an azadibenzothienyl group, an azafluorenyl group, an azadibenzosilolyl group, $-Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, $-S(=O)_2(Q_{31})$, and $-P(=O)(Q_{31})(Q_{32})$; and

$-Si(Q_1)(Q_2)(Q_3)$, $-N(Q_1)(Q_2)$, $-B(Q_1)(Q_2)$, $-C(=O)(Q_1)$, $-S(=O)_2(Q_1)$, and $-P(=O)(Q_1)(Q_2)$,

wherein $Q_1$ to $Q_3$ and $Q_{31}$ to $Q_{33}$ may each independently be selected from:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, and $-CD_2CDH_2$, and

an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, and a triazinyl group, each unsubstituted or substituted with at least one selected from deuterium, a $C_1$-$C_{10}$ alkyl group, a phenyl group, a biphenyl group, a pyridinyl group, a pyrimidinyl group, a pyridazinyl group, a pyrazinyl group, and a triazinyl group.

In one or more embodiments, $R_1$ to $R_8$, $R_{11}$, $R_{11a}$, $R_{11b}$, $R_{12}$, $R_{21}$, $R_{21a}$, $R_{21b}$, $R_{22}$, $R_{22a}$, $R_{22b}$ $R_{32}$, $R_{33}$, $R_{31a}$, $R_{32a}$, and $R_{33a}$ may each independently be selected from:

hydrogen, deuterium, a $C_1$-$C_{20}$ (*e.g.* $C_1$-$C_{10}$) alkyl group, and a $C_1$-$C_{20}$ (*e.g.* $C_1$-$C_{10}$) alkoxy group;

a $C_1$-$C_{20}$ *(e.g.* $C_1$-$C_{10}$) alkyl group and a $C_1$-$C_{20}$ (*e.g.* $C_1$-$C_{10}$) alkoxy group, each substituted with at least one selected from deuterium, $-CD_3$, $-CD_2H$, $-CDH_2$, $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, and a naphthyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thienyl group, a furanyl group, an isoindolyl group, an indolyl group, an indazolyl group, a purinyl group, a carbazolyl group, a benzofuranyl group, a benzothienyl group, a dibenzofuranyl group, a dibenzothienyl group, a benzocarbazolyl group, and a dibenzocarbazolyl group, each unsubstituted or substituted with at least one selected from deuterium, $-CD_3$, $-CD_2H$, $-CDH_2$, a $C_1$-$C_{20}$ (*e.g.* $C_1$-$C_{10}$) alkyl group, a $C_1$-$C_{20}$ (*e.g.* $C_1$-$C_{10}$) alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thienyl group, a furanyl group, an isoindolyl group, an indolyl group, an indazolyl group, a purinyl group, a carbazolyl group, a benzofuranyl group, a benzothienyl group, a dibenzofuranyl group, a dibenzothienyl group, a benzocarbazolyl group, a dibenzocarbazolyl group, $-Si(Q_{31})(Q_{32})(Q_{33})$, and $-N(Q_{31})(Q_{32})$, $-B(Q_{31})(Q_{32})$;

and

-Si($Q_1$)($Q_2$)($Q_3$), -N($Q_1$)($Q_2$), and -B($Q_1$)($Q_2$),

wherein $Q_1$ to $Q_3$ and $Q_{31}$ to $Q_{33}$ may each independently be selected from:

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, and $-CD_2CDH_2$, and

an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, unsubstituted or substituted with at least one selected from deuterium, a $C_1$-$C_{10}$ alkyl group, a phenyl group, and a biphenyl group.

In an embodiment, $R_1$ to $R_8$ may each be deuterium, or each of $R_1$ to $R_8$ may not be deuterium.

In an embodiment, the at least one first compound may be selected from Group I, and the at least one second compound may be selected from Group II. However, embodiments of the present disclosure are not limited thereto:

Group I

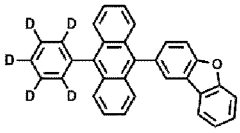

1-1

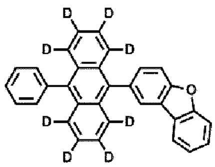

1-2

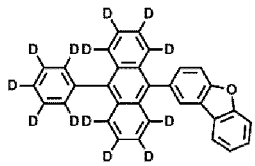

1-3

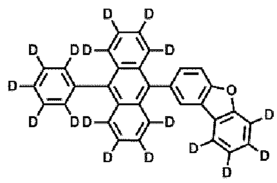

1-4

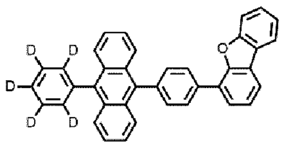

1-5

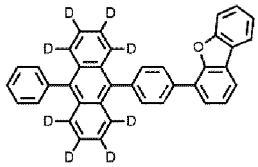

1-6

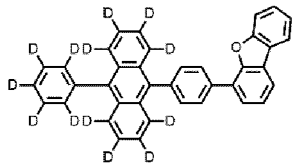

1-7

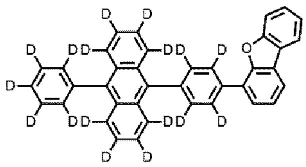

1-8

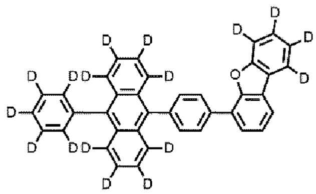

1-9

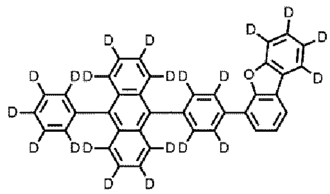

1-10

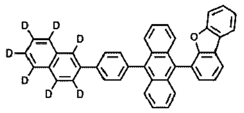
1-11

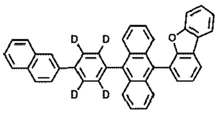
1-12

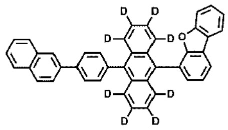
1-13

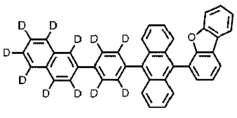
1-14

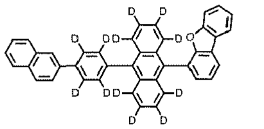
1-15

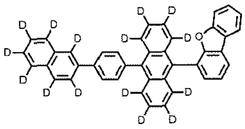
1-16

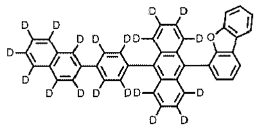
1-17

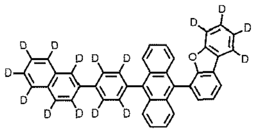
1-18

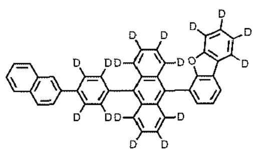
1-19

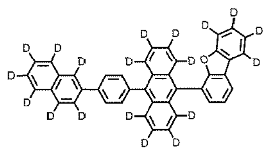
1-20

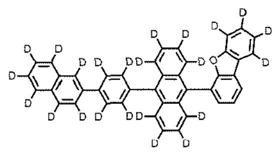
1-21

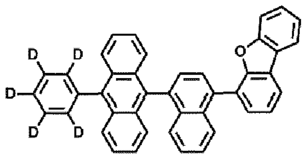
1-22

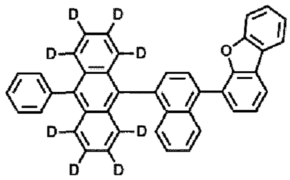
1-23

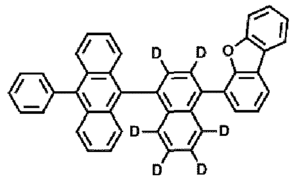
1-24

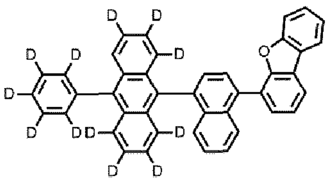
1-25

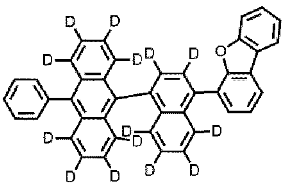
1-26

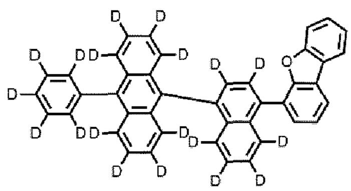
1-27

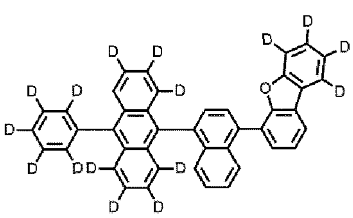
1-28

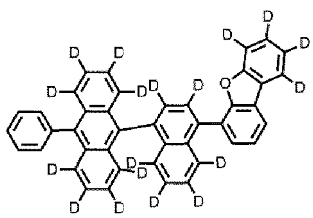
1-29

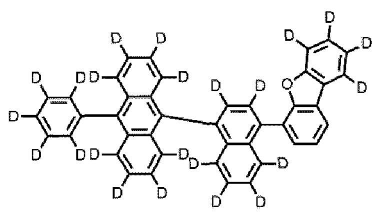
1-30

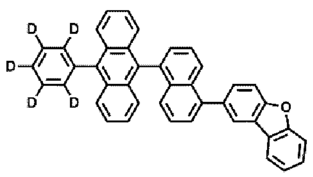

**1-31**

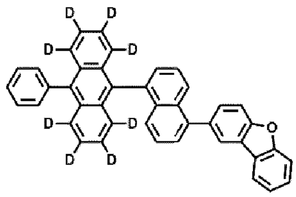

**1-32**

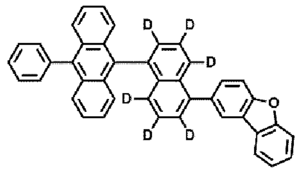

**1-33**

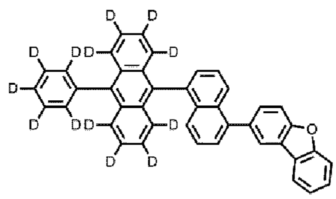

**1-34**

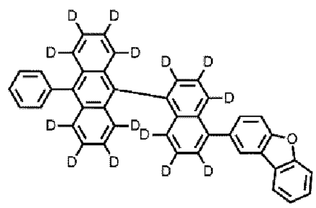

**1-35**

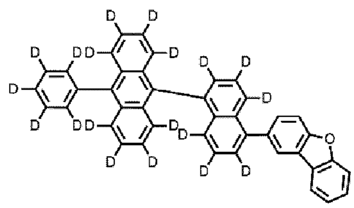

**1-36**

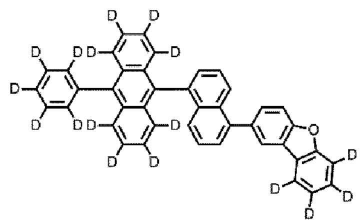

**1-37**

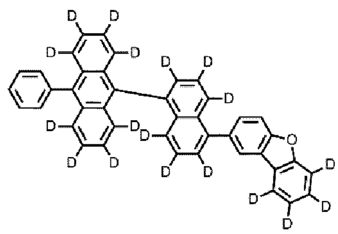

**1-38**

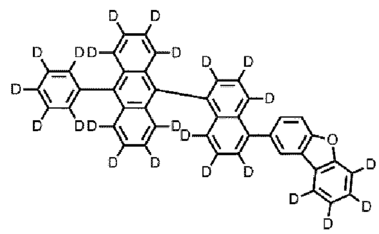

**1-39**

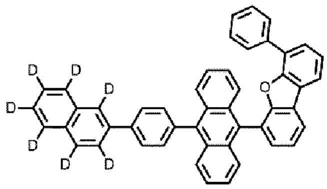

**1-40**

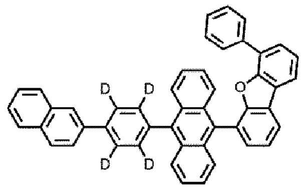

**1-41**

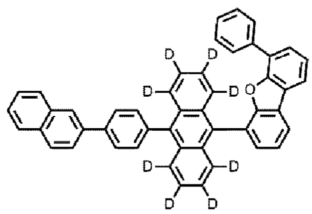

**1-42**

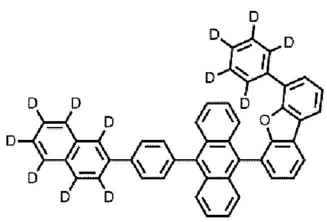

**1-43**

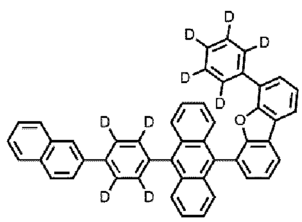

**1-44**

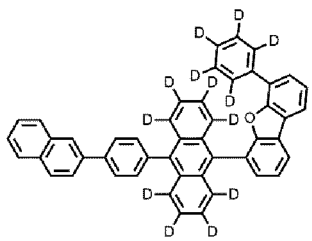

**1-45**

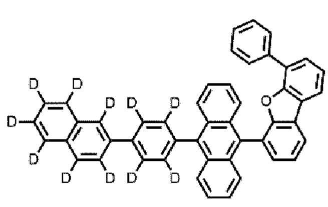

**1-46**

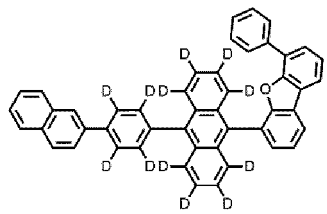

**1-47**

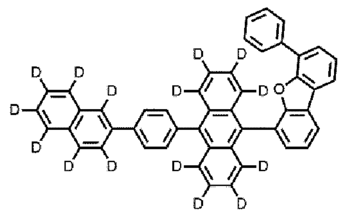

**1-48**

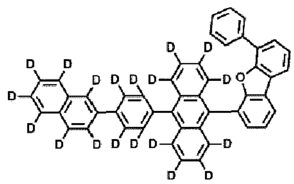
1-49

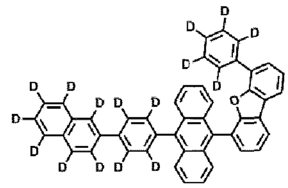
1-50

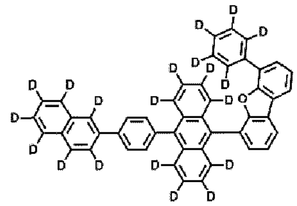
1-51

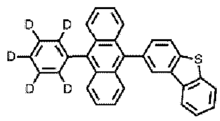
1-52

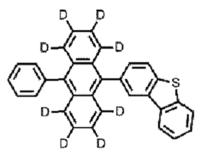
1-53

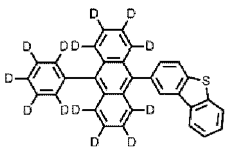
1-54

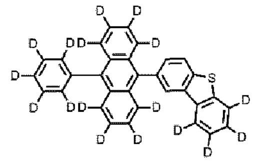
1-55

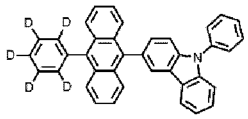
1-56

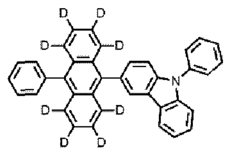
1-57

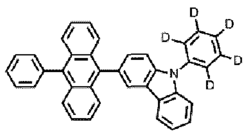
1-58

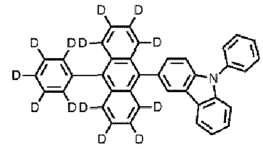
1-59

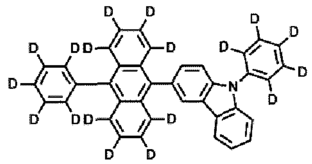
1-60

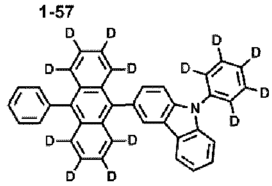
1-61

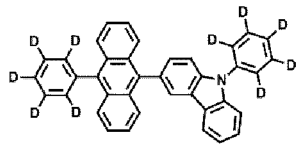
1-62

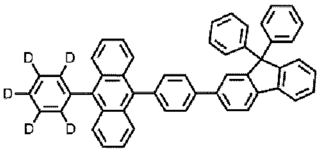
1-63

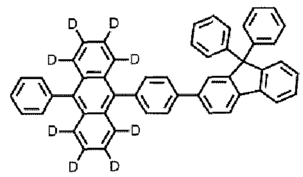
1-64

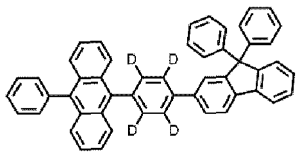
1-65

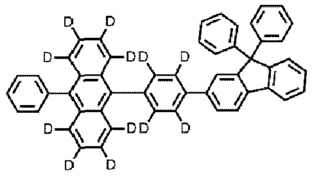
1-66

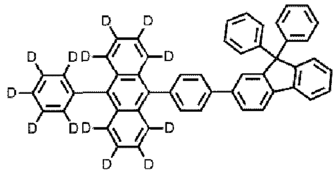
1-67

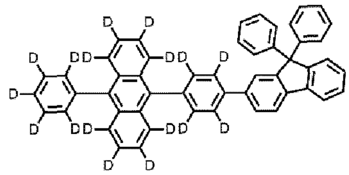
1-68

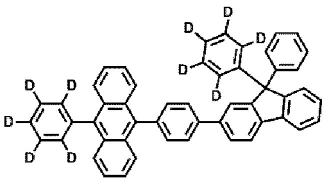
1-69

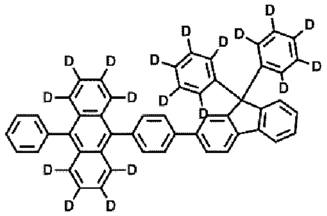
1-70

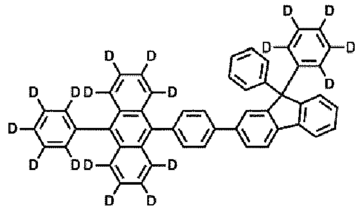
1-71

Group II

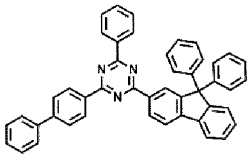
2-1

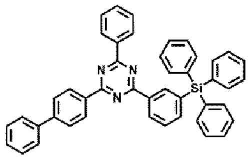
2-2

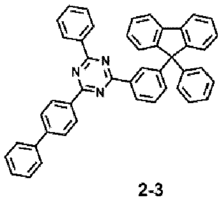
2-3

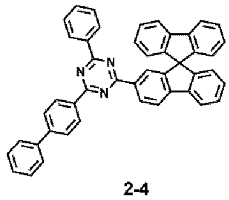
2-4

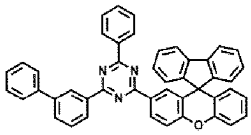
2-5

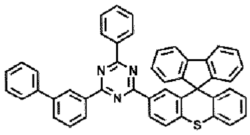
2-6

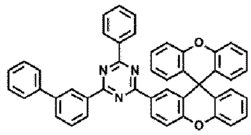
2-7

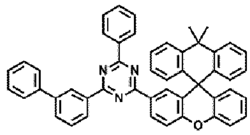
2-8

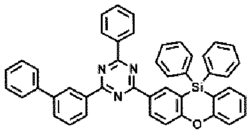
2-9

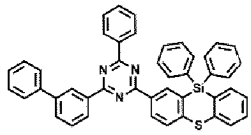
2-10

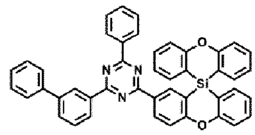
2-11

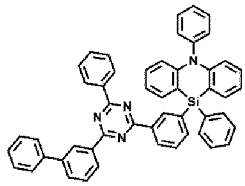
2-12

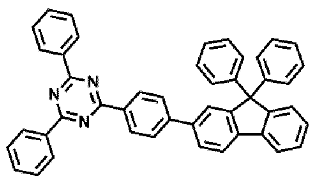
2-13

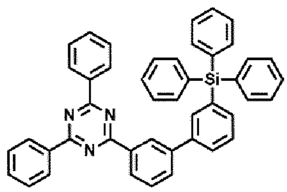
2-14

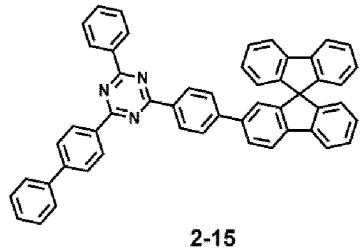
2-15

In an embodiment, the at least one first compound may be included in the emission layer.

In an embodiment, the first electrode may be an anode,

the second electrode may be a cathode, and
the interlayer may further include a hole transport region between the emission layer and the first electrode.

In an embodiment, the interlayer may further include an electron transport region between the emission layer and the second electrode.

The at least one second compound may be included in the electron transport region.

In an embodiment, the hole transport region may include a hole injection layer, a hole transport layer, an emission auxiliary layer, an electron blocking layer, or any combination thereof.

In an embodiment, the electron transport region may include a buffer layer, a hole blocking layer, an electron control layer, an electron transport layer, an electron injection layer, or any combination thereof.

In an embodiment, the at least one second compound may be included in the electron transport layer.

In an embodiment, the emission layer may further include a third compound,

wherein the third compound may be a fluorescent compound or a thermally activated delayed fluorescence (TADF) compound satisfying Equation 1:

Equation 1

$$\triangle E_{ST} = S1 - T1 \leq 0.3 \text{ eV}$$

wherein, in Equation 1, S1 is a lowest excitation singlet energy level (eV) of the TADF, and T1 is a lowest excitation triplet energy level (eV) of the TADF compound. Specifically, T1 is the lowest excitation triplet energy level at the onset wavelength of the low-temperature photoluminescence (PL) spectrum of the thermally activated delayed fluorescence (TADF) compound, and "the lowest excitation triplet energy level at the onset wavelength" in the specification represents the lowest excitation triplet energy level at the onset wavelength of the room temperature PL spectrum of the TADF compound. S1 is the lowest excitation singlet energy level at the onset wavelength of the room temperature PL spectrum of the TADF compound and in the specification, "the lowest excitation singlet energy level at the onset wavelength" refers to the singlet energy at where the room temperature PL spectrum begins, and may be calculated from the singlet energy at a point (that is, the x intercept) where the curve of the function obtained by plotting the PL spectrum as a quadratic function meets the wavelength.

In an embodiment, the emission layer may further include the third compound,
wherein the third compound may include at least one of the compounds represented by Formulae 4-1 to 4-9:

Formula 4-1

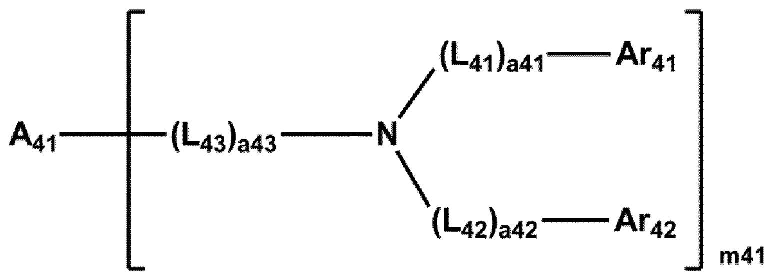

Formula 4-2

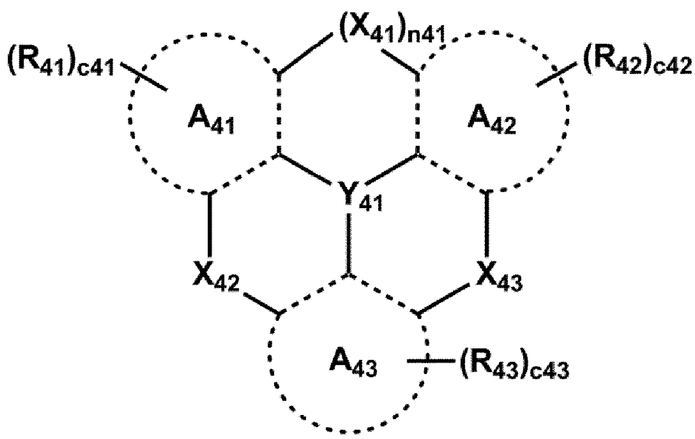

Formula 4-3

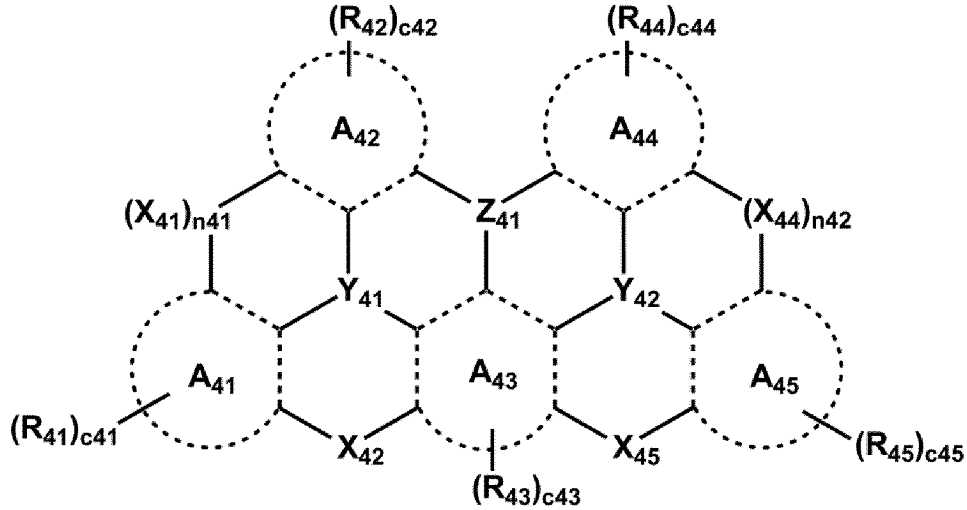

Formula 4-4

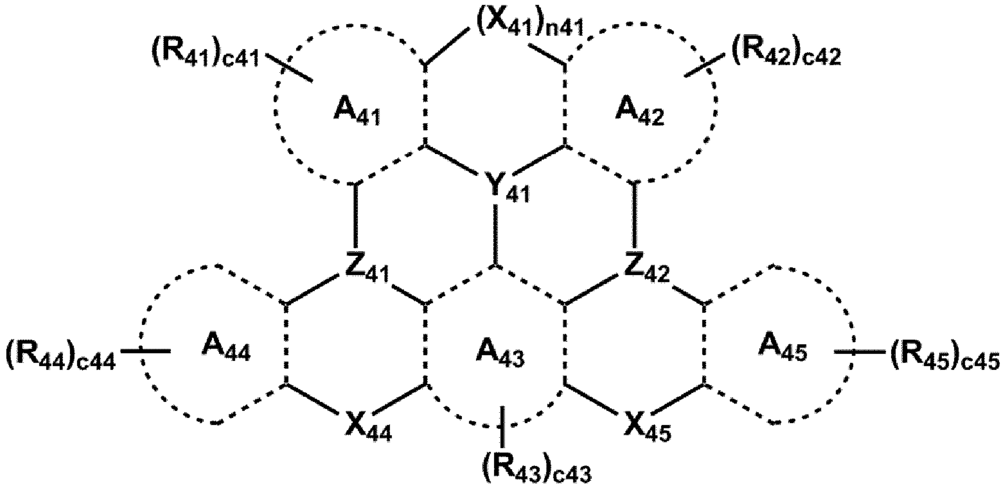

Formula 4-5 $(EDG)_{b41}$-$[(L_{44})_{a44}$-$(EWG)_{t42}]_{s41}$

Formula 4-6 $(EWG)_{t42}$-$[(L_{44})_{a44}$-$(EDG)_{b41}]_{s42}$

Formula 4-7 $(EDG)_{b411}$-$(L_{44})_{a44}$-$(EWG)_{t42}$-$(L_{45})_{a45}$-$(EDG)_{b412}$

Formula 4-8 $(EWG)_{t421}$-$(L_{44})_{a44}$-$(EDG)_{b41}$-$(L_{45})_{a45}$-$(EWG)_{t422}$

Formula 4-9 $A_{41}$-$[(L_{44})_{a44}$-$(EDG)_{b41}]_{s43}$.

In Formula 4-1,

$A_{41}$ is a $C_3$-$C_{60}$ (e.g. $C_3$-$C_{30}$) carbocyclic group unsubstituted or substituted with at least one $R_{10a}$ or a $C_1$-$C_{60}$ (e.g. $C_1$-$C_{20}$) heterocyclic group unsubstituted or substituted with at least one $R_{10a}$,
$L_{41}$ to $L_{43}$ are each independently a single bond, a $C_3$-$C_{60}$ (e.g. $C_3$-$C_{30}$) carbocyclic group unsubstituted or substituted with at least one $R_{10a}$, or a $C_1$-$C_{60}$ (e.g. $C_1$-$C_{20}$) heterocyclic group unsubstituted or substituted with at least one $R_{10a}$,
a41 to a43 are each independently an integer from 1 to 3,
$Ar_{41}$ and $Ar_{42}$ are each independently a $C_3$-$C_{60}$ (e.g. $C_3$-$C_{30}$) carbocyclic group unsubstituted or substituted with at least one $R_{10a}$, a $C_1$-$C_{60}$ (e.g. $C_1$-$C_{10}$) heterocyclic group unsubstituted or substituted with at least one $R_{10a}$, or a $C_6$-$C_{60}$ (e.g. $C_6$-$C_{30}$) aryloxy group unsubstituted or substituted with at least one $R_{10a}$, and

m41 is an integer from 1 to 6,
in Formulae 4-2 to 4-4,
$X_{41}$ to $X_{45}$ are each independently a single bond, O, S, N($R_{46}$), B($R_{46}$), C($R_{46}$)($R_{47}$), or Si($R_{46}$)($R_{47}$),
n41 and n42 are each independently be 0, 1, or 2, when n41 is 0, $A_{41}$ and $A_{42}$ are not linked to each other, and when n42 is 0, $A_{44}$ and $A_{45}$ are not be linked to each other,
$Y_{41}$ and $Y_{42}$ are each independently N, B, or P,
$Z_{41}$ and $Z_{42}$ are each independently N, C($R_{48}$), or Si($R_{48}$),
$A_{41}$ to $A_{45}$ are each independently selected from a $C_3$-$C_{30}$ (e.g. $C_3$-$C_{20}$) carbocyclic group and a $C_1$-$C_{30}$ (e.g. $C_1$-$C_{20}$) heterocyclic group,
$R_{41}$ to $R_{48}$ are each independently hydrogen, deuterium, -F, -Cl, -Br, -I, a hydroxyl group, a cyano group, a nitro group, a $C_1$-$C_{60}$ (e.g. $C_1$-$C_{20}$) alkyl group unsubstituted or substituted with at least one $R_{10a}$, a $C_2$-$C_{60}$ (e.g. $C_2$-$C_{20}$) alkenyl group unsubstituted or substituted with at least one $R_{10a}$, a $C_2$-$C_{60}$ (e.g. $C_2$-$C_{20}$) alkynyl group unsubstituted or substituted with at least one $R_{10a}$, a $C_1$-$C_{60}$ (e.g. $C_1$-$C_{20}$) alkoxy group unsubstituted or substituted with at least one $R_{10a}$, a $C_3$-$C_{60}$ (e.g. $C_3$-$C_{30}$) carbocyclic group unsubstituted or substituted with at least one $R_{10a}$, a $C_1$-$C_{60}$ (e.g. $C_1$-$C_{20}$) heterocyclic group unsubstituted or substituted with at least one $R_{10a}$, a $C_6$-$C_{60}$ (e.g. $C_6$-$C_{30}$) aryloxy group unsubstituted or substituted with at least one $R_{10a}$, a $C_6$-$C_{60}$ (e.g. $C_6$-$C_{30}$) arylthio group unsubstituted or substituted with at least one $R_{10a}$, -Si($Q_1$)($Q_2$)($Q_3$), - N($Q_1$)($Q_2$), -B($Q_1$)($Q_2$), -C(=O)($Q_1$), -S(=O)$_2$($Q_1$), or -P(=O)($Q_1$)($Q_2$), and
c41 to c45 are each independently an integer from 1 to 10, and
in Formulae 4-5 to 4-9,
$A_{41}$ is a $C_3$-$C_{60}$ (e.g. $C_3$-$C_{30}$) carbocyclic group unsubstituted or substituted with at least one $R_{10a}$ or a $C_1$-$C_{60}$ (e.g. $C_1$-$C_{20}$) heterocyclic group unsubstituted or substituted with at least one $R_{10a}$,
EDG represents an electron donating group, and EWG represents an electron withdrawing group. The electron withdrawing group is not limited to any group having a property of withdrawing electrons (e.g. -F, $-CFH_2$, $-CF_2H$, $-CF_3$, -CN or $-NO_2$; a $C_1$-$C_{60}$ alkyl group substituted with at least one -F, $-CFH_2$, $-CF_2H$, $-CF_3$, -CN, $-NO_2$ or any combination thereof; or a $\pi$ electron-depleted nitrogen-containing $C_1$-$C_{60}$ cyclic group substituted or unsubstituted with at least one $R_{10a}$), and the electron donating group is not limited to any group having a property of donating electrons (e.g $\pi$ electron-rich $C_3$-$C_{60}$ cyclic group unsubstituted or substituted with at least one $R_{10a}$ or - N($Q_1$)($Q_2$)).

b41, b411, b412, t42, t421, and t422 are each independently an integer from 1 to 3,

$L_{44}$ and $L_{45}$ are each independently a single bond, a $C_3$-$C_{60}$ (e.g. $C_3$-$C_{30}$) carbocyclic group unsubstituted or substituted with at least one $R_{10a}$, or a $C_1$-$C_{60}$ (e.g. $C_1$-$C_{20}$) heterocyclic group unsubstituted or substituted with at least one $R_{10a}$,
a44 and a45 are each independently integer from 1 to 3,
s41 and s42 are each independently an integer from 1 to 3,
s43 is an integer from 1 to 6, and
$R_{10a}$ is the same as described elsewhere herein.

In an embodiment, the emission layer may emit blue light or blue-green light.
In an embodiment, the emission layer may emit blue light or blue-green light, having a maximum emission wavelength in a range of about 400 nm to about 500 nm.
In an embodiment, the light-emitting device may further include a second capping layer outside the second electrode and having a refractive index (at a wavelength of 589 nm) of equal to or greater than 1.6.
Another aspect of an embodiment of the present disclosure provides an electronic apparatus including: the light-emitting device; and

a thin-film transistor, wherein:
the thin-film transistor includes a source electrode and a drain electrode, and
the first electrode of the light-emitting device is electrically coupled to the source electrode or the drain electrode.

In an embodiment, the electronic apparatus may further include a color filter, a color conversion layer, a touch screen layer, a polarizing layer, or any combination thereof.
When the emission layer of the light-emitting device includes the first compound represented by Formula 1, which includes at least one deuterium, the light-emitting device may have a significantly improved lifespan.
In addition, when the electron transport region of the light-emitting device includes the at least one second compound represented by Formula 2, the light-emitting device may have improved electron transport capability, thereby having increased luminescence efficiency.
Thus, the light-emitting device, such as an organic light-emitting device, including the at least one first compound

and the at least one second compound at the same time (e.g., substantially the same time) may have a low driving voltage, high efficiency, and a long lifespan.

The expression "(an interlayer) includes at least one first compound," as used herein, may include a case in which "(an interlayer) includes identical first compounds" and a case in which "(an interlayer) includes two or more different first compounds."

In an embodiment, the interlayer may include, as the first compound, only Compound 1-1. In this embodiment, Compound 1-1 may be included in the emission layer of the light-emitting device. In one or more embodiments, the interlayer may include, as the first compound, Compound 1-1 and Compound 1-2. In this embodiment, Compound 1-1 and Compound 1-2 may be included in the same layer (for example, both Compound 1-1 and Compound 1-2 may be included in the emission layer) or in different layers (for example, Compound 1-1 may be included in the emission layer, and Compound 1-2 may be included in the electron transport layer).

The term "interlayer," as used herein, refers to a single layer and/or a plurality of layers between the first electrode and the second electrode of the light-emitting device. A material included in the "interlayer" is not limited to an organic material. For example, the interlayer may include an inorganic material.

For example, the light-emitting device may have i) a stacked structure including a first electrode, an interlayer, a second electrode, and a second capping layer which are sequentially stacked in this stated order, ii) a stacked structure including a first capping layer, a first electrode, an interlayer, and a second electrode which are sequentially stacked in this stated order, or iii) a stacked structure including a first capping layer, a first electrode, an interlayer, a second electrode, and a second capping layer which are sequentially stacked in this stated order.

### Description of FIG. 1

FIG. 1 is a schematic cross-sectional view of a light-emitting device 10 according to an embodiment. The light-emitting device 10 includes a first electrode 110, an interlayer 130, and a second electrode 150.

Hereinafter, the structure of the light-emitting device 10 according to an embodiment and a method of manufacturing the light-emitting device 10 will be described in connection with FIG. 1.

### First electrode 110

In FIG. 1, a substrate may be additionally under the first electrode 110 and/or above the second electrode 150. As the substrate, a glass substrate and/or a plastic substrate may be used. In an embodiment, the substrate may be a flexible substrate, and may include plastics (e.g., polymers) having excellent heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing and/or sputtering a material for forming the first electrode 110 on the substrate. When the first electrode 110 is an anode, the material for forming the first electrode 110 may be a high work function material that facilitates injection of holes.

The first electrode 110 may be a reflective electrode, a semi-transmissive electrode, or a transmissive electrode. When the first electrode 110 is a transmissive electrode, the material for forming the first electrode 110 may include indium tin oxide (ITO), indium zinc oxide (IZO), tin oxide ($SnO_2$), zinc oxide (ZnO), or any combination thereof. When the first electrode 110 is a semi-transmissive electrode or a reflective electrode, the material for forming the first electrode 110 may include magnesium (Mg), silver (Ag), aluminium (Al), aluminium-lithium (Al-Li), calcium (Ca), magnesium-indium (Mg-In), magnesium-silver (Mg-Ag), or any combination thereof.

The first electrode 110 may have a single layer including (e.g., consisting of) a single-layered structure or a multilayer structure including a plurality of layers. For example, the first electrode 110 may have a three-layered structure of ITO/Ag/ITO.

### Interlayer 130

The interlayer 130 may be on the first electrode 110. The interlayer 130 includes an emission layer.

The interlayer 130 includes the at least one first compound represented by Formula 1 and the at least one second compound represented by Formula 2.

The interlayer 130 may further include a hole transport region between the first electrode 110 and the emission layer and an electron transport region between the emission layer and the second electrode 150.

The interlayer 130 may further include, a metal-containing compound, such as an organometallic compound, an inorganic material, such as a quantum dot, and/or the like, in addition to various suitable organic materials.

The interlayer 130 may include, i) two or more emitting units sequentially stacked between the first electrode 110 and the second electrode 150 and ii) a charge generation layer between the two emitting units. When the interlayer 130

includes the emitting units and the charge generation layer as described above, the light-emitting device 10 may be a tandem light-emitting device.

**Hole transport region in interlayer 130**

The hole transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The hole transport region may include a hole injection layer, a hole transport layer, an emission auxiliary layer, an electron blocking layer, or any combination thereof.

For example, the hole transport region may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein layers in each structure are stacked sequentially on the first electrode 110.

The hole transport region may include a compound represented by Formula 201, a compound represented by Formula 202, or any combination thereof:

Formula 201

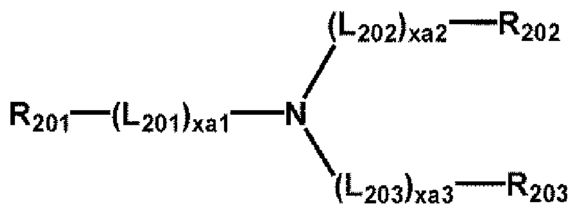

Formula 202

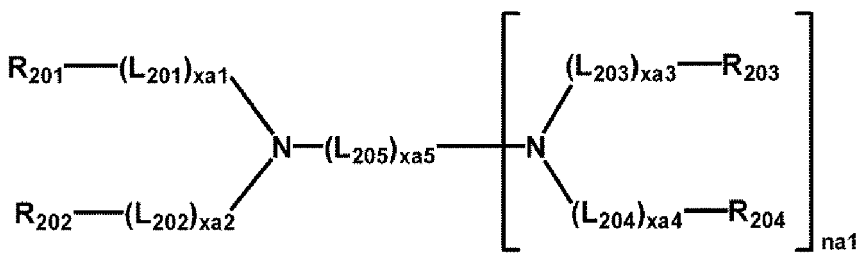

wherein, in Formulae 201 and 202,

$L_{201}$ to $L_{204}$ may each independently be a $C_3$-$C_{60}$ (e.g. $C_3$-$C_{30}$) carbocyclic group unsubstituted or substituted with at least one $R_{10a}$ or a $C_1$-$C_{60}$ (e.g. $C_1$-$C_{20}$) heterocyclic group unsubstituted or substituted with at least one $R_{10a}$,

$L_{205}$ may be *-O-*', *-S-*', *-N($Q_{201}$)-*', a $C_1$-$C_{20}$ (e.g. $C_1$-$C_{10}$) alkylene group unsubstituted or substituted with at least one $R_{10a}$, a $C_2$-$C_{20}$ (e.g. $C_2$-$C_{10}$) alkenylene group unsubstituted or substituted with at least one $R_{10a}$, a $C_3$-$C_{60}$ (e.g. $C_3$-$C_{30}$) carbocyclic group unsubstituted or substituted with at least one $R_{10a}$, or a $C_1$-$C_{60}$ (e.g. $C_1$-$C_{20}$) heterocyclic group unsubstituted or substituted with at least one $R_{10a}$,

xa1 to xa4 may each independently an integer from 0 to 5,

xa5 may be an integer from 1 to 10,

$R_{201}$ to $R_{204}$ and $Q_{201}$ may each independently be a $C_3$-$C_{60}$ (e.g. $C_3$-$C_{30}$) carbocyclic group unsubstituted or substituted with at least one $R_{10a}$ or a $C_1$-$C_{60}$ (e.g. $C_1$-$C_{20}$) heterocyclic group unsubstituted or substituted with at least one $R_{10a}$,

$R_{201}$ and $R_{202}$ may optionally be linked to each other, via a single bond, to form a $C_1$-$C_5$ alkylene group unsubstituted or substituted with at least one $R_{10a}$, or a $C_2$-$C_5$ alkenylene group unsubstituted or substituted with at least one $R_{10a}$, to form a Cs-$C_{60}$ (e.g. $C_8$-$C_{30}$) polycyclic group (for example, a carbazole group and/or the like) unsubstituted or substituted with at least one $R_{10a}$ (see Compound HT16 and/or the like),

$R_{203}$ and $R_{204}$ may optionally be linked to each other, via a single bond, a $C_1$-$C_5$ alkylene group unsubstituted or substituted with at least one $R_{10a}$, or a $C_2$-$C_5$ alkenylene group unsubstituted or substituted with at least one $R_{10a}$, to form a $C_8$-$C_{60}$ (e.g. $C_8$-$C_{30}$) polycyclic group unsubstituted or substituted with at least one $R_{10a}$, and

na1 may be an integer from 1 to 4.

For example, each of Formulae 201 and 202 may include at least one of the groups represented by Formulae CY201 to CY217:

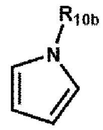
CY201

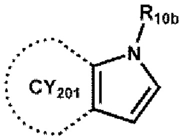
CY202

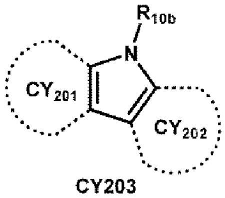
CY203

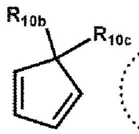
CY204

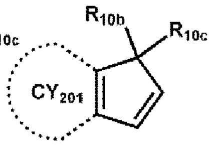
CY205

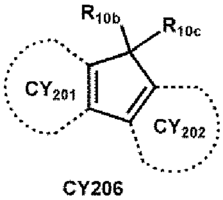
CY206

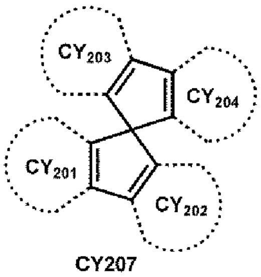
CY207

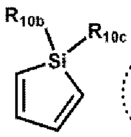
CY208

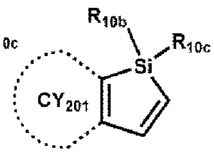
CY209

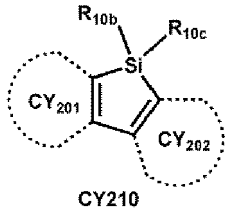
CY210

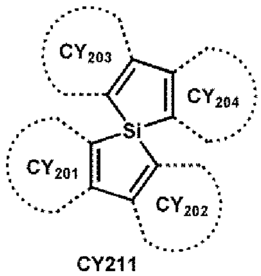
CY211

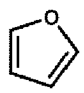
CY212

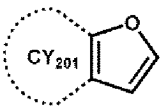
CY213

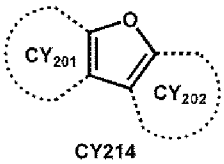
CY214

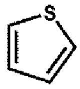
CY215

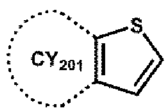
CY216

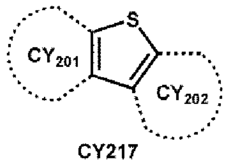
CY217

wherein, in Formulae CY201 to CY217, $R_{10b}$ and $R_{10c}$ may each be the same as described in connection with $R_{10a}$, and ring $CY_{201}$ to ring $CY_{204}$ may each independently be a $C_3$-$C_{20}$ carbocyclic group or a $C_1$-$C_{20}$ heterocyclic group, and at least one hydrogen in Formulae CY201 to CY217 may be unsubstituted or substituted with at least one $R_{10a}$.

In an embodiment, in Formulae CY201 to CY217, ring $CY_{201}$ to ring $CY_{204}$ may each independently be a benzene group, a naphthalene group, a phenanthrene group, or an anthracene group.

In one or more embodiments, each of Formulae 201 and 202 may include at least one of the groups represented by Formulae CY201 to CY203.

In one or more embodiments, Formula 201 may include at least one of the groups represented by Formulae CY201 to CY203 and at least one of the groups represented by Formulae CY204 to CY217.

In one or more embodiments, in Formula 201, xa1 may be 1, $R_{201}$ may be a group represented by one of Formulae CY201 to CY203, xa2 may be 0, and $R_{202}$ may be a group represented by one of Formulae CY204 to CY207.

In one or more embodiments, each of Formulae 201 and 202 may not include a group represented by one of Formulae CY201 to CY203.

In one or more embodiments, each of Formulae 201 and 202 may not include a group represented by one of Formulae CY201 to CY203, and may include at least one of the groups represented by Formulae CY204 to CY217.

In one or more embodiments, each of Formulae 201 and 202 may not include a group represented by one of Formulae CY201 to CY217.

For example, the hole transport region may include one of Compounds HT1 to HT46, m-MTDATA, TDATA, 2-TNATA, NPB(NPD), β-NPB, TPD, Spiro-TPD, Spiro-NPB, methylated-NPB, TAPC, HMTPD, 4,4',4"-tris(N-carbazolyl) triphenylamine (TCTA), polyaniline/dodecylbenzenesulfonic acid (PANI/DBSA), poly(3,4-ethylenedioxythiophene)/-poly(4-styrenesulfonate) (PEDOT/PSS), polyaniline/camphor sulfonic acid (PANI/CSA), polyaniline/poly(4-styrenesulfonate) (PANI/PSS), or any combination thereof:

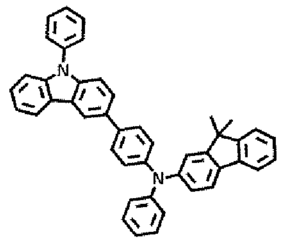
HT1

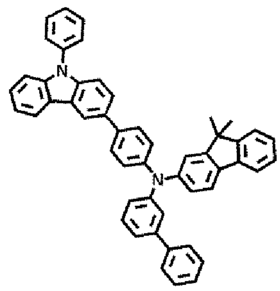
HT2

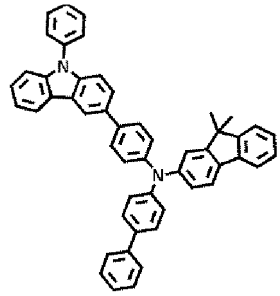
HT3

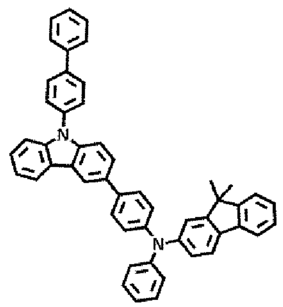
HT4

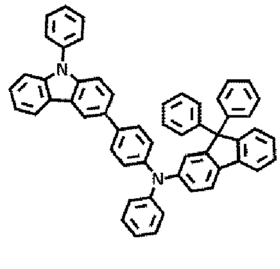
HT5

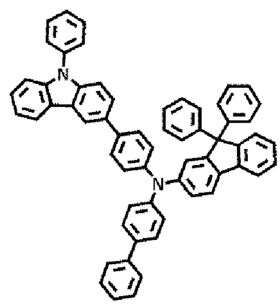
HT6

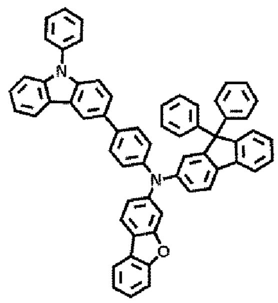
HT7

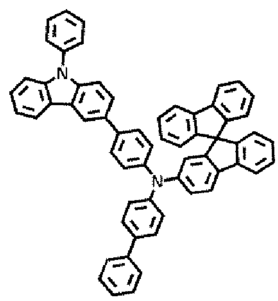
HT8

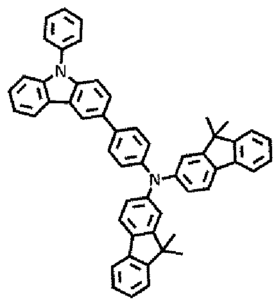
HT9

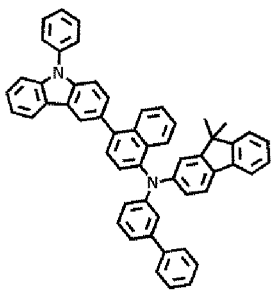
HT10

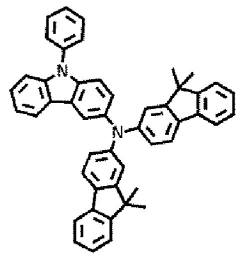
HT11

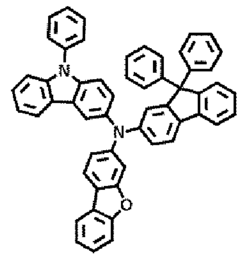
HT12

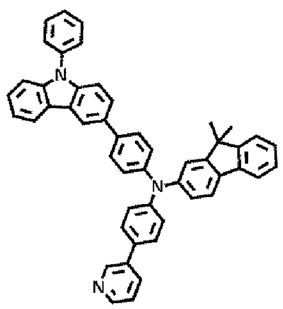
HT13

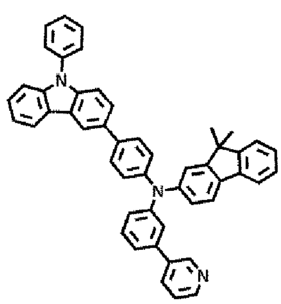
HT14

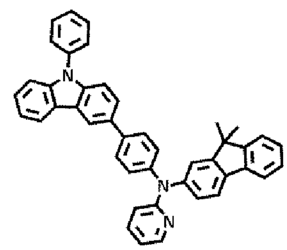
HT15

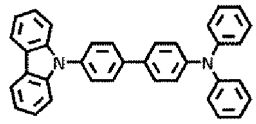

HT16

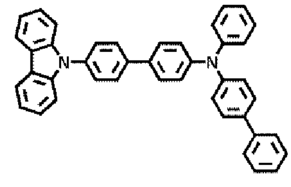

HT17

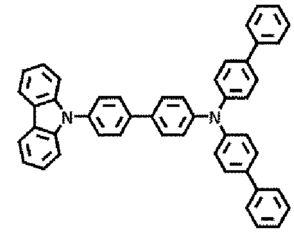

HT18

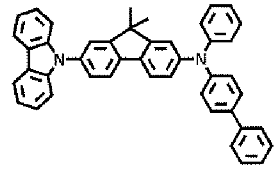

HT19

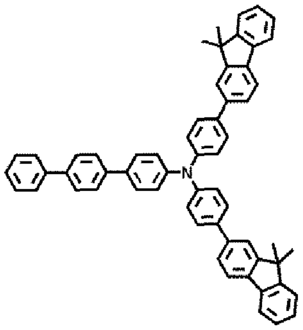

HT20

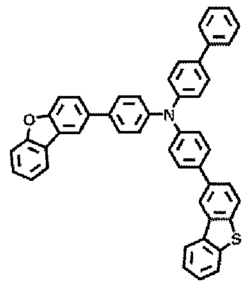

HT21

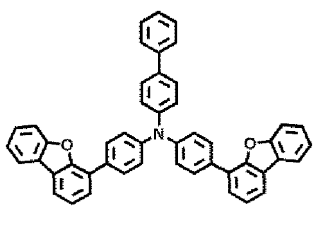

HT22

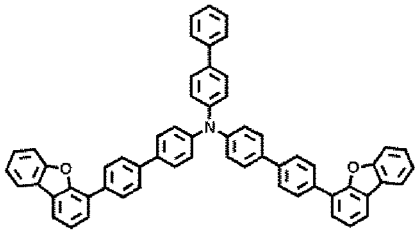

HT23

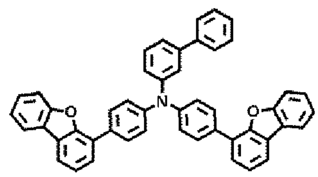

HT24

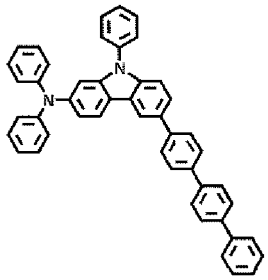

HT25

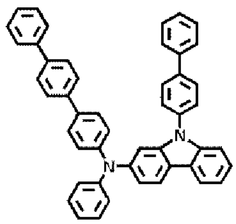

HT26

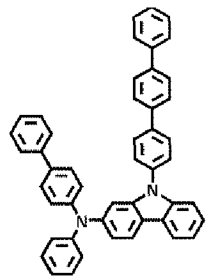

HT27

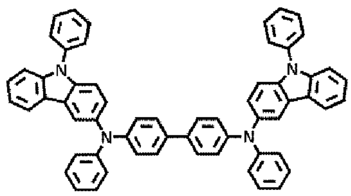

HT28

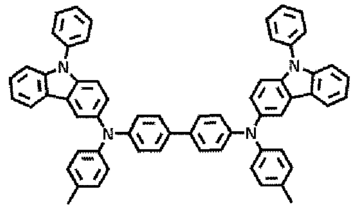

HT29

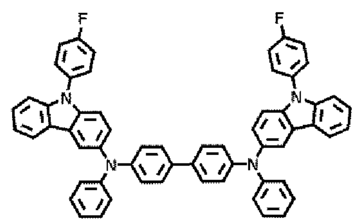

HT30

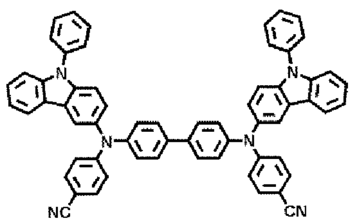

HT31

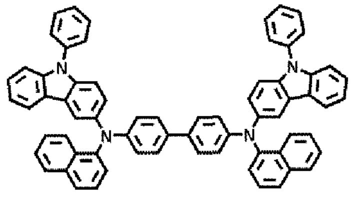

HT32

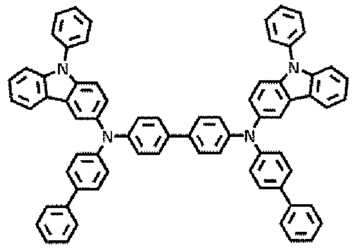

HT33

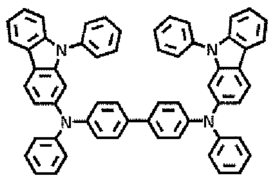

HT34

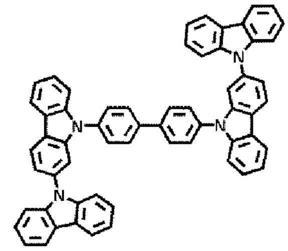

HT35

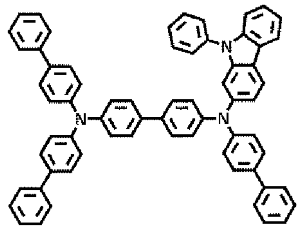

HT36

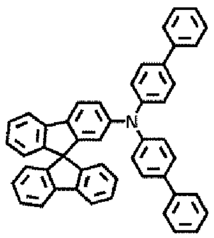

HT37

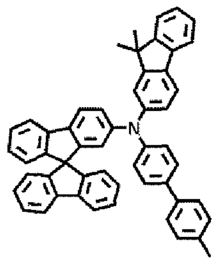

HT38

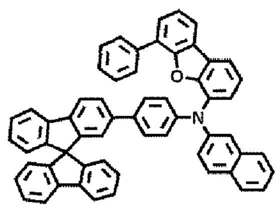

HT39

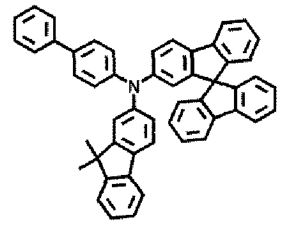

HT40

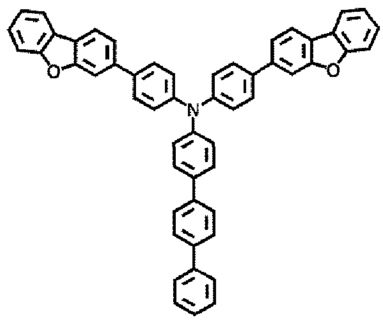

HT41

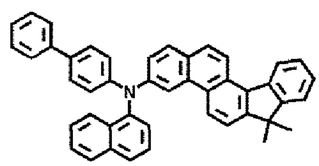

HT42

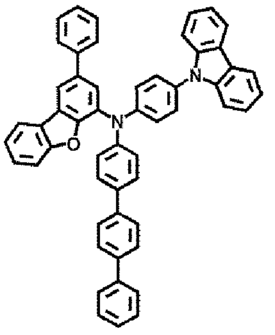

HT43

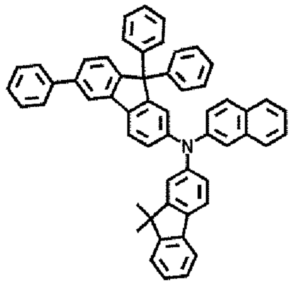

HT44

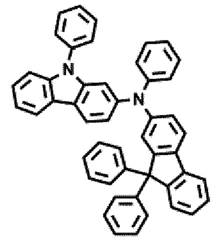

HT45

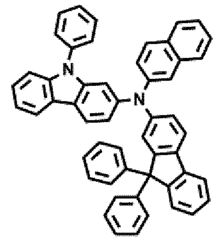

HT46

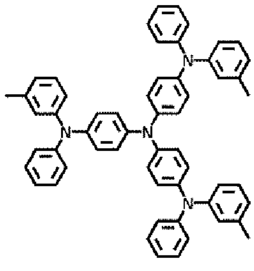

m-MTDATA

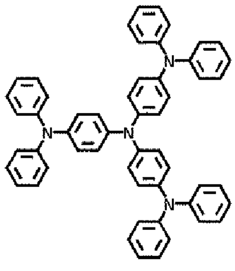

TDATA

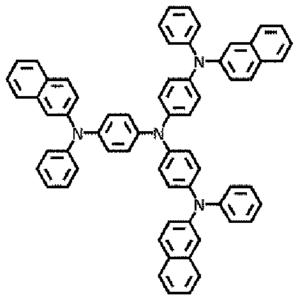

2-TNATA

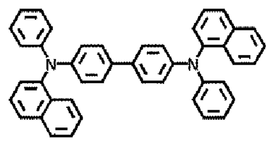

NPB

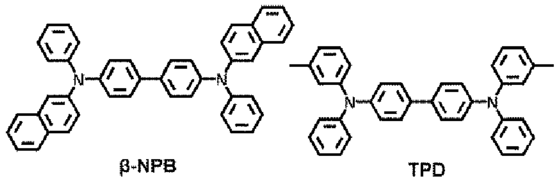

β-NPB

TPD

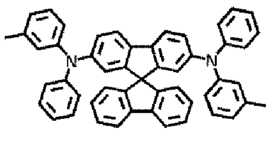

Spiro-TPD

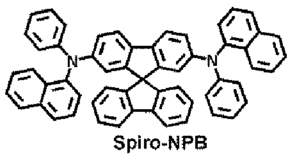

Spiro-NPB

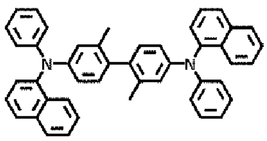

methylated-NPB

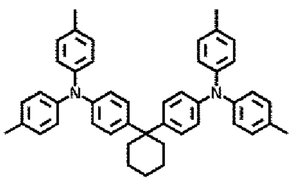

TAPC

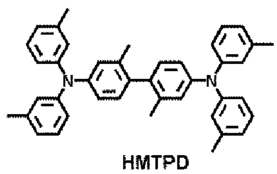

HMTPD

A thickness of the hole transport region may be in a range of about 50 Å to about 10,000 Å, for example, about 100 Å to about 7,000 Å, about 100 Å to about 5,000 Å, about 100 Å to about 4,000 Å or about 100 Å to about 1,200 Å. When the hole transport region includes a hole injection layer, a hole transport layer, or any combination thereof, a thickness of the hole injection layer may be in a range of about 100 Å to about 9,000 Å, for example, about 100 Å to about 7,000 Å, about 100 Å to about 5,000 Å, about 100 Å to about 3,000 Å, about 100 Å to about 2,000 Å, about 100 Å to about 1,000 Å or about 100 Å to about 300 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, suitable or satisfactory hole transporting characteristics may be obtained without a substantial increase in driving voltage.

The emission auxiliary layer may increase light-emission efficiency by compensating for an optical resonance distance according to the wavelength of light emitted by the emission layer 150, and the electron blocking layer may block or reduce the flow of electrons from the electron transport region. The emission auxiliary layer and the electron blocking layer may include the materials as described above.

**p-dopant**

The hole transport region may further include, in addition to these materials, a charge-generation material for the improvement of conductive properties (e.g., electrically conductive properties). The charge-generation material may be uniformly or non-uniformly dispersed in the hole transport region (for example, in the form of a single layer including (e.g., consisting of) a charge-generation material).

The charge-generation material may be, for example, a p-dopant.

For example, a lowest unoccupied molecular orbital (LUMO) energy level of the p-dopant may be equal to or less than -3.5 eV.

In an embodiment, the p-dopant may include a quinone derivative, a cyano group-containing compound, a compound containing element EL1 and element EL2, or any combination thereof.

Examples of the quinone derivative include TCNQ, F4-TCNQ, and/or the like.

Examples of the cyano group-containing compound include HAT-CN, a compound represented by Formula 221, and/or the like:

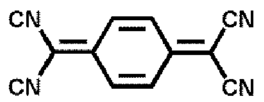

TCNQ

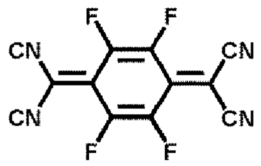

F4-TCNQ

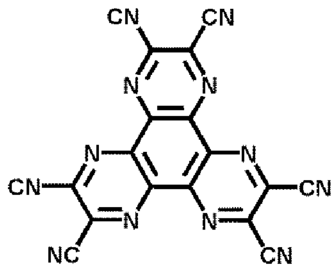

HAT-CN

Formula 221

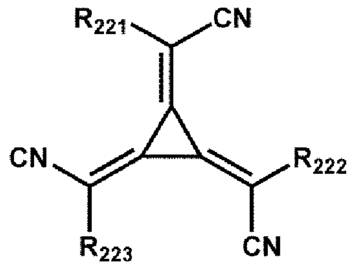

wherein, in Formula 221,

$R_{221}$ to $R_{223}$ may each independently be a $C_3$-$C_{60}$ (e.g. $C_3$-$C_{30}$) carbocyclic group unsubstituted or substituted with at least one $R_{10a}$ or a $C_1$-$C_{60}$ (e.g. $C_1$-$C_{20}$) heterocyclic group unsubstituted or substituted with at least one $R_{10a}$, and at least one of $R_{221}$ to $R_{223}$ may each independently be a $C_3$-$C_{60}$ (e.g. $C_3$-$C_{30}$) carbocyclic group or a $C_1$-$C_{60}$ (e.g. $C_1$-$C_{20}$) heterocyclic group, each substituted with a cyano group; -F; -Cl; -Br; -I; a $C_1$-$C_{20}$ *(e.g.* $C_1$-$C_{10}$) alkyl group substituted with a cyano group, -F, -Cl, -Br, -I, or any combination thereof; or any combination thereof.

In the compound containing element EL1 and element EL2, element EL1 may be metal, metalloid, or a combination thereof, and element EL2 may be non-metal, metalloid, or a combination thereof.

Examples of the metal include: an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.); and the like.

Examples of the metalloid include silicon (Si), antimony (Sb), tellurium (Te), and the like.

Examples of the non-metal include oxygen (O), halogen (for example, F, Cl, Br, I, etc.), and the like.

Examples of the compound containing element EL1 and element EL2 include a metal oxide, a metal halide (for example, metal fluoride, metal chloride, metal bromide, and/or metal iodide), a metalloid halide (for example, metalloid fluoride, metalloid chloride, metalloid bromide, and/or metalloid iodide), a metal telluride, or any combination thereof.

Examples of the metal oxide include tungsten oxide (for example, WO, $W_2O_3$, $WO_2$, $WO_3$, $W_2O_5$, etc.), vanadium oxide (for example, VO, $V_2O_3$, $VO_2$, $V_2O_5$, etc.), molybdenum oxide (MoO, $Mo_2O_3$, $MoO_2$, MoOs, $Mo_2O_5$, etc.), rhenium oxide (for example, ReOs, etc.), and the like.

Examples of the metal halide include alkali metal halide, alkaline earth metal halide, transition metal halide, post-transition metal halide, lanthanide metal halide, and the like.

Examples of the alkali metal halide include LiF, NaF, KF, RbF, CsF, LiCl, NaCl, KCl, RbCl, CsCl, LiBr, NaBr, KBr, RbBr, CsBr, LiI, NaI, KI, RbI, CsI, and the like.

Examples of the alkaline earth metal halide include $BeF_2$, $MgF_2$, $CaF_2$, $SrF_2$, $BaF_2$, $BeCl_2$, $MgCl_2$, $CaCl_2$, $SrCl_2$, $BaCl_2$, $BeBr_2$, $MgBr_2$, $CaBr_2$, $SrBr_2$, $BaBr_2$, $BeI_2$, $MgI_2$, $CaI_2$, $SrI_2$, $BaI_2$, and the like.

Examples of the transition metal halide include titanium halide (for example, $TiF_4$, $TiCl_4$, $TiBr_4$, $TiI_4$, etc.), zirconium halide (for example, $ZrF_4$, $ZrCl_4$, $ZrBr_4$, $ZrI_4$, etc.), hafnium halide (for example, $HfF_4$, $HfCl_4$, $HfBr_4$, $HfI_4$, etc.), vanadium halide (for example, $VF_3$, $VCl_3$, $VBr_3$, $VI_3$, etc.), niobium halide (for example, $NbF_3$, $NbCl_3$, $NbBr_3$, $NbI_3$, etc.), tantalum halide (for example, $TaF_3$, $TaCl_3$, $TaBr_3$, $TaI_3$, etc.), chromium halide (for example, $CrF_3$, $CrCl_3$, $CrBr_3$, $CrI_3$, etc.), molybdenum halide (for example, $MoF_3$, $MoCl_3$, $MoBr_3$, $MoI_3$, etc.), tungsten halide (for example, $WF_3$, $WCl_3$, $WBr_3$, $WI_3$, etc.), manganese halide (for example, $MnF_2$, $MnCl_2$, $MnBr_2$, $MnI_2$, etc.), technetium halide (for example, $TcF_2$, $TcCl_2$, $TcBr_2$, $TcI_2$, etc.), rhenium halide (for example, $ReF_2$, $ReCl_2$, $ReBr_2$, $ReI_2$, etc.), iron halide (for example, $FeF_2$, $FeCl_2$, $FeBr_2$, $FeI_2$, etc.), ruthenium halide (for example, $RuF_2$, $RuCl_2$, $RuBr_2$, $RuI_2$, etc.), osmium halide (for example, $OsF_2$, $OsCl_2$, $OsBr_2$, $OsI_2$, etc.), cobalt halide (for example, $CoF_2$, $CoCl_2$, $CoBr_2$, $CoI_2$, etc.), rhodium halide (for example, $RhF_2$, $RhCl_2$, $RhBr_2$, $RhI_2$, etc.), iridium halide (for example, $IrF_2$, $IrCl_2$, $IrBr_2$, $IrI_2$, etc.), nickel halide (for example, $NiF_2$, $NiCl_2$, $NiBr_2$, $NiI_2$, etc.), palladium halide (for example, $PdF_2$, $PdCl_2$, $PdBr_2$, $PdI_2$, etc.), platinum halide (for example, $PtF_2$, $PtCl_2$, $PtBr_2$, $PtI_2$, etc.), copper halide (for example, CuF, CuCl, CuBr, CuI, etc.), silver halide (for example, AgF, AgCl, AgBr, AgI, etc.), gold halide (for example, AuF, AuCl, AuBr, AuI, etc.), and the like.

Examples of the post-transition metal halide include zinc halide (for example, $ZnF_2$, $ZnCl_2$, $ZnBr_2$, $ZnI_2$, etc.), indium halide (for example, $InI_3$, etc.), tin halide (for example, $SnI_2$, etc.), and the like.

Examples of the lanthanide metal halide include YbF, $YbF_2$, $YbF_3$, $SmF_3$, YbCl, $YbCl_2$, $YbCl_3$ $SmCl_3$, YbBr, $YbBr_2$, $YbBr_3$ $SmBr_3$, YbI, $YbI_2$, $YbI_3$, $SmI_3$, and the like.

Examples of the metalloid halide include antimony halide (for example, $SbCl_5$, etc.) and the like.

Examples of the metal telluride include alkali metal telluride (for example, $Li_2Te$, $Na_2Te$, $K_2Te$, $Rb_2Te$, $Cs_2Te$, etc.), alkaline earth metal telluride (for example, BeTe, MgTe, CaTe, SrTe, BaTe, etc.), transition metal telluride (for example, $TiTe_2$, $ZrTe_2$, $HfTe_2$, $V_2Te_3$, $Nb_2Te_3$, $Ta_2Te_3$, $Cr_2Te_3$, $Mo_2Te_3$, $W_2Te_3$, MnTe, TcTe, ReTe, FeTe, RuTe, OsTe, CoTe, RhTe, IrTe, NiTe, PdTe, PtTe, $Cu_2Te$, CuTe, $Ag_2Te$, AgTe, $Au_2Te$, etc.), post-transition metal telluride (for example, ZnTe, etc.), lanthanide metal telluride (for example, LaTe, CeTe, PrTe, NdTe, PmTe, EuTe, GdTe, TbTe, DyTe, HoTe, ErTe, TmTe, YbTe, LuTe, etc.), and the like.

### Emission layer in interlayer 130

When the light-emitting device 10 is a full-color light-emitting device, the emission layer may be patterned into a red emission layer, a green emission layer, and/or a blue emission layer, according to a sub-pixel. In an embodiment, the emission layer may have a stacked structure of two or more layers of a red emission layer, a green emission layer, and a blue emission layer, in which the two or more layers contact (e.g., physically contact) each other or are separated from each other. In one or more embodiments, the emission layer may include two or more materials of a red light-emitting material, a green light-emitting material, and a blue light-emitting material, in which the two or more materials are mixed with each other in a single layer to emit white light.

The emission layer may include a host and a dopant. The dopant may include a phosphorescent dopant, a fluorescent dopant, or any combination thereof.

The emission layer may include the first compound represented by Formula 1.

For example, the host included in the emission layer may include the first compound represented by Formula 1.

An amount of the dopant in the emission layer may be in a range of about 0.01 parts by weight to about 15 parts by weight based on 100 parts by weight of the host.

In an embodiment, the emission layer may include quantum dots.

In one or more embodiments, the emission layer may include a delayed fluorescence material. The delayed fluorescence material may act as a host or a dopant in the emission layer.

A thickness of the emission layer may be in a range of about 100 Å to about 1,000 Å, for example, about 100 Å to about 800 Å, about 150 Å to about 800 Å, about 150 Å to about 700 Å, about 150 Å to about 650 Å, about 200 Å to about 600 Å or about 200 Å to about 400 Å. When the thickness of the emission layer is within these ranges, excellent light-emission characteristics may be obtained without a substantial increase in driving voltage.

### Host

In an embodiment, the host may further include a compound represented by Formula 301:

Formula 301 $[Ar_{301}]_{xb11}$-$[(L_{301})_{xb1}$-$R_{301}]_{xb21}$

wherein, in Formula 301,

$Ar_{301}$ and $L_{301}$ may each independently be a $C_3$-$C_{60}$ (e.g. $C_3$-$C_{30}$) carbocyclic group unsubstituted or substituted with at least one $R_{10a}$ or a $C_1$-$C_{60}$ (e.g. $C_1$-$C_{20}$) heterocyclic group unsubstituted or substituted with at least one $R_{10a}$,

xb11 may be 1, 2, or 3,

xb1 may be an integer from 0 to 5,

$R_{301}$ may be hydrogen, deuterium, -F, -Cl, -Br, -I, a hydroxyl group, a cyano group, a nitro group, a $C_1$-$C_{60}$ (*e.g.* $C_1$-$C_{20}$) alkyl group unsubstituted or substituted with at least one $R_{10a}$, a $C_2$-$C_{60}$ (*e.g.* $C_2$-$C_{20}$) alkenyl group unsubstituted or substituted with at least one $R_{10a}$, a $C_2$-$C_{60}$ (*e.g.* $C_2$-$C_{20}$) alkynyl group unsubstituted or substituted with at least one $R_{10a}$, a $C_1$-$C_{60}$ (*e.g.* $C_1$-$C_{20}$) alkoxy group unsubstituted or substituted with at least one $R_{10a}$, a $C_3$-$C_{60}$ (*e.g.* $C_3$-$C_{30}$) carbocyclic group unsubstituted or substituted with at least one $R_{10a}$, a $C_1$-$C_{60}$ (*e.g.* $C_1$-$C_{20}$) heterocyclic group unsubstituted or substituted with at least one $R_{10a}$, -Si($Q_{301}$)($Q_{302}$)($Q_{303}$), -N($Q_{301}$)($Q_{302}$), -B($Q_{301}$)($Q_{302}$), - C(=O)($Q_{301}$), -S(=O)$_2$($Q_{301}$), or -P(=O)($Q_{301}$)($Q_{302}$),

xb21 may be an integer from 1 to 5, and

$Q_{301}$ to $Q_{303}$ may each be the same as described in connection with $Q_1$.

For example, when xb11 in Formula 301 is 2 or more, two or more of $Ar_{301}$(s) may be linked to each other via a single bond.

In one or more embodiments, the host may include a compound represented by Formula 301-1, a compound represented by Formula 301-2, or any combination thereof:

Formula 301-1

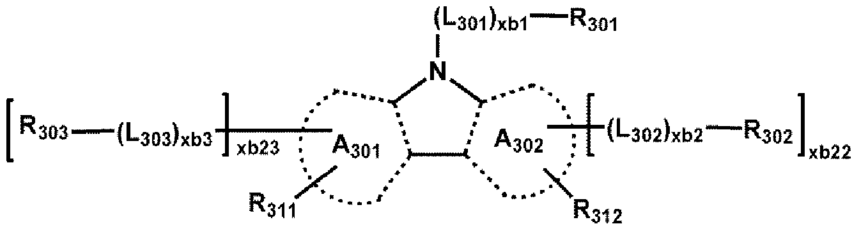

Formula 301-2

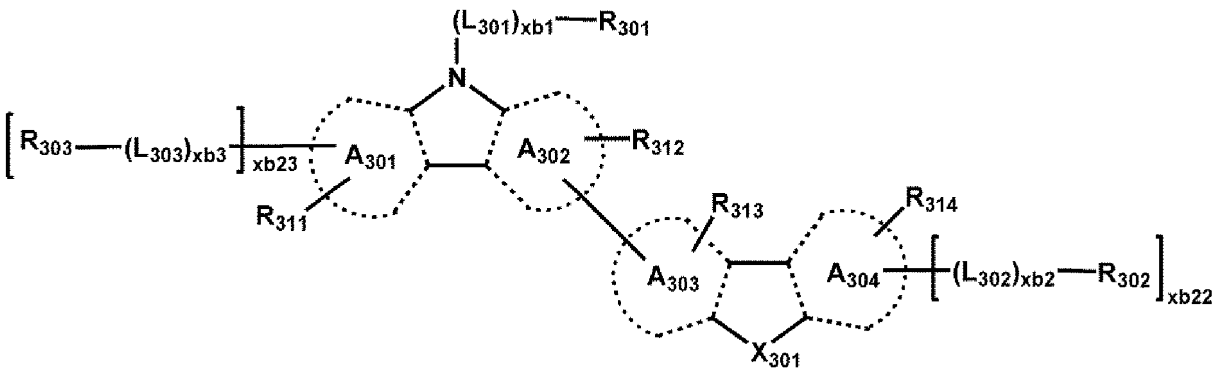

wherein, in Formulae 301-1 and 301-2,

ring $A_{301}$ to ring $A_{304}$ may each independently be a $C_3$-$C_{60}$ (e.g. $C_3$-$C_{30}$) carbocyclic group unsubstituted or substituted with at least one $R_{10}$ or a $C_1$-$C_{60}$ (e.g. $C_1$-$C_{20}$) heterocyclic group unsubstituted or substituted with at least one R10a,

$X_{301}$ may be O, S, N-[$(L_{304})_{xb4}$-$R_{304}$], C($R_{304}$)($R_{305}$), or Si($R_{304}$)($R_{305}$),

xb22 and xb23 may each independently be 0, 1, or 2,

$L_{301}$, xb1, and $R_{301}$ may each be the same as described elsewhere herein,

$L_{302}$ to $L_{304}$ may each independently be the same as described in connection with $L_{301}$,

xb2 to xb4 may each independently be the same as described in connection with xb1, and

$R_{302}$ to $R_{305}$ and $R_{311}$ to $R_{314}$ may each be the same as described in connection with $R_{301}$.

In one or more embodiments, the host may include an alkaline earth-metal complex. In one or more embodiments, the host may include a Be complex (for example, Compound H55), an Mg complex, a Zn complex, or any combination thereof.

In one or more embodiments, the host may include one of Compounds H1 to H124, 9,10-di(2-naphthyl) anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or any combination thereof, but embodiments of the present disclosure are not limited thereto:

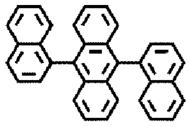
H1

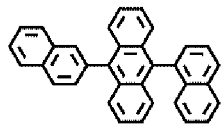
H2

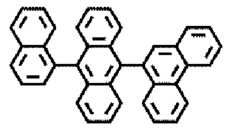
H3

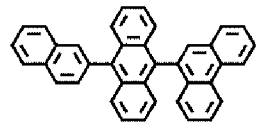
H4

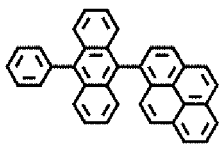
H5

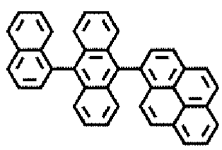
H6

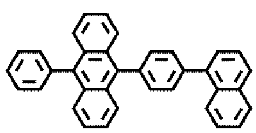
H7

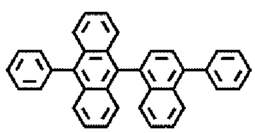
H8

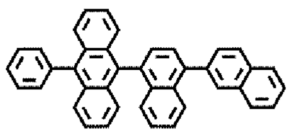
H9

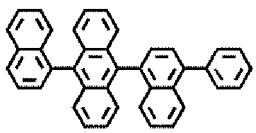
H10

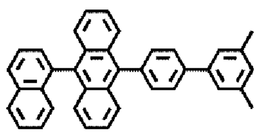
H11

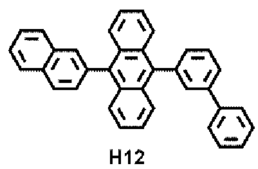
H12

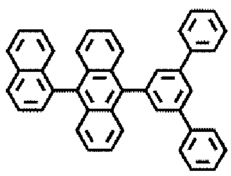
H13

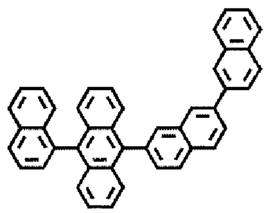
H14

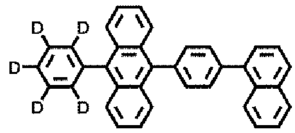
H15

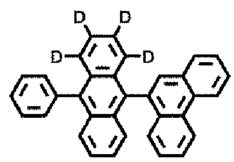
H16

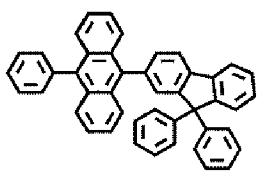
H17

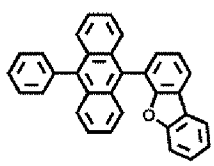
H18

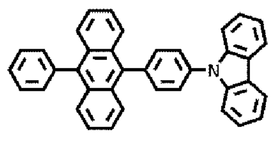
H19

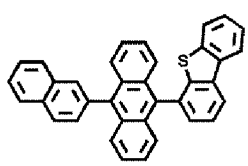
H20

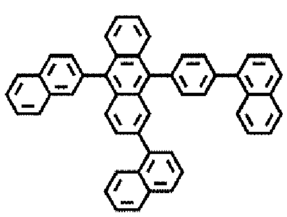
H21

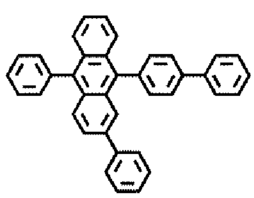
H22

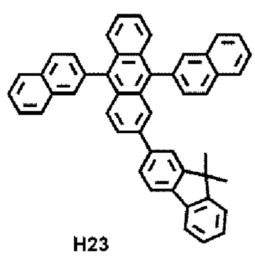
H23

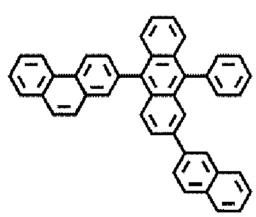
H24

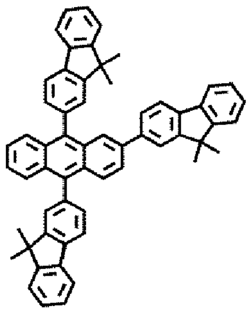

H25

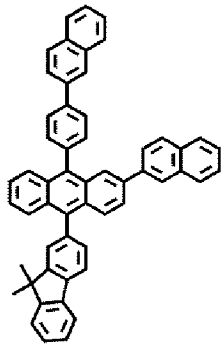

H26

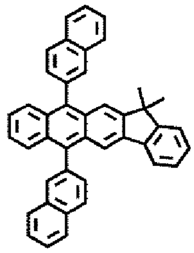

H27

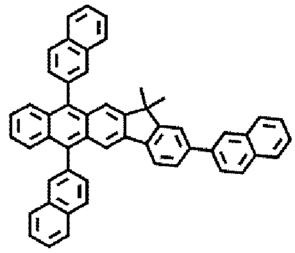

H28

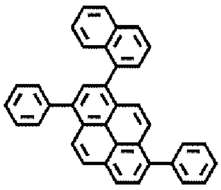

H29

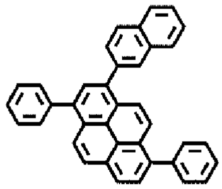

H30

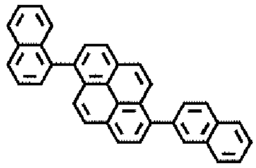

H31

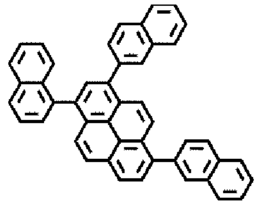

H32

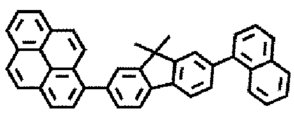

H33

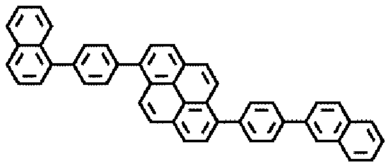

H34

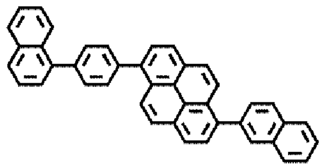

H35

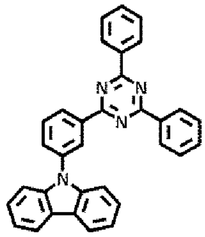

H36

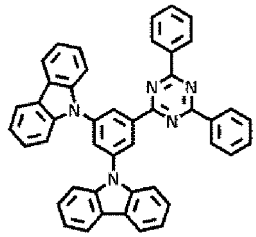

H37

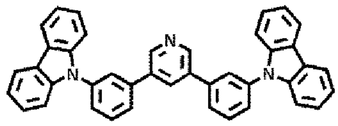

H38

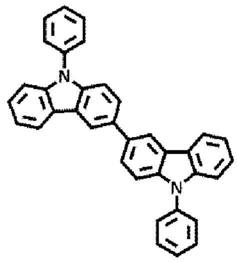

H39

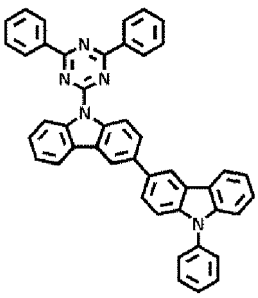

H40

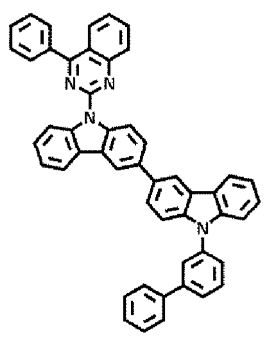

H41

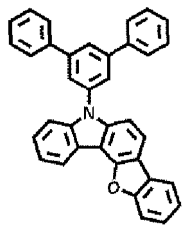

H42

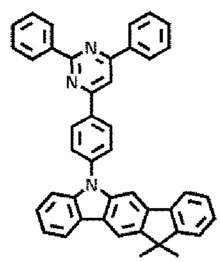

H43

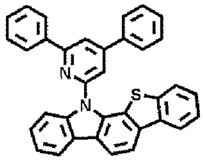
H44

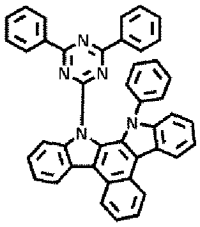
H45

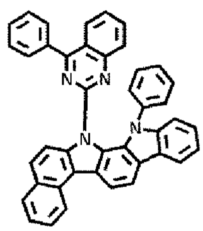
H46

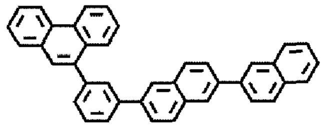
H47

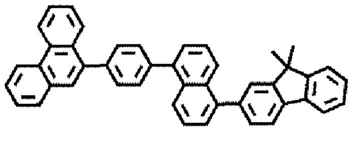
H48

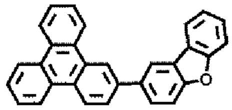
H49

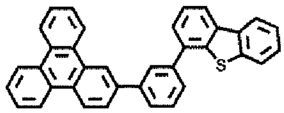
H50

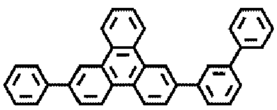
H51

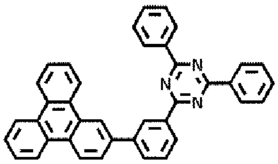
H52

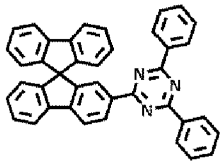
H53

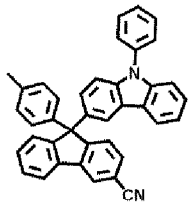
H54

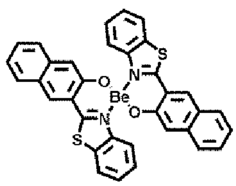
H55

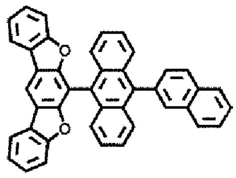
H56

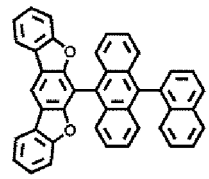
H57

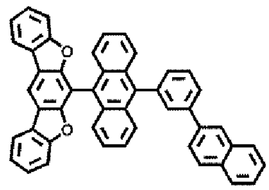
H58

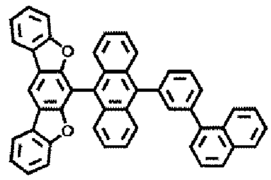
H59

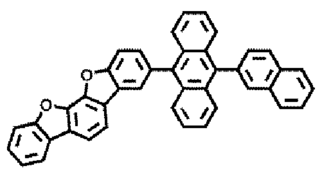
H60

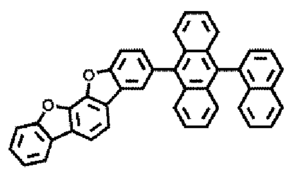
H61

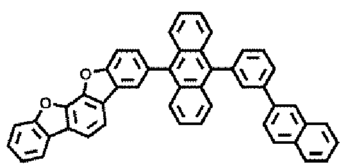
H62

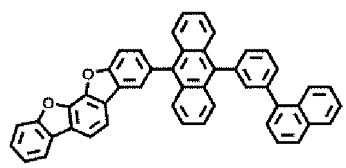
H63

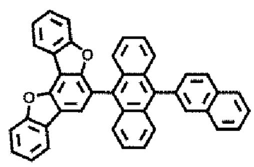
H64

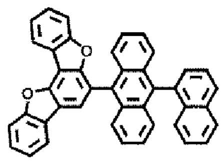
H65

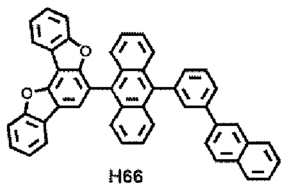
H66

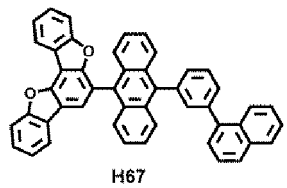
H67

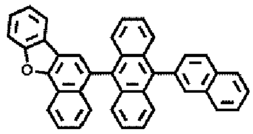
H68

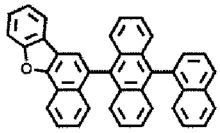
H69

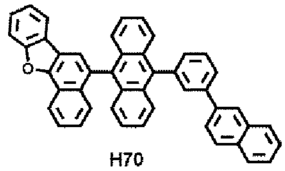
H70

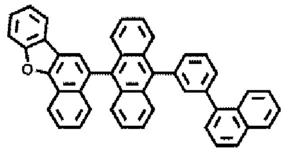
H71

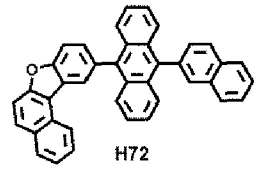
H72

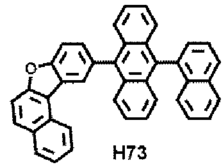
H73

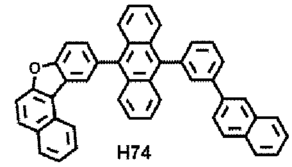
H74

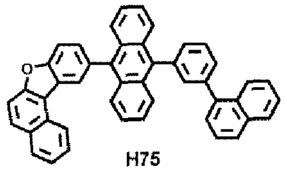
H75

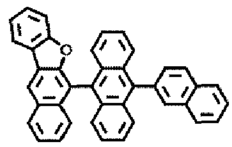
H76

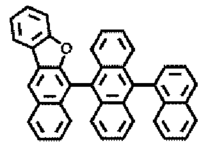
H77

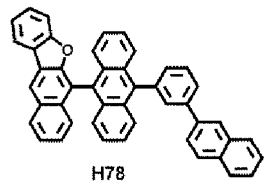
H78

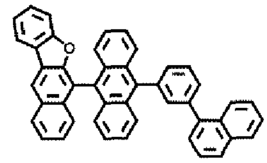
H79

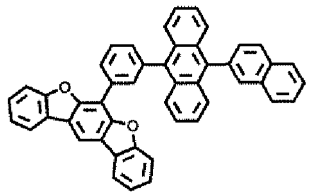
H80

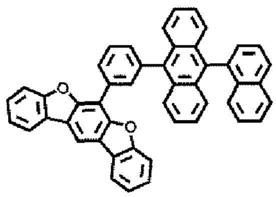
H81

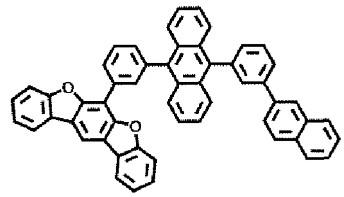
H82

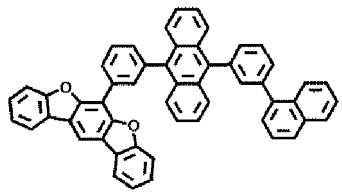
H83

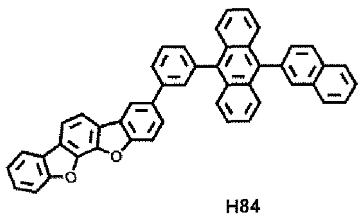
H84

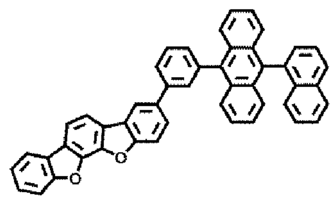
H85

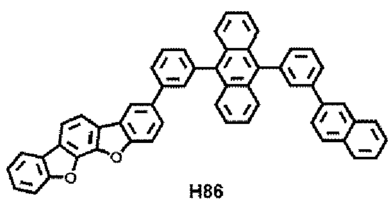
H86

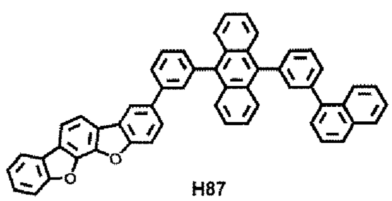
H87

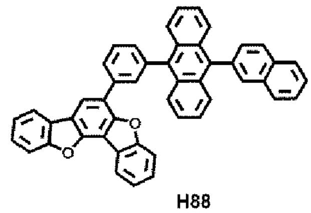
H88

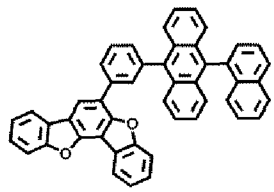
H89

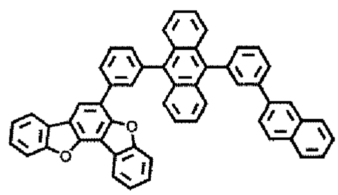
H90

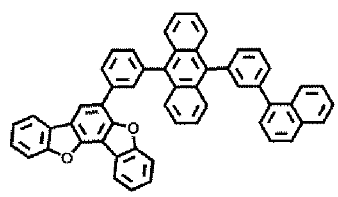
H91

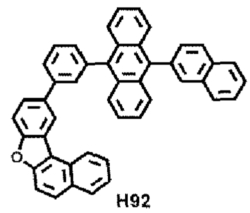
H92

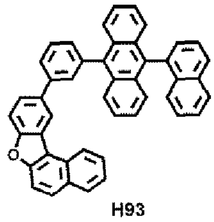
H93

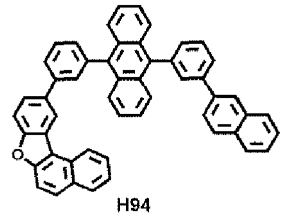
H94

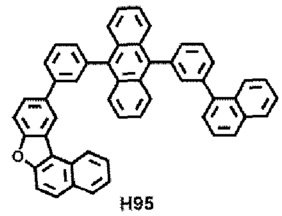
H95

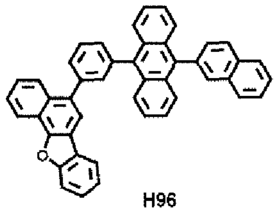
H96

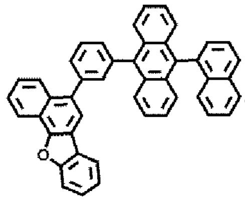
H97

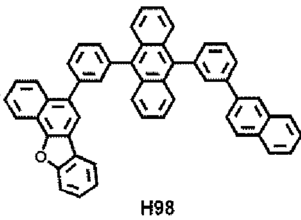
H98

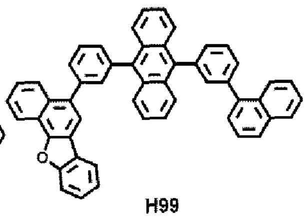
H99

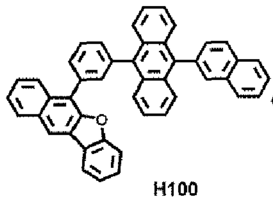
H100

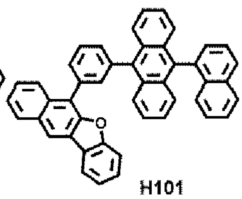
H101

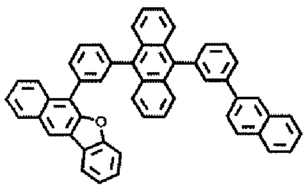
H102

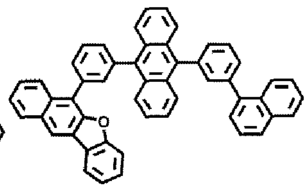
H103

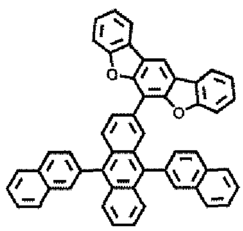
H104

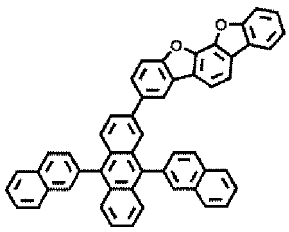
H105

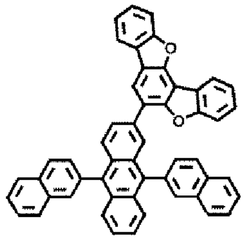
H106

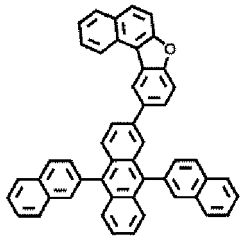
H107

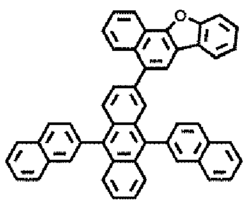
H108

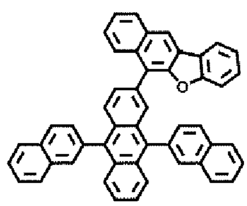
H109

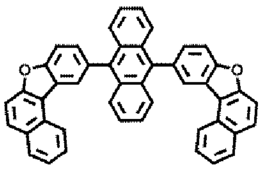
H110

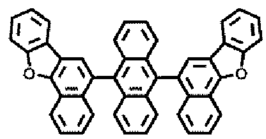
H111

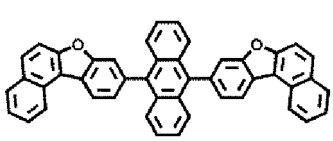
H112

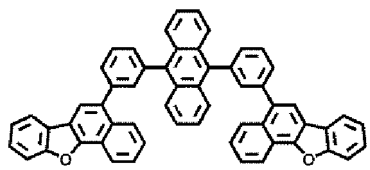
H113

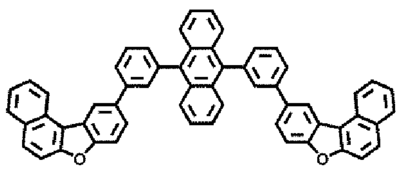
H114

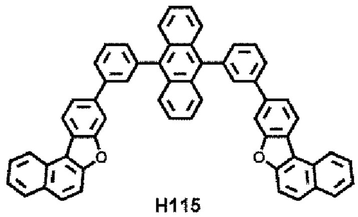

H115

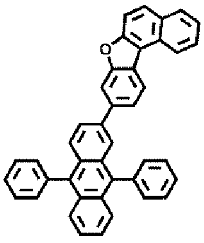

H116

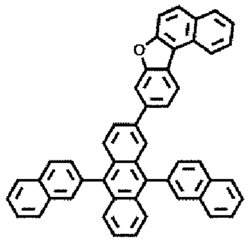

H117

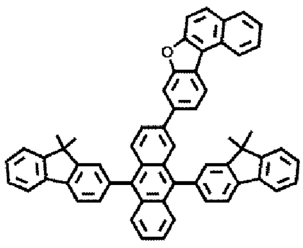

H118

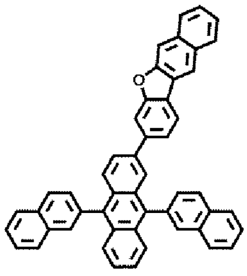

H119

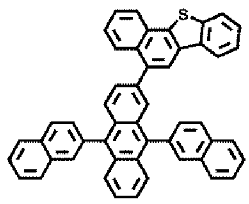

H120

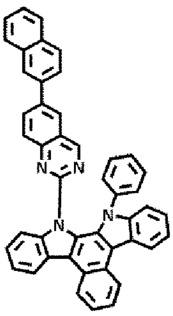

H121

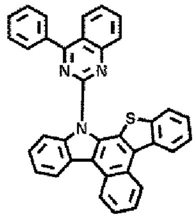

H122

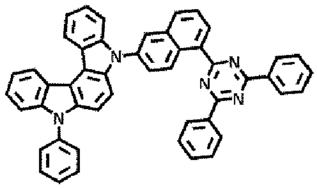

H123

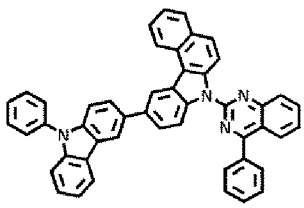

H124

.

**Delayed fluorescence** material

The emission layer may include a delayed fluorescence material.

In the present specification, the delayed fluorescence material may be selected from compounds capable of emitting delayed fluorescence based on a delayed fluorescence emission mechanism.

The delayed fluorescence material included in the emission layer may act as a host or a dopant depending on the type or kind of other materials included in the emission layer.

In an embodiment, a difference between a triplet energy level (eV) of the delayed fluorescence material and a singlet energy level (eV) of the delayed fluorescence material may be greater than or equal to 0 eV and less than or equal to 0.5 eV. When the difference between the triplet energy level (eV) of the delayed fluorescence material and the singlet energy level (eV) of the delayed fluorescence material is within the range above, up-conversion from the triplet state to the singlet state of the delayed fluorescence materials may effectively occur, thereby improving luminescence efficiency of the light-emitting device 10.

For example, the delayed fluorescence material may include i) a material including at least one electron donor (for example, a $\pi$ electron-rich $C_3$-$C_{60}$ (e.g. $C_3$-$C_{30}$) cyclic group, such as a carbazole group) and at least one electron acceptor (for example, a sulfoxide group, a cyano group, or a $\pi$ electron-deficient nitrogen-containing $C_1$-$C_{60}$ *(e.g.* $C_1$-$C_{20}$) cyclic group), and ii) a material including a $C_8$-$C_{60}$ *(e.g.* $C_8$-$C_{30}$) polycyclic group in which two or more cyclic groups are condensed (e.g., combined together) while sharing boron (B).

For example, the delayed fluorescence material may include at least one of Compounds DF1 to DF9:

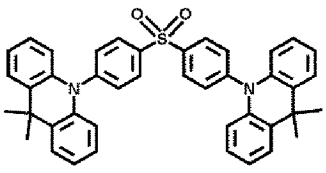
DF1(DMAC-DPS)

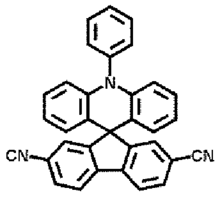
DF2(ACRFLCN)

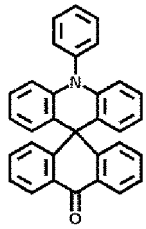
DF3(ACRSA)

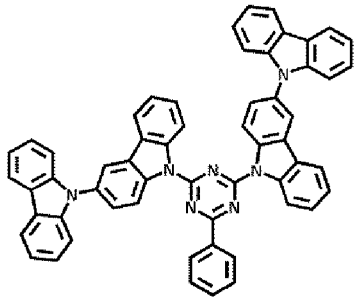
DF4(CC2TA)

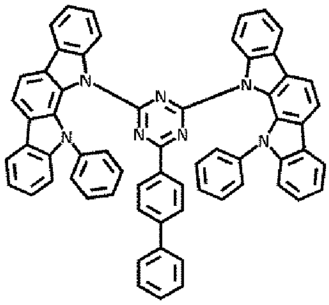
DF5(PIC-TRZ)

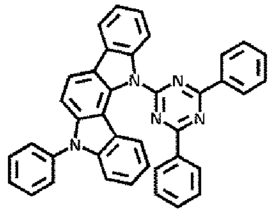
DF6(PIC-TRZ2)

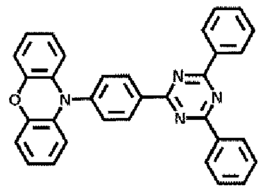
DF7(PXZ-TRZ)

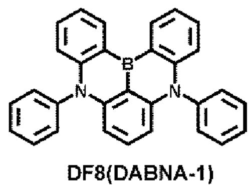
DF8(DABNA-1)

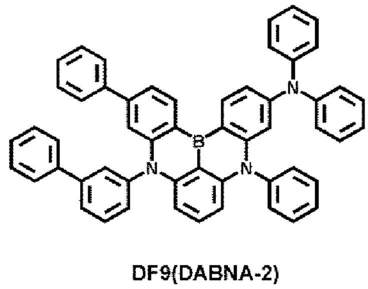
DF9(DABNA-2)

.

**Quantum dots**

The emission layer may include quantum dots.

In the present specification, the term "quantum dots," refers to crystals of a semiconductor compound, and may include any suitable material capable of emitting light of various suitable emission wavelengths according to the size of the crystals.

A diameter of the quantum dots may be, for example, in a range of about 1 nm to about 10 nm.

The quantum dots may be synthesized by a wet chemical process, a metal organic chemical vapor deposition process, a molecular beam epitaxy process, or any suitable process similar thereto.

According to the wet chemical process, a precursor material is mixed with an organic solvent to grow quantum dot particle crystals. When the crystals grow, the organic solvent naturally acts as a dispersant coordinated on the surface of the quantum dot crystals and controls the growth of the crystals so that the growth of quantum dot particles may be controlled through a process which is more easily performed than vapor deposition methods, such as metal organic chemical vapor deposition (MOCVD) or molecular beam epitaxy (MBE), and which requires low costs.

The quantum dots may include a Group II-VI semiconductor compound; a Group III-V semiconductor compound; a Group III-VI semiconductor compound; a Group I-III-VI semiconductor compound; a Group IV-VI semiconductor compound; a Group IV element or compound; or any combination thereof.

Examples of the Group II-VI semiconductor compound include: a binary compound, such as CdSe, CdTe, ZnS, ZnSe, ZnTe, ZnO, HgS, HgSe, HgTe, MgSe, and/or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, and/or MgZnS; a quaternary compound, such as CdZnSeS, CdZnSeTe, CdZnSTe, CdHgSeS, CdHgSeTe, CdHgSTe, HgZnSeS, HgZnSeTe, and/or HgZnSTe; or any combination thereof.

Examples of the Group III-V semiconductor compound include: a binary compound, such as GaN, GaP, GaAs,

GaSb, AlN, AlP, AlAs, AlSb, InN, InP, InAs, and/or InSb; a ternary compound, such as GaNP, GaNAs, GaNSb, GaPAs, GaPSb, AlNP, AlNAs, AlNSb, AlPAs, AlPSb, InGaP, InNP, InAlP, InNAs, InNSb, InPAs, and/or InPSb; a quaternary compound, such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, and/or InAlPSb; or any combination thereof. The Group III-V semiconductor compound may further include a Group II element. Examples of the Group III-V semiconductor compound further including the Group II element include InZnP, InGaZnP, InAlZnP, and the like.

Examples of the Groups III-VI semiconductor compound include a binary compound, such as GaS, GaSe, $Ga_2Se_3$, GaTe, InS, $In_2S_3$, InSe, $In_2Se_3$, and/or InTe; a ternary compound, such as $InGaS_3$, and/or InGaSes; and any combination thereof.

Examples of the Group I-III-VI semiconductor compound include: a ternary compound, such as AgInS, $AgInS_2$, CuInS, $CuInS_2$, $CuGaO_2$, $AgGaO_2$, and/or $AgAlO_2$; or any combination thereof.

Examples of the Group IV-VI semiconductor compound include: a binary compound, such as SnS, SnSe, SnTe, PbS, PbSe, and/or PbTe; a ternary compound, such as SnSeS, SnSeTe, SnSTe, PbSeS, PbSeTe, PbSTe, SnPbS, SnPbSe, and/or SnPbTe; a quaternary compound, such as SnPbSSe, SnPbSeTe, and/or SnPbSTe; or any combination thereof.

The Group IV element or compound may include: a single element compound, such as Si or Ge; a binary compound, such as SiC and/or SiGe; or any combination thereof.

Each element included in a multi-element compound, such as the binary compound, ternary compound, and quaternary compound, may be present as a particle having a uniform concentration or non-uniform concentration.

Meanwhile, the quantum dots may have a single structure or a dual core-shell structure. In the case of the quantum dots having a single structure, the concentration of each element included in the corresponding quantum dots may be uniform (e.g., substantially uniform). For example, the material contained in the core and the material contained in the shell may be different from each other.

The shell of the quantum dots may act as a protective layer to prevent or reduce chemical degeneration of the core to maintain semiconductor characteristics and/or as a charging layer to impart electrophoretic characteristics to the quantum dots. The shell may be a single layer or a multilayer. The interface between the core and the shell may have a concentration gradient that decreases along a direction toward the center of the element present in the shell.

Examples of the shell of the quantum dots include an oxide of metal and/or non-metal, a semiconductor compound, or any combination thereof. Examples of the oxide of metal and/or non-metal include: a binary compound, such as $SiO_2$, $Al_2O_3$, $TiO_2$, ZnO, MnO, $Mn_2O_3$, $Mn_3O_4$, CuO, FeO, $Fe_2O_3$, $Fe_3O_4$, CoO, $Co_3O_4$, and/or NiO; a ternary compound, such as $MgAl_2O_4$, $CoFe_2O_4$, $NiFe_2O_4$, and/or $CoMn_2O_4$; or any combination thereof. Examples of the semiconductor compound include, as described herein, a Group III-VI semiconductor compound; a Group II-VI semiconductor compound; a Group III-V semiconductor compound; a Group III-VI semiconductor compound; a Group I-III-VI semiconductor compound; a Group IV-VI semiconductor compound; or any combination thereof. Examples of the semiconductor compound include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or any combination thereof.

A full width at half maximum (FWHM) of an emission wavelength spectrum of the quantum dots may be equal to or less than about 45 nm, for example, equal to or less than about 40 nm, and for example, equal to or less than about 30. In addition, because light emitted through the quantum dots is emitted in all directions, a wide viewing angle may be improved.

In addition, the quantum dots may be, for example, spherical, pyramidal, multi-arm, and/or cubic nanoparticles, nanotubes, nanowires, nanofibers, and/or nanoplate particles.

Because the energy band gap may be adjusted by controlling the size of the quantum dots, light having various suitable wavelength bands may be obtained from the emission layer including the quantum dots. Therefore, by using quantum dots of different sizes, a light-emitting display that emits light of various suitable wavelengths may be implemented. For example, the size of the quantum dots may be selected from to emit red, green, and/or blue light. In addition, the size of the quantum dots may be configured to emit white light by combining light of various suitable colors.

**Electron transport region in interlayer 130**

The electron transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron transport region may include a buffer layer, a hole blocking layer, an electron control layer, an electron transport layer, an electron injection layer, or any combination thereof.

For example, the electron transport region may have an electron transport layer/electron injection layer structure, a hole blocking layer/electron transport layer/electron injection layer structure, an electron control layer/electron transport

layer/electron injection layer structure, or a buffer layer/electron transport layer/electron injection layer structure, wherein layers in each structure are sequentially stacked on the emission layer.

The electron transport region may include the at least one second compound represented by Formula 2.

In an embodiment, the electron transport region (for example, the buffer layer, the hole blocking layer, the electron control layer, or the electron transport layer in the electron transport region) may include a metal-free compound including at least one π electron-deficient nitrogen-containing $C_1$-$C_{60}$ (e.g. $C_1$-$C_{30}$) cyclic group.

In one or more embodiments, the electron transport region may include a compound represented by Formula 601:

Formula 601 $[Ar_{601}]_{xe11}$-$[(L_{601})_{xe1}$-$R_{601}]_{xe21}$

wherein, in Formula 601,

$Ar_{601}$ and $L_{601}$ may each independently be a $C_3$-$C_{60}$ (e.g. $C_3$-$C_{30}$) carbocyclic group unsubstituted or substituted with at least one $R_{10a}$ or a $C_1$-$C_{60}$ (e.g. $C_1$-$C_{20}$) heterocyclic group unsubstituted or substituted with at least one $R_{10a}$,

xe11 may be 1, 2, or 3,

xe1 may be 0, 1, 2, 3, 4, or 5,

$R_{601}$ may be a $C_3$-$C_{60}$ (e.g. $C_3$-$C_{30}$) carbocyclic group unsubstituted or substituted with at least one $R_{10a}$, a $C_1$-$C_{60}$ (e.g. $C_1$-$C_{20}$) heterocyclic group unsubstituted or substituted with at least one $R_{10a}$, -Si($Q_{601}$)($Q_{602}$)($Q_{603}$), -C(=O)($Q_{601}$), - S(=O)$_2$($Q_{601}$), or -P(=O)($Q_{601}$)($Q_{602}$),

$Q_{601}$ to $Q_{603}$ may each be the same as described in connection with $Q_1$,

xe21 may be 1, 2, 3, 4, or 5, and

at least one of $Ar_{601}$, $L_{601}$, and $R_{601}$ may each independently be a π electron-deficient nitrogen-containing $C_1$-$C_{60}$ (e.g. $C_1$-$C_{30}$) cyclic group unsubstituted or substituted with at least one $R_{10a}$.

In an embodiment, when xe11 in Formula 601 is 2 or more, two or more of $Ar_{601}$(s) may be linked via a single bond.

In one or more embodiments, $Ar_{601}$ in Formula 601 may be a substituted or unsubstituted anthracene group.

In one or more embodiments, the electron transport region may include a compound represented by Formula 601-1:

Formula 601-1

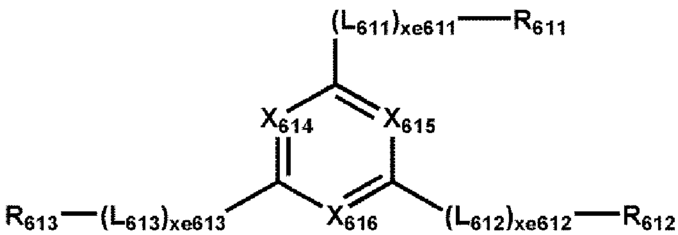

wherein, in Formula 601-1,

$X_{614}$ may be N or C($R_{614}$), $X_{615}$ may be N or C($R_{615}$), $X_{616}$ may be N or C($R_{616}$), and at least one selected from $X_{614}$ to $X_{616}$ may be N,

$L_{611}$ to $L_{613}$ may each be the same as described in connection with $L_{601}$,

xe611 to xe613 may each be the same as described in connection with xe1,

$R_{611}$ to $R_{613}$ may each be the same as described in connection with $R_{601}$, and

$R_{614}$ to $R_{616}$ may each independently be hydrogen, deuterium, -F, -Cl, -Br, -I, a hydroxyl group, a cyano group, a nitro group, a $C_1$-$C_{20}$ (e.g. $C_1$-$C_{10}$) alkyl group, a $C_1$-$C_{20}$ *(e.g.* $C_1$-$C_{10}$) alkoxy group, a $C_3$-$C_{60}$ *(e.g.* $C_3$-$C_{30}$) carbocyclic group unsubstituted or substituted with at least one $R_{10a}$, or a $C_1$-$C_{60}$ (e.g. $C_1$-$C_{20}$) heterocyclic group substituted or unsubstituted at least one $R_{10a}$.

For example, xe1 and xe611 to xe613 in Formulae 601 and 601-1 may each independently be 0, 1, or 2.

The electron transport region may include one of Compounds ET1 to ET45, 2,9-dimethyl-4,7-diphenyl-1,10-phenanthroline (BCP), 4,7-diphenyl-1,10-phenanthroline (Bphen), $Alq_3$, BAlq, TAZ, NTAZ, T2T, or any combination thereof:

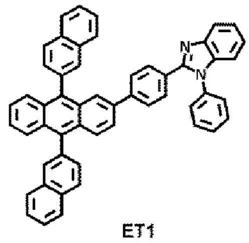
ET1

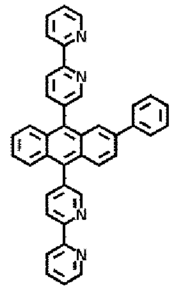
ET2

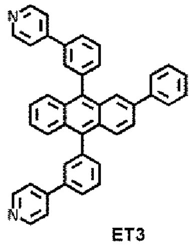
ET3

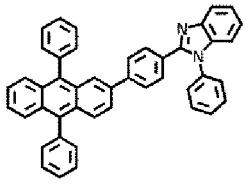
ET4

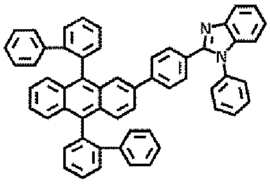
ET5

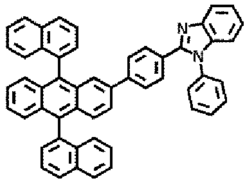
ET6

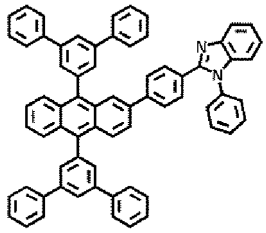
ET7

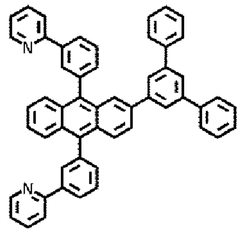
ET8

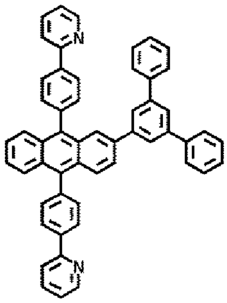
ET9

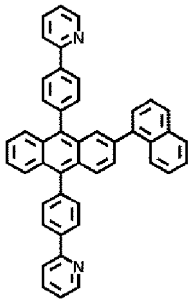
ET10

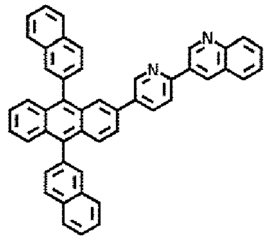
ET11

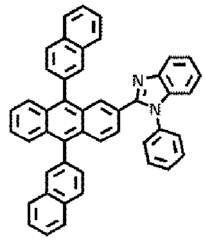
ET12

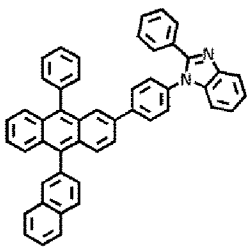
ET13

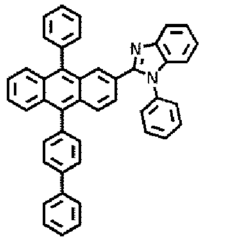
ET14

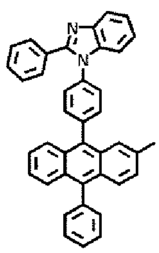
ET15

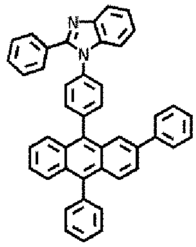
ET16

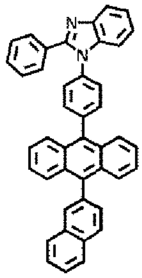
ET17

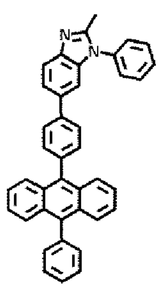
ET18

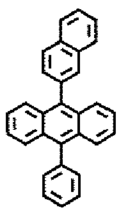
ET19

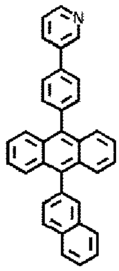
ET20

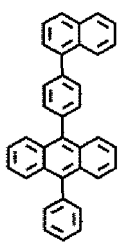
ET21

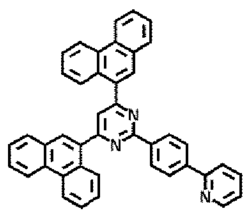
ET22

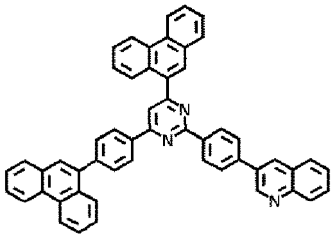
ET23

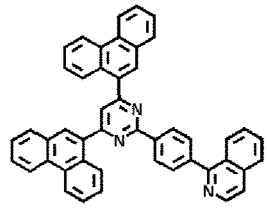
ET24

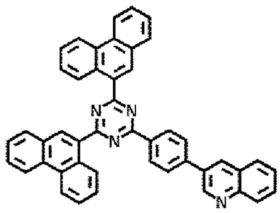
ET25

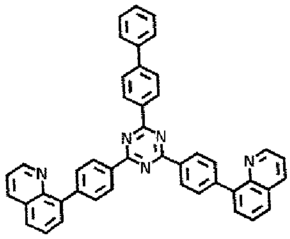
ET26

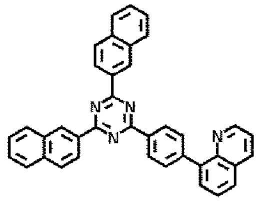
ET27

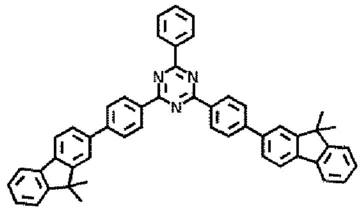
ET28

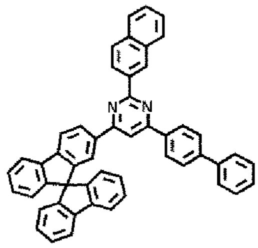
ET29

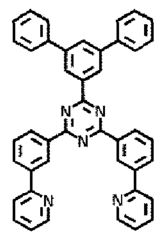
ET30

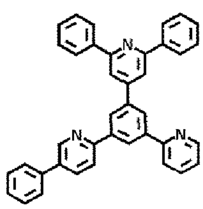
ET31

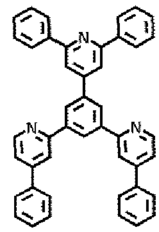
ET32

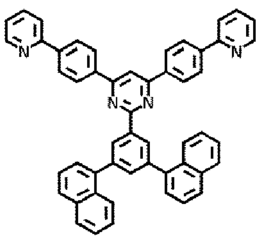
ET33

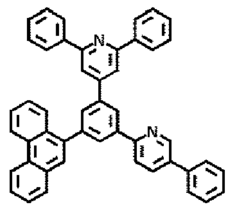
ET34

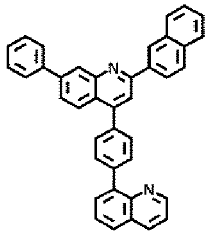
ET35

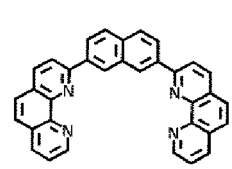
ET36

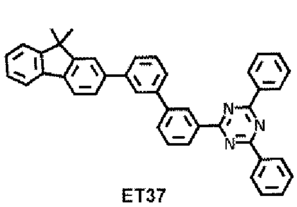
ET37

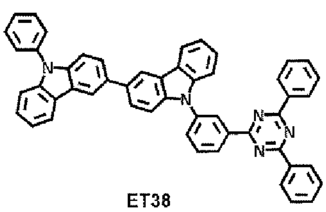
ET38

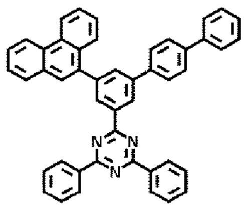
ET39

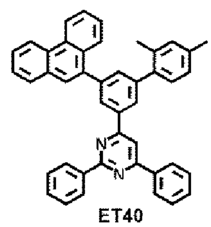
ET40

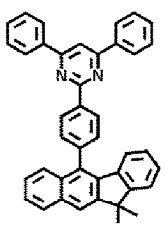
ET41

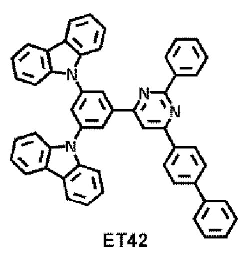
ET42

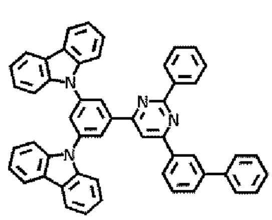
ET43

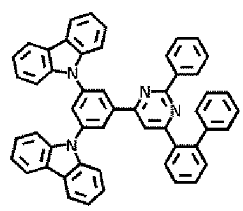
ET44

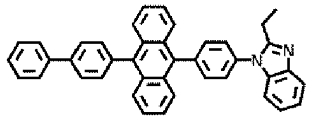

ET45

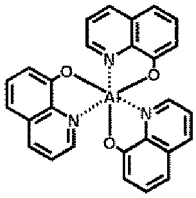

$Alq_3$

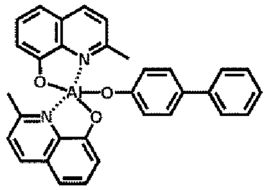

BAlq

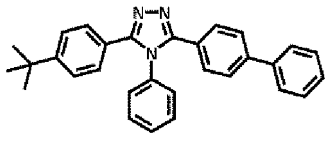

TAZ

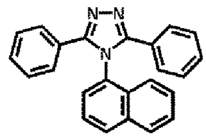

NTAZ

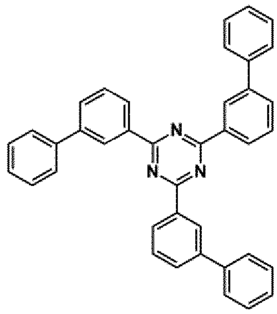

T2T .

A thickness of the electron transport region may be in a range of about 160 Å to about 5,000 Å, for example, about 100 Å to about 4,000 Å or about 100 Å to about 1,000 Å. When the electron transport region includes a buffer layer, a hole blocking layer, an electron control layer, an electron transport layer, or any combination thereof, a thickness of the buffer layer, the hole blocking layer, or the electron control layer may be in a range of about 20 Å to about 1000 Å, for example, about 20 Å to about 700 Å, about 20 Å to about 500 Å, about 20 Å to about 400 Å, about 30 Å to about 400 Å or about 30 Å to about 300 Å, and a thickness of the electron transport layer may be in a range of about 100 Å to about 1000 Å, for example, about 100 Å to about 700 Å, about 100 Å to about 600 Å, about 150 Å to about 600 Å, about 150 Å to about 500 Å or about 200 Å to about 400 Å. When the thicknesses of the buffer layer, hole blocking layer, electron control layer, electron transport layer, and/or electron transport layer are within these ranges, suitable or satisfactory electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, alkaline earth metal complex, or any combination thereof. The metal ion of an alkali metal complex may be a Li ion, a Na ion, a K ion, a Rb ion, or a Cs ion, and the metal ion of alkaline earth metal complex may be a Be ion, a Mg ion, a Ca ion, a Sr ion, or a Ba ion. A ligand coordinated with the metal ion of the alkali metal complex and/or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxydiphenyloxadiazole, a hydroxydiphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

For example, the metal-containing material may include a Li complex. The Li complex may include, for example, Compound ET-D1 (LiQ) or ET-D2:

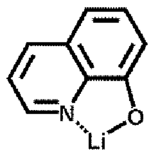 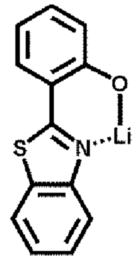

ET-D1 ET-D2 .

The electron transport region may include an electron injection layer that facilitates the injection of electrons from the second electrode 150. The electron injection layer may directly contact (e.g., physically contact) the second electrode 150.

The electron injection layer may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron injection layer may include an alkali metal, alkaline earth metal, a rare earth metal, an alkali metal-containing compound, alkaline earth metal-containing compound, a rare earth metal-containing compound, an alkali metal complex, alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may include oxides, halides (for example, fluorides, chlorides, bromides, or iodides), or tellurides of the alkali metal, the alkaline earth metal, and the rare earth metal, or any combination thereof.

The alkali metal-containing compound may include alkali metal oxides, such as $Li_2O$, $Cs_2O$, and/or $K_2O$, alkali metal halides, such as LiF, NaF, CsF, KF, LiI, NaI, CsI, and/or KI, or any combination thereof. The alkaline earth metal-containing compound may include an alkaline earth metal compound, such as BaO, SrO, CaO, $Ba_xSr_{1-x}O$ (wherein x is a real number satisfying the condition of $0<x<1$), $Ba_xCa_{1-x}O$ (wherein x is a real number satisfying the condition of $0<x<1$), and/or the like. The rare earth metal-containing compound may include $YbF_3$, $ScF_3$, $Sc_2O_3$, $Y_2O_3$, $Ce_2O_3$, $GdF_3$, $TbF_3$, $YbI_3$, $ScI_3$, $TbI_3$, or any combination thereof. In an embodiment, the rare earth metal-containing compound may include a lanthanide metal telluride. Examples of the lanthanide metal telluride include LaTe, CeTe, PrTe, NdTe, PmTe, SmTe, EuTe, GdTe, TbTe, DyTe, HoTe, ErTe, TmTe, YbTe, LuTe, $La_2Te_3$, $Ce_2Te_3$, $Pr_2Te_3$, $Nd_2Te_3$, $Pm_2Te_3$, $Sm_2Te_3$, $Eu_2Te_3$, $Gd_2Te_3$, $Tb_2Te_3$, $Dy_2Te_3$, $Ho_2Te_3$, $Er_2Te_3$, $Tm_2Te_3$, $Yb_2Te_3$, $Lu_2Te_3$, and the like.

The alkali metal complex, the alkaline earth-metal complex, and the rare earth metal complex may include i) one of ions of the alkali metal, the alkaline earth metal, and the rare earth metal and ii), as a ligand bonded to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxydiphenyloxadiazole, hydroxydiphenylthiadiazole, hydroxyphenylpyridine, hydroxyphenyl benzimidazole, hydroxyphenylbenzothiazole, bipyridine, phenanthroline, cyclopentadiene, or any combination thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. For example, the electron injection layer may further include an organic material (for example, a compound represented by Formula 601).

In an embodiment, the electron injection layer may include (e.g., consist of) i) an alkali metal-containing compound (for example, an alkali metal halide), ii) a) an alkali metal-containing compound (for example, an alkali metal halide); and b) an alkali metal, an alkaline earth metal, a rare earth metal, or any combination thereof. In one or more embodiments, the electron injection layer may be a KI:Yb co-deposited layer, an RbI:Yb co-deposited layer, and/or the like.

When the electron injection layer further includes an organic material, alkali metal, alkaline earth metal, rare earth metal, an alkali metal-containing compound, an alkaline earth metal-containing compound, a rare earth metal-containing compound, alkali metal complex, alkaline earth-metal complex, rare earth metal complex, or any combination thereof may be homogeneously or non-homogeneously dispersed in a matrix including the organic material.

A thickness of the electron injection layer may be in a range of about 1 Å to about 100 Å, and, for example, about 3 Å to about 90 Å or about 3 Å to about 20 Å. When the thickness of the electron injection layer is within these ranges, suitable or satisfactory electron injection characteristics may be obtained without a substantial increase in driving voltage.

**Second electrode 150**

The second electrode 150 may be on the interlayer 130 having such a structure. The second electrode 150 may be a cathode, which is an electron injection electrode, and as a material for forming the second electrode 150, a metal, an alloy, an electrically conductive compound, or any combination thereof, each having a low work function, may be used.
The second electrode 150 may include at least one selected from lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.
The second electrode 150 may have a single-layered structure or a multi-layered structure including two or more layers.

**Capping layer**

A first capping layer may be outside the first electrode 110, and/or a second capping layer may be outside the second electrode 150. In more detail, the light-emitting device 10 may have a structure in which the first capping layer, the first electrode 110, the interlayer 130, and the second electrode 150 are sequentially stacked in this stated order, a structure in which the first electrode 110, the interlayer 130, the second electrode 150, and the second capping layer are sequentially stacked in this stated order, or a structure in which the first capping layer, the first electrode 110, the interlayer 130, the second electrode 150, and the second capping layer are sequentially stacked in this stated order.
Light generated in the emission layer of the interlayer 130 of the light-emitting device 10 may be extracted toward the outside through the first electrode 110, which is a semi-transmissive electrode or a transmissive electrode, and the first capping layer or light generated in the emission layer of the interlayer 130 of the light-emitting device 10 may be extracted toward the outside through the second electrode 150, which is a semi-transmissive electrode or a transmissive electrode, and the second capping layer.
The first capping layer and the second capping layer may increase external emission efficiency according to the principle of constructive interference. Accordingly, light extraction efficiency of the light-emitting device 10 may be increased, so that luminescence efficiency of the light-emitting device 10 may be improved.
Each of the first capping layer and second capping layer may include a material having a refractive index (at a wavelength of 589 nm) of equal to greater than 1.6.
The first capping layer and the second capping layer may each independently be an organic capping layer including an organic material, an inorganic capping layer including an inorganic material, or a composite capping layer including an organic material and an inorganic material.
At least one of the first capping layer and the second capping layer may each independently include a carbocyclic compound, a heterocyclic compound, an amine group-containing compound, a porphyrine derivative, a phthalocyanine derivative, a naphthalocyanine derivatives, an alkali metal complex, an alkaline earth-based complex, or any combination thereof. The carbocyclic compound, the heterocyclic compound, and the amine group-containing compound may be optionally substituted with a substituent containing O, N, S, Se, Si, F, Cl, Br, I, or any combination thereof. In an embodiment, at least one selected from the first capping layer and the second capping layer may each independently include an amine group-containing compound.
In one or more embodiments, at least one of the first capping layer and the second capping layer may each independently include a compound represented by Formula 201, a compound represented by Formula 202, or any combination thereof.
In one or more embodiments, at least one of the first capping layer and the second capping layer may each independently include a compound selected from Compounds HT28 to HT33, Compounds CP1 to CP6, β-NPB, or any combination thereof:

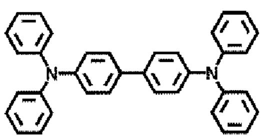
CP1

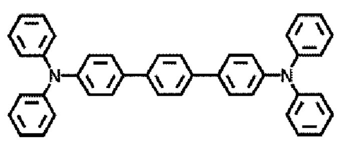
CP2

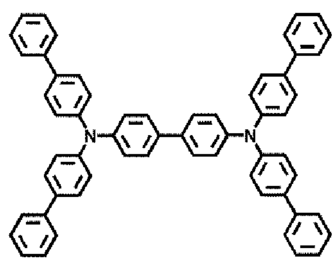
CP3

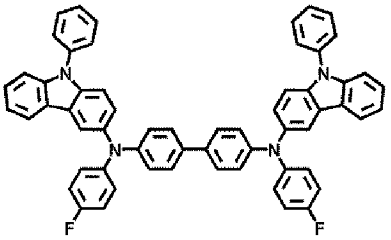

CP4

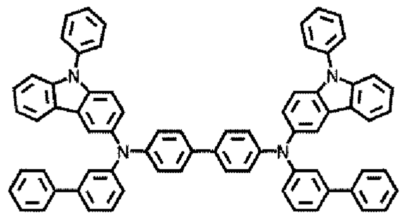

CP5

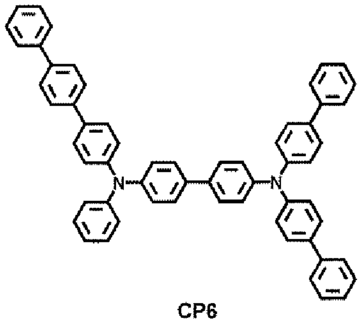

CP6

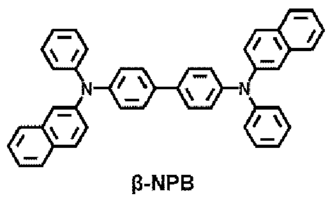

β-NPB

**Electronic apparatus**

The light-emitting device may be included in various suitable electronic apparatuses. For example, the electronic apparatus including the light-emitting device may be a light-emitting apparatus, an authentication apparatus, and/or the like.

The electronic apparatus (for example, a light-emitting apparatus) may further include, in addition to the light-emitting device, i) a color filter, ii) a color conversion layer, or iii) a color filter and a color conversion layer. The color filter and/or the color conversion layer may be in at least one traveling direction of light emitted from the light-emitting device. For example, light emitted from the light-emitting device may be blue light or white light. The light-emitting device may be the same as described elsewhere herein. For example, the color conversion layer may include quantum dots. The quantum dots may be, for example, the same as described elsewhere herein.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be among the subpixel areas to define each of the subpixel areas.

The color filter may further include a plurality of color filter areas and a light-blocking patterns among the color filter areas, and the color conversion layer may include a plurality of color conversion areas and light-blocking patterns among the color conversion areas.

The color filter areas (or the color conversion areas) may include a first area emitting first color light, a second area emitting second color light, and/or a third area emitting third color light, and the first color light, the second color light, and/or the third color light may have different maximum emission wavelengths from one another. For example, the first color light may be red light, the second color light may be green light, and the third color light may be blue light. For example, the color filter areas (or the color conversion areas) may include quantum dots. In more detail, the first area may include red quantum dots, the second area may include green quantum dots, and the third area may not include quantum dots. The quantum dots may be the same as described elsewhere herein. The first area, the second area, and/or the third area may each include a scatterer (e.g., a light scatterer).

For example, the light-emitting device may emit a first light, the first area may absorb the first light to emit a first first-color light, the second area may absorb the first light to emit a second first-color light, and the third area may absorb the first light to emit a third first-color light. Here, the first first-color light, the second first-color light, and the third first-color light may have different maximum emission wavelengths from one another. In more detail, the first light may be blue light, the first first-color light may be red light, the second first-color light may be green light, and the third first-color light may be blue light.

The electronic apparatus may further include a thin-film transistor in addition to the light-emitting device as described above. The thin-film transistor may include a source electrode, a drain electrode, and an activation layer, wherein any one of the source electrode and the drain electrode may be electrically coupled to any one selected from the first electrode and the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

The electronic apparatus may further include a sealing portion for sealing the light-emitting device. The sealing portion and/or the color conversion layer may be between the color filter and the light-emitting device. The sealing portion allows light from the light-emitting device to be extracted to the outside, while concurrently (e.g., simultaneously) preventing or reducing penetration of ambient air and/or moisture into the light-emitting device. The sealing portion may be a sealing substrate including a transparent glass substrate and/or a plastic substrate. The sealing portion may be a thin-film encapsulation layer including at least one layer of an organic layer and/or an inorganic layer. When the sealing portion is a thin-film encapsulation layer, the electronic apparatus may be flexible.

Various suitable functional layers may be additionally on the sealing portion, in addition to the color filter and/or the color conversion layer, according to the use of the electronic apparatus. The functional layers may include a touch screen layer, a polarizing layer, and/or the like. The touch screen layer may be a pressure-sensitive touch screen layer, a capacitive touch screen layer, and/or an infra-red touch screen layer. The authentication apparatus may be, for example, a biometric authentication apparatus that authenticates an individual by using biometric information of a living body (for example, fingertips, pupils, etc.).

The authentication apparatus may further include, in addition to the light-emitting device, a biometric information collector.

The electronic apparatus may be applied to various suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, and/or endoscope displays), fish finders, various suitable measuring instruments, meters (for example, meters for a vehicle, an aircraft, and/or a vessel), projectors, and/or the like.

**Description of FIGS. 2 and 3**

FIG. 2 is a cross-sectional view showing a light-emitting apparatus according to an embodiment of the present disclosure.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, and/or a metal substrate. A buffer layer 210 may be on the substrate 100. The buffer layer 210 may prevent or reduce penetration of impurities through the substrate 100 and may provide a flat surface on the substrate 100.

The TFT may be on the buffer layer 210. The TFT may include an activation layer 220, a gate electrode 240, a source electrode 260, and a drain electrode 270.

The activation layer 220 may include an inorganic semiconductor, such as silicon and/or polysilicon, an organic semiconductor, and/or an oxide semiconductor, and may include a source region, a drain region, and a channel region.

A gate insulating film 230 for insulating the activation layer 220 from the gate electrode 240 may be on the activation layer 220, and the gate electrode 240 may be on the gate insulating film 230.

An interlayer insulating film 250 may be on the gate electrode 240. The interlayer insulating film 250 may be between the gate electrode 240 and the source electrode 260 to insulate the gate electrode 240 from the source electrode 260, and may be between the gate electrode 240 and the drain electrode 270 to insulate the gate electrode 240 from the drain electrode 270.

The source electrode 260 and the drain electrode 270 may be on the interlayer insulating film 250. The interlayer insulating film 250 and the gate insulating film 230 may expose the source region and the drain region of the activation layer 220, and the source electrode 260 and the drain electrode 270 may be in contact (e.g., physical contact) with the exposed portions of the source region and the drain region of the activation layer 220.

The TFT may be electrically coupled to a light-emitting device to drive the light-emitting device, and may be covered by a passivation layer 280. The passivation layer 280 may include an inorganic insulating film, an organic insulating film, or a combination thereof. The light-emitting device may be provided on the passivation layer 280. The light-emitting device may include a first electrode 110, an interlayer 130, and a second electrode 150.

The first electrode 110 may be on the passivation layer 280. The passivation layer 280 may expose a portion of the drain electrode 270 without completely covering the drain electrode 270, and the first electrode 110 may be coupled to the exposed portion of the drain electrode 270.

A pixel defining layer 290 containing an insulating material may be on the first electrode 110. The pixel defining layer 290 exposes a region of the first electrode 110, and an interlayer 130 may be formed in the exposed region of the first electrode 110. The pixel defining layer 290 may be a polyimide organic film and/or a polyacrylic organic film. In some

embodiments, at least some layers of the interlayer 130 may extend beyond the upper portion of the pixel defining layer 290 to be a common layer.

The second electrode 150 may be on the interlayer 130, and a capping layer 170 may be additionally formed on the second electrode 150. The capping layer 170 may cover the second electrode 150.

The encapsulation portion 300 may be on the capping layer 170. The encapsulation portion 300 may be on a light-emitting device to protect the light-emitting device from moisture and/or oxygen. The encapsulation portion 300 may include: an inorganic film including silicon nitride (SiNx), silicon oxide (SiOx), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or any combination thereof; or a combination of the inorganic film and the organic film.

FIG. 3 shows a cross-sectional view showing a light-emitting apparatus according to another embodiment of the present disclosure.

The light-emitting apparatus of FIG. 3 is the same as the light-emitting apparatus of FIG. 2, except that a light-blocking pattern 500 and a functional region 400 are additionally on the encapsulation portion 300. The functional region 400 may include i) a color filter area, ii) a color conversion area, or iii) a combination of the color filter area and the color conversion area. In an embodiment, the light-emitting device included in the light-emitting apparatus of FIG. 3 may be a tandem light-emitting device.

**Manufacture method**

Respective layers included in the hole transport region, the emission layer, and respective layers included in the electron transport region may be formed in a certain region by using one or more suitable methods selected from vacuum deposition, spin coating, casting, Langmuir-Blodgett (LB) deposition, ink-jet printing, laser-printing, and laser-induced thermal imaging.

When respective layers included in the hole transport region, the emission layer, and respective layers included in the electron transport region are formed by vacuum deposition, the deposition conditions may include, for example, a deposition temperature in a range of about 100 °C to about 500 °C, a vacuum degree in a range of about $10^{-8}$ torr to about $10^{-3}$ torr, and a deposition speed in a range of about 0.01 Å /sec to about 100 Å/sec, depending on a material to be included in a layer to be formed and a structure of a layer to be formed.

**Definition of terms**

The term "$C_3$-$C_{60}$ carbocyclic group," as used herein, refers to a cyclic group consisting of carbon only and having three to sixty carbon atoms, and the term "$C_1$-$C_{60}$ heterocyclic group," as used herein, refers to a cyclic group that has 1 to 60 carbon atoms and further has, in addition to carbon, a heteroatom. The $C_3$-$C_{60}$ carbocyclic group and the $C_1$-$C_{60}$ heterocyclic group may each be a monocyclic group consisting of one ring or a polycyclic group in which two or more rings are condensed with each other (e.g., combined together with each other). For example, the number of ring-forming atoms of the $C_1$-$C_{60}$ heterocyclic group may be from 3 to 61.

The term "cyclic group," as used herein, may include both the $C_3$-$C_{60}$ carbocyclic group and the $C_1$-$C_{60}$ heterocyclic group.

The term "$\pi$ electron-rich $C_3$-$C_{60}$ cyclic group," as used herein, refers to a cyclic group that has three to sixty carbon atoms and does not include *-N=*' as a ring-forming moiety, and the term "$\pi$ electron-deficient nitrogen-containing $C_1$-$C_{60}$ cyclic group," as used herein, refers to a heterocyclic group that has 1 to 60 carbon atoms and includes *-N=*' as a ring-forming moiety.

For example,

the $C_3$-$C_{60}$ carbocyclic group may be i) group T1 or ii) a condensed cyclic group in which two or more groups T1 are condensed with (e.g., combined together with) each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),

the $C_1$-$C_{60}$ heterocyclic group may be i) group T2, ii) a condensed cyclic group in which two or more groups T2 are condensed with (e.g., combined together with) each other, or iii) a condensed cyclic group in which at least one group T2 and at least one group T1 are condensed with (e.g., combined together with) each other (for example, a pyrrole

group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),

the π electron-rich $C_3$-$C_{60}$ cyclic group may be i) group T1 , ii) a condensed cyclic group in which two or more groups T1 are condensed with (e.g., combined together with) each other, iii) group T3, iv) a condensed cyclic group in which two or more groups T3 are condensed with (e.g., combined together with) each other, or v) a condensed cyclic group in which at least one group T3 and at least one group T1 are condensed with (e.g., combined together with) each other (for example, the $C_3$-$C_{60}$ carbocyclic group, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),

the π electron-deficient nitrogen-containing $C_1$-$C_{60}$ cyclic group may be i) group T4, ii) a condensed cyclic group in which two or more group T4 are condensed with (e.g., combined together with) each other, iii) a condensed cyclic group in which at least one group T4 and at least one group T1 are condensed with (e.g., combined together with) each other, iv) a condensed cyclic group in which at least one group T4 and at least one group T3 are condensed with (e.g., combined together with) each other, or v) a condensed cyclic group in which at least one group T4, at least one group T1, and at least one group T3 are condensed with (e.g., combined together with) one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),

group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1 .1 .1]pentane group, a bicyclo[2.1.1]hexane group, a bicyclo[2.2.2]octane group, or a benzene group,

group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group,

group T3 may be a furan group, a thiophene group, a 1H-pyrrole group, a silole group, or a borole group, and

group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group," "the $C_3$-$C_{60}$ carbocyclic group," "the $C_1$-$C_{60}$ heterocyclic group," "the π electron-rich

$C_3$-$C_{60}$ cyclic group," or "the π electron-deficient nitrogen-containing $C_1$-$C_{60}$ cyclic group," as used herein, refer to a group condensed to any cyclic group or a polyvalent group (for example, a divalent group, a trivalent group, a tetravalent group, etc.), depending on the structure of a formula in connection with which the terms are used. For example, "a benzene group" may be a benzo group, a phenyl group, a phenylene group, and/or the like, which may be easily understand by one of ordinary skill in the art according to the structure of a formula including the "benzene group."

Examples of the monovalent $C_3$-$C_{60}$ carbocyclic group and the monovalent $C_1$-$C_{60}$ heterocyclic group include a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group, and examples of the divalent $C_3$-$C_{60}$ carbocyclic group and the monovalent $C_1$-$C_{60}$ heterocyclic group include a $C_3$-$C_{10}$ cycloalkylene group, a $C_1$-$C_{10}$ heterocycloalkylene group, a $C_3$-$C_{10}$ cycloalkenylene group, a $C_1$-$C_{10}$ heterocycloalkenylene group, a $C_6$-$C_{60}$ arylene group, a $C_1$-$C_{60}$ heteroarylene group, a divalent non-aromatic condensed polycyclic group, and a substituted or unsubstituted divalent non-aromatic condensed heteropolycyclic group.

The term "$C_1$-$C_{60}$ alkyl group," as used herein, refers to a linear or branched aliphatic hydrocarbon monovalent group that has one to sixty carbon atoms, and examples thereof include a methyl group, an ethyl group, an n-propyl group, an isopropyl group, an n-butyl group, a sec-butyl group, an isobutyl group, a tert-butyl group, an n-pentyl group, a tert-pentyl group, neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, and the like. The term "$C_1$-$C_{60}$ alkylene group," as used herein, refers to a divalent group having substantially the same structure as the $C_1$-$C_{60}$ alkyl group. Corresponding definitions apply to other ranges given for the number of carbon atoms in an alkyl/alkylene group.

The term "$C_2$-$C_{60}$ alkenyl group," as used herein, refers to a monovalent hydrocarbon group having at least one carbon-carbon double bond at a main chain (e.g., in the middle) or at a terminal end (e.g., the terminus) of the $C_2$-$C_{60}$ alkyl group, and examples thereof include an ethenyl group, a propenyl group, a butenyl group, and the like. The term "$C_2$-$C_{60}$ alkenylene group," as used herein, refers to a divalent group having substantially the same structure as the $C_2$-$C_{60}$ alkenyl group. Corresponding definitions apply to other ranges given for the number of carbon atoms in an alkenyl/alkenylene group.

The term "$C_2$-$C_{60}$ alkynyl group," as used herein, refers to a monovalent hydrocarbon group having at least one carbon-carbon triple bond at a main chain (e.g., in the middle) or at a terminal end (e.g., the terminus) of the $C_2$-$C_{60}$ alkyl group, and examples thereof include an ethynyl group, a propynyl group, and the like. The term "$C_1$-$C_{60}$ alkynylene group," as used herein, refers to a divalent group having substantially the same structure as the $C_1$-$C_{60}$ alkynyl group. Corresponding definitions apply to other ranges given for the number of carbon atoms in an alkynyl/alkynylene group.

The term "$C_1$-$C_{60}$ alkoxy group," as used herein, refers to a monovalent group represented by $-OA_{101}$ (wherein $A_{101}$ is the $C_1$-$C_{60}$ alkyl group), and examples thereof include a methoxy group, an ethoxy group, an isopropyloxy group, and the like. Corresponding definitions apply to other ranges given for the number of carbon atoms in an alkoxy group.

The term "$C_3$-$C_{10}$ cycloalkyl group," as used herein, refers to a monovalent saturated hydrocarbon cyclic group having 3 to 10 carbon atoms, and examples thereof include a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and the like. The term "$C_3$-$C_{10}$ cycloalkylene group," as used herein, refers to a divalent group having substantially the same structure as the $C_3$-$C_{10}$ cycloalkyl group.

The term "$C_1$-$C_{10}$ heterocycloalkyl group," as used herein, refers to a monovalent cyclic group that further includes, in addition to a carbon atom, at least one heteroatom as a ring-forming atom and has 1 to 10 carbon atoms, and examples thereof include a 1,2,3,4-oxatriazolidinyl group, a tetrahydrofuranyl group, a tetrahydrothienyl group, and the like. The term "$C_1$-$C_{10}$ heterocycloalkylene group," as used herein, refers to a divalent group having substantially the same structure as the $C_1$-$C_{10}$ heterocycloalkyl group.

The term "$C_3$-$C_{10}$ cycloalkenyl group," as used herein, refers to a monovalent cyclic group that has 3 to 10 carbon atoms and at least one carbon-carbon double bond in the ring thereof and no aromaticity (e.g., is not aromatic), and examples thereof include a cyclopentenyl group, a cyclohexenyl group, a cycloheptenyl group, and the like. The term "$C_3$-$C_{10}$ cycloalkenylene group," as used herein, refers to a divalent group having substantially the same structure as the $C_3$-$C_{10}$ cycloalkenyl group.

The term "$C_1$-$C_{10}$ heterocycloalkenyl group," as used herein, refers to a monovalent cyclic group that has, in addition to a carbon atom, at least one heteroatom as a ring-forming atom, 1 to 10 carbon atoms, and at least one carbon-carbon double bond in the cyclic structure thereof. Examples of the $C_1$-$C_{10}$ heterocycloalkenyl group include a 4,5-dihydro-1,2,3,4-oxatriazolyl group, a 2,3-dihydrofuranyl group, a 2,3-dihydrothienyl group, and the like. The term "$C_1$-$C_{10}$ heterocycloalkenylene group" as used herein refers to a divalent group having substantially the same structure as the

$C_1$-$C_{10}$ heterocycloalkenyl group.

The term "$C_6$-$C_{60}$ aryl group," as used herein, refers to a monovalent group having a carbocyclic aromatic system having 6 to 60 carbon atoms, and the term "$C_6$-$C_{60}$ arylene group," as used herein, refers to a divalent group having a carbocyclic aromatic system having 6 to 60 carbon atoms. Examples of the $C_6$-$C_{60}$ aryl group include a fluorenyl group, a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, and the like. When the $C_6$-$C_{60}$ aryl group and the $C_6$-$C_{60}$ arylene group each include two or more rings, the two or more rings may be condensed with each other (e.g., combined together with each other). Corresponding definitions apply to other ranges given for the number of carbon atoms in an aryl/arylene group.

The term "$C_1$-$C_{60}$ heteroaryl group," as used herein, refers to a monovalent group having a heterocyclic aromatic system that has, in addition to a carbon atom, at least one heteroatom as a ring-forming atom, and 1 to 60 carbon atoms. The term "$C_1$-$C_{60}$ heteroarylene group," as used herein, refers to a divalent group having a heterocyclic aromatic system that has, in addition to a carbon atom, at least one heteroatom as a ring-forming atom, and 1 to 60 carbon atoms. Examples of the $C_1$-$C_{60}$ heteroaryl group include a carbazolyl group, a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, a naphthyridinyl group, and the like. When the $C_1$-$C_{60}$ heteroaryl group and the $C_1$-$C_{60}$ heteroarylene group each include two or more rings, the two or more rings may be condensed with each other (e.g., combined together with each other). Corresponding definitions apply to other ranges given for the number of carbon atoms in an heteroaryl/heteroarylene group.

The term "monovalent non-aromatic condensed polycyclic group," as used herein, refers to a monovalent group (for example, having 8 to 60 carbon atoms) having two or more rings condensed to each other (e.g., combined together with each other), only carbon atoms as ring-forming atoms, and no aromaticity in its entire molecular structure (e.g., is not aromatic when considered as a whole). Examples of the monovalent non-aromatic condensed polycyclic group include an indenyl group, a fluorenyl group, a spiro-bifluorenyl group, a benzofluorenyl group, an indenophenanthrenyl group, an indenoanthracenyl group, and the like. The term "divalent non-aromatic condensed polycyclic group," as used herein, refers to a divalent group having substantially the same structure as a monovalent non-aromatic condensed polycyclic group.

The term "monovalent non-aromatic condensed heteropolycyclic group," as used herein, refers to a monovalent group (for example, having 1 to 60 carbon atoms) having two or more rings condensed to each other (e.g., combined together with each other), at least one heteroatom other than carbon atoms, as a ring-forming atom, and no aromaticity in its entire molecular structure (e.g., is not aromatic when considered as a whole). Examples of the monovalent non-aromatic condensed heteropolycyclic group include a pyrrolyl group, a thienyl group, a furanyl group, an indolyl group, a benzoindolyl group, a naphthoindolyl group, an isoindolyl group, a benzoisoindolyl group, a naphthoisoindolyl group, a benzosilolyl group, a benzothienyl group, a benzofuranyl group, a carbazolyl group, a dibenzosilolyl group, a dibenzothienyl group, a dibenzofuranyl group, an azacarbazolyl group, an azafluorenyl group, an azadibenzosilolyl group, an azadibenzothienyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothienyl group, a benzonaphthosilolyl group, a benzofurodibenzofuranyl group, a benzofurodibenzothienyl group, a benzothienodibenzothienyl group, and the like. The term "divalent non-aromatic heterocondensed polycyclic group," as used herein, refers to a divalent group having the same structure as a monovalent non-aromatic heterocondensed polycyclic group.

The term "$C_6$-$C_{60}$ aryloxy group," as used herein, indicates $-OA_{102}$ (wherein $A_{102}$ is the $C_6$-$C_{60}$ aryl group), and the term "$C_6$-$C_{60}$ arylthio group," as used herein, indicates $-SA_{103}$ (wherein $A_{103}$ is the $C_6$-$C_{60}$ aryl group). Corresponding definitions apply to other ranges given for the number of carbon atoms in an aryloxy group and an arylthio group.

The term "$R_{10a}$," as used herein, refers to:

deuterium, -F, -Cl, -Br, -I, a hydroxyl group, a cyano group, or a nitro group,

a $C_1$-$C_{60}$ *(e.g.* $C_1$-$C_{20}$) alkyl group, a $C_2$-$C_{60}$ *(e.g.* $C_2$-$C_{20}$) alkenyl group, a $C_2$-$C_{60}$ *(e.g.* $C_2$-$C_{20}$) alkynyl group, or a $C_1$-$C_{60}$ *(e.g.* $C_1$-$C_{20}$) alkoxy group, each unsubstituted or substituted with deuterium, -F, -Cl, -Br, -I, a hydroxyl group, a cyano group, a nitro group, a $C_3$-$C_{60}$ (*e.g.* $C_3$-$C_{30}$) carbocyclic group, a $C_1$-$C_{60}$ *(e.g.* $C_1$-$C_{20}$) heterocyclic group, a $C_6$-$C_{60}$ (*e.g.* $C_6$-$C_{30}$) aryloxy group, a $C_6$-$C_{60}$ *(e.g.* $C_6$-$C_{30}$) arylthio group, $-Si(Q_{11})(Q_{12})(Q_{13})$, $-N(Q_{11})(Q_{12})$, $-B(Q_{11})$

$(Q_{12})$, -C(=O)$(Q_{11})$, -S(=O)2$(Q_{11})$, - P(=O)$(Q_{11})(Q_{12})$, or any combination thereof,

a $C_3$-$C_{60}$ (*e.g.* $C_3$-$C_{30}$) carbocyclic group, a $C_1$-$C_{60}$ (*e.g.* $C_1$-$C_{20}$) heterocyclic group, a $C_6$-$C_{60}$ (*e.g.* $C_6$-$C_{30}$) aryloxy group, or a $C_6$-$C_{60}$ (*e.g.* $C_6$-$C_{30}$) arylthio group, each unsubstituted or substituted with deuterium, -F, -Cl, -Br, -I, a hydroxyl group, a cyano group, a nitro group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, a $C_1$-$C_{60}$ (*e.g.* $C_1$-$C_{20}$) alkoxy group, a $C_3$-$C_{60}$ (*e.g.* $C_3$-$C_{30}$) carbocyclic group, a $C_1$-$C_{60}$ (*e.g.* $C_1$-$C_{20}$) heterocyclic group, a $C_6$-$C_{60}$ (*e.g.* $C_6$-$C_{30}$) aryloxy group, a $C_6$-$C_{60}$ (*e.g.* $C_6$-$C_{30}$) arylthio group, -Si$(Q_{21})(Q_{22})(Q_{23})$, -N$(Q_{21})(Q_{22})$, -B$(Q_{21})(Q_{22})$, -C(=O)$(Q_{21})$, -S$(=O)_2(Q_{21})$, - P(=O)$(Q_{21})(Q_{22})$, or any combination thereof, or

-Si$(Q_{31})(Q_{32})(Q_{33})$, -N$(Q_{31})(Q_{32})$, -B$(Q_{31})(Q_{32})$, -C(=O)$(Q_{31})$, -S$(=O)_2(Q_{31})$, or - P(=O)$(QQ_{31})(Q_{32})$.

In the present specification, $Q_1$ to $Q_3$, $Q_{11}$ to $Q_{13}$, $Q_{21}$ to $Q_{23}$, and $Q_{31}$ to $Q_{33}$ may each independently be: hydrogen; deuterium; -F; -Cl; -Br; -I; a hydroxyl group; a cyano group; a nitro group; $C_1$-$C_{60}$ (*e.g.* $C_1$-$C_{20}$) alkyl group; $C_2$-$C_{60}$ (*e.g.* $C_2$-$C_{20}$) alkenyl group; $C_2$-$C_{60}$ (*e.g.* $C_2$-$C_{20}$) alkynyl group; $C_1$-$C_{60}$ (*e.g.* $C_1$-$C_{20}$) alkoxy group; or a $C_3$-$C_{60}$ (*e.g.* $C_3$-$C_{30}$) carbocyclic group or a $C_1$-$C_{60}$ (*e.g.* $C_1$-$C_{20}$) heterocyclic group, each unsubstituted or substituted with deuterium, -F, a cyano group, a $C_1$-$C_{60}$ (*e.g.* $C_1$-$C_{20}$) alkyl group, a $C_1$-$C_{60}$ (e.g. $C_1$-$C_{20}$) alkoxy group, a phenyl group, a biphenyl group, or any combination thereof.

The term "heteroatom," as used herein, refers to any atom other than a carbon atom. Examples of the heteroatom are O, S, N, P, Si, B, Ge, Se, or any combination thereof.

The term "Ph," as used herein, refers to a phenyl group, the term "Me," as used herein, refers to a methyl group, the term "Et," as used herein, refers to an ethyl group, the term "ter-Bu" or "$Bu^t$," as used herein, refers to a tert-butyl group, and the term "OMe," as used herein, refers to a methoxy group.

The term "biphenyl group," as used herein, refers to "a phenyl group substituted with a phenyl group." In other words, the "biphenyl group" is a substituted phenyl group having a $C_6$-$C_{60}$ aryl group as a substituent.

The term "terphenyl group," as used herein, refers to "a phenyl group substituted with a biphenyl group." In other words, the "terphenyl group" is a substituted phenyl group having, as a substituent, a $C_6$-$C_{60}$ aryl group substituted with a $C_6$-$C_{60}$ aryl group.

**[0240]** * and *', as used herein, unless defined otherwise, each refer to a binding site to a neighboring atom in a corresponding formula.

Hereinafter, a light-emitting device according to embodiments will be described in more detail with reference to Examples.

## Examples

### Comparative Example 1

As an anode, an ITO substrate was cut to a size of 50 mm x 50 mm x 0.5 mm, sonicated with isopropyl alcohol and pure water each for 10 minutes, and then cleaned by exposure to ultraviolet rays and ozone for 10 minutes. Then, the ITO substrate was provided to a vacuum deposition apparatus.

HAT-CN was deposited on the ITO substrate to form a hole injection layer having a thickness of 100 Å. Then, NPB was vacuum-deposited on the hole injection layer to form a hole transport layer having a thickness of 1,000 Å, Compound HT18 was deposited on the hole transport layer to form an electron blocking layer having a thickness of 100 Å, and Compound A1 (host) and Compound DOPANT 1 (dopant) were co-deposited at a weight ratio of 97:3 on the electron blocking layer to form an emission layer having a thickness of 200 Å.

T2T was deposited on the emission layer to form a hole blocking layer having a thickness of 50 Å. TPBi and LiQ were deposited at a weight ratio of 1:1 on the hole blocking layer to form an electron transport layer having a thickness of 310 Å.

Yb was deposited on the electron transport layer to form an electron injection layer having a thickness of 10 Å, Ag and Mg were co-deposited at a weight ratio of 9:1 on the electron injection layer to form a cathode having a thickness of 1,000 Å, and Compound HT28 was deposited on the cathode to form a capping layer having a thickness of 600 Å, thereby completing the manufacture of a light-emitting device.

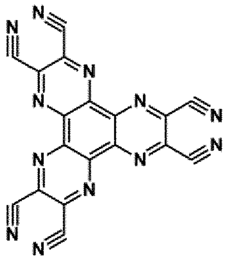

HAT-CN

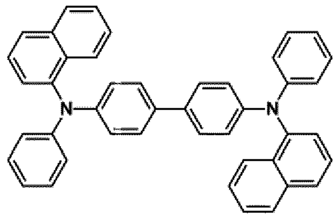

NPB

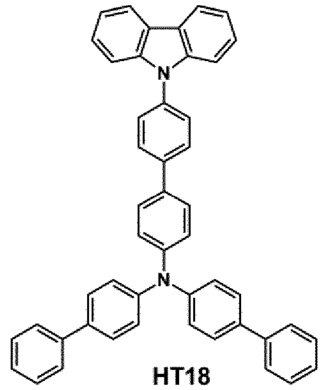

HT18

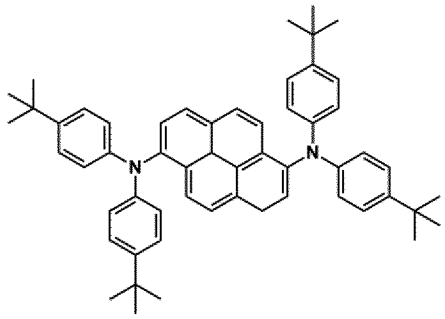

DOPANT 1

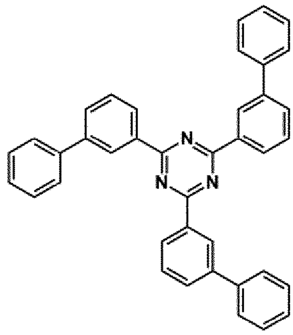

T2T

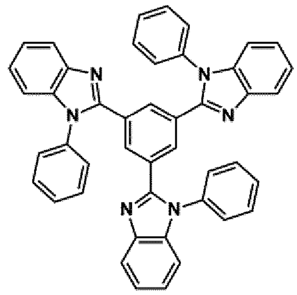

TPBi

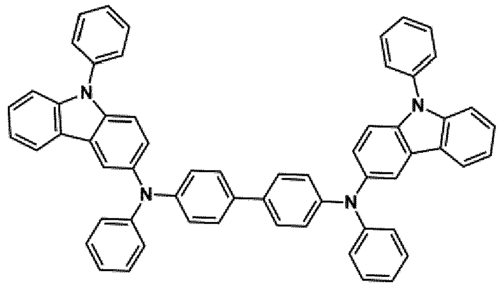

HT28

**Examples 1 to 12 and Comparative Examples 2 to 7**

Light-emitting devices were manufactured in substantially the same manner as in Comparative Example 1, except that compounds listed in Table 1 were used instead of the host and the dopant included in the emission layer and TPBi included in the electron transport layer, respectively.

**Evaluation Example 1**

To evaluate characteristics of the light-emitting devices manufactured according to Examples 1 to 12 and Comparative Examples 1 to 7, the driving voltage at the current density of 10 $mA/cm^2$ and luminescence efficiency thereof were measured. The driving voltage of the light-emitting device was measured using a source meter (manufactured by Keithley Instrument Company, 2400 series), and the lifespan was obtained by measuring the time (T) to become 97% of initial luminance at the same current density. Evaluation results of the characteristics of the light-emitting devices are shown in Table 1.

Table 1

| | Host | Dopant | Electron transport layer | Driving voltage (V) | Efficiency (cd/A) | Lifespan $T_{97}$ (h) |
|---|---|---|---|---|---|---|
| Comparative Example 1 | A1 | DOPANT 1 | TPBi | 4.6 | 3.9 | 89 |
| Comparative Example 2 | B1 | DOPANT 1 | TPBi | 4.5 | 4.0 | 95 |
| Comparative Example 3 | A1 | DOPANT 1 | 2-1 | 4.2 | 4.6 | 91 |
| Comparative Example 4 | B1 | DOPANT 1 | 2-1 | 4.2 | 4.5 | 90 |
| Comparative Example 5 | A1 | DOPANT 2 | 2-5 | 3.6 | 7.1 | 123 |
| Comparative Example 6 | B1 | DOPANT 2 | 2-5 | 3.7 | 7.3 | 132 |
| Comparative Example 7 | A1 | DOPANT 1 | C1 | 4.3 | 4.4 | 87 |
| Experimental Example 1 | 1-1 | DOPANT 1 | 2-1 | 4.2 | 4.7 | 102 |
| Experimental Example 2 | 1-2 | DOPANT 1 | 2-1 | 4.1 | 4.8 | 120 |
| Experimental Example 3 | 1-3 | DOPANT 1 | 2-1 | 4.2 | 4.8 | 119 |
| Experimental Example 4 | 1-5 | DOPANT 1 | 2-1 | 4.2 | 4.6 | 105 |
| Experimental Example 5 | 1-6 | DOPANT 1 | 2-1 | 4.2 | 4.5 | 116 |
| Experimental Example 6 | 1-7 | DOPANT 1 | 2-1 | 4.2 | 4.7 | 113 |
| Experimental Example 7 | 1-1 | DOPANT 2 | 2-5 | 3.5 | 7.0 | 156 |
| Experimental Example 8 | 1-2 | DOPANT 2 | 2-5 | 3.6 | 7.3 | 178 |
| Experimental Example 9 | 1-3 | DOPANT 2 | 2-5 | 3.6 | 7.2 | 175 |
| Experimental Example 10 | 1-5 | DOPANT 2 | 2-5 | 3.6 | 7.4 | 145 |
| Experimental Example 11 | 1-6 | DOPANT 2 | 2-5 | 3.7 | 7.3 | 179 |
| Experimental Example 12 | 1-7 | DOPANT 2 | 2-5 | 3.6 | 7.5 | 185 |

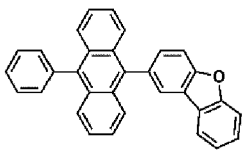

A1

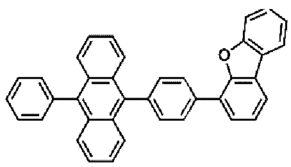

B1

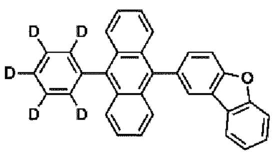

1-1

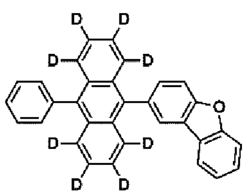

1-2

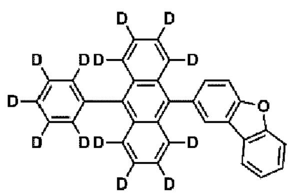

1-3

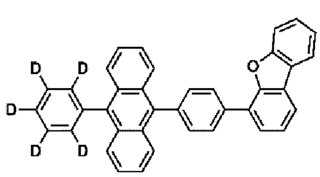

1-5

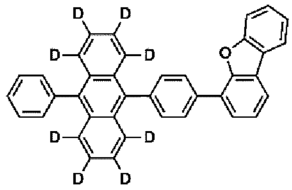

1-6

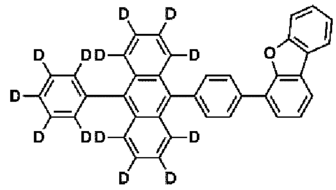

1-7

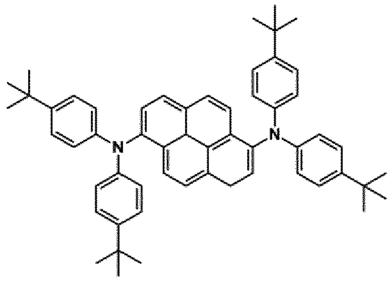

DOPANT 1

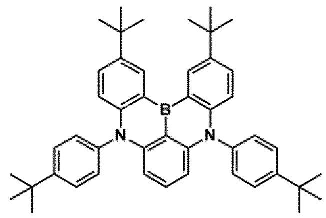

DOPANT 2

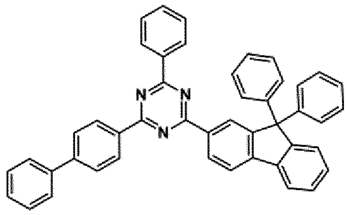

2-1

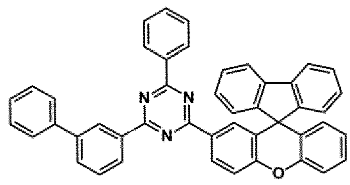

2-5

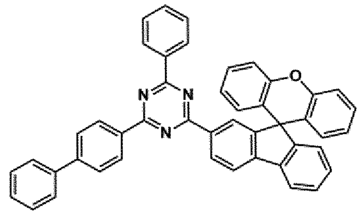

C1

Referring to Table 1, it can be seen that the light-emitting devices of Examples 1 to 12 had a low driving voltage, excellent luminescence efficiency, and a long lifespan, compared to the light-emitting device of Comparative Examples 1 to 7.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the following claims.

## Claims

**1.** A light-emitting device comprising:

a first electrode (110);
a second electrode (150) facing the first electrode;
an interlayer (130) between the first electrode and the second electrode and comprising an emission layer;
**characterised in that** the interlayer (130) further comprises at least one first compound represented by Formula 1; and
at least one second compound represented by Formula 2:

Formula 1

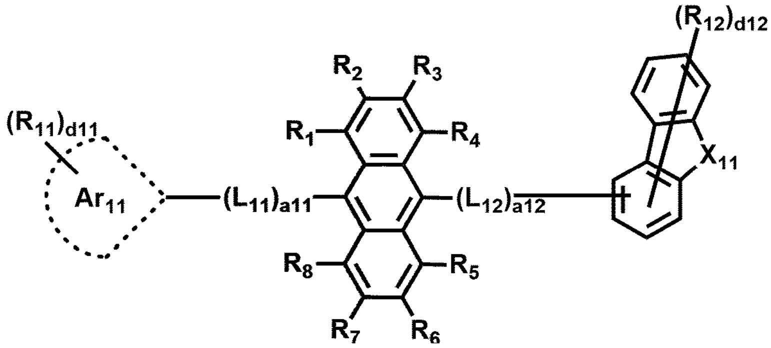

Formula 2

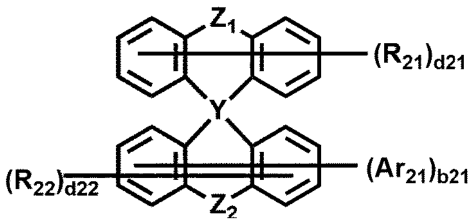

Formula 3

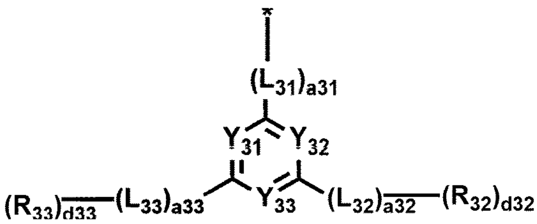

wherein, in Formulae 1, 2, and 3,

$X_{11}$ is O, S, $N(R_{11a})$, or $C(R_{11a})(R_{11b})$,

$Ar_{11}$ is a $C_5$-$C_{60}$ carbocyclic group or a $C_1$-$C_{60}$ heterocyclic group, $L_{11}$, $L_{12}$, and $L_{31}$ to $L_{33}$ are each independently a single bond, a $C_5$-$C_{60}$ carbocyclic group unsubstituted or substituted with at least one $R_{10a}$, or a $C_1$-$C_{60}$ heterocyclic group unsubstituted or substituted with at least one $R_{10a}$,

a11, a12, and a31 to a33 are each independently an integer from 1 to 3,

Y is C or Si,

$Z_1$ is no bond, a single bond, O, S, $N(R_{21a})$, or $C(R_{21a})(R_{21b})$,

$Z_2$ is no bond, a single bond, O, S, $N(R_{22a})$, or $C(R_{22a})(R_{22b})$,

wherein when $Z_1$ is O or S, $Z_2$ is not a single bond,

$Ar_{21}$ is a group represented by Formula 3,

b21 is an integer from 1 to 10,

$Y_{31}$ **is** N **or** $C(R_{31a})$,

$Y_{32}$ is N or $C(R_{32a})$,

$Y_{33}$ **is** N **or** $C(R_{33a})$,

* in Formula 3 indicates a binding site to a neighboring atom,

$R_1$ **to** $R_8$, $R_{11}$, $R_{11a}$, $R_{11b}$, $R_{12}$, $R_{21}$, $R_{21a}$, $R_{21b}$, $R_{22}$, $R_{22a}$, $R_{22b}$, $R_{32}$, $R_{33}$, $R_{31a}$, $R_{32a}$, and $R_{33a}$ are each independently hydrogen, deuterium, -F, -Cl, -Br, -I, a hydroxyl group, a cyano group, a nitro group, an amidino group, a hydrazino group, a hydrazono group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least **one** $R_{10a}$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, **or** - $P(=O)(Q_1)(Q_2)$,

d11 is an integer from 1 to 10,

d12 is an integer from 1 to 7,
d21 is an integer from 1 to 10,
d22 is an integer from 1 to 9,
d32 is 1,
d33 is 1,
the at least one first compound comprises at least one deuterium, and
$R_{10a}$ is:

deuterium, -F, -Cl, -Br, -I, a hydroxyl group, a cyano group, or a nitro group,
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, -Si($Q_{11}$)($Q_{12}$)($Q_{13}$), - N($Q_{11}$)($Q_{12}$), -B($Q_{11}$)($Q_{12}$), -C(=O)($Q_{11}$), -S(=O)$_2$($Q_{11}$), -P(=O)($Q_{11}$)($Q_{12}$), or any combination thereof,
a $C_3$-$C_{60}$ carbocyclic group, a $C_1$-$C_{60}$ heterocyclic group, a $C_6$-$C_{60}$ aryloxy group, or a $C_6$-$C_{60}$ arylthio group, unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, -Si($Q_{21}$)($Q_{22}$)($Q_{23}$), -N($Q_{21}$)($Q_{22}$), -B($Q_{21}$)($Q_{22}$), -C(=O)($Q_{21}$), -S(=O)$_2$($Q_{21}$), - P(=O)($Q_{21}$)($Q_{22}$), or any combination thereof, or
-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), or - P(=O)($Q_{31}$)($Q_{32}$), and
wherein $Q_1$ to $Q_3$, $Q_{11}$ to $Q_{13}$, $Q_{21}$ to $Q_{23}$, and $Q_{31}$ to $Q_{33}$ are each independently: hydrogen; deuterium; -F; -Cl; -Br; -I; a hydroxyl group; a cyano group; a nitro group; a $C_1$-$C_{60}$ alkyl group; a $C_2$-$C_{60}$ alkenyl group; a $C_2$-$C_{60}$ alkynyl group; a $C_1$-$C_{60}$ alkoxy group; or a $C_3$-$C_{60}$ carbocyclic group or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof.

2. The light-emitting device of claim 1, wherein the emission layer comprises the at least one first compound.

3. The light-emitting device of claim 1 or claim 2, wherein the first electrode is an anode,

the second electrode is a cathode,
the interlayer further comprises a hole transport region between the emission layer and the first electrode,
the interlayer further comprises an electron transport region between the emission layer and the second electrode,
the hole transport region comprises a hole injection layer, a hole transport layer, an emission auxiliary layer, an electron blocking layer, or any combination thereof, and
the electron transport region comprises a buffer layer, a hole blocking layer, an electron transport layer, an electron control layer, an electron injection layer, or any combination thereof.

4. The light-emitting device of claim 3, wherein the electron transport region comprises the at least one second compound.

5. The light-emitting device of any one of claims 2 to 4, wherein the emission layer further comprises a third compound, and

the third compound is a fluorescent compound or a thermally activated delayed fluorescence compound satisfying Equation 1:

Equation 1

$$\triangle E_{ST} = S1 - T1 \leq 0.3\ eV$$

wherein, in Equation 1, S1 is a lowest excited singlet energy level (eV) of the thermally activated delayed fluorescence compound, and T1 is a lowest excited triplet energy level (eV) of the TADF compound.

6. The organic light-emitting device of claim 4 or claim 5, further comprising a capping layer outside the second electrode and having a refractive index at a wavelength of 589 nm of equal to or greater than 1.6.

7. The light-emitting device of any one of claims 2 to 6, wherein the emission layer further comprises a third compound, and
the third compound comprises at least one of the compounds represented by Formulae 4-1 to 4-9:

Formula 4-1

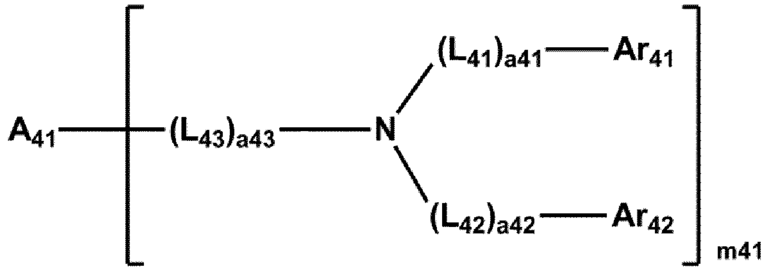

Formula 4-2

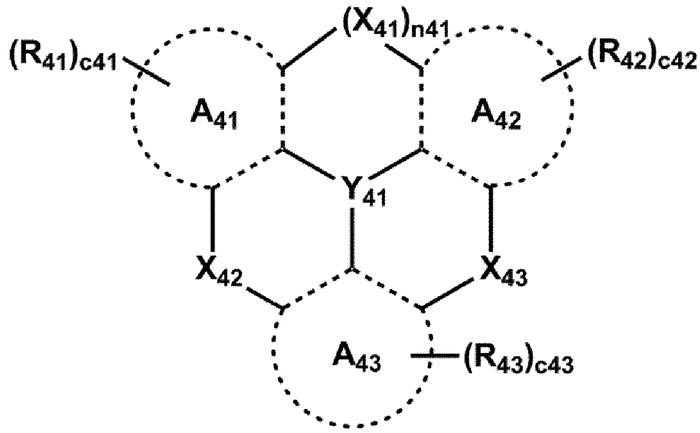

Formula 4-3

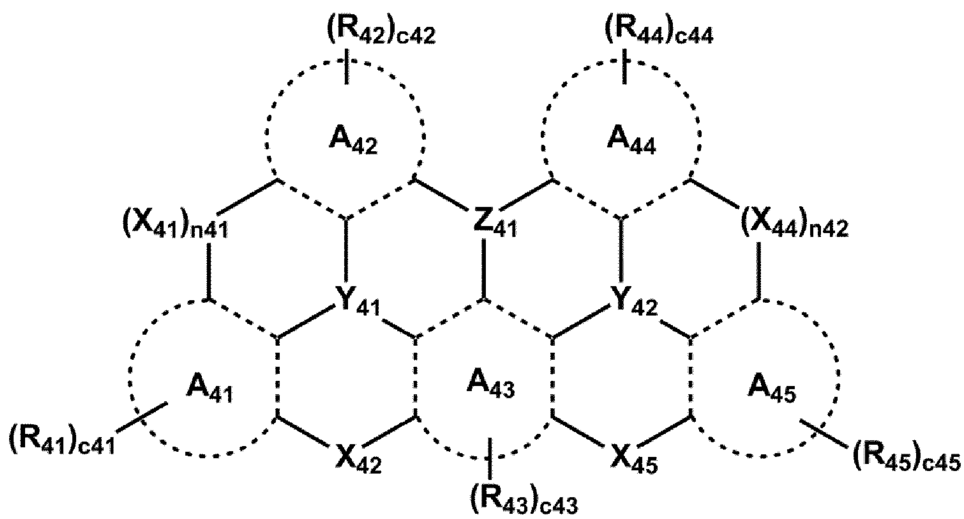

Formula 4-4

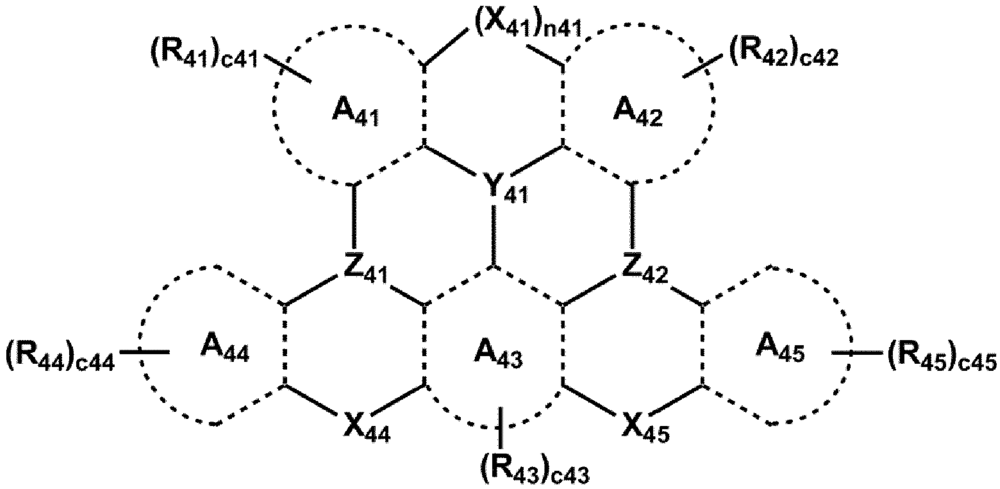

Formula 4-5 $(EDG)_{b41}-[(L_{44})_{a44}-(EWG)_{t42}]_{s41}$

Formula 4-6 $(EWG)_{t42}-[(L_{44})_{a44}-(EDG)_{b41}]_{s42}$

Formula 4-7 $(EDG)_{b411}-(L_{44})_{a44}-(EWG)_{t42}-(L_{45})_{a45}-(EDG)_{b412}$

Formula 4-8 $(EWG)_{t421}-(L_{44})_{a44}-(EDG)_{b41}-(L_{45})_{a45}-(EWG)_{t422}$

Formula 4-9 $A_{41}-[(L_{44})_{a44}-(EDG)_{b41}]_{s43}$

wherein, in Formula 4-1,
$A_{41}$ is a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$L_{41}$ to $L_{43}$ are each independently a single bond, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
a41 to a43 are each independently an integer from 1 to 3,
$Ar_{41}$ and $Ar_{42}$ are each independently a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, or a $C_6$-$C_{60}$ aryloxy group unsubstituted or substituted with at least one $R_{10a}$, and
m41 is an integer from 1 to 6,
in Formulae 4-2 to 4-4,
$X_{41}$ to $X_{45}$ are each independently a single bond, O, S, $N(R_{46})$, $B(R_{46})$, $C(R_{46})(R_{47})$, or $Si(R_{46})(R_{47})$,
n41 and n42 are each independently 0, 1, or 2, wherein, when n41 is 0, $A_{41}$ and $A_{42}$ are not linked to each other, and when n42 is 0, $A_{44}$ and $A_{45}$ are not linked to each other,
$Y_{41}$ and $Y_{42}$ are each independently N, B, or P,
$Z_{41}$ and $Z_{42}$ are each independently N, $C(R_{48})$, or $Si(R_{48})$,
$A_{41}$ to $A_{45}$ are each independently selected from a $C_3$-$C_{30}$ carbocyclic group and a $C_1$-$C_{30}$ heterocyclic group,
$R_{41}$ to $R_{48}$ are each independently hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$, and
c41 to c45 are each independently an integer from 1 to 10, and
in Formulae 4-5 to 4-9,

$A_{41}$ is a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
EDG indicates an electron donating group, and EWG indicates an electron withdrawing group,
b41, b411, b412, t42, t421, and t422 are each independently an integer from 1 to 3,
$L_{44}$ and $L_{45}$ are each independently a single bond, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
a44 and a45 are each independently an integer from 1 to 3,
s41 and s42 are each independently an integer from 1 to 3,
s43 is an integer from 1 to 6, and
$R_{10a}$ is the same as defined with respect to Formulae 1 to 3.

**8.** The light-emitting device of any one of claims 1 to 7, wherein:

(i) the emission layer emits blue light or blue-green light; and/or
(ii) Formula 1 satisfies at least one of Conditions (1) to (7):

**Condition (1)**
at least one of $R_{11}$(s) in a number of d11 comprises at least one deuterium
**Condition** (2)
at least one of $L_{11}$(s) in a number of a11 comprises at least one deuterium
**Condition** (3)
at least one of $R_1$ to $R_8$ comprises at least one deuterium
**Condition (4)**
at least one of $L_{12}$(s) in a number of a12 comprises at least one deuterium
**Condition** (5)
at least one of $R_{12}$(s) in a number of d12 comprises at least one deuterium
**Condition (6)**
$X_{11}$ is $N(R_{11a})$, and $R_{11a}$ comprises at least one deuterium
**Condition** (7)
$X_{11}$ is $C(R_{11a})(R_{11b})$, and at least one of $R_{11a}$ and $R_{11b}$ comprises at least one deuterium.

**9.** The light-emitting device of any one of claims 1 to 8, wherein $Ar_{11}$ is a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, optionally wherein $Ar_{11}$ is represented by one of Formulae 11-1 to 11-51:

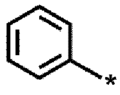
11-1

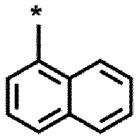
11-2

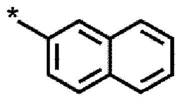
11-3

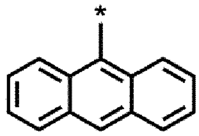
11-4

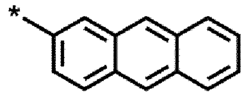
11-5

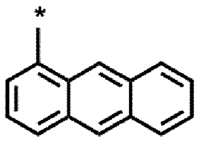
11-6

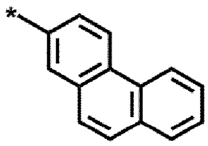
11-7

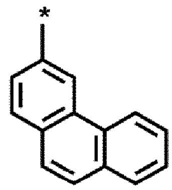
11-8

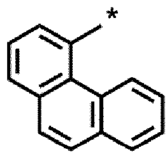
11-9

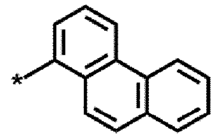
11-10

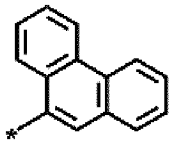
11-11

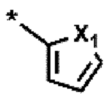
11-12

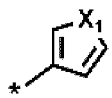
11-13

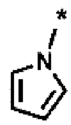
11-14

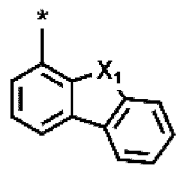
11-15

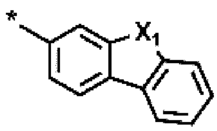
11-16

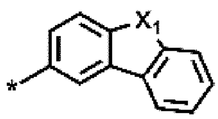
11-17

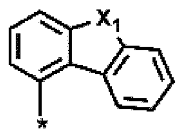
11-18

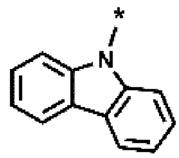
11-19

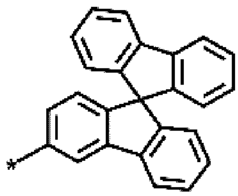
11-20

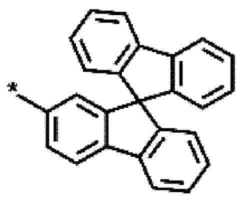
11-21

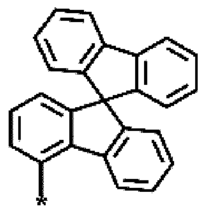
11-22

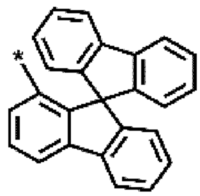
11-23

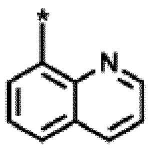
11-24

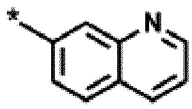
11-25

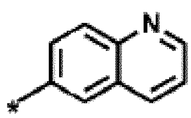
11-26

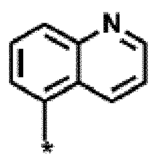
11-27

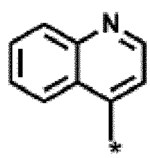
11-28

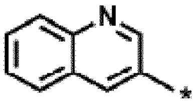
11-29
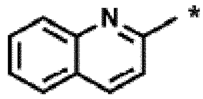
11-30
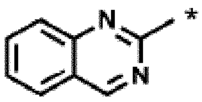
11-31
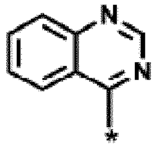
11-32
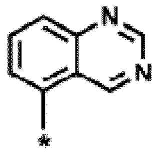
11-33

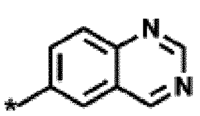
11-34
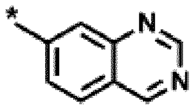
11-35
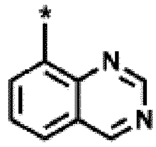
11-36
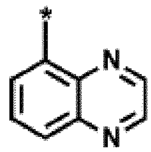
11-37
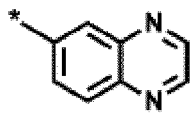
11-38

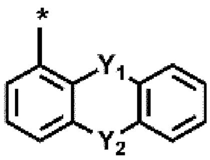
11-39
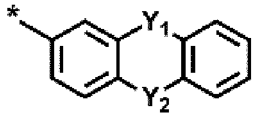
11-40
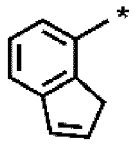
11-41
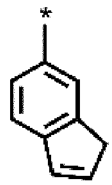
11-42
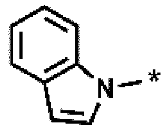
11-43

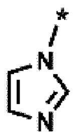
11-44
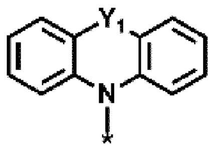
11-45
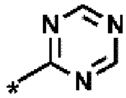
11-46
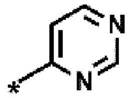
11-47
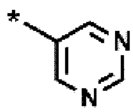
11-48

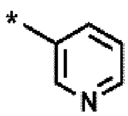
11-49
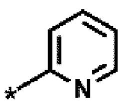
11-50
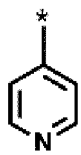
11-51

wherein, in Formulae 11-1 to 11-51:

$X_1$ is O, S, $N(R_{1a})$, or $C(R_{1a})(R_{1b})$,
$Y_1$ is O, S, $N(R_{1a})$, or $C(R_{1a})(R_{1b})$,
$Y_2$ is O, S, $N(R_{2a})$, or $C(R_{2a})(R_{2b})$,
$R_{1a}$, $R_{1b}$, $R_{2a}$, and $R_{2b}$ are each the same as defined in connection with $R_{11}$ in claim 1, and
* indicates a binding site to a neighboring atom.

**10.** The light-emitting device of any one of claims 1 to 9, wherein $L_{11}$, $L_{12}$, and $L_{31}$ to $L_{33}$ are each independently:

a single bond; or
a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group,

a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, each unsubstituted or substituted with at least one $R_{10a}$, optionally wherein $L_{11}$, $L_{12}$, and $L_{31}$ to $L_{33}$ are each independently: a single bond; or

a group represented by one of Formulae 10-1 to 10-41:

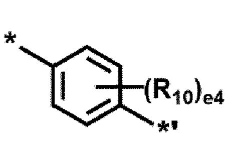

10-1

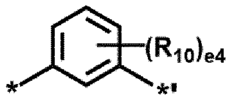

10-2

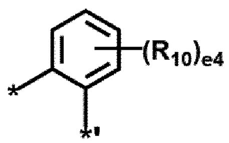

10-3

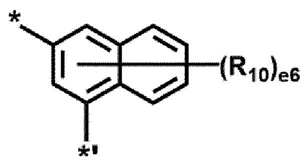

10-4

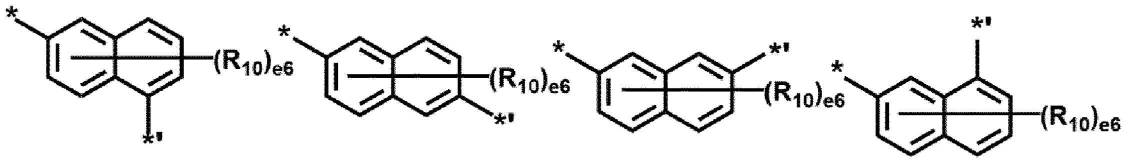

10-5 10-6 10-7 10-8

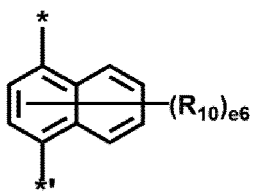

10-9

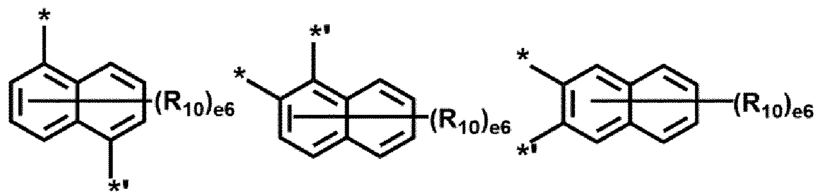

10-10 10-11 10-12

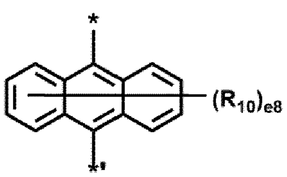

10-13

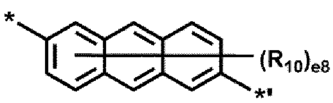

10-14

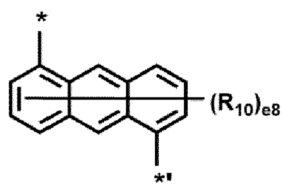

10-15

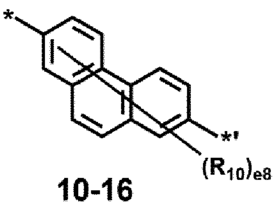
10-16

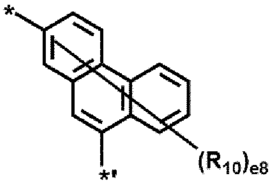
10-17

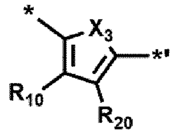
10-18

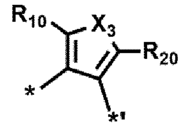
10-19

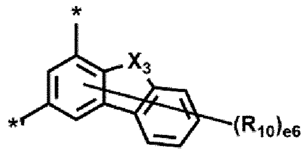
10-20

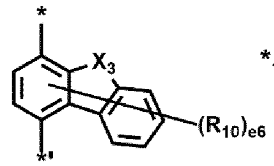
10-21

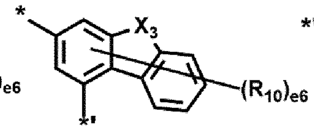
10-22

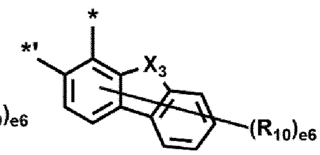
10-23

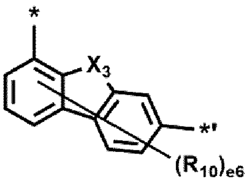
10-24

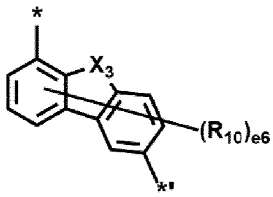
10-25

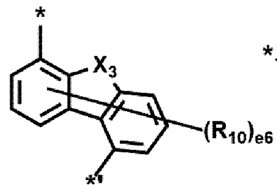
10-26

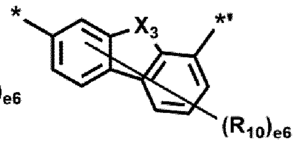
10-27

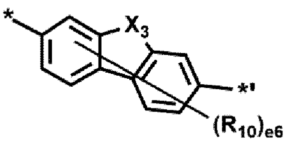
10-28

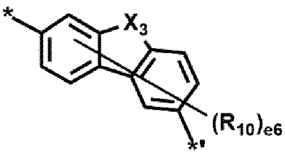
10-29

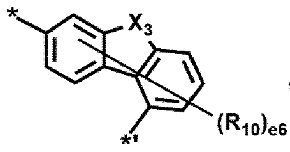
10-30

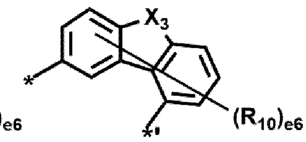
10-31

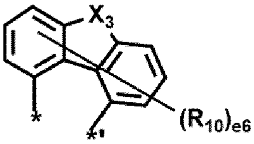
10-32

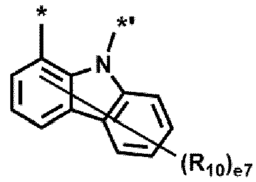
10-33

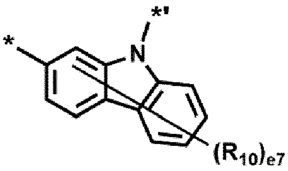
10-34

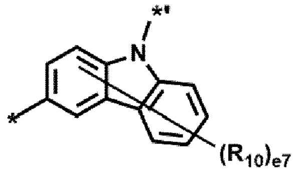
10-35

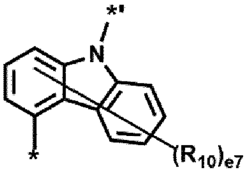
10-36

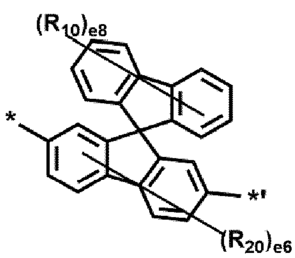
10-37

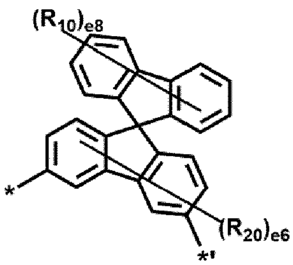
10-38

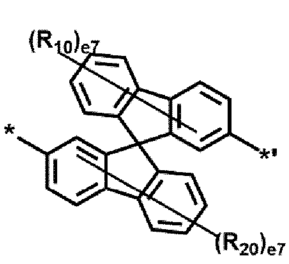
10-39

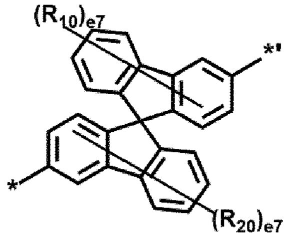

10-40

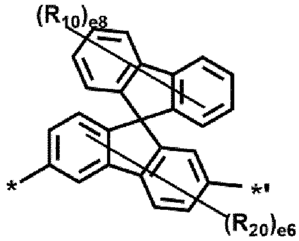

10-41

wherein, in Formulae 10-1 to 10-41,
$X_3$ is O, S, $N(R_{3a})$, or $C(R_{3a})(R_{3b})$,
$R_{10}$, $R_{20}$, $R_{3a}$, and $R_{3b}$ are each the same as defined in connection with $R_{11}$ in claim 1,
e4 is an integer from 1 to 4,
e6 is an integer from 1 to 6,
e7 is an integer from 1 to 7,
e8 is an integer from 1 to 8, and
* and *' each indicate a binding site to a neighboring atom.

**11.** The light-emitting device of any one of claims 1 to 10, wherein Formula 2 is represented by one of Formulae 2-1 to 2-6:

Formula 2-1

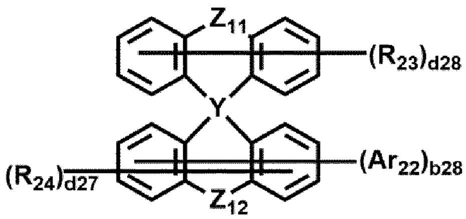

Formula 2-2

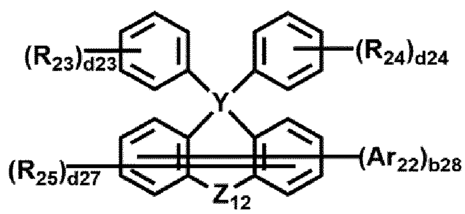

Formula 2-3

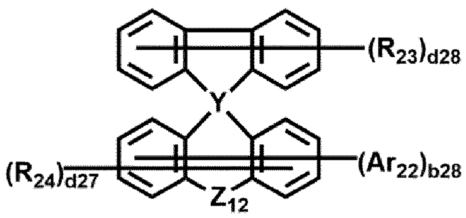

Formula 2-4

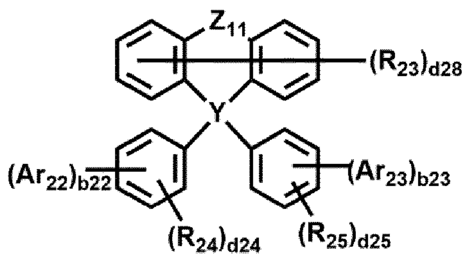

Formula 2-5

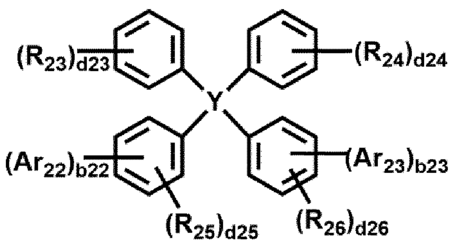

Formula 2-6

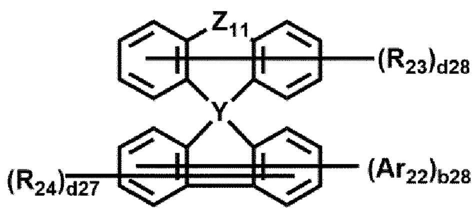

wherein, in Formulae 2-1 to 2-6,
Y is C or Si,
$Ar_{22}$ and $Ar_{23}$ are each the same as defined in connection with $Ar_{21}$ in claim 1, b28 is an integer from 1 to 8, wherein, in Formulae 2-4 and 2-5, b22 is an integer from 0 to 5, b23 is an integer from 0 to 5, and a sum of b22 and b23 is an integer of 1 or more,

$R_{23}$ to $R_{26}$ are each independently the same as defined in connection with $R_{21}$ in claim 1,
d23 is an integer from 1 to 5,
d24 is an integer from 1 to 5,
d25 is an integer from 1 to 5,
d26 is an integer from 1 to 5,
d27 is an integer from 1 to 7,
d28 is an integer from 1 to 8, and
$Z_{12}$ is O, S, $N(R_{24a})$, or $C(R_{24a})(R_{24b})$,
in Formulae 2-1 and 2-4, $Z_{11}$ is O, S, $N(R_{23a})$, or $C(R_{23a})(R_{23b})$,
in Formula 2-6, $Z_{11}$ is $N(R_{23a})$ or $C(R_{23a})(R_{23b})$, and
$R_{23a}$, $R_{23b}$, $R_{24a}$, and $R_{24b}$ are each independently the same as defined in connection with $R_{21a}$ in claim 1.

**12.** The light-emitting device of any one of claims 1 to 11, wherein:

(i) a moiety represented by

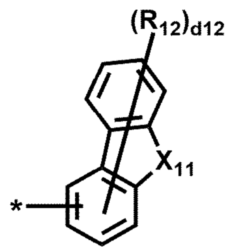

in Formula 1 is represented by one of Formulae 1-1 to 1-4:

Formula 1-1

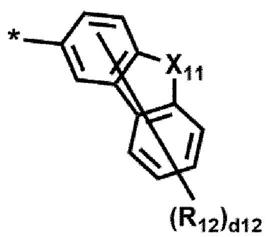

Formula 1-2

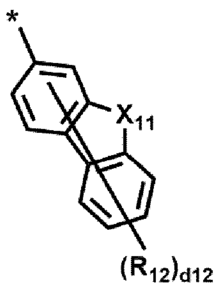

Formula 1-3

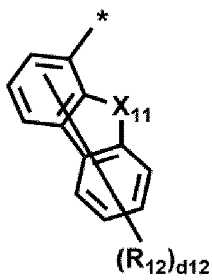

Formula 1-4

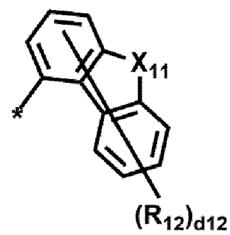

wherein, in Formulae 1-1 to 1-4,
$X_{11}$, $R_{12}$, and d12 are each the same as defined in claim 1, and
* indicates a binding site to a neighboring atom; and/or

(ii) Formula 2 is represented by one of Formulae 2-11 to 2-14:

Formula 2-11

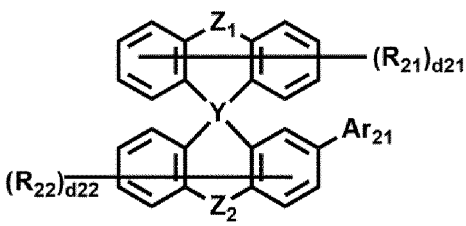

Formula 2-12

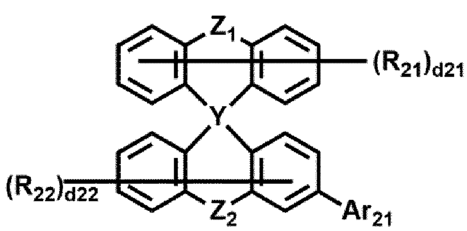

Formula 2-13

Formula 2-14

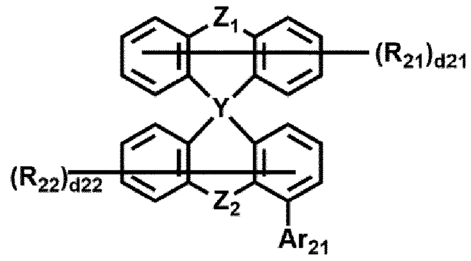

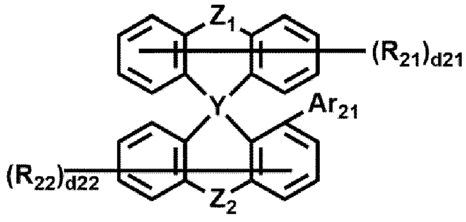

wherein, in Formulae 2-11 to 2-14, Y, $Z_1$, $Z_2$, $Ar_{21}$, $R_{21}$, $R_{22}$, d21, and d22 are each the same as defined in claim 1.

**13.** The light-emitting device of any one of claims 1 to 12, wherein $R_1$ to $R_8$, $R_{11}$, $R_{11a}$, $R_{11b}$, $R_{12}$, $R_{21}$, $R_{21a}$, $R_{21b}$, $R_{22}$, $R_{22a}$, $R_{22b}$, $R_{32}$, $R_{33}$, $R_{31a}$, $R_{32a}$, and $R_{33a}$ are each independently selected from:

hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, and a $C_1$-$C_{20}$ alkoxy group;
a $C_1$-$C_{20}$ alkyl group and a $C_1$-$C_{20}$ alkoxy group, each substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazino group, a hydrazono group, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, and a pyrimidinyl group,
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thienyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothienyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothienyl group, a benzocarbazolyl group, a dibenzocarbazolyl group, an imidazopyridinyl group, an imidazopyrimidinyl group, an azacarbazolyl group, an azadibenzofuranyl group, an azadibenzothienyl group, an azafluorenyl group, and an azadibenzosilolyl group, each unsubstituted or substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thienyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothienyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothienyl group, a benzocarbazolyl group, a dibenzocarbazolyl group, an imidazopyridinyl group, an imidazopyrimidinyl group, an azacarbazolyl group, an azadibenzofuranyl group, an azadibenzothienyl group, an azafluorenyl group, an azadibenzosilolyl group, - $Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, $-S(=O)_2(Q_{31})$, and $-P(=O)(Q_{31})(Q_{32})$; and
$-Si(Q_1)(Q_2)(Q_3)$, $-N(Q_1)(Q_2)$, $-B(Q_1)(Q_2)$, $-C(=O)(Q_1)$, $-S(=O)_2(Q_1)$, and - $P(=O)(Q_1)(Q_2)$,
wherein $Q_1$ to $Q_3$ and $Q_{31}$ to $Q_{33}$ are each independently selected from:

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, and $-CD_2CDH_2$, and

an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, and a triazinyl group, each unsubstituted or substituted with at least one selected from deuterium, a $C_1$-$C_{10}$ alkyl group, a phenyl group, a biphenyl group, a pyridinyl group, a pyrimidinyl group, a pyridazinyl group, a pyrazinyl group, and a triazinyl group.

**14.** The light-emitting device of any one of claims 1 to 13, wherein the at least one first compound is selected from Group I and the at least one second compound is selected from Group II:

Group I

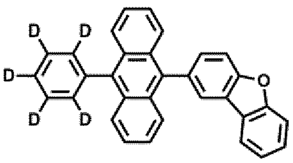

1-1

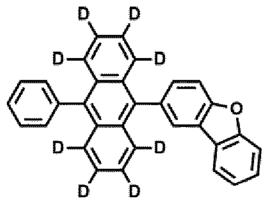

1-2

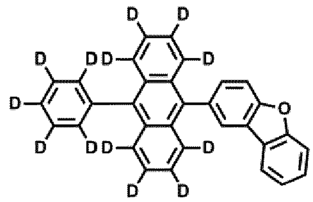

1-3

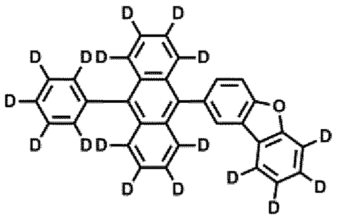

1-4

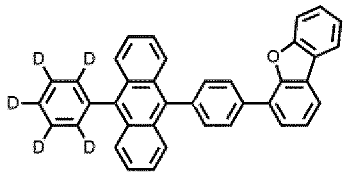

1-5

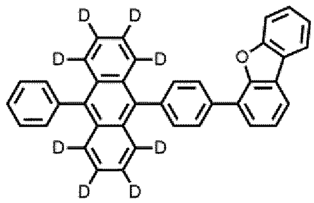

1-6

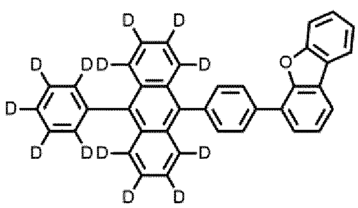

1-7

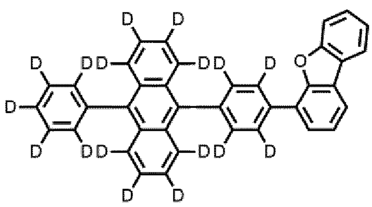

1-8

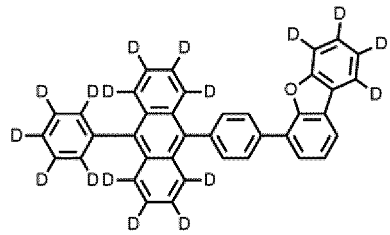

1-9

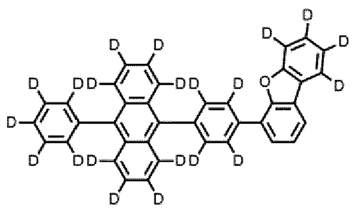

1-10

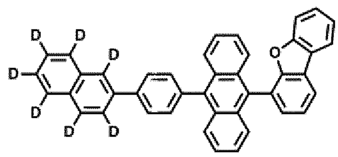

1-11

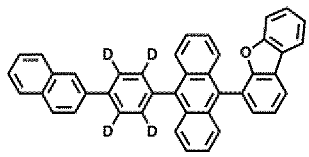

1-12

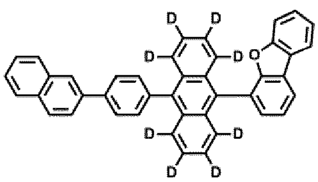

1-13

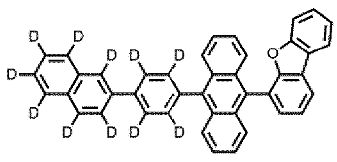

1-14

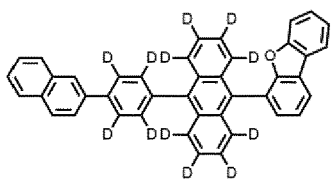

1-15

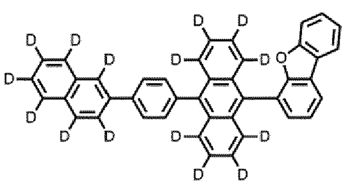

1-16

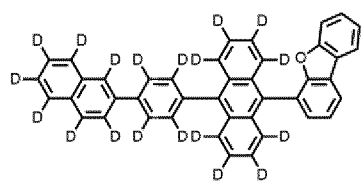

1-17

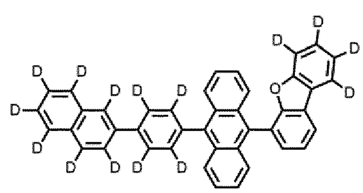

1-18

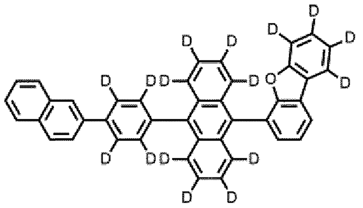

1-19

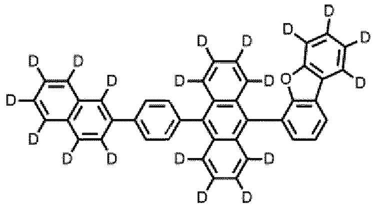

1-20

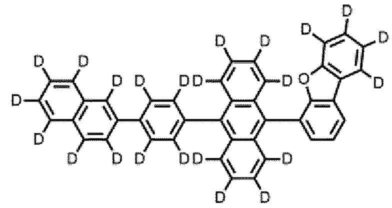

1-21

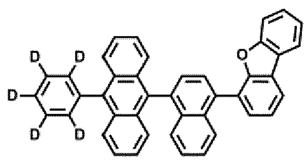

1-22

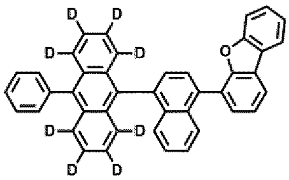

1-23

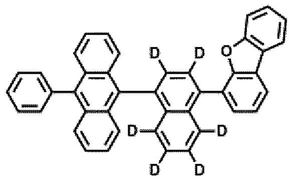

1-24

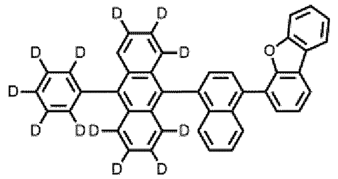

1-25

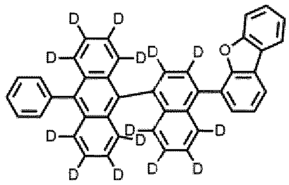

1-26

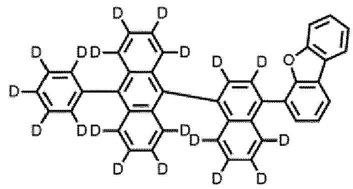

1-27

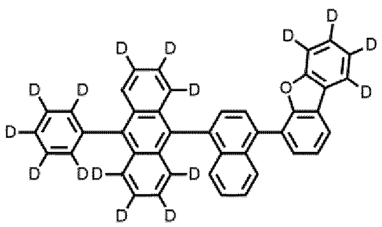

1-28

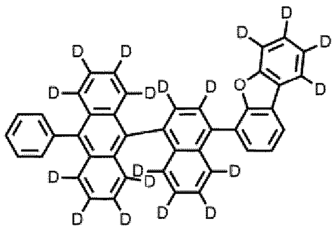

1-29

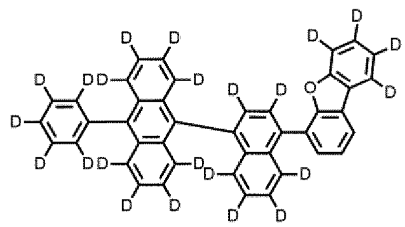

1-30

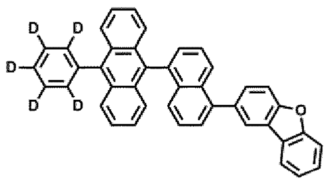

**1-31**

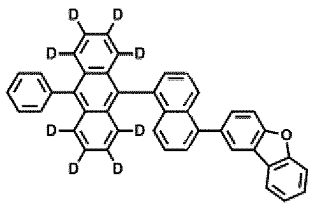

**1-32**

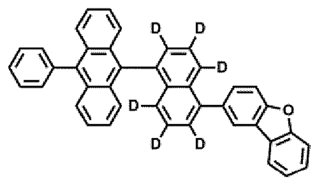

**1-33**

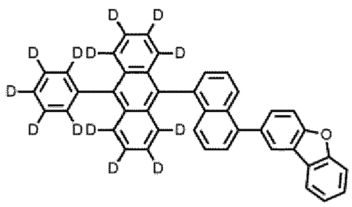

**1-34**

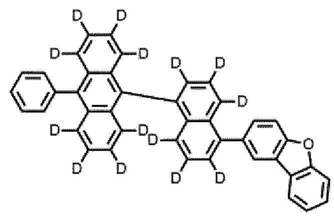

**1-35**

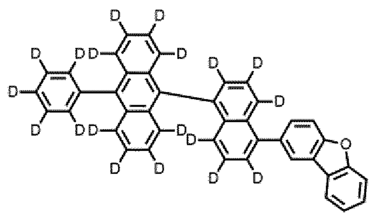

**1-36**

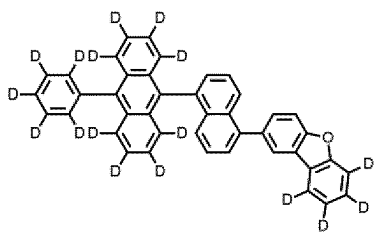

**1-37**

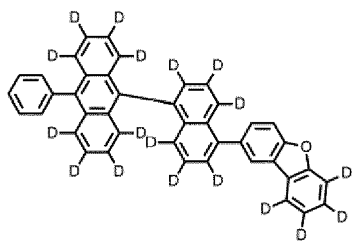

**1-38**

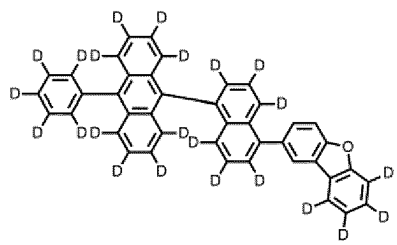

**1-39**

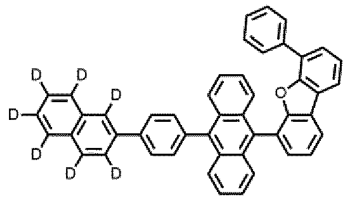

**1-40**

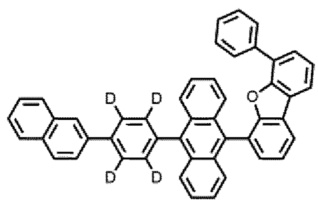

**1-41**

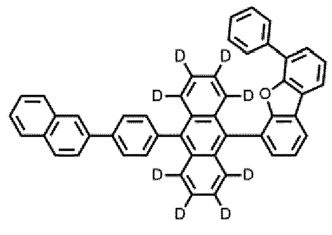

**1-42**

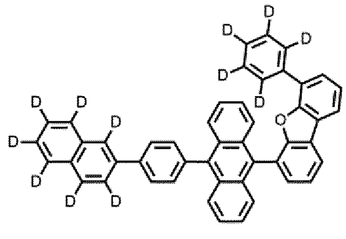

**1-43**

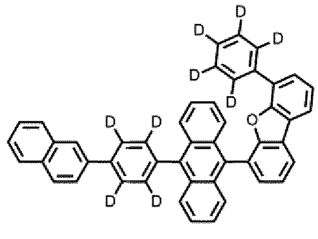

**1-44**

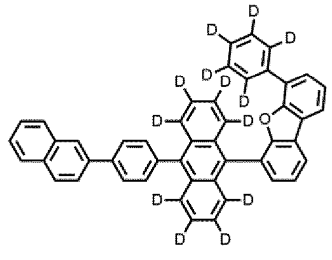

**1-45**

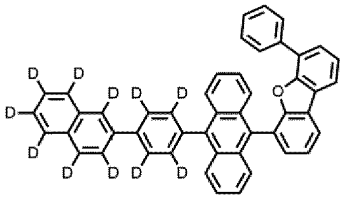

**1-46**

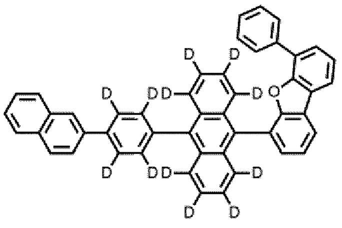

**1-47**

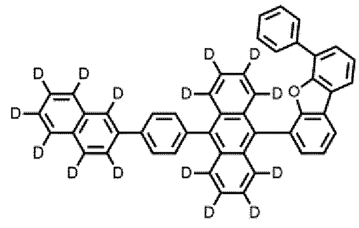

**1-48**

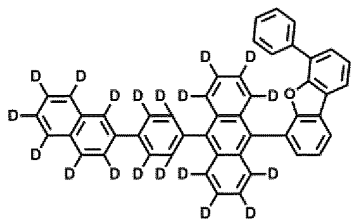

1-49

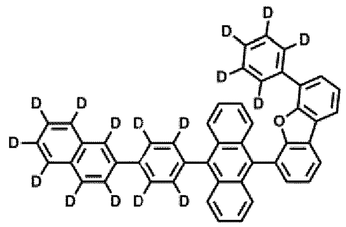

1-50

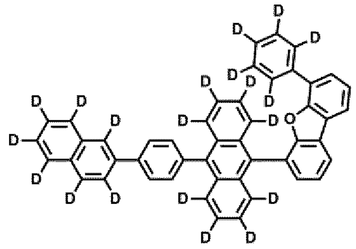

1-51

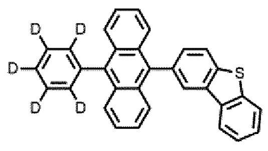

1-52

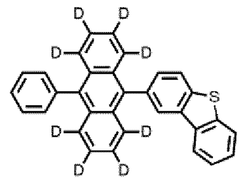

1-53

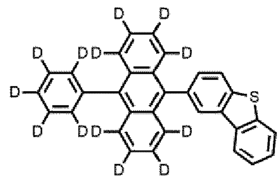

1-54

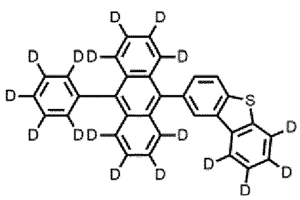

1-55

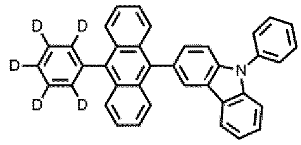

1-56

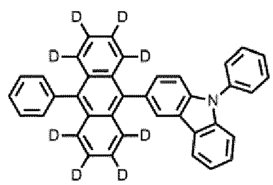

1-57

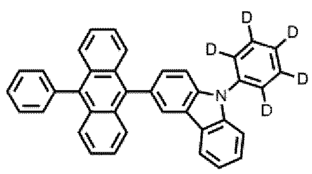

1-58

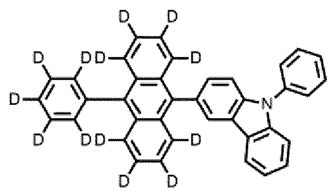

1-59

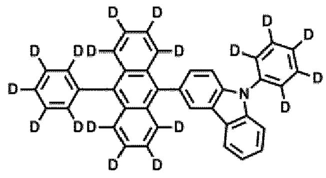

1-60

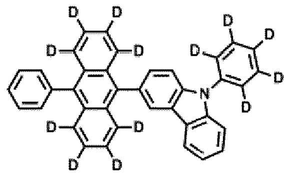

1-61

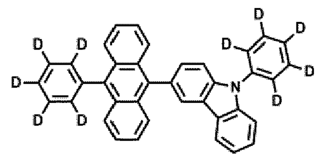

1-62

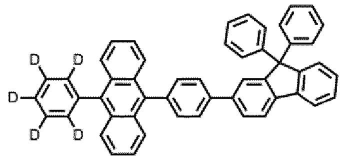

1-63

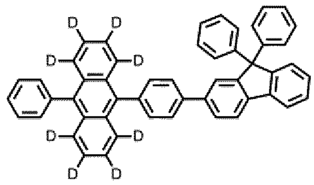

1-64

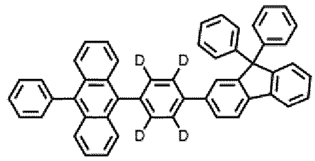

1-65

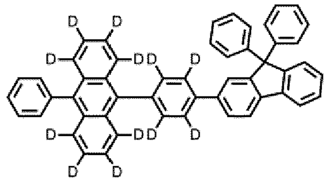

1-66

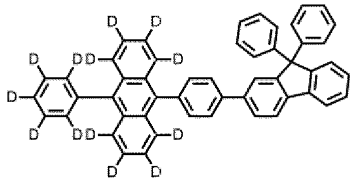

1-67

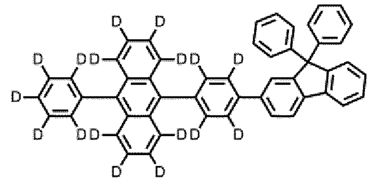

1-68

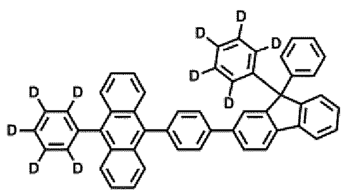

1-69

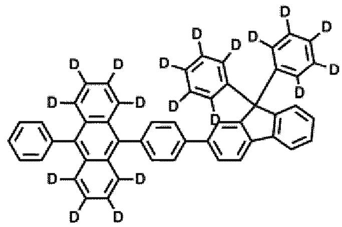

1-70

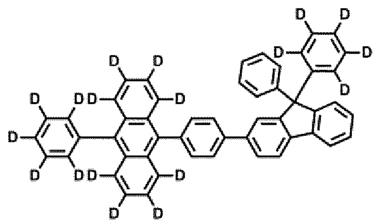

1-71

Group II

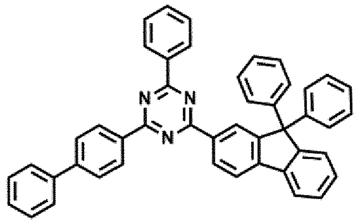

2-1

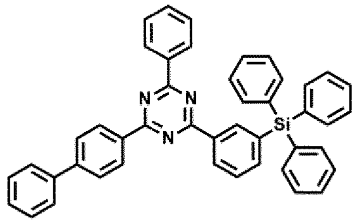

2-2

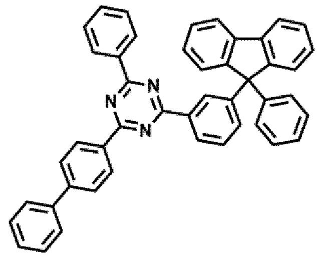

2-3

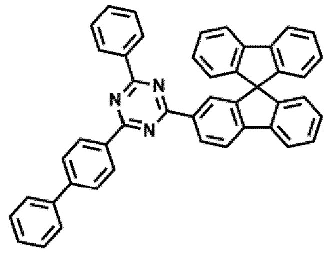

2-4

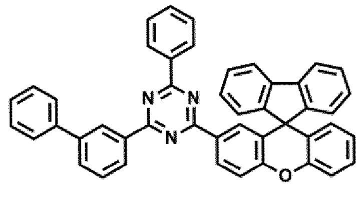

2-5

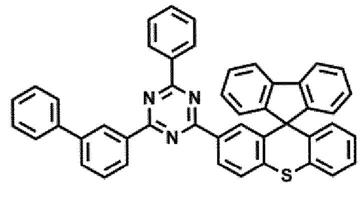

2-6

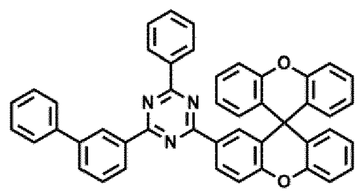

2-7

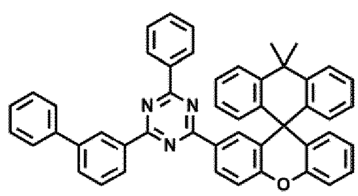

2-8

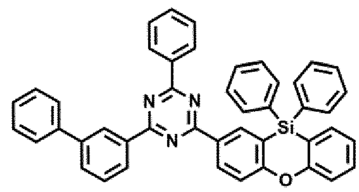

2-9

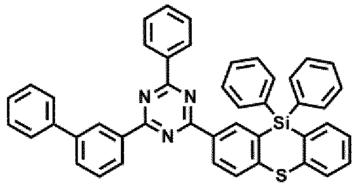

2-10

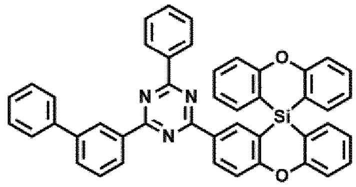

2-11

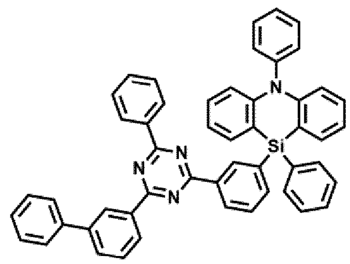

2-12

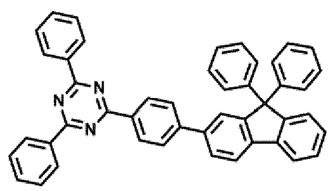

2-13

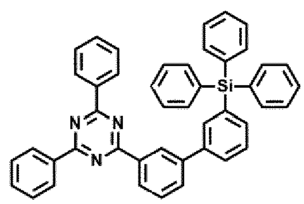

2-14

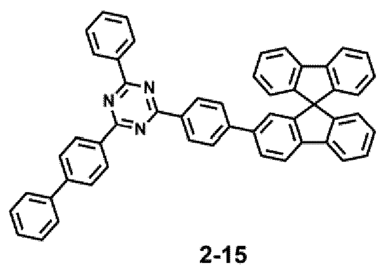

2-15 .

**15.** An electronic apparatus comprising:

the light-emitting device of any one of claims 1 to 14, and
a thin-film transistor,
wherein the thin-film transistor comprises a source electrode (260) and a drain electrode (270), and
the first electrode of the light-emitting device is electrically coupled to the source electrode or the drain electrode,
optionally wherein the apparatus further comprises a color filter, a color conversion layer, a touch screen layer, a polarizing layer, or any combination thereof.

## Patentansprüche

**1.** Lichtemittierende Vorrichtung, umfassend:

eine erste Elektrode (110);
eine zweite Elektrode (150), die der ersten Elektrode zugewandt ist;
eine Zwischenschicht (130) zwischen der ersten Elektrode und der zweiten Elektrode, die eine Emissionsschicht umfasst;
**dadurch gekennzeichnet, dass** die Zwischenschicht (130) ferner mindestens eine erste Verbindung, die durch Formel 1 dargestellt ist; und mindestens eine zweite Verbindung, die durch Formel 2 dargestellt ist, umfasst:

Formel 1

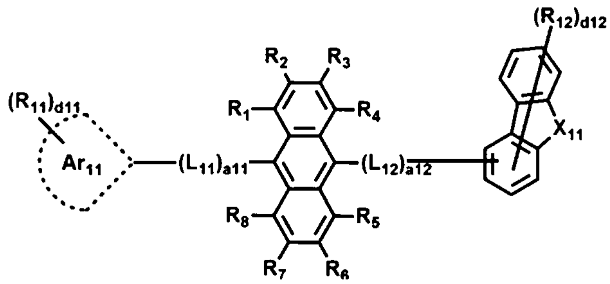

Formel 2

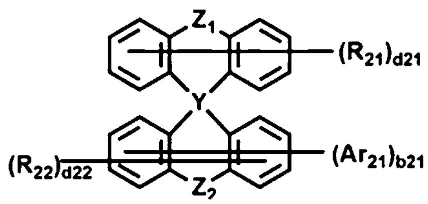

Formel 3

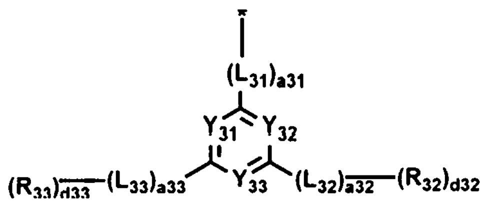

wobei in den Formeln 1, 2 und 3,
$X_{11}$ O, S, $N(R_{11a})$ oder $C(R_{11a})(R_{11b})$ ist,
$Ar_{11}$ eine carbocyclische $C_3$-$C_{60}$-Gruppe oder eine heterocyclische $C_1$-$C_{60}$-Gruppe ist,
$L_{11}$, $L_{12}$ und $L_{31}$ bis $L_{33}$ jeweils unabhängig voneinander eine Einfachbindung, eine carbocyclische $C_3$-$C_{60}$-Gruppe, unsubstituiert oder mit mindestens einem $R_{10a}$ substituiert, oder eine heterocyclische $C_1$-$C_{60}$-Gruppe, unsubstituiert oder mit mindestens einem $R_{10a}$ substituiert, sind,
a11, a12 und a31 bis a33 jeweils unabhängig voneinander eine ganze Zahl von 1 bis 3 sind,
Y C oder Si ist,
$Z_1$ keine Bindung, eine Einfachbindung, O, S, $N(R_{21a})$ oder $C(R_{21a})(R_{21b})$ ist,
$Z_2$ keine Bindung, eine Einfachbindung, O, S, $N(R_{22a})$ oder $C(R_{22a})(R_{22b})$ ist, wobei, wenn $Z_1$ O oder S ist, $Z_2$ keine Einfachbindung ist,
$Ar_{21}$ eine durch Formel 3 dargestellte Gruppe ist,
b21 eine ganze Zahl von 1 bis 10 ist,
$Y_{31}$ N oder $C(R_{31a})$ ist,
$Y_{32}$ N oder $C(R_{32a})$ ist,
$Y_{33}$ N oder $C(R_{33a})$ ist,
* in Formel 3 eine Bindungsstelle an ein benachbartes Atom bezeichnet,

$R_1$ bis $R_8$, $R_{11}$, $R_{11a}$, $R_{11b}$, $R_{12}$, $R_{21}$, $R_{21a}$, $R_{21b}$, $R_{22}$, $R_{22a}$, $R_{22b}$, $R_{32}$, $R_{33}$, $R_{31a}$, $R_{32a}$ und $R_{33a}$ jeweils unabhängig voneinander Wasserstoff, Deuterium, -F, -Cl, -Br, -I, eine Hydroxyl-Gruppe, eine Cyano-Gruppe, eine Nitro-Gruppe, eine Amidino-Gruppe, eine Hydrazino-Gruppe, eine Hydrazono-Gruppe, eine $C_1$-$C_{60}$-Alkyl-Gruppe, unsubstituiert oder mit mindestens einem $R_{10a}$ substituiert, eine $C_2$-$C_{60}$-Alkenyl-Gruppe, unsubstituiert oder mit mindestens einem $R_{10a}$ substituiert, eine $C_2$-$C_{60}$-Alkinyl-Gruppe, unsubstituiert oder mit mindestens einem $R_{10a}$ substituiert, eine $C_1$-$C_{60}$-Alkoxy-Gruppe, unsubstituiert oder mit mindestens einem $R_{10a}$ substituiert, eine carbocyclische $C_3$-$C_{60}$-Gruppe, unsubstituiert oder mit mindestens einem $R_{10a}$ substituiert, eine heterocyclische $C_1$-$C_{60}$-Gruppe, unsubstituiert oder mit mindestens einem $R_{10a}$ substituiert, eine $C_6$-$C_{60}$-Aryloxy-Gruppe, unsubstituiert oder mit mindestens einem $R_{10a}$ substituiert, eine $C_6$-$C_{60}$-Arylthio-Gruppe, unsubstituiert oder mit mindestens einem $R_{10a}$ substituiert, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$ oder $-P(=O)(Q_1)(Q_2)$, sind,
d11 eine ganze Zahl von 1 bis 10 ist,
d12 eine ganze Zahl von 1 bis 7 ist,
d21 eine ganze Zahl von 1 bis 10 ist,
d22 eine ganze Zahl von 1 bis 9 ist,
d32 1 ist,
d33 1 ist,
die mindestens eine erste Verbindung mindestens ein Deuterium umfasst, und
$R_{10a}$ ist:

Deuterium, -F, -Cl, -Br, -I, eine Hydroxyl-Gruppe, eine Cyano-Gruppe oder eine Nitro-Gruppe,
eine $C_1$-$C_{60}$-Alkyl-Gruppe, eine $C_2$-$C_{60}$-Alkenyl-Gruppe, eine $C_2$-$C_{60}$-Alkinyl-Gruppe oder eine $C_1$-$C_{60}$-Alkoxy-Gruppe, jeweils unsubstituiert oder mit Deuterium, -F, -Cl, -Br, -I, einer Hydroxyl-Gruppe, einer Cyano-Gruppe, einer Nitro-Gruppe, einer carbocyclischen $C_3$-$C_{60}$-Gruppe, einer heterocyclischen $C_1$-$C_{60}$-Gruppe, einer $C_6$-$C_{60}$-Aryloxy-Gruppe, einer $C_6$-$C_{60}$-Arylthio-Gruppe, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, $-P(=O)(Q_{11})(Q_{12})$ oder einer beliebigen Kombination davon substituiert,
eine carbocyclische $C_3$-$C_{60}$-Gruppe, eine heterocyclische $C_1$-$C_{60}$-Gruppe, eine $C_6$-$C_{60}$-Aryloxy-Gruppe oder eine $C_6$-$C_{60}$-Arylthio-Gruppe, jeweils unsubstituiert oder mit Deuterium, -F, -Cl, -Br, -I, einer Hydroxyl-Gruppe, einer Cyano-Gruppe, einer Nitro-Gruppe, einer $C_1$-$C_{60}$-Alkyl-Gruppe, einer $C_2$-$C_{60}$-Alkenyl-Gruppe, einer $C_2$-$C_{60}$-Alkinyl-Gruppe, einer $C_1$-$C_{60}$-Alkoxy-Gruppe, einer carbocyclischen $C_3$-$C_{60}$-Gruppe, einer heterocyclischen $C_1$-$C_{60}$-Gruppe, einer $C_6$-$C_{60}$-Aryloxy-Gruppe, einer $C_6$-$C_{60}$-Arylthio-Gruppe, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$ oder einer beliebigen Kombination davon substituiert, oder
$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$ oder $-P(=O)(Q_{31})(Q_{32})$, und
wobei $Q_1$ bis $Q_3$, $Q_{11}$ bis $Q_{13}$, $Q_{21}$ bis $Q_{23}$ und $Q_{31}$ bis $Q_{33}$ jeweils unabhängig voneinander sind: Wasserstoff; Deuterium; -F; -Cl; -Br; -I; eine Hydroxyl-Gruppe; eine Cyano-Gruppe; eine Nitro-Gruppe; eine $C_1$-$C_{60}$-Alkyl-Gruppe; eine $C_2$-$C_{60}$-Alkenyl-Gruppe; eine $C_2$-$C_{60}$-Alkinyl-Gruppe; eine $C_1$-$C_{60}$-Alkoxy-Gruppe; oder eine carbocyclische $C_3$-$C_{60}$-Gruppe oder eine heterocyclische $C_1$-$C_{60}$-Gruppe, jeweils unsubstituiert oder mit Deuterium, -F, einer Cyano-Gruppe, einer $C_1$-$C_{60}$-Alkyl-Gruppe, einer $C_1$-$C_{60}$-AlkoxyGruppe, einer Phenyl-Gruppe, einer Biphenyl-Gruppe oder einer beliebigen Kombination davon substituiert.

**2.** Lichtemittierende Vorrichtung nach Anspruch 1, wobei die Emissionsschicht die mindestens eine erste Verbindung umfasst.

**3.** Lichtemittierende Vorrichtung nach Anspruch 1 oder Anspruch 2, wobei die erste Elektrode eine Kathode ist,

die zweite Elektrode eine Kathode ist,
die Zwischenschicht ferner einen Löchertransportbereich zwischen der Emissionsschicht und der ersten Elektrode umfasst,
die Zwischenschicht ferner einen Elektronentransportbereich zwischen der Emissionsschicht und der zweiten Elektrode umfasst,
der Löchertransportbereich eine Löcherinjektionsschicht, eine Löchertransportschicht, eine Emissionshilfsschicht, eine Elektronensperrschicht oder eine beliebige Kombination davon umfasst, und
der Elektronentransportbereich eine Pufferschicht, eine Löchersperrschicht, eine Elektronentransportschicht, eine Elektronensteuerschicht, eine Elektroneninjektionsschicht oder eine beliebige Kombination davon umfasst.

**4.** Lichtemittierende Vorrichtung nach Anspruch 3, wobei der Elektronentransportbereich die mindestens eine zweite Verbindung umfasst.

5. Lichtemittierende Vorrichtung nach einem der Ansprüche 2 bis 4, wobei die Emissionsschicht ferner eine dritte Verbindung umfasst, und
die dritte Verbindung eine fluoreszierende Verbindung oder eine thermisch aktivierte Verbindung mit verzögerter Fluoreszenz ist, die Gleichung 1 erfüllt:

Gleichung 1

$$\Delta E_{ST} = S1 - T1 \leq 0{,}3\ eV$$

wobei in Gleichung 1 S1 das niedrigste angeregte Singulett-Energieniveau (eV) der thermisch aktivierten Verbindung mit verzögerter Fluoreszenz ist und T1 das niedrigste angeregte Triplett-Energieniveau (eV) der TADF-Verbindung ist.

6. Organische lichtemittierende Vorrichtung nach Anspruch 4 oder Anspruch 5, ferner umfassend eine Deckschicht außerhalb der zweiten Elektrode und aufweisend einen Brechungsindex bei einer Wellenlänge von 589 nm von gleich oder mehr als 1,6.

7. Lichtemittierende Vorrichtung nach einem der Ansprüche 2 bis 6, wobei die Emissionsschicht ferner eine dritte Verbindung umfasst, und
die dritte Verbindung mindestens eine der durch die Formeln 4-1 bis 4-9 dargestellten Verbindungen umfasst:

Formel 4-1

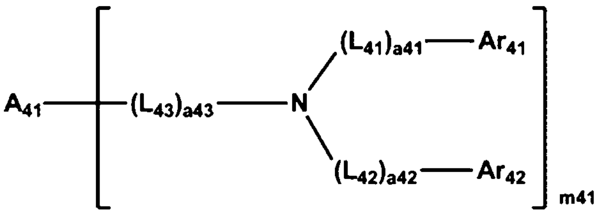

Formel 4-2

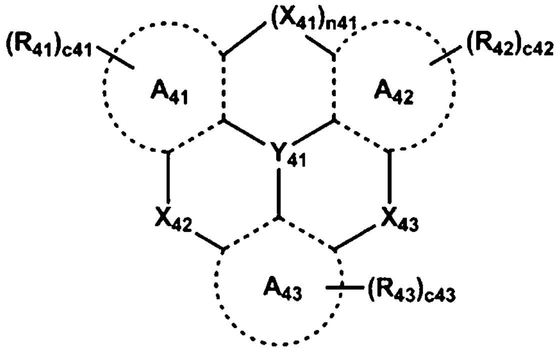

Formel 4-3

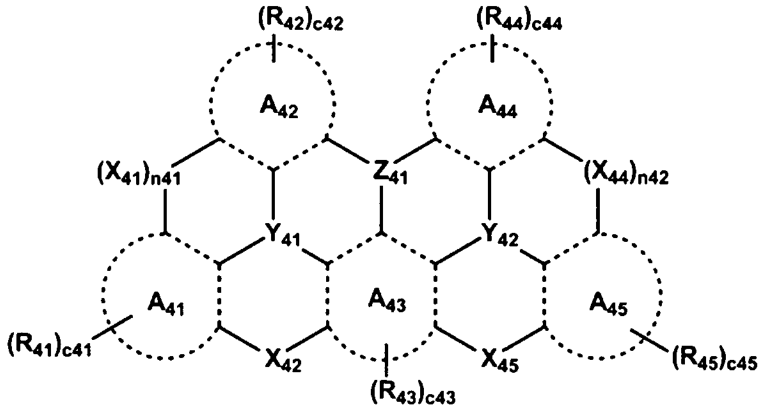

Formel 4-4

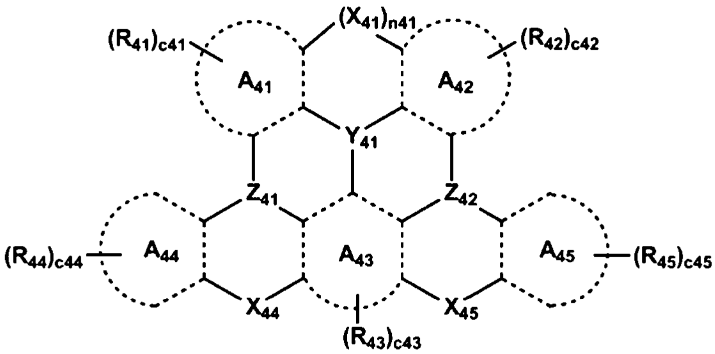

| | |
|---|---|
| Formel 4-5 | $(EDG)_{b41}$-$[(L_{44})_{a44}$-$(EWG)_{t42}]_{s41}$ |
| Formel 4-6 | $(EWG)_{t42}$-$[(L_{44})_{a44}$-$(EDG)_{b41}]_{s42}$ |
| Formel 4-7 | $(EDG)_{b411}$-$(L_{44})_{a44}$-$(EWG)_{t42}$-$(L_{43})_{a43}$-$(EDG)_{b412}$ |
| Formel 4-8 | $(EWG)_{t421}$-$(L_{44})_{a44}$-$(EDG)_{b41}$-$(L_{45})_{a45}$-$(EWG)_{t422}$ |
| Formel 4-9 | $A_{41}$-$[(L_{44})_{a44}$-$(EDG)_{b41}]_{s43}$ |

wobei in Formel 4-1:

$A_{41}$ eine carbocyclische $C_3$-$C_{60}$-Gruppe, unsubstituiert oder mit mindestens einem $R_{10a}$ substituiert, oder eine heterocyclische $C_1$-$C_{60}$-Gruppe, unsubstituiert oder mit mindestens einem $R_{10a}$ substituiert, ist,

$L_{41}$ bis $L_{43}$ jeweils unabhängig voneinander eine Einfachbindung, eine carbocyclische $C_3$-$C_{60}$-Gruppe, unsubstituiert oder mit mindestens einem $R_{10a}$ substituiert, oder eine heterocyclische $C_1$-$C_{60}$-Gruppe, unsubstituiert oder mit mindestens einem $R_{10a}$ substituiert, sind,

a41 bis a43 jeweils unabhängig voneinander eine ganze Zahl von 1 bis 3 sind,

$Ar_{41}$ und $Ar_{42}$ jeweils unabhängig voneinander eine carbocyclische $C_3$-$C_{60}$-Gruppe, unsubstituiert oder mit mindestens einem $R_{10a}$ substituiert, eine heterocyclische $C_1$-$C_{60}$-Gruppe, unsubstituiert oder mit mindestens einem $R_{10a}$ substituiert, oder eine $C_6$-$C_{60}$-Aryloxy-Gruppe, unsubstituiert oder mit mindestens einem $R_{10a}$ substituiert, sind, und

m41 eine ganze Zahl von 1 bis 6 ist,

wobei in den Formeln 4-2 bis 4-4,

$X_{41}$ bis $X_{45}$ jeweils unabhängig voneinander eine Einfachbindung, O, S, $N(R_{46})$, $B(R_{46})$, $C(R_{46})(R_{47})$ oder $Si(R_{46})(R_{47})$ sind,

n41 und n42 jeweils unabhängig voneinander 0, 1 oder 2 sind, wobei, wenn n41 0 ist, $A_{41}$ und $A_{42}$ nicht miteinander verbunden sind, und wenn n42 0 ist, $A_{44}$ und $A_{45}$ nicht miteinander verbunden sind,
$Y_{41}$ und $Y_{42}$ jeweils unabhängig voneinander N, B oder P sind,
$Z_{41}$ und $Z_{42}$ jeweils unabhängig voneinander N, $L(R_{48})$ oder $Si(R_{48})$ sind,
$A_{41}$ bis $A_{45}$ jeweils unabhängig voneinander aus einer carbocyclischen $C_3$-$C_{30}$-Gruppe und einer heterocyclischen $C_1$-$C_{30}$-Gruppe ausgewählt sind,
$R_{41}$ bis $R_{48}$ jeweils unabhängig voneinander Wasserstoff, Deuterium, -F, -Cl, -Br, -I, eine Hydroxyl-Gruppe, eine Cyano-Gruppe, eine Nitro-Gruppe, eine $C_1$-$C_{60}$-Alkyl-Gruppe, unsubstituiert oder mit mindestens einem $R_{10a}$ substituiert, eine $C_2$-$C_{60}$-Alkenyl-Gruppe, unsubstituiert oder mit mindestens einem $R_{10a}$ substituiert, eine $C_2$-$C_{60}$-Alkinyl-Gruppe, unsubstituiert oder mit mindestens einem $R_{10a}$ substituiert, eine $C_1$-$C_{60}$-Alkoxy-Gruppe, unsubstituiert oder mit mindestens einem $R_{10a}$ substituiert, eine carbocyclische $C_3$-$C_{60}$-Gruppe, unsubstituiert oder mit mindestens einem $R_{10a}$ substituiert, eine heterocyclische $C_1$-$C_{60}$-Gruppe, unsubstituiert oder mit mindestens einem $R_{10a}$ substituiert, eine $C_6$-$C_{60}$-Aryloxy-Gruppe, unsubstituiert oder mit mindestens einem $R_{10a}$ substituiert, eine $C_6$-$C_{60}$-Arylthio-Gruppe, unsubstituiert oder mit mindestens einem $R_{10a}$ substituiert, $-Si(Q_1)(Q_2)(Q_3)$, $-N(Q_1)(Q_2)$, $-B(Q_1)(O_2)$, $-C(=O)(Q_1)$, $-S(=O)_2(Q_1)$ oder $-P(=O)(Q_1)(Q_2)$, sind, und
c41 bis c45 jeweils unabhängig voneinander eine ganze Zahl von 1 bis 10 sind, und
wobei in den Formeln 4-5 bis 4-9:

$A_{41}$ eine carbocyclische $C_3$-$C_{60}$-Gruppe, unsubstituiert oder mit mindestens einem $R_{10a}$ substituiert, oder eine heterocyclische $C_1$-$C_{60}$-Gruppe, unsubstituiert oder mit mindestens einem $R_{10a}$ substituiert, ist,
EDG eine elektronenabgebende Gruppe bezeichnet und EWG eine elektronenziehende Gruppe bezeichnet,
b41, b411, b412, t42, t421 und t422 jeweils unabhängig voneinander eine ganze Zahl von 1 bis 3 sind,
$L_{44}$ und $L_{45}$ jeweils unabhängig voneinander eine Einfachbindung, eine carbocyclische $C_3$-$C_{60}$-Gruppe, unsubstituiert oder mit mindestens einem $R_{10a}$ substituiert, oder eine heterocyclische $C_1$-$C_{60}$-Gruppe, unsubstituiert oder mit mindestens einem $R_{10a}$ substituiert, sind,
a44 und a45 jeweils unabhängig voneinander eine ganze Zahl von 1 bis 3 sind, s41 und s42 jeweils unabhängig voneinander eine ganze Zahl von 1 bis 3 sind,
s43 eine ganze Zahl von 1 bis 6 ist, und
$R_{10a}$ dasselbe ist wie in Bezug auf die Formeln 1 bis 3 definiert.

**8.** Lichtemittierende Vorrichtung nach einem der Ansprüche 1 bis 7, wobei:

(i) die Emissionsschicht blaues Licht oder blaugrünes Licht emittiert; und/oder
(ii) die Formel 1 mindestens eine der Bedingungen (1) bis (7) erfüllt:

**Bedingung (1)**
Mindestens eines von $R_{11}$(s) in einer Anzahl von d11 umfasst mindestens ein Deuterium.
**Bedingung (2)**
Mindestens eines von $L_{11}$(s) in einer Anzahl von a11 umfasst mindestens ein Deuterium.
**Bedingung (3)**
Mindestens eines von $R_1$ bis $R_8$ umfasst mindestens ein Deuterium.
**Bedingung (4)**
Mindestens eines von $L_{12}$(s) in einer Anzahl von a12 umfasst mindestens ein Deuterium.
**Bedingung (5)**
Mindestens eines von $R_{12}$(s) in einer Anzahl von d12 umfasst mindestens ein Deuterium.
**Bedingung (6)**
$X_{11}$ ist $N(R_{11a})$ und $R_{11a}$ umfasst mindestens ein Deuterium.
**Bedingung (7)**
$X_{11}$ ist $C(R_{11a})(R_{11b})$ und mindestens eines von $R_{11a}$ und $R_{11b}$ umfasst mindestens ein Deuterium.

**9.** Lichtemittierende Vorrichtung nach einem der Ansprüche 1 bis 8, wobei $Ar_{11}$ eine Benzol-Gruppe, eine Naphthalin-Gruppe, eine Anthracen-Gruppe, eine Phenanthren-Gruppe, eine Triphenylen-Gruppe, eine Pyren-Gruppe, eine Chrysen-Gruppe, eine Cyclopentadien-Gruppe, eine 1,2,3,4-Tetrahydronaphthalin-Gruppe, eine Thiophen-Gruppe, eine Furan-Gruppe, eine Indol-Gruppe, eine Benzoborol-Gruppe, eine Benzophosphol-Gruppe, eine Inden-Gruppe, eine Benzosilol-Gruppe, eine Benzogermol-Gruppe, eine Benzothiophen-Gruppe, eine Benzoselenophen-Gruppe, eine Benzofuran-Gruppe, eine Carbazol-Gruppe, eine Dibenzoborol-Gruppe, eine Dibenzophosphol-Gruppe, eine Fluoren-Gruppe, eine Dibenzosilol-Gruppe, eine Dibenzogermol-Gruppe, eine Dibenzothiophen-Gruppe, eine Dibenzoselenophen-Gruppe, eine Dibenzofuran-Gruppe, eine Dibenzothiophen-5-oxid-Gruppe, eine 9H-Fluoren-9-on-Gruppe, eine Dibenzothiophen-5,5-dioxid-Gruppe, eine Azaindol-Gruppe, eine Azabenzoborol-Gruppe, eine Azabenzophosphol-Gruppe, eine Azainden-Gruppe, eine Azabenzosilol-Gruppe, eine Azabenzogermol-Gruppe, eine Azabenzothiophen-Gruppe, eine Azabenzoselenophen-Gruppe, eine Azabenzofuran-Gruppe, eine Azacarbazol-Gruppe, eine Azadibenzoborol-Gruppe, eine Azadibenzophosphol-Gruppe, eine Azafluoren-Gruppe, eine Azadibenzosilol-Gruppe, eine Azadibenzogermol-Gruppe, eine Azadibenzothiophen-Gruppe, eine Azadibenzoselenophen-Gruppe, eine Azadibenzofuran-Gruppe, eine Azadibenzothiophen-5-oxid-Gruppe, eine Aza-9H-Fluoren-9-on-Gruppe, eine Azadibenzothiophen-5,5-dioxid-Gruppe, eine Pyridin-Gruppe, eine Pyrimidin-Gruppe, eine Pyrazin-Gruppe, eine Pyridazin-Gruppe, eine Triazin-Gruppe, eine Chinolin-Gruppe, eine Isochinolin-Gruppe, eine Chinoxalin-Gruppe, eine Chinazolin-Gruppe, eine Phenanthrolin-Gruppe, eine Pyrrol-Gruppe, eine Pyrazol-Gruppe, eine Imidazol-Gruppe, eine Triazol-Gruppe, eine Oxazol-Gruppe, eine Isooxazol-Gruppe, eine Thiazol-Gruppe, eine Isothiazol-Gruppe, eine Oxadiazol-Gruppe, eine Thiadiazol-Gruppe, eine Benzopyrazol-Gruppe, eine Benzimidazol-Gruppe, eine Benzoxazol-Gruppe, eine Benzothiazol-Gruppe, eine Benzoxadiazol-Gruppe, eine Benzothiadiazol-Gruppe, eine 5,6,7,8-Tetrahydroisoquinolin-Gruppe oder eine 5,6,7,8-Tetrahydrochinolin-Gruppe ist, wobei optional $Ar_{11}$ durch eine der Formeln 11-1 bis 11-51 dargestellt ist:

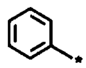
11-1

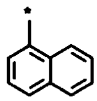
11-2

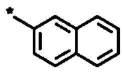
11-3

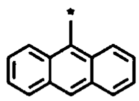
11-4

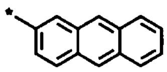
11-5

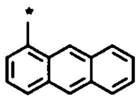
11-6

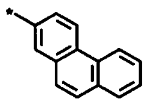
11-7

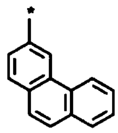
11-8

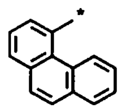
11-9

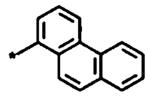
11-10

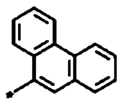
11-11

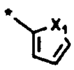
11-12

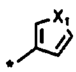
11-13

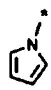
11-14

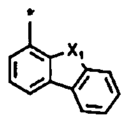
11-15

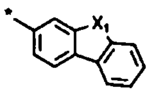
11-16

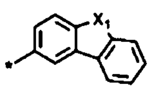
11-17

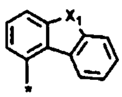
11-18

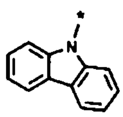
11-19

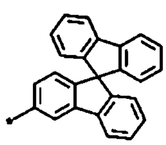
11-20

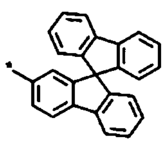
11-21

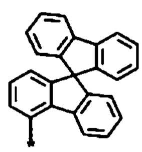
11-22

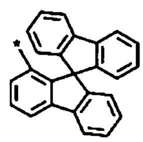
11-23

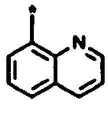
11-24

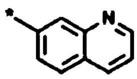
11-25

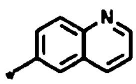
11-26

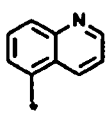
11-27

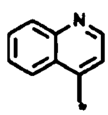
11-28

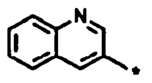 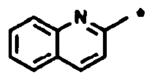 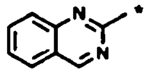 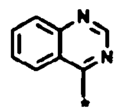 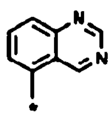

11-29 11-30 11-31 11-32 11-33

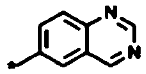 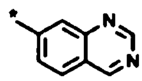 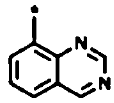 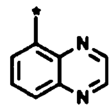 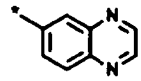

11-34 11-35 11-36 11-37 11-38

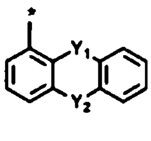 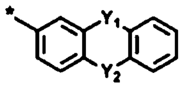 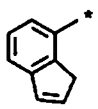 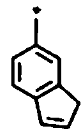 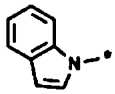

11-39 11-40 11-41 11-42 11-43

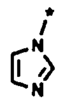 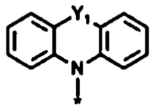 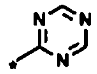 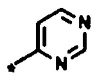 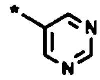

11-44 11-45 11-46 11-47 11-48

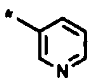 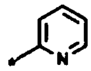 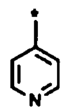

11-49 11-50 11-51

wobei in den Formeln 11-1 bis 11-51:

$X_1$ O, S, $N(R_{1a})$ oder $C(R_{1a})(R_{1b})$ ist,
$Y_1$ O, S, $N(R_{1a})$ oder $C(R_{1a})(R_{1b})$ ist,
$Y_2$ O, S, $N(R_{2a})$ oder $C(R_{2a})(R_{2b})$ ist,
$R_{1a}$, $R_{1b}$, $R_{2a}$ und $R_{2b}$ jeweils dasselbe sind wie in Verbindung mit $R_{11}$ in Anspruch 1 definiert, und
* eine Bindungsstelle an ein benachbartes Atom bezeichnet.

**10.** Lichtemittierende Vorrichtung nach einem der Ansprüche 1 bis 9, wobei $L_{11}$, $L_{12}$ und $L_{31}$ bis $L_{33}$ jeweils unabhängig voneinander eines von Folgendem sind:

eine Einfachbindung; oder
eine Benzol-Gruppe, eine Naphthalin-Gruppe, eine Anthracen-Gruppe, eine Phenanthren-Gruppe, eine Triphenylen-Gruppe, eine Pyren-Gruppe, eine Chrysen-Gruppe, eine Cyclopentadien-Gruppe, eine 1,2,3,4-Tetrahydronaphthalin-Gruppe, eine Thiophen-Gruppe, eine Furan-Gruppe, eine Indol-Gruppe, eine Benzoborol-Gruppe, eine Benzophosphol-Gruppe, eine Inden-Gruppe, eine Benzosilol-Gruppe, eine Benzogermol-Gruppe, eine Benzothiophen-Gruppe, eine Benzoselenophen-Gruppe, eine Benzofuran-Gruppe, eine Carbazol-Gruppe, eine Dibenzoborol-Gruppe, eine Dibenzophosphol-Gruppe, eine Fluoren-Gruppe, eine Dibenzosilol-Gruppe, eine Dibenzogermol-Gruppe, eine Dibenzothiophen-Gruppe, eine Dibenzoselenophen-Gruppe, eine Dibenzofuran-Gruppe, eine Dibenzothiophen-5-oxid-Gruppe, eine 9H-Fluoren-9-on-Gruppe, eine Dibenzo-thiophen-5,5-dioxid-Gruppe, eine Azaindol-Gruppe, eine Azabenzoborol-Gruppe, eine Azabenzophosphol-Gruppe, eine Azainden-Gruppe, eine Azabenzosilol-Gruppe, eine Azabenzogermol-Gruppe, eine Azabenzothiophen-Gruppe, eine Azabenzoselenophen-Gruppe, eine Azabenzofuran-Gruppe, eine Azacarbazol-Gruppe, eine Azadibenzoborol-Gruppe, eine Azadibenzophosphol-Gruppe, eine Azafluoren-Gruppe, eine Azadibenzosilol-Gruppe, eine Azadibenzogermol-Gruppe, eine Azadibenzothiophen-Gruppe, eine Azadibenzoselenophen-Gruppe, eine Azadibenzofuran-Gruppe, eine Azadibenzothiophen-5-oxid-Gruppe, eine Aza-9H-Fluoren-9-on-Gruppe, eine Azadibenzothiophen-5,5-dioxid-Gruppe, eine Pyridin-Gruppe, eine Pyrimidin-Gruppe,

eine Pyrazin-Gruppe, eine Pyridazin-Gruppe, eine Triazin-Gruppe, eine Chinolin-Gruppe, eine Isochinolin-Gruppe, eine Chinoxalin-Gruppe, eine Chinazolin-Gruppe, eine Phenantrolin-Gruppe, eine Pyrrol-Gruppe, eine Pyrazol-Gruppe, eine Imidazol-Gruppe, eine Triazol-Gruppe, eine Oxazol-Gruppe, eine Isooxazol-Gruppe, eine Thiazol-Gruppe, eine Isothiazol-Gruppe, eine Oxadiazol-Gruppe, eine Thiadiazol-Gruppe, eine Benzopyrazol-Gruppe, eine Benzimidazol-Gruppe, eine Benzoxazol-Gruppe, eine Benzothiazol-Gruppe, eine Benzoxadiazol-Gruppe, eine Benzothiadiazol-Gruppe, eine 5,6,7,8-Tetrahydroisoquinolin-Gruppe oder eine 5,6,7,8-Tetrahydrochinolin-Gruppe, jeweils unsubstituiert oder mit mindestens einem $R_{10a}$ substituiert, wobei optional $L_{11}$, $L_{12}$ und $L_{31}$ bis $L_{33}$ jeweils unabhängig voneinander eines von Folgendem sind:

eine Einfachbindung; oder

eine Gruppe, die durch eine der Formeln 10-1 bis 10-41 dargestellt ist:

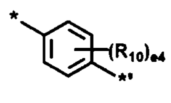
10-1

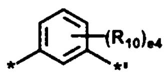
10-2

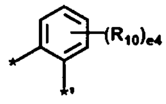
10-3

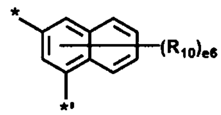
10-4

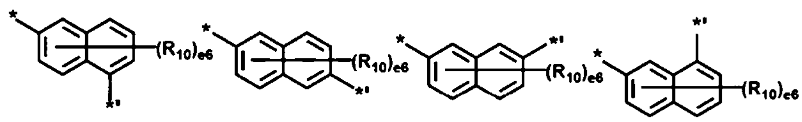
10-5 10-6 10-7 10-8

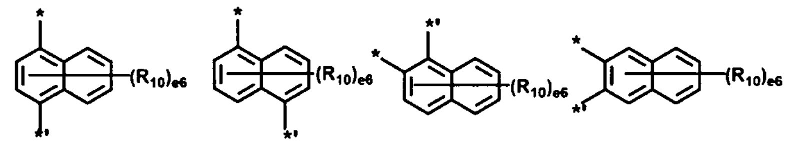
10-9 10-10 10-11 10-12

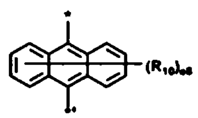
10-13

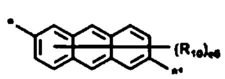
10-14

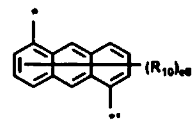
10-15

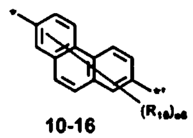
10-16

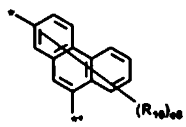
10-17

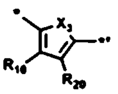
10-18

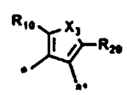
10-19

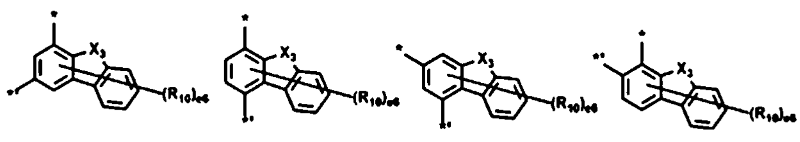
10-20 10-21 10-22 10-23

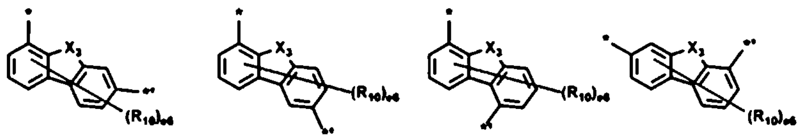
10-24 10-25 10-26 10-27

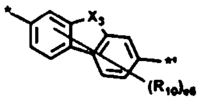

10-28

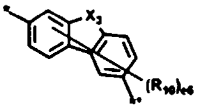

10-29

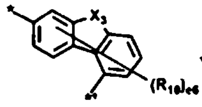

10-30

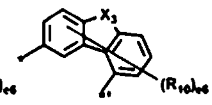

10-31

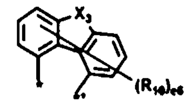

10-32

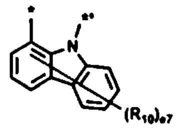

10-33

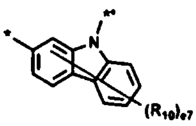

10-34

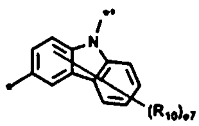

10-35

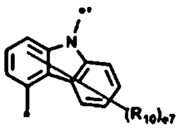

10-36

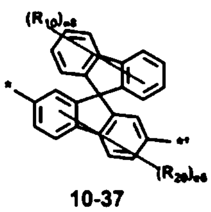

10-37

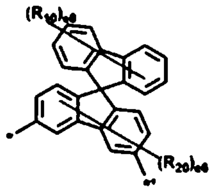

10-38

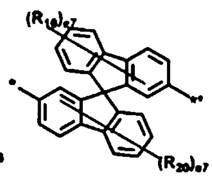

10-39

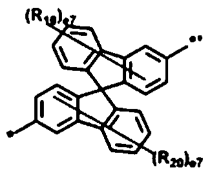

10-40

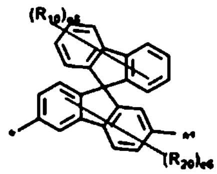

10-41

wobei in den Formeln 10-1 bis 10-41,
$X_3$ O, S, $N(R_{3a})$ oder $C(R_{3a})(R_{3b})$ ist,
$R_{10}$, $R_{20}$, $R_{3a}$ und $R_{3b}$ jeweils dasselbe sind wie in Verbindung mit $R_{11}$ in Anspruch 1 definiert,
e4 eine ganze Zahl von 1 bis 4 ist,
e6 eine ganze Zahl von 1 bis 6 ist,
e7 eine ganze Zahl von 1 bis 7 ist,
e8 eine ganze Zahl von 1 bis 8 ist, und
* und *' jeweils eine Bindungsstelle an ein benachbartes Atom bezeichnen.

**11.** Lichtemittierende Vorrichtung nach einem der Ansprüche 1 bis 10, wobei Formel 2 durch eine der Formeln 2-1 bis 2-6 dargestellt ist:

Formel 2-1

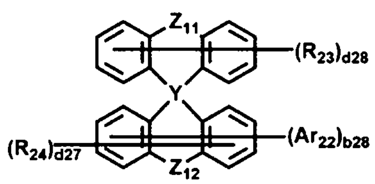

Formel 2-2

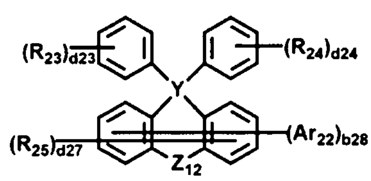

Formel 2-3

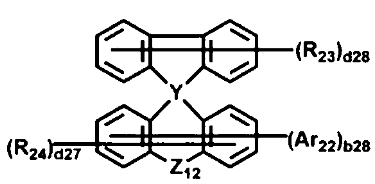

Formel 2-4

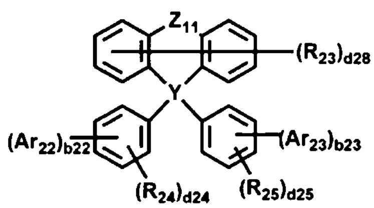

Formel 2-5

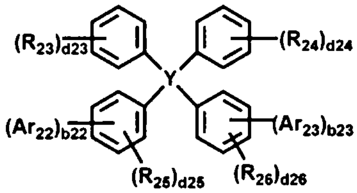

Formel 2-6

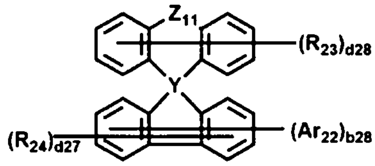

wobei in den Formeln 2-1 bis 2-6
Y C oder Si ist,
$Ar_{22}$ und $Ar_{23}$ jeweils dasselbe sind wie in Verbindung mit $Ar_{21}$ nach Anspruch 1 definiert,
b28 eine ganze Zahl von 1 bis 8 ist,
wobei in den Formeln 2-4 und 2-5 b22 eine ganze Zahl von 0 bis 5 ist, b23 eine ganze Zahl von 0 bis 5 ist und die Summe aus b22 und b23 eine ganze Zahl von 1 oder mehr ist,
$R_{23}$ bis $R_{26}$ jeweils unabhängig voneinander dasselbe sind wie in Verbindung mit $R_{21}$ in Anspruch 1 definiert,
d23 eine ganze Zahl von 1 bis 5 ist,
d24 eine ganze Zahl von 1 bis 5 ist,
d25 eine ganze Zahl von 1 bis 5 ist,
d26 eine ganze Zahl von 1 bis 5 ist,
d27 eine ganze Zahl von 1 bis 7 ist,
d28 eine ganze Zahl von 1 bis 8 ist, und
$Z_{12}$ O, S, $N(R_{24a})$ oder $C(R_{24a})(R_{24b})$ ist,
in den Formeln 2-1 und 2-4 $Z_{11}$ O, S, $N(R_{23a})$ oder $C(R_{23a})(R_{23b})$ ist,
in Formel 2-6 $Z_{11}$ $N(R_{23a})$ oder $C(R_{23a})(R_{23b})$ ist, und
$R_{23a}$, $R_{23b}$, $R_{24a}$ und $R_{24b}$ jeweils unabhängig voneinander dasselbe sind wie im Zusammenhang mit $R_{21a}$ in Anspruch 1 definiert.

**12.** Lichtemittierende Vorrichtung nach einem der Ansprüche 1 bis 11, wobei:

(i) ein durch

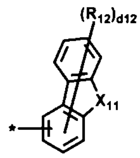

in Formel 1 dargestellter Rest durch eine der Formeln 1-1 bis 1-4 dargestellt ist:

Formel 1-1

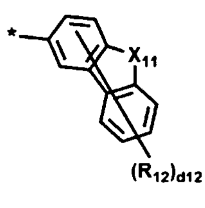

Formel 1-2

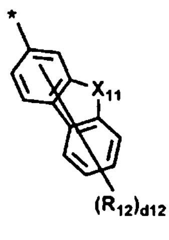

Formel 1-3

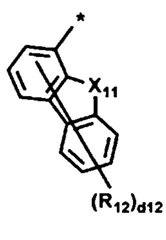

Formel 1-4

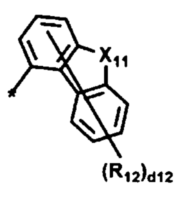

wobei in den Formeln 1-1 bis 1-4:

$X_{11}$, $R_{12}$ und d12 jeweils dasselbe sind wie in Anspruch 1 definiert, und
* eine Bindungsstelle an ein benachbartes Atom bezeichnet; und/oder

(ii) Formel 2 durch eine der Formeln 2-11 bis 2-14 dargestellt ist:

Formel 2-11

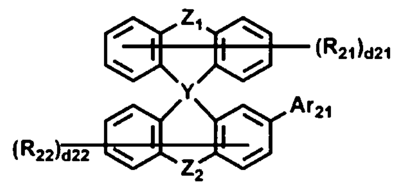

Formel 2-12

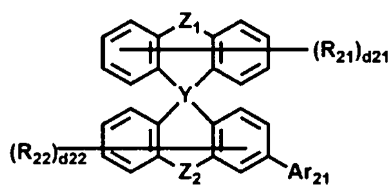

Formel 2-13

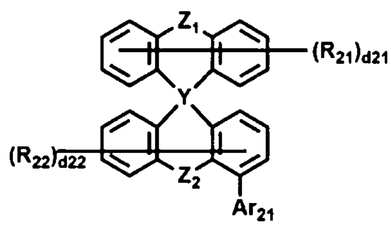

Formel 2-14

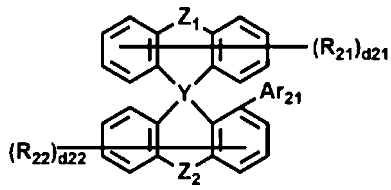

wobei in den Formeln 2-11 bis 2-14 Y, $Z_1$, $Z_2$, $Ar_{21}$, $R_{21}$, $R_{22}$, d21 und d22 jeweils dasselbe sind wie nach Anspruch 1 definiert.

**13.** Lichtemittierende Vorrichtung nach einem der Ansprüche 1 bis 12, wobei $R_1$ bis $R_8$, $R_{11}$, $R_{11a}$, $R_{11b}$, $R_{12}$, $R_{21}$, $R_{21a}$, $R_{21b}$, $R_{22}$, $R_{22a}$, $R_{22b}$, $R_{32}$, $R_{33}$, $R_{31a}$, $R_{32a}$ und $R_{33a}$ jeweils unabhängig voneinander aus Folgendem ausgewählt sind:

Wasserstoff, Deuterium, -F, -Cl, -Br, -I, eine Hydroxyl-Gruppe, eine Cyano-Gruppe, eine Nitro-Gruppe, eine Amidino-Gruppe, eine Hydrazino-Gruppe, eine Hydrazono-Gruppe, eine $C_1$-$C_{20}$-Alkyl-Gruppe und eine $C_1$-$C_{20}$-Alkoxy-Gruppe;
eine $C_1$-$C_{20}$-Alkyl-Gruppe und eine $C_1$-$C_{20}$-Alkoxy-Gruppe, die jeweils mit mindestens einem von Folgendem substituiert sind: Deuterium, -F, -Cl, -Br, -I, $-CD_3$, $-CD_2H$, $-CDH_2$, $-CF_3$, $-CF_2H$, $-CFH_2$, eine Hydroxyl-Gruppe, eine Cyano-Gruppe, eine Nitro-Gruppe, eine Amidino-Gruppe, eine Hydrazino-Gruppe, eine Hydrazono-Gruppe, eine $C_1$-$C_{10}$-Alkyl-Gruppe, eine Cyclopentyl-Gruppe, eine Cyclohexyl-Gruppe, eine Cycloheptyl-Gruppe, eine Cyclooctyl-Gruppe, eine Adamantanyl-Gruppe, eine Norbornanyl-Gruppe, eine Norbornenyl-Gruppe, eine Cyclopentenyl-Gruppe, eine Cyclohexenyl-Gruppe, eine Cycloheptenyl-Gruppe, eine Phenyl-Gruppe, eine Biphenyl-Gruppe, eine Naphthyl-Gruppe, eine Pyridinyl-Gruppe und eine **Pyrimidinyl-Gruppe,**
eine Cyclopentyl-Gruppe, eine Cyclohexyl-Gruppe, eine Cycloheptyl-Gruppe, eine Cycloctyl-Gruppe, eine Adamantanyl-Gruppe, eine Norbornanyl-Gruppe, eine Norbornenyl-Gruppe, eine Cyclopentenyl-Gruppe, eine Cyclohexenyl-Gruppe, eine Cycloheptenyl-Gruppe, eine Phenyl-Gruppe, eine Biphenyl-Gruppe, eine $C_1$-$C_{10}$-Alkylphenyl-Gruppe, eine Naphthyl-Gruppe, eine Fluorenyl-Gruppe, eine Phenanthrenyl-Gruppe, eine Anthracenyl-Gruppe, eine Fluoranthenyl-Gruppe, eine Triphenylenyl-Gruppe, eine Pyrenyl-Gruppe, eine Chrysenyl-Gruppe, eine Pyrrolyl-Gruppe, eine Thienyl-Gruppe, eine Furanyl-Gruppe, eine Imidazolyl-Gruppe, eine Pyrazolyl-Gruppe, eine Thiazolyl-Gruppe, eine Isothiazolyl-Gruppe, eine Oxazolyl-Gruppe, eine Isoxazolyl-Gruppe, eine Pyridinyl-Gruppe, eine Pyrazinyl-Gruppe, eine Pyrimidinyl-Gruppe, eine Pyridazinyl-Gruppe, eine Isoindolyl-Gruppe, eine Indolyl-Gruppe, eine Indazolyl-Gruppe, eine Purinyl-Gruppe, eine Chinolinyl-Gruppe, eine Isochinolinyl-Gruppe, eine Penzochinolinyl-Gruppe, eine Chinoxalinyl-Gruppe, eine Chinazolinyl-Gruppe, eine Cinnolinyl-Gruppe, eine Carbazolyl-Gruppe, eine Phenanthrolinyl-Gruppe, eine Benzimidazolyl-Gruppe, eine Benzofuranyl-Gruppe, eine Benzothienyl-Gruppe, eine Benzoisothiazolyl-Gruppe, eine Benzoxazolyl-Gruppe, eine Benzoisoxazolyl-Gruppe, eine Triazolyl-Gruppe, eine Tetrazolyl-Gruppe, eine Oxadiazolyl-Gruppe, eine Triazinyl-Gruppe, eine Dibenzofuranyl-Gruppe, eine Dibenzothienyl-Gruppe, eine Benzocarbazolyl-Gruppe, eine Dibenzocarbazolyl-Gruppe, eine Imidazopyridinyl-Gruppe, eine Imidazopyrimidinyl-Gruppe, eine Azacarbazolyl-Gruppe, eine Azadibenzofuranyl-Gruppe, eine Azadibenzothienyl-Gruppe, eine Azafluorenyl-Gruppe und eine Azadibenzosilolyl-Gruppe, jeweils unsubstituiert oder mit mindestens einem von Folgendem substituiert: Deuterium, -F, -Cl, -Br, -I, $-CD_3$, $-CD_2H$, $-CDH_2$, $-CF_3$, $-CF_2H$, $-CFH_2$, eine Hydroxyl-Gruppe, eine Cyano-Gruppe, eine Nitro-Gruppe, eine Amidino-Gruppe, eine Hydrazino-Gruppe, eine Hydrazono-Gruppe, eine $C_1$-$C_{20}$-Alkyl-Gruppe, eine $C_1$-$C_{20}$-Alkoxy-Gruppe, eine Cyclopentyl-Gruppe, eine Cyclohexyl-Gruppe, eine Cycloheptyl-Gruppe, eine Cycloctyl-Gruppe, eine Adamantanyl-Gruppe, eine Norbornanyl-Gruppe, eine Norbornenyl-Gruppe, eine Cyclopentenyl-Gruppe, eine Cyclohexenyl-Gruppe, eine Cycloheptenyl-Gruppe,

eine Phenyl-Gruppe, eine Biphenyl-Gruppe, eine $C_1$-$C_{10}$-Alkylphenyl-Gruppe, eine Naphthyl-Gruppe, eine Fluorenyl-Gruppe, eine Phenanthrenyl-Gruppe, eine Anthracenyl-Gruppe, eine Fluoranthenyl-Gruppe, eine Triphenylenyl-Gruppe, eine Pyrenyl-Gruppe, eine Chrysenyl-Gruppe, eine Pyrrolyl-Gruppe, eine Thienyl-Gruppe, eine Furanyl-Gruppe, eine Imidazolyl-Gruppe, eine Pyrazolyl-Gruppe, eine Thiazolyl-Gruppe, eine Isothiazolyl-Gruppe, eine Oxazolyl-Gruppe, eine Isoxazolyl-Gruppe, eine Pyridinyl-Gruppe, eine Pyrazinyl-Gruppe, eine Pyrimidinyl-Gruppe, eine Pyridazinyl-Gruppe, eine Isoindolyl-Gruppe, eine Indolyl-Gruppe, eine Indazolyl-Gruppe, eine Purinyl-Gruppe, eine Chinolinyl-Gruppe, eine Isochinolinyl-Gruppe, eine Benzochinolinyl-Gruppe, eine Chinoxalinyl-Gruppe, eine Chinazolinyl-Gruppe, eine Cinnolinyl-Gruppe, eine Carbazolyl-Gruppe, eine Phenanthrolinyl-Gruppe, eine Benzimidazolyl-Gruppe, eine Benzofuranyl-Gruppe, eine Benzothienyl-Gruppe, eine Benzoisothiazolyl-Gruppe, eine Benzoxazolyl-Gruppe, eine Benzoisoxazolyl-Gruppe, eine Triazolyl-Gruppe, eine Tetrazolyl-Gruppe, eine Oxadiazolyl-Gruppe, eine Triazinyl-Gruppe, eine Dibenzofuranyl-Gruppe, eine Dibenzothienyl-Gruppe, eine Benzocarbazolyl-Gruppe, eine Dibenzocarbazolyl-Gruppe, eine Imidazopyridinyl-Gruppe, eine Imidazopyrimidinyl-Gruppe, eine Azacarbazolyl-Gruppe, eine Azadibenzofuranyl-Gruppe, eine Azadibenzothienyl-Gruppe, eine Azafluorenyl-Gruppe, eine Azadibenzosilolyl-Gruppe, $-Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, $-S(=O)_2(Q_{31})$ und $-P(=O)(Q_{31})(Q_{32})$; und $-Si(Q_1)(Q_2)(Q_3)$, $-N(Q_1)(Q_2)$, $-B(Q_1)(Q_2)$, $-C(=O)(Q_1)$, $-S(=O)_2(Q_1)$ und $-P(=O)(Q_1)(Q_2)$, wobei $Q_1$ bis $Q_3$ und $Q_{31}$ bis $Q_{33}$ jeweils unabhängig voneinander aus Folgendem ausgewählt sind:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$ und $-CD_2CDH_2$, und
eine n-Propyl-Gruppe, eine Isopropyl-Gruppe, eine n-Butyl-Gruppe, eine Isobutyl-Gruppe, eine sec-Butyl-Gruppe, eine tert-Butyl-Gruppe, eine n-Pentyl-Gruppe, eine Isopentyl-Gruppe, eine sec-Pentyl-Gruppe, eine tert-Pentyl-Gruppe, eine Phenyl-Gruppe, eine Naphthyl-Gruppe, eine Pyridinyl-Gruppe, eine Pyrimidinyl-Gruppe, eine Pyridazinyl-Gruppe, eine Pyrazinyl-Gruppe und eine Triazinyl-Gruppe, jeweils unsubstituiert oder substituiert mit mindestens einem, das aus Folgendem ausgewählt ist: Deuterium, eine $C_1$-$C_{10}$-Alkyl-Gruppe, eine Phenyl-Gruppe, eine Biphenyl-Gruppe, eine Pyridinyl-Gruppe, eine Pyrimidinyl-Gruppe, eine Pyridazinyl-Gruppe, eine Pyrazinyl-Gruppe und eine Triazinyl-Gruppe.

**14.** Lichtemittierende Vorrichtung nach einem der Ansprüche 1 bis 13, wobei die mindestens eine erste Verbindung aus Gruppe I und die mindestens eine zweite Verbindung aus Gruppe II ausgewählt ist:

Gruppe I

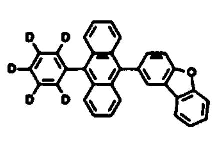

1-1

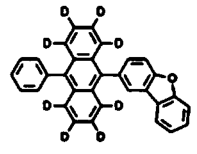

1-2

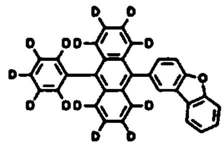

1-3

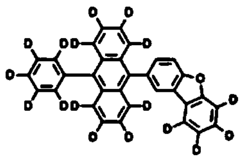

1-4

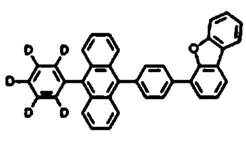

1-5

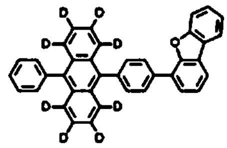

1-6

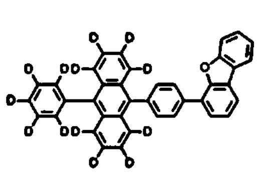

1-7

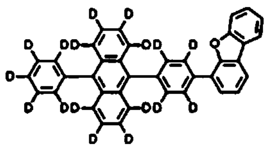

1-8

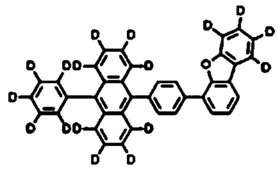

1-9

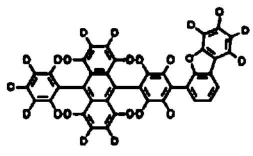

1-10

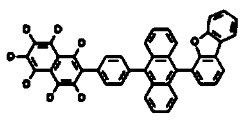

1-11

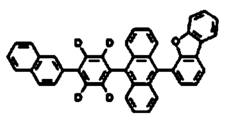

1-12

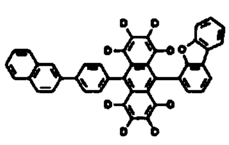

1-13

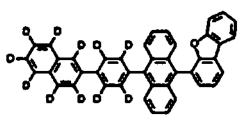

1-14

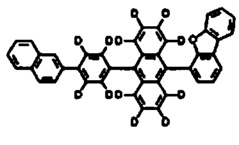

1-15

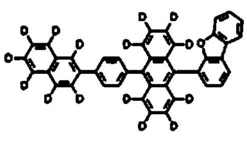

1-16

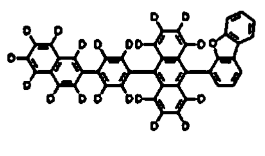

1-17

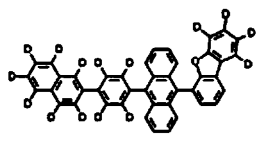

1-18

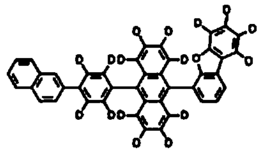

1-19

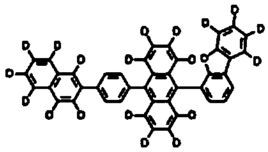

1-20

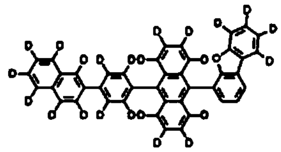

1-21

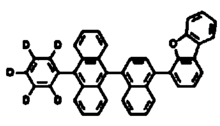

1-22

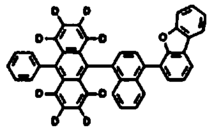

1-23

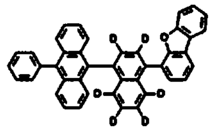

1-24

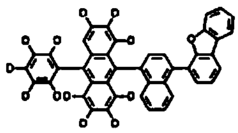

1-25

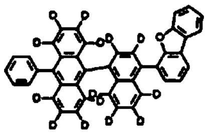

1-26

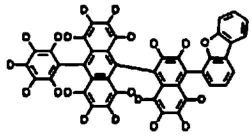

1-27

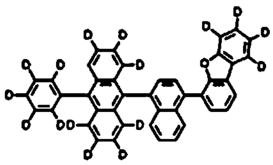

1-28

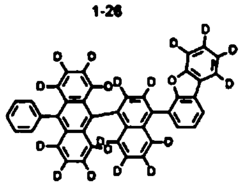

1-29

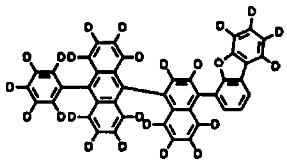

1-30

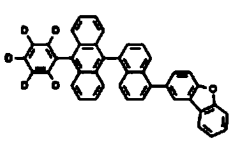

1-31

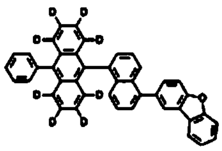

1-32

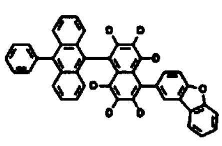

1-33

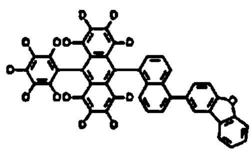

1-34

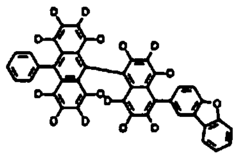

1-35

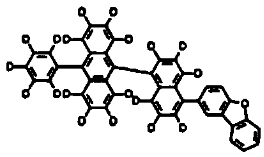

1-36

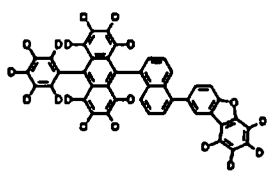

1-37

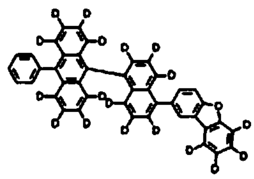

1-38

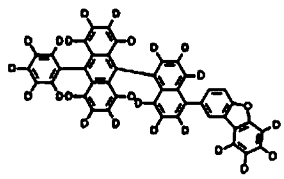

1-39

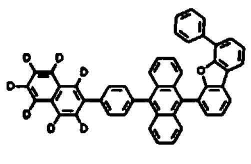
1-40

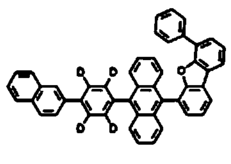
1-41

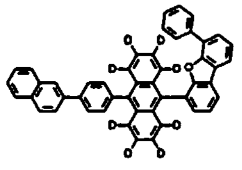
1-42

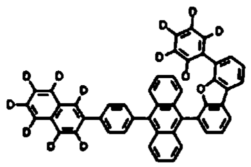
1-43

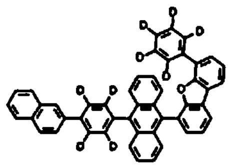
1-44

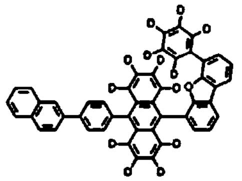
1-45

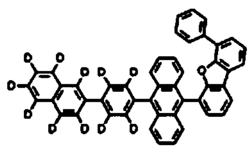
1-46

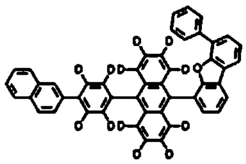
1-47

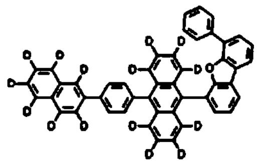
1-48

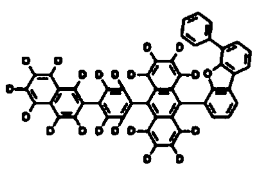
1-49

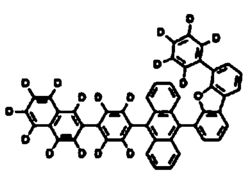
1-50

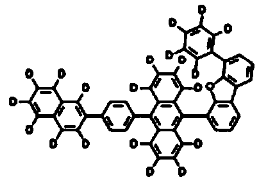
1-51

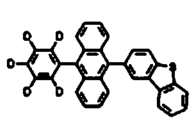
1-52

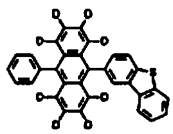
1-53

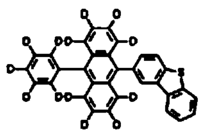
1-54

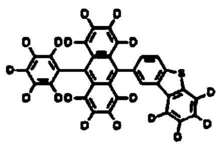
1-55

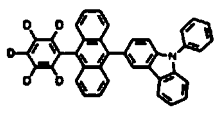
1-56

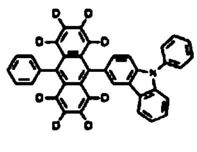
1-57

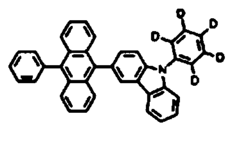
1-58

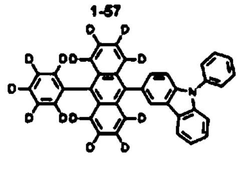
1-59

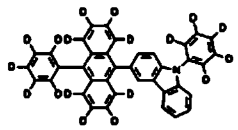

1-60

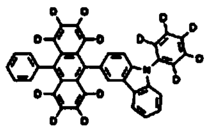

1-61

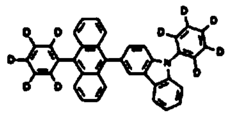

1-62

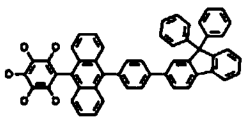

1-63

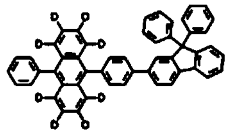

1-64

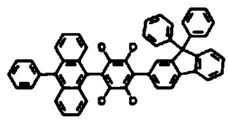

1-65

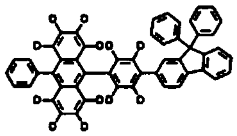

1-66

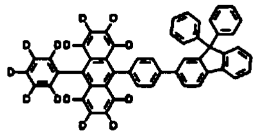

1-67

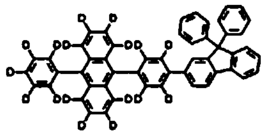

1-68

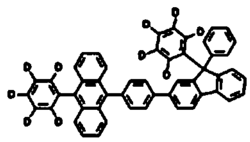

1-69

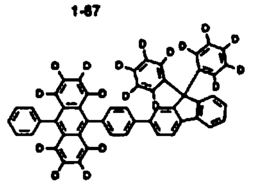

1-70

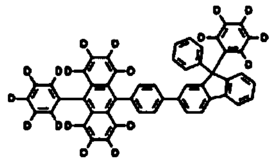

1-71

Gruppe II

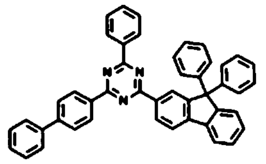

2-1

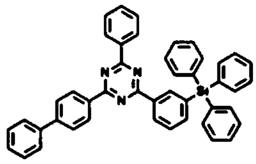

2-2

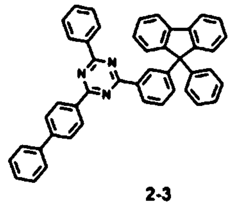

2-3

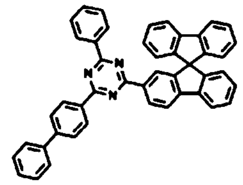

2-4

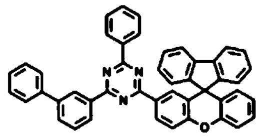

2-5

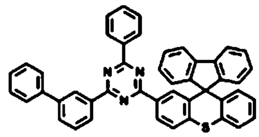

2-6

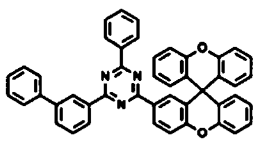

2-7

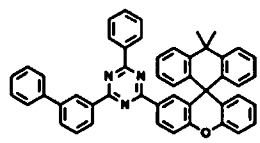

2-8

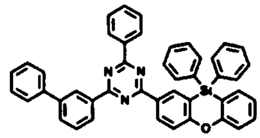

2-9

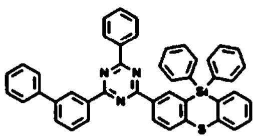

2-10

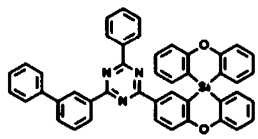

2-11

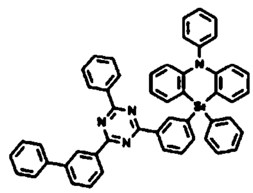

2-12

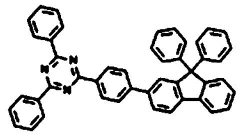

2-13

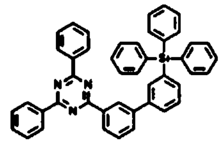

2-14

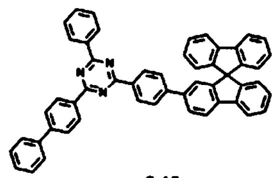

2-15

.

**15.** Elektronische Einrichtung, umfassend:

die lichtemittierende Vorrichtung nach einem der Ansprüche 1 bis 14, und
einen Dünnschichttransistor,
wobei der Dünnschichttransistor eine Source-Elektrode (260) und eine Drain-Elektrode (270) umfasst, und die erste Elektrode der lichtemittierenden Vorrichtung mit der Source-Elektrode oder der Drain-Elektrode elektrisch gekoppelt ist, wobei die Einrichtung optional ferner einen Farbfilter, eine Farbwandlungsschicht, eine Berührungsbildschirm-Schicht, eine polarisierende Schicht oder eine beliebige Kombination davon umfasst.

## Revendications

**1.** Dispositif électroluminescent comprenant :

une première électrode (110) ;
une deuxième électrode (150) face à la première électrode ;
une couche intermédiaire (130) entre la première électrode et la deuxième électrode et comprenant une couche d'émission ;
**caractérisé en ce que** la couche intermédiaire (130) comprend en outre au moins un premier composé représenté par la formule 1; et au moins un deuxième composé représenté par la formule 2 :

Formule 1

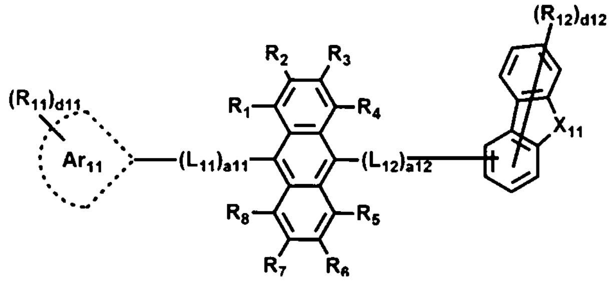

Formule 2

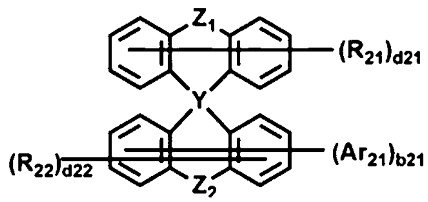

Formule 3

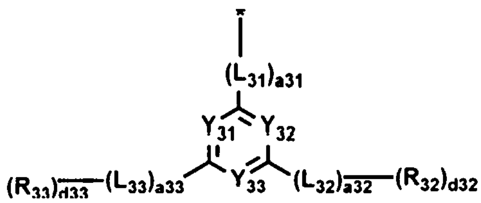

dans lequel, dans les formules 1, 2 et 3,
$X_{11}$ est O, S, $N(R_{11a})$, ou $C(R_{11a})(R_{11b})$,
$Ar_{11}$ est un groupe carbocyclique $C_5$ - $C_{60}$ ou un groupe hétérocyclique $C_1$ - $C_{60}$, $L_{11}$, $L_{12}$, et $L_{31}$ à $L_{33}$ sont chacun indépendamment une liaison simple, un groupe carbocyclique $C_5$ - $C_{60}$ non substitué ou substitué par au moins un $R_{10a}$, ou un groupe hétérocyclique $C_1$ - $C_{60}$ non substitué ou substitué par au moins un $R_{10a}$,
a11, a12 et a31 à a33 sont chacun indépendamment un entier de 1 à 3 ,
Y est C ou Si,
$Z_1$ représente l'absence de liaison, une liaison simple, O,S,$N(R_{21a})$, ou $C(R_{21a})(R_{21}b)$,
$Z_2$ représente l'absence de liaison, une liaison simple, O,S,$N(R_{22a})$, ou $C(R_{22a})(R_{22}b)$,
dans lequel, lorsque $Z_1$ est O ou S, $Z_2$ n'est pas une liaison simple,
$Ar_{21}$ est un groupe représenté par la Formule 3,
b21 est un entier compris entre 1 et 10.
$Y_{31}$ est N ou $C(R_{31a})$,
$Y_{32}$ est N ou $C(R_{32a})$,
$Y_{33}$ est N ou $C(R_{33a})$,
*Dans la formule 3, indique un site de liaison à un atome voisin.
$R_1$ à $R_8$, $R_{11}$, $R_{11a}$, $R_{11b}$, $R_{12}$, $R_{21}$, $R_{21a}$, $R_{21b}$, $R_{22}$, $R_{22a}$, $R_{22b}$, $R_{32}$, $R_{33}$, $R_{31a}$, $R_{32a}$, et $R_{33a}$ représentent chacun indépendamment un hydrogène, un deutérium,-F, -Cl, -Br, -I, un groupe hydroxyle, un groupe cyano, un groupe nitro, un groupe amidino, un groupe hydrazino, un groupe hydrazono, un groupe alkyle $C_1$ - $C_{60}$ non substitué ou substitué par au moins un groupe alcényle $R_{10a}$, a $C_2$ - $C_{60}$ non substitué ou substitué par au moins un groupe alcynyle $R_{10a}$, un groupe alcynyle $C_2$ - $C_{60}$ non substitué ou substitué par au moins un $R_{10a}$, un groupe alcoxy $C_1$ - $C_{60}$ non substitué ou substitué par au moins un groupe carbocyclique $R_{10a}$, a$C_3$ - $C_{60}$ non substitué ou substitué par au moins un groupe hétérocyclique $R_{10a}C_1$-$C_{60}$ non substitué ou substitué par au moins un groupe $R_{10a}$, un groupe aryloxy $C_6$ - $C_{60}$ non substitué ou substitué par au moins un au moins un $R_{10a}$, un groupe arylthio $C_6$-$C_{60}$ non substitué ou substitué par au moins un $R_{10a}$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, ou $P(=O)(Q_1)(Q_2)$,
d11 est un entier compris entre 1 et 10,
d12 est un entier compris entre 1 et 7,

d21 est un entier compris entre 1 et 10,
d22 est un entier compris entre 1 et 9,
d32 est 1,
d33 vaut 1,
l'au moins un premier composé comprend au moins un atome de deutérium, et $R_{10a}$ est :

deutérium, -F, -Cl, -Br, -I, un groupe hydroxyle, un groupe cyano ou un groupe nitro,
un groupe alkyle $C_1$ - $C_{60}$, un groupe alcényle $C_2$ - $C_{60}$, un groupe alcynyle $C_2$ - $C_{60}$ ou un groupe alcoxy $C_1$ - $C_{60}$, chacun non substitué ou substitué par du deutérium, -F, -Cl, -Br, -I, un groupe hydroxyle, un groupe cyano, un groupe nitro, un groupe carbocyclique $C_3$ - $C_{60}$, un groupe hétérocyclique $C_1$ - $C_{60}$, un groupe aryloxy $C_6$ - $C_{60}$, un groupe arylthio $C_6$ - $C_{60}$, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, $-P(=O)(Q_{11})(Q_{12})$, ou toute combinaison de ceux-ci,
un groupe carbocyclique $C_3$ - $C_{60}$, un groupe hétérocyclique $C_1$ - $C_{60}$, un groupe aryloxy $C_6$ - $C_{60}$ ou un groupe arylthio $C_6$ - $C_{60}$, non substitué ou substitué par du deutérium, -F, -Cl, -Br, -I, un groupe hydroxyle, un groupe cyano, un groupe nitro, un groupe alkyle $C_1$ - $C_{60}$, un groupe alcényle $C_2$ - $C_{60}$, un groupe alcynyle $C_2$ - $C_{60}$, un groupe alcoxy $C_1$ - $C_{60}$, un groupe carbocyclique $C_3$ - $C_{60}$, un groupe hétérocyclique $C_1$ $C_{60}$, un groupe aryloxy $C_6$ - $C_{60}$, un groupe arylthio $C_6$ - $C_{60}$, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, ou toute combinaison de ceux-ci, ou
$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, ou $P(=O)(Q_{31})(Q_{32})$, et
dans lequel $Q_1$ à $Q_3$, $Q_{11}$ à $Q_{13}$, $Q_{21}$ à $Q_{23}$ et $Q_{31}$ à $Q_{33}$ représentent chacun indépendamment : un hydrogène ; un deutérium ; -F ; -Cl ; -Br ; -I ; un groupe hydroxyle ; un groupe cyano ; un groupe nitro ; un groupe alkyle $C_1$ - $C_{60}$ ; un groupe alcényle $C_2$ - $C_{60}$ ; un groupe alcynyle $C_2$ - $C_{60}$ ; un groupe alcoxy $C_1$ - $C_{60}$ ; ou un groupe carbocyclique $C_3$ - $C_{60}$ ou un groupe hétérocyclique $C_1$ - $C_{60}$, chacun non substitué ou substitué par du deutérium, -F, un groupe cyano, un groupe alkyle $C_1$ - $C_{60}$, un groupe alcoxy $C_1$ - $C_{60}$, un groupe phényle, un groupe biphényle ou toute combinaison de ceux-ci.

**2.** Dispositif électroluminescent selon la revendication 1, dans lequel la couche d'émission comprend l'au moins un premier composé.

**3.** Dispositif électroluminescent selon la revendication 1 ou la revendication 2, dans lequel la première électrode est une anode,

la deuxième électrode est une cathode,
La couche intermédiaire comprend en outre une région de transport de trous entre la couche d'émission et la première électrode,
la couche intermédiaire comprend en outre une région de transport d'électrons entre la couche d'émission et la deuxième électrode,
la région de transport de trous comprend une couche d'injection de trous, une couche de transport de trous, une couche auxiliaire d'émission, une couche de blocage d'électrons, ou toute combinaison de celles-ci, et
la région de transport d'électrons comprend une couche tampon, une couche de blocage des trous, une couche de transport d'électrons, une couche de contrôle d'électrons, une couche d'injection d'électrons, ou toute combinaison de celles-ci.

**4.** Dispositif électroluminescent selon la revendication 3, dans lequel la région de transport d'électrons comprend l'au moins un deuxième composé.

**5.** Dispositif électroluminescent selon l'une quelconque des revendications 2 à 4, dans lequel la couche d'émission comprend en outre un troisième composé, et
le troisième composé est un composé fluorescent ou un composé à fluorescence retardée activée thermiquement satisfaisant l'équation 1 :

Équation 1

$$\Delta E_{ST} = S1 - T1 \leq 0{,}3\ eV$$

dans lequel, dans l'équation 1, S1 est un niveau d'énergie singulet excité le plus bas (eV) du composé à fluorescence retardée activée thermiquement, et T1 est un niveau d'énergie triplet excité le plus bas (eV) du composé TADF.

6. Dispositif électroluminescent organique selon la revendication 4 ou la revendication 5, comprenant en outre une couche de recouvrement à l'extérieur de la deuxième électrode et présentant un indice de réfraction à une longueur d'onde de 589 nm égal ou supérieur à 1,6.

7. Dispositif électroluminescent selon l'une quelconque des revendications 2 à 6, dans lequel la couche d'émission comprend en outre un troisième composé, et
le troisième composé comprend au moins un des composés représentés par les formules 4-1 à 4-9 :

Formule 4-1

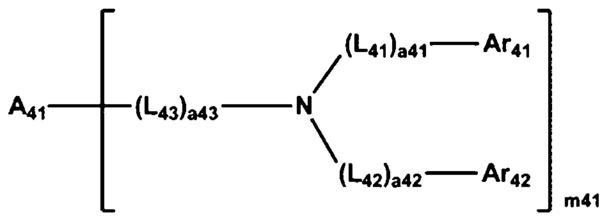

Formule 4-2

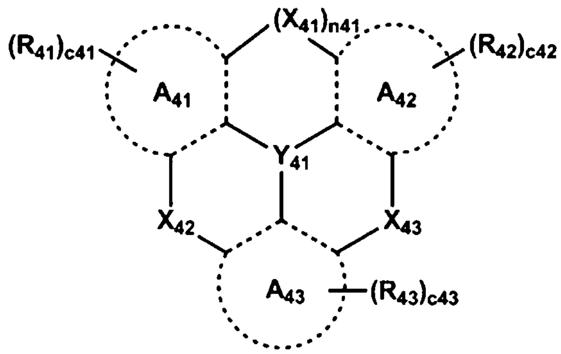

Formule 4-3

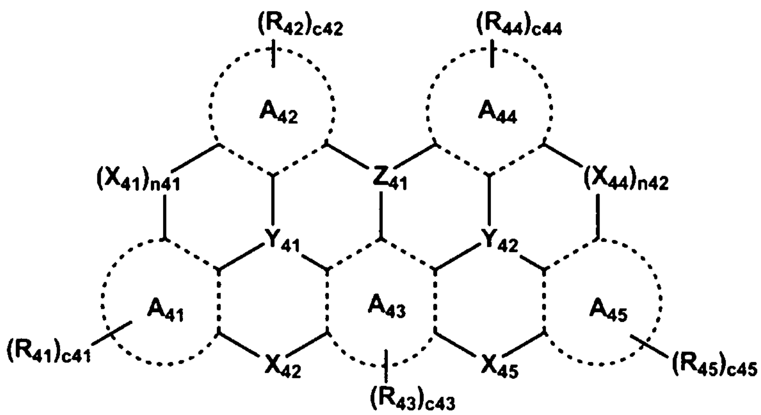

Formule 4-4

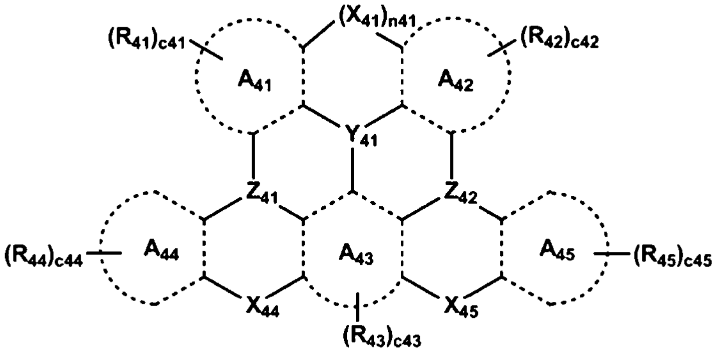

Formule 4-5 $(EDG_{b41} - [(L_{44})_{a44} - (EWG)_{t42}]_{s41}$

Formule 4-6 $(EWG_{t42} - [(L_{44})_{a44} - (EDG)b_{41}]_{s42}$

Formule 4-7 $(EDG_{b411} - (L_{44})_{a44} - (EWG_{t42} - (L_{45})_{a45} - (EDG)_{b412}$

Formule 4-8 $(EWG_{t421} - (L_{44})_{a44}\text{-}(EDG_4)_{b41} - (L_{45})_{a45} - (EWG)_{t422}$

Formule 4-9 $A_{41}\text{-}[(L_{44})_{a44} - (EDG)b_{41}]_{s43}$

dans lequel, dans la formule 4-1,
$A_{41}$ est un groupe carbocyclique $C_3$ - $C_{60}$ non substitué ou substitué par au moins un $R_{10a}$ ou un groupe hétérocyclique $C_1$ - $C_{60}$ non substitué ou substitué par au moins un $R_{10a}$,
$L_{41}$ à $L_{43}$ sont chacun indépendamment une liaison simple, un groupe carbocyclique $C_3$ - $C_{60}$ non substitué ou substitué par au moins un $R_{10a}$, ou un groupe hétérocyclique $C_1$ - $C_{60}$ non substitué ou substitué par au moins un $R_{10a}$,
a41 à a43 sont chacun indépendamment un entier de 1 à 3,
$Ar_{41}$ et $Ar_{42}$ sont chacun indépendamment un groupe carbocyclique $C_3$ - $C_{60}$ non substitué ou substitué par au moins un $R_{10a}$, un groupe hétérocyclique $C_1$ - $C_{60}$ non substitué ou substitué par au moins un $R_{10a}$, ou un groupe aryloxy $C_6$ - $C_{60}$ non substitué ou substitué par au moins un $R_{10a}$, et
m41 est un entier de 1 à 6,
dans les formules 4-2 à 4-4,
$X_{41}$ à $X_{45}$ sont chacun indépendamment une liaison simple, O, S, $N(R_{46})$, $B(R_{46})$, $C(R_{46})(R_{47})$, ou $Si(R_{46})(R_{47})$,
n 41 et n 42 sont chacun indépendamment 0, 1 ou 2, dans lequel, lorsque n 41 est 0, $A_{41}$ et $A_{42}$ ne sont pas liés l'un à l'autre, et lorsque n42 est 0, $A_{44}$ et $A_{45}$ ne sont pas liés l'un à l'autre,
$Y_{41}$ et $Y_{42}$ sont chacun indépendamment N, B, ou P,
$Z_{41}$ et $Z_{42}$ sont chacun indépendamment N, $C(R_{48})$, ou $Si(R_{48})$,
$A_{41}$ à $A_{45}$ sont chacun sélectionnés indépendamment parmi un groupe carbocyclique $C_3$-C30 et un groupe hétérocyclique $C_1$ - $C_{30}$,
$R_{41}$ à $R_{48}$ représentent chacun indépendamment un hydrogène, un deutérium, un groupe -F, -Cl, -Br, -I, un groupe hydroxyle, un groupe cyano, un groupe nitro, un groupe alkyle $C_1$ - $C_{60}$ non substitué ou substitué par au moins un $R_{10a}$, un groupe alcényle $C_2$ - $C_{60}$ non substitué ou substitué par au moins un $R_{10a}$, un groupe alcynyle $C_2$ - $C_{60}$ non substitué ou substitué par au moins un $R_{10a}$, un groupe alcoxy $C_1$ - $C_{60}$ non substitué ou substitué par au moins un $R_{10a}$, un groupe carbocyclique $C_3$ - $C_{60}$ non substitué ou substitué par au moins un $R_{10a}$, un groupe hétérocyclique $C_1$ - $C_{60}$ non substitué ou substitué par au moins un $R_{10a}$, un groupe aryloxy $C_6$ - $C_{60}$ non substitué ou substitué par au moins un $R_{10a}$, un groupe arylthio $C_6$ - $C_{60}$ non substitué ou substitué par au moins un $R_{10a}$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, ou $-P(=O)(Q_1)(Q_2)$, et
c41 à c45 sont chacun indépendamment un entier de 1 à 10, et
dans les formules 4-5 à 4-9,
$A_{41}$ est un groupe carbocyclique $C_3$ - $C_{60}$ non substitué ou substitué par au moins un $R_{10a}$ ou un groupe hétérocyclique $C_1$ - $C_{60}$ non substitué ou substitué par au moins un $R_{10a}$,
EDG indique un groupe donneur d'électrons, et EWG indique un groupe attracteur d'électrons.

b41, b411, b412, t42, t421 et t422 sont chacun indépendamment un entier de 1 à 3,
$L_{44}$ et $L_{45}$ sont chacun indépendamment une liaison simple, un groupe carbocyclique $C_3$ - $C_{60}$ non substitué ou substitué par au moins un $R_{10a}$, ou un groupe hétérocyclique $C_1$ - $C_{60}$ non substitué ou substitué par au moins un $R_{10a}$,
a44 et a45 sont chacun indépendamment un entier de 1 à 3,
s41 et s42 sont chacun indépendamment un entier de 1 à 3,
s43 est un entier compris entre 1 et 6, et
$R_{10a}$ est identique à celle définie par rapport aux formules 1 à 3.

**8.** Dispositif électroluminescent selon l'une quelconque des revendications 1 à 7, dans lequel :

(i) la couche d'émission émet de la lumière bleue ou de la lumière bleu-vert ; et/ou
(ii) la formule 1 satisfait au moins une des conditions (1) à (7) :

**Condition (1)**
au moins un des $R_{11}$(s) dans un certain nombre de d11 comprend au moins un deutérium
**Condition (2)**
au moins un des $L_{11}$ (s) dans un certain nombre de a11 comprend au moins un deutérium
**Condition (3)**
au moins un des $R_1$ à $R_8$ comprend au moins un deutérium
**Condition (4)**
au moins un des $L_{12}$(s) dans un certain nombre de a12 comprend au moins un deutérium
**Condition (5)**
au moins un des $R_{12}$(s) dans un certain nombre de d12 comprend au moins un deutérium
**Condition (6)**
$X_{11}$ est $N(L_{11a})$, et $R_{11a}$ comprend au moins un deutérium
**Condition (7)**
$X_{11}$ est $C(R_{11a})(R_{11b})$, et au moins l'un de $R_{11a}$ et $R_{11b}$ comprend au moins un deutérium.

**9.** Dispositif électroluminescent selon l'une quelconque des revendications 1 à 8, dans lequel $Ar_{11}$ représente un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphtalène, un groupe thiophène, un groupe furane, un groupe indole, un groupe benzoborole, un groupe benzophosphole, un groupe indène, un groupe benzosilole, un groupe benzogermole, un groupe benzothiophène, un groupe benzosélénophène, un groupe benzofurane, un groupe carbazole, un groupe dibenzoborole, un groupe dibenzophosphole, un groupe fluorène, un groupe dibenzosilole, un groupe dibenzogermole, un groupe dibenzothiophène, un groupe dibenzosélénophène, un groupe dibenzofurane, un groupe dibenzothiophène 5-oxyde, un groupe 9H-fluorène-9-one, un groupe dibenzothiophène 5,5-dioxyde, un groupe azaindole, un groupe azabenzoborole, un groupe azabenzophosphole, un groupe azaindène, un groupe azabenzosilole, un groupe azabenzogermole, un groupe azabenzothiophène, un groupe azabenzosélénophène, un groupe azabenzofurane, un groupe azacarbazole, un groupe azadibenzoborole, un groupe azadibenzophosphole, un groupe azafluorène, un groupe azadibenzosilole, un groupe azadibenzogermole, un groupe azadibenzothiophène, un groupe azadibenzosélénophène, un groupe azadibenzofurane, un groupe azadibenzothiophène 5-oxyde, un groupe aza-9H-fluorène-9-one, un groupe azadibenzothiophène 5,5-dioxyde, un groupe pyridine, un groupe pyrimidine, un groupe pyrazine, un groupe pyridazine, un groupe triazine, un groupe quinoléine, un groupe isoquinoléine, un groupe quinoxaline, un groupe quinazoline, un groupe phénanthroline, un groupe pyrrole, un groupe pyrazole, un groupe imidazole, un groupe triazole, un groupe oxazole, un groupe isooxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, un groupe benzothiadiazole, un groupe 5,6,7,8-tétrahydroisoquinoléine ou un groupe 5,6,7,8-tétrahydroquinoléine, éventuellement représenté par l'une des formules 11-1 à $Ar_{11}$ 11-51 :

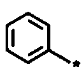
11-1

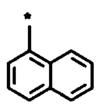
11-2

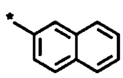
11-3

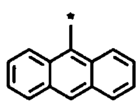
11-4

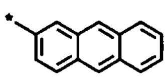
11-5

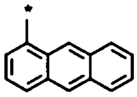 11-6 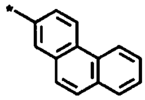 11-7 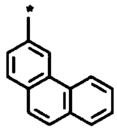 11-8 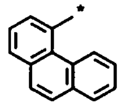 11-9 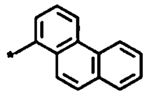 11-10

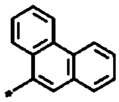 11-11 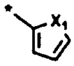 11-12 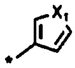 11-13 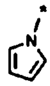 11-14 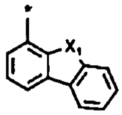 11-15

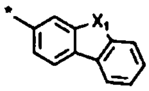 11-16 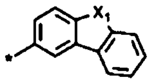 11-17 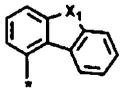 11-18 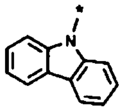 11-19

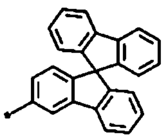 11-20 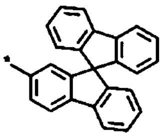 11-21 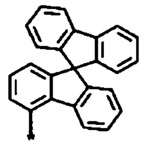 11-22 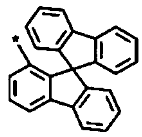 11-23

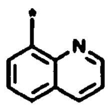 11-24 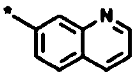 11-25 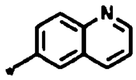 11-26 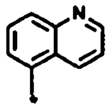 11-27 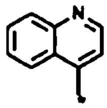 11-28

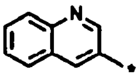 11-29 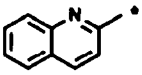 11-30 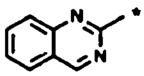 11-31 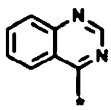 11-32 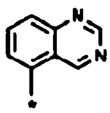 11-33

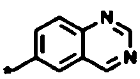 11-34 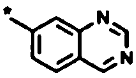 11-35 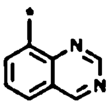 11-36 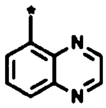 11-37 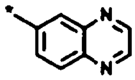 11-38

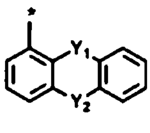 11-39 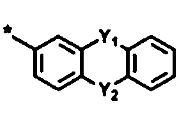 11-40 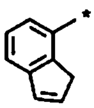 11-41 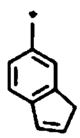 11-42 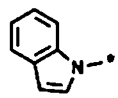 11-43

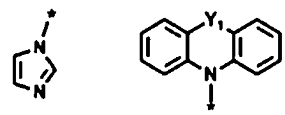 11-44 11-45 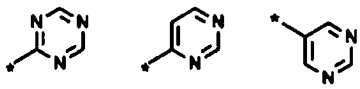 11-46 11-47 11-48

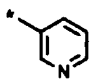 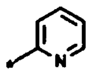 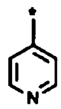

11-49 11-50 11-51

dans lequel, dans les formules 11-1 à 11-51 :

$X_1$ est O, S, $N(R_{1a})$, ou $C(R_{1a})(R_{1b})$,
$Y_1$ est O, S, $N(R_{1a})$, ou $C(R_{1a})(R_{1b})$,
$Y_2$ est O, S, $N(R_{2a})$, ou $C(R_{2a})(R_{2b})$,
$R_{1a}$, $R_{1b}$, $R_{2a}$, et $R_{2b}$ sont chacun identiques à ceux définis en relation avec $R_{11}$ dans la revendication 1, et
* indique un site de liaison avec un atome voisin.

**10.** Dispositif électroluminescent selon l'une quelconque des revendications 1 à 9, dans lequel $L_{11}$, $L_{12}$, et $L_{31}$ à $L_{33}$ sont chacun indépendamment :

une liaison simple ; ou
un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphtalène, un groupe thiophène, un groupe furane, un groupe indole, un groupe benzoborole, un groupe benzophosphole, un groupe indène, un groupe benzosilole, un groupe benzogermole, un groupe benzothiophène, un groupe benzosélénophène, un groupe benzofurane, un groupe carbazole, un groupe dibenzoborole, un groupe dibenzophosphole, un groupe fluorène, un groupe dibenzosilole, un groupe dibenzogermole, un groupe dibenzothiophène, un groupe dibenzosélénophène, un groupe dibenzofurane, un groupe 5-oxyde de dibenzothiophène, un groupe 9H-fluorène-9-one, un groupe dibenzothiophène 5,5-dioxyde, un groupe azaindole, un groupe azabenzoborole, un groupe azabenzophosphole, un groupe azaindène, un groupe azabenzosilole, un groupe azabenzogermole, un groupe azabenzothiophène, un groupe azabenzosélénophène, un groupe azabenzofurane, un groupe azacarbazole, un groupe azadibenzoborole, un groupe azadibenzophosphole, un groupe azafluorène, un groupe azadibenzosilole, un groupe azadibenzogermole, un groupe azadibenzothiophène, un groupe azadibenzosélénophène, un groupe azadibenzofurane, un groupe azadibenzothiophène 5-oxyde, un groupe aza-9H-fluorén-9-one, un groupe azadibenzothiophène 5,5-dioxyde, un groupe pyridine, un groupe pyrimidine, un groupe pyrazine, un groupe pyridazine, un groupe triazine, un groupe quinoléine, un groupe isoquinoléine, un groupe quinoxaline, un groupe quinazoline, un groupe phénanthroline, un groupe pyrrole, un groupe pyrazole, un groupe imidazole, un groupe triazole, un groupe oxazole, un groupe isooxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, un groupe benzothiadiazole, un groupe 5,6,7,8-tétrahydroisoquinoléine ou un groupe 5,6,7,8-tétrahydroquinoléine, chacun non substitué ou substitué par au moins un groupe $R_{10}$, éventuelement dans lequel $L_{11}$, $L_{12}$, et $L_{31}$ à $L_{33}$ représentent chacun indépendamment : une liaison simple ; ou
un groupe représenté par l'une des formules 10-1 à 10-41 :

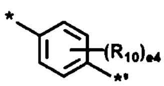 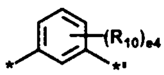 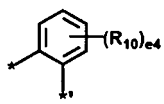 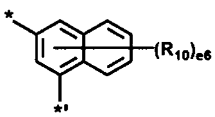

10-1 10-2 10-3 10-4

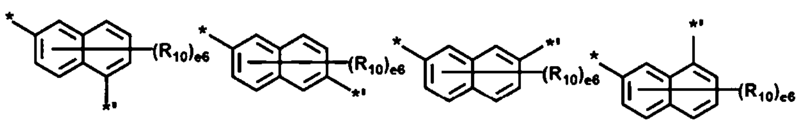

10-5 10-6 10-7 10-8

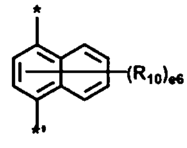
10-9

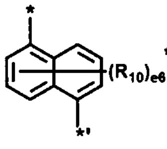
10-10

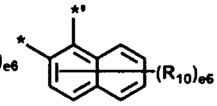
10-11

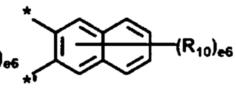
10-12

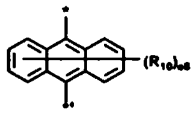
10-13

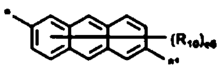
10-14

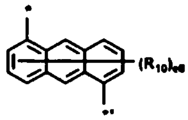
10-15

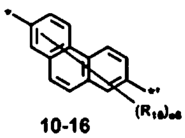
10-16

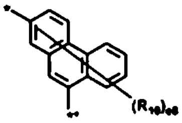
10-17

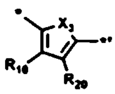
10-18

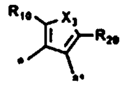
10-19

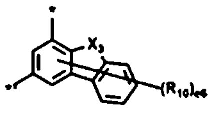
10-20

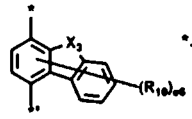
10-21

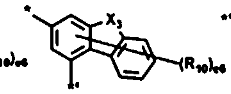
10-22

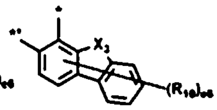
10-23

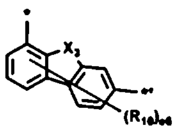
10-24

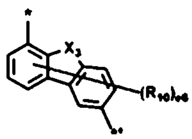
10-25

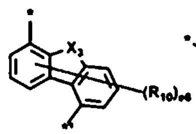
10-26

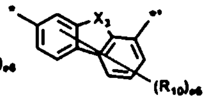
10-27

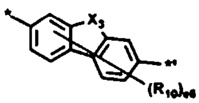
10-28

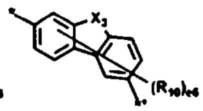
10-29

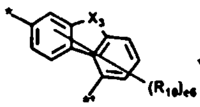
10-30

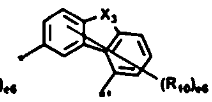
10-31

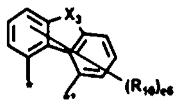
10-32

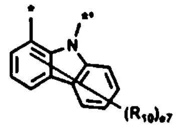
10-33

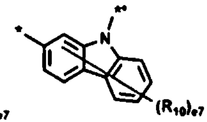
10-34

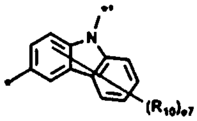
10-35

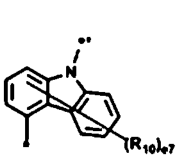
10-36

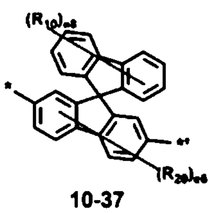
10-37

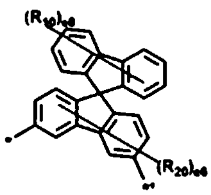
10-38

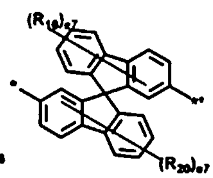
10-39

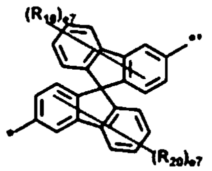

10-40

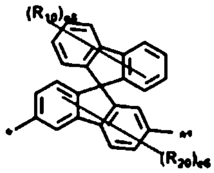

10-41

dans lequel, dans les formules 10-1 à 10-41,
$X_3$ est O, S, $N(R_{3a})$, ou $C(R_{3a})(R_{3b})$,
$R_{10}$, $R_{20}$, $R_{3a}$, et $R_{3b}$ sont chacun identiques à ceux définis en relation avec $R_{11}$ dans la revendication 1,
e4 est un entier compris entre 1 et 4.
e6 est un entier compris entre 1 et 6.
e7 est un entier compris entre 1 et 7, e8 est un entier compris entre 1 et 8, et
* et *' chacun indiquent un site de liaison avec un atome voisin.

**11.** Dispositif électroluminescent selon l'une quelconque des revendications 1 à 10, dans lequel la formule 2 est représentée par l'une des formules 2-1 à 2-6 :

Formule 2-1

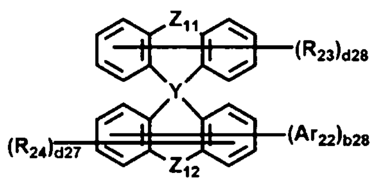

Formule 2-2

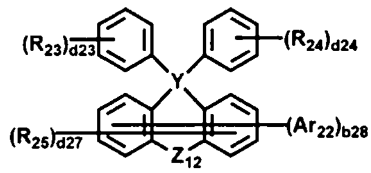

Formule 2-3

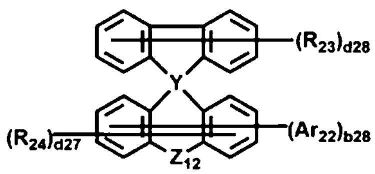

Formule 2-4

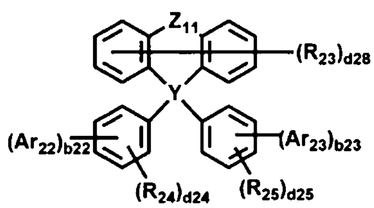

Formule 2-5

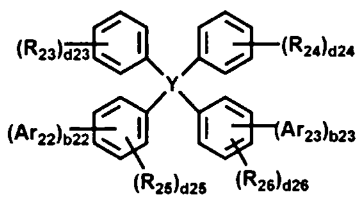

Formule 2-6

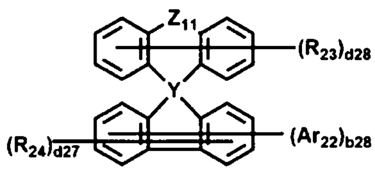

dans lequel, dans les formules 2-1 à 2-6,
Y est C ou Si,
$Ar_{22}$ et $Ar_{23}$ sont chacun identiques à ceux définis en relation avec $Ar_{21}$ dans la revendication 1, b28 est un entier de 1 à 8,
dans lequel, dans les formules 2-4 et 2-5, b22 est un entier de 0 à 5, b23 est un entier de 0 à 5, et la somme de b22 et b23 est un entier de 1 ou plus,
$R_{23}$ à $R_{26}$ sont chacun indépendamment identiques à ce qui est défini en relation avec $R_{21}$ dans la revendication 1,
d23 est un entier compris entre 1 et 5,
d24 est un entier compris entre 1 et 5,
d25 est un entier compris entre 1 et 5,
d26 est un entier compris entre 1 et 5,

d27 est un entier compris entre 1 et 7,
d28 est un entier compris entre 1 et 8, et
$Z_{12}$ est O, S, $N(R_{24a})$, ou $C(R_{24a})(R_{24b})$,
dans les formules 2-1 et 2-4, $Z_{11}$ est O, S, $N(R_{23a})$, ou $C(R_{23a})(R_{23b})$,
Dans la formule 2-6, $Z_{11}$ est $N(R_{23a})$ ou $C(R_{23a})(R_{23b})$, et
$R_{23a}$, $R_{23b}$, $R_{24a}$, et $R_{24b}$ sont chacun indépendamment identiques à ce qui est défini en relation avec $R_{21a}$ dans la revendication 1.

**12.** Dispositif électroluminescent selon l'une quelconque des revendications 1 à 11, dans lequel :

(i) une fraction représentée par

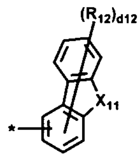

dans la formule 1 est représentée par l'une des formules 1-1 à 1-4 :

Formule 1-1

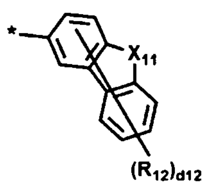

Formule 1-2

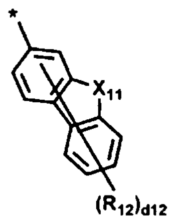

Formule 1-3

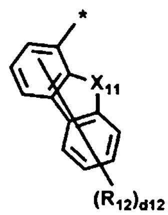

Formule 1-4

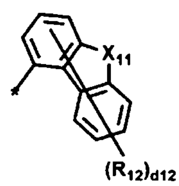

dans lequel, dans les formules 1-1 à 1-4,
$L_{11}$, $R_{12}$, et d12 sont chacun identiques à ceux définis dans la revendication 1, et
* indique un site de liaison à un atome voisin ; et/ou

(ii) la formule 2 est représentée par l'une des formules 2-11 à 2-14 :

Formule 2-11

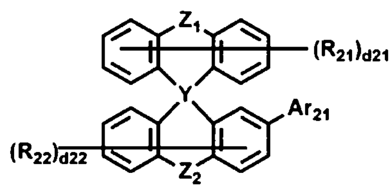

Formule 2-12

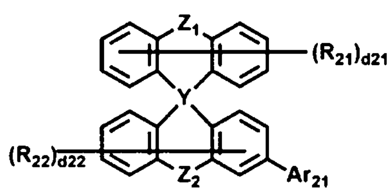

Formule 2-13

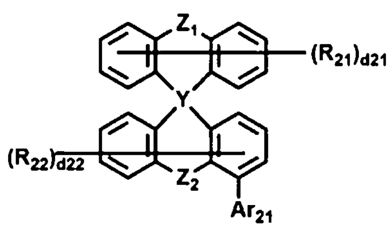

Formule 2-14

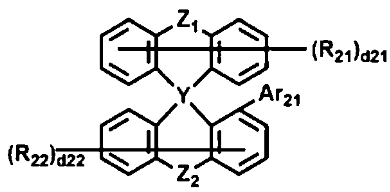

dans lequel, dans les formules 2-11 à 2-14, Y, $Z_1$, $Z_2$, $Ar_{21}$, $R_{21}$, $R_{22}$, d21 et d22 sont chacun identiques à ceux définis dans la revendication 1.

**13.** Dispositif électroluminescent selon l'une quelconque des revendications 1 à 12, dans lequel $R_1$ à $R_8$, $R_{11}$, $R_{11a}$, $R_{11b}$, $R_{12}$, $R_{21}$, [ $R_{21a}$, $R_{21b}$, $R_{22}$, $R_{22a}$, $R_{22b}$, $R_{32}$, $R_{33}$, $R_{31a}$, $R_{32a}$, et $R_{33a}$ sont chacun sélectionnés indépendamment parmi :

hydrogène, deutérium, -F, -Cl, -Br, -I, un groupe hydroxyle, un groupe cyano, un groupe nitro, un groupe amidino, un groupe hydrazino, un groupe hydrazono, un groupe alkyle $C_1$ - $C_{20}$ et un groupe alcoxy $C_1$ - $C_{20}$ ;
un groupe alkyle $C_1$ - $C_{20}$ et un groupe alcoxy $C_1$ - $C_{20}$, chacun substitué par au moins un des groupes suivants : deutérium, -F, -Cl, -Br, -I, $-CD_3$, $-CD_2H$, $-CDH_2$, $-CF_3$, - $CF_2H$, $-CFH_2$, un groupe hydroxyle, un groupe cyano, un groupe nitro, un groupe amidino, un groupe hydrazino, un groupe hydrazono, un groupe alkyle $C_1$ - $C_{10}$, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe biphényle, un groupe naphtyle, un groupe pyridinyle et un groupe pyrimidinyle.
un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe phényle, un groupe biphényle, un $C_1$ - $C_{10}$ groupe alkylphényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle groupe, un groupe pyridazinyle, un groupe isoindolyle, un groupe indolyle, un groupe indazolyle, un groupe purinyle, un groupe quinolinyle, un groupe isoquinoléinyle, un groupe penzoquinoléinyle, un groupe quinoxalinyle, un groupe quinazolinyle, un groupe cinnoléinyle, un groupe carbazolyle, un groupe phénanthrolinyle, un groupe benzimidazolyle, un groupe benzofuranyle, un groupe benzothiényle, un groupe benzoisothiazolyle, un groupe benzoxazolyle, un groupe benzoisoxazolyle, un groupe triazolyle, un groupe tétrazolyle, un groupe oxadiazolyle, un groupe triazinyle, un groupe dibenzofuranyle, un groupe dibenzothiényle, un groupe benzocarbazolyle, un groupe dibenzocarbazolyle, un groupe imidazopyridinyle, un groupe imidazopyrimidinyle, un groupe azacarbazolyle, un groupe azadibenzofuranyle, un groupe azadibenzothiényle, un groupe azafluorényle et un groupe azadibenzosilolyle, chacun non substitué ou substitué par au moins un des éléments suivants : deutérium, -F, -Cl, -Br, -I, $-CD_3$, $CD_2H$, $-CDH_2$, $-CF_3$, $-CF_2H$, $-CFH_2$, un groupe hydroxyle, un groupe cyano, un groupe nitro, un groupe amidino, un groupe hydrazino, un groupe hydrazono, un groupe alkyle $C_1$ - $C_{20}$, un groupe alcoxy $C_1$ - $C_{20}$, un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe phényle, un groupe biphényle, un groupe alkylphényle $C_1$ - $C_{10}$, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiényle, un groupe benzoisothiazolyle, un groupe benzoxazolyle, un groupe benzoisoxazolyle, un groupe triazolyle, un groupe tétrazolyle, un groupe oxadiazolyle, un groupe triazinyle, un groupe dibenzofuranyle, un groupe dibenzothiényle, un groupe benzocarbazolyle, un groupe dibenzocarbazolyle, un groupe imidazopyridinyle, un groupe imidazopyrimidinyle, un groupe azacarbazolyle, un groupe azadibenzofuranyle, un groupe azadibenzothiényle, un groupe azafluorényle, un groupe azadibenzosilolyle, - $Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, $-S(=O)_2(Q_{41})$ et - $P(=O)(Q_{31})(Q_{32})$ ; et $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, et - $P(=O)(Q_1)(Q_2)$,
dans lequel $Q_1$ à $Q_3$ et $Q_{31}$ à $Q_{33}$ sont chacun sélectionnés indépendamment parmi :

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, et $-CD_2CDH_2$, et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, un groupe naphtyle, un groupe pyridinyle, un groupe pyrimidinyle, un groupe pyridazinyle, un groupe pyrazinyle et un groupe triazinyle, chacun non substitué ou substitué par au moins un groupe choisi parmi le deutérium, un groupe alkyle $C_1$ - $C_{10}$, un groupe phényle, un groupe biphényle, un

groupe pyridinyle, un groupe pyrimidinyle, un groupe pyridazinyle, un groupe pyrazinyle et un groupe triazinyle.

**14.** Dispositif électroluminescent selon l'une quelconque des revendications 1 à 13, dans lequel au moins un premier composé est choisi dans le groupe I et au moins un deuxième composé est choisi dans le groupe II :

Groupe I

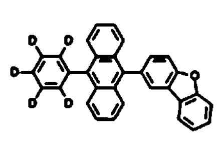
1-1

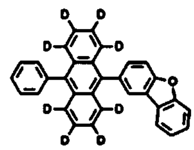
1-2

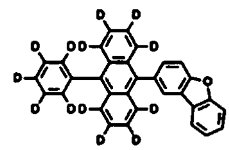
1-3

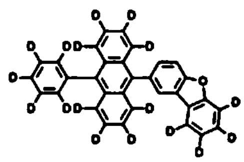
1-4

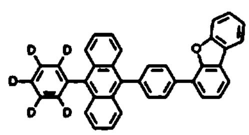
1-5

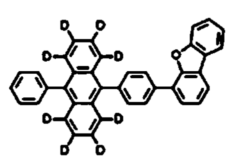
1-6

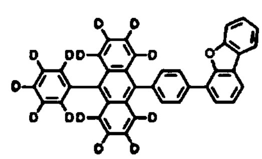
1-7

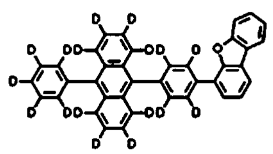
1-8

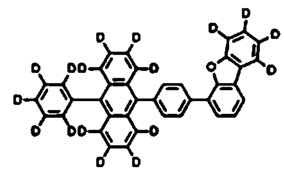
1-9

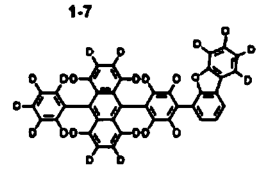
1-10

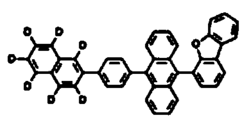
1-11

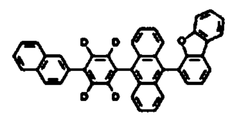
1-12

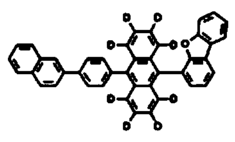
1-13

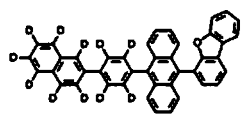
1-14

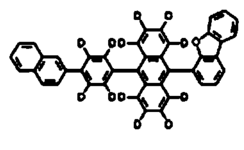
1-15

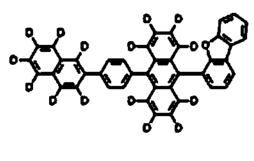
1-16

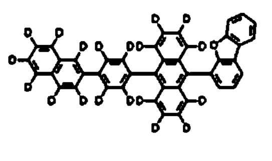
1-17

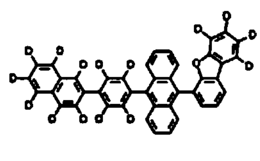
1-18

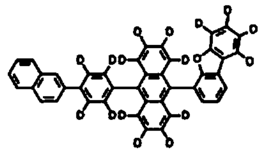
1-19

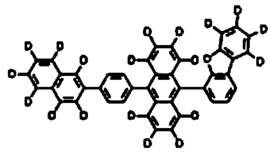
1-20

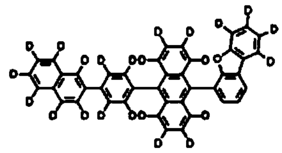
1-21

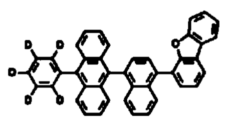
1-22

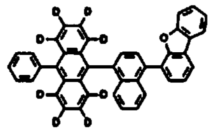
1-23

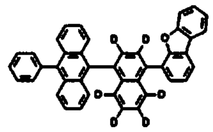
1-24

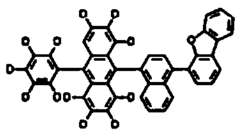
1-25

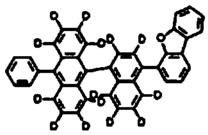
1-26

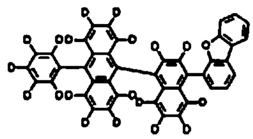
1-27

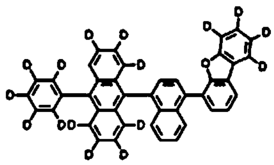
1-28

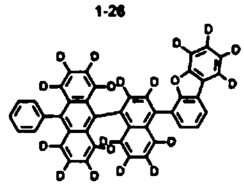
1-29

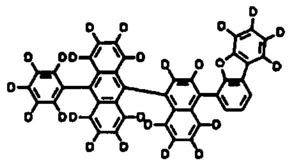
1-30

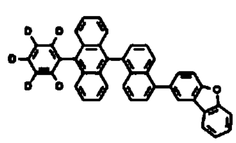
1-31

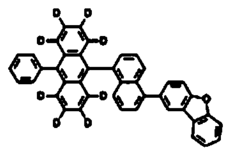
1-32

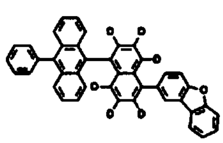
1-33

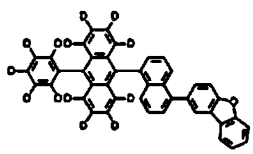
1-34

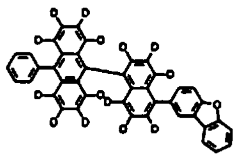
1-35

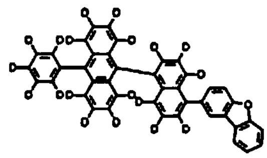
1-36

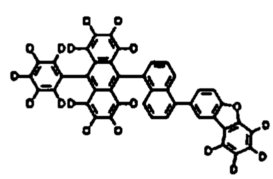
1-37

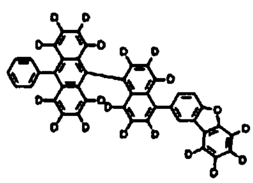
1-38

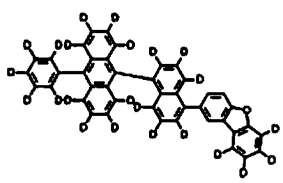
1-39

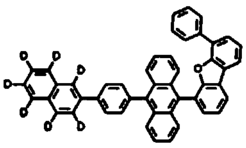

1-40

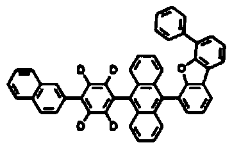

1-41

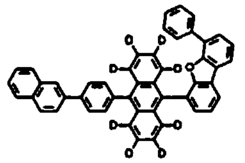

1-42

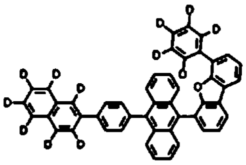

1-43

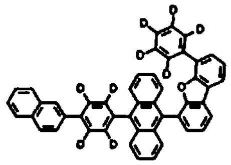

1-44

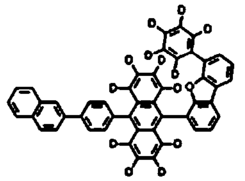

1-45

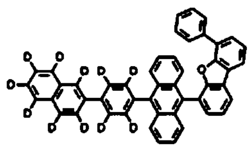

1-46

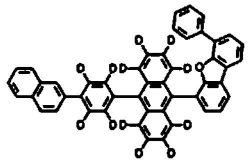

1-47

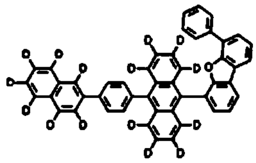

1-48

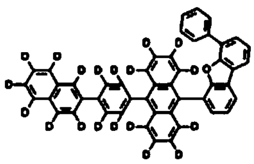

1-49

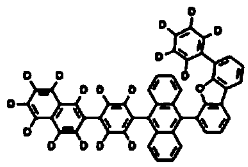

1-50

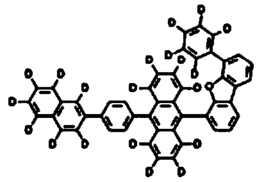

1-51

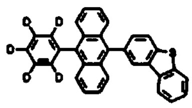

1-52

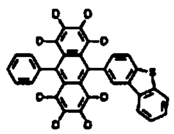

1-53

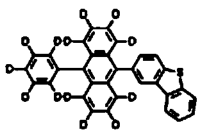

1-54

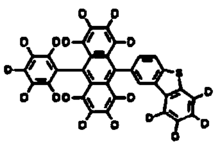

1-55

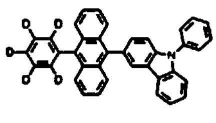

1-56

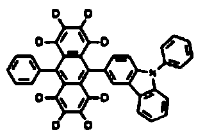

1-57

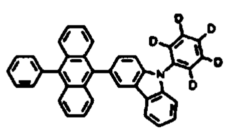

1-58

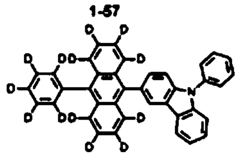

1-59

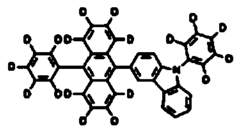
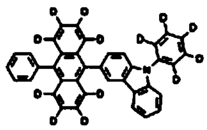
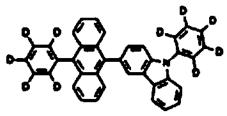

1-60 1-61 1-62

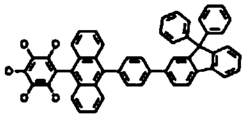
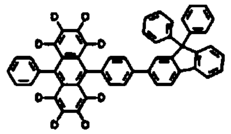
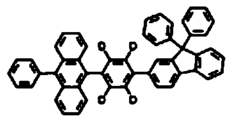

1-63 1-64 1-65

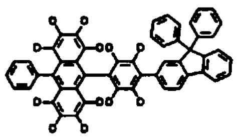
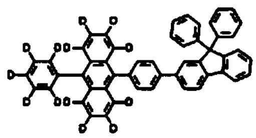
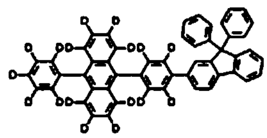

1-66 1-67 1-68

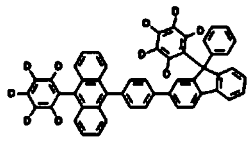
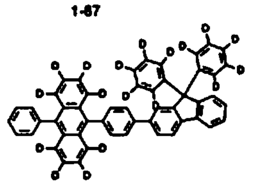
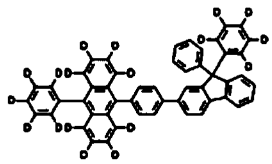

1-69 1-70 1-71

Groupe II

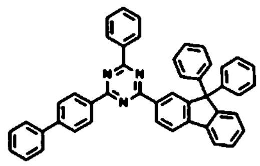

2-1

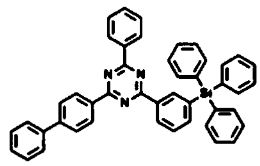

2-2

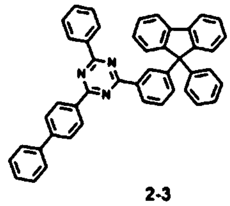

2-3

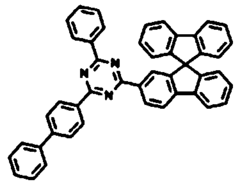

2-4

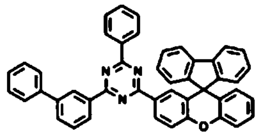

2-5

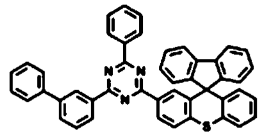

2-6

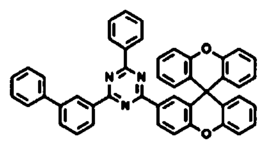

2-7

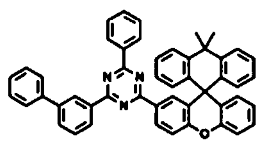

2-8

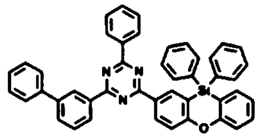

2-9

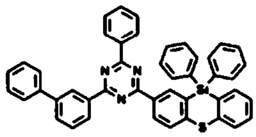

2-10

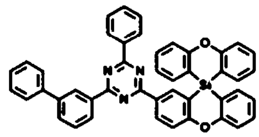

2-11

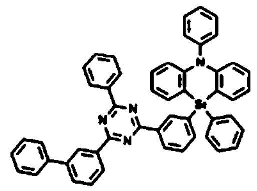

2-12

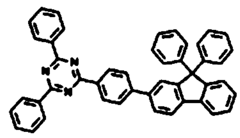

2-13

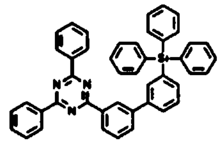

2-14

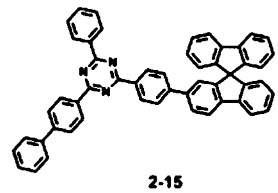

2-15

**15.** Appareil électronique, comprenant :

le dispositif électroluminescent selon l'une quelconque des revendications 1 à 14, et
un transistor à couche mince,
dans lequel le transistor à couche mince comprend une électrode source (260) et une électrode drain (270), et la première électrode du dispositif électroluminescent est couplée électriquement à l'électrode source ou à l'électrode drain, éventuellement dans lequel l'appareil comprend un filtre de couleur, une couche de conversion de couleur, une couche d'écran tactile, une couche polarisante ou toute combinaison de ceux-ci.

FIG. 1

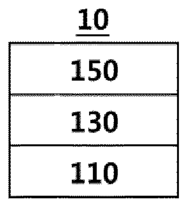
10
150
130
110

FIG. 2

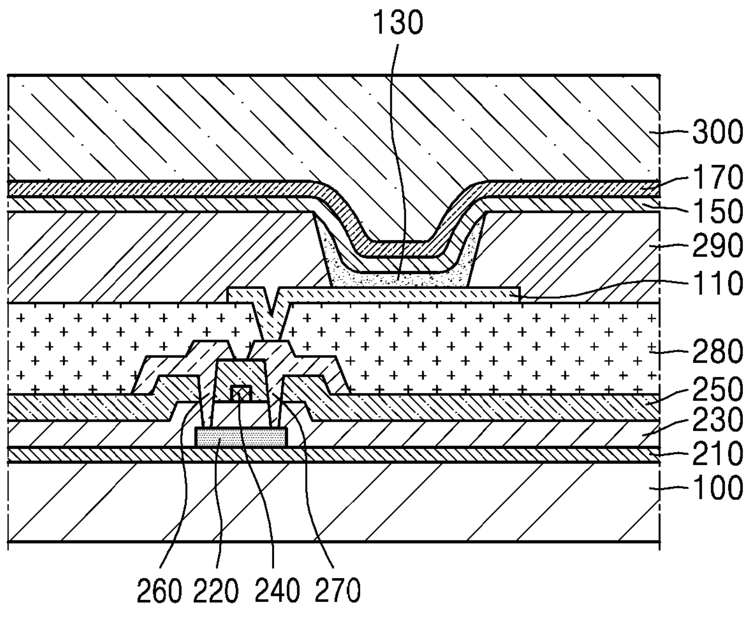
130
300
170
150
290
110
280
250
230
210
100
260
220
240
270

FIG. 3

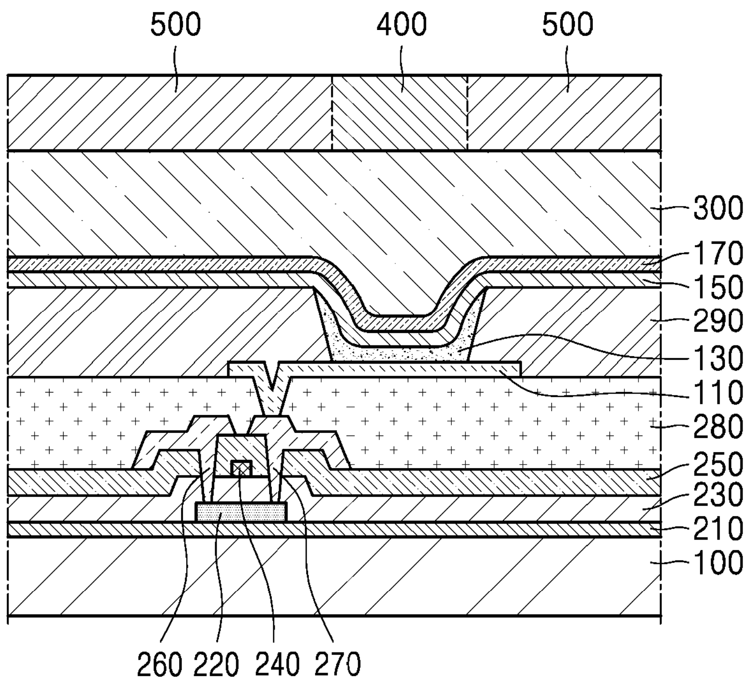
500
400
500
300
170
150
290
130
110
280
250
230
210
100
260
220
240
270

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2020235343 A1